# EUROPEAN PATENT APPLICATION

(11) **EP 4 753 175 A1**
(43) Date of publication of application: **03.06.2026**
(21) Application number: 24383287.0
(22) Date of filing: 28.11.2024
(51) Int. Cl.: H04B 17/391, H04W 16/22

(54) **SIMULATING WIRELESS COMMUNICATION**

(71) Applicant: Nvidia Corporation, Santa Clara, CA 95051 (US)
(72) Inventor: TANG, Xiangguo, Sunnyvale (US); CHEN, Yongce, Sunnyvale (US); HU, Zhen, San Jose (US); HUANG, Yan, San Jose (US); SCHMITZ, David, Mountain View (US); CASAS, Christian Ibars, Bordils (ES)
(74) Representative: Elzaburu S.L.P.

(57) **Abstract**

Apparatuses, systems, and techniques to simulate communicated between wireless devices and base stations. In at least one embodiment, communication between wireless devices and base stations are simulated based on a grouping of wireless devices according to shared communication frequency bands.

## Description

### TECHNICAL FIELD

In at least one embodiment, communication between wireless devices and base stations are to be simulated.

### BACKGROUND

Communication between wireless devices and base stations can simulated using parameters associated with simulated devices. Methods of performing simulating wireless devices in a wireless network can be improved in terms of time, quality, computing resources, and/or other considerations.

### BRIEF DESCRIPTION OF DRAWINGS

FIG.1 illustrates an example of a wireless network simulation system, in accordance with at least one embodiment;
FIG. 2 illustrates an example of a wireless network simulation system, according to at least one embodiment;
FIG. 3 illustrates a system for simulating multiple channels and user equipment (UE) in a wireless communication network, according to at least one embodiment;
FIG. 4 illustrates a flowchart depicting a method for simulating communication between wireless devices and base stations, in accordance with at least one embodiment;
FIG. 5 illustrates an example of a system, in accordance with at least one embodiment;
FIG. 6 is a block diagram illustrating a driver and/or runtime including one or more libraries to provide one or more application programming interfaces (APIs), according to at least one embodiment;
FIG. 7 illustrates an example data center system, in accordance with at least one embodiment;
FIG. 8 illustrates an system-on-a-chip (SOC), in accordance with at least one embodiment;
FIG. 9A illustrates a parallel processor, in accordance with at least one embodiment;
FIG. 9B illustrates a processing cluster, in accordance with at least one embodiment;
FIG. 9C illustrates a graphics multiprocessor, in accordance with at least one embodiment;
FIG. 10 illustrates an accelerator processor, in accordance with at least one embodiment;
FIG. 11A illustrate a central processing unit, in accordance with at least one embodiment;
FIG. 11B illustrates a core of central processing unit in FIG. 10A, in accordance with at least one embodiment;
FIG. 12 illustrates another accelerator processor, in accordance with at least one embodiment;
FIG. 13 illustrates a neuromorphic processor, in accordance with at least one embodiment;
FIG. 14 illustrates a supercomputer, in accordance with at least one embodiment;
FIG. 15 illustrates another accelerator processor, in accordance with at least one embodiment;
FIG. 16 illustrates another processor, in accordance with at least one embodiment;
FIG. 17 illustrates another accelerator processor, in accordance with at least one embodiment;
FIG. 18 illustrates a tensor processing unit, in accordance with at least one embodiment;
FIG. 19 illustrates a RISC-V-compatible processor, in accordance with at least one embodiment;
FIGS. 20A and 20B illustrate a language processing unit, in accordance with at least one embodiment;
FIG. 21 illustrates a software stack of a programming platform, in accordance with at least one embodiment;
FIG. 22 illustrates software that is supported by a programming platform, in accordance with at least one embodiment;
FIG. 23 illustrates compiling code to execute on programming platforms of FIG. 21, in accordance with at least one embodiment;
FIG. 24 illustrates an example of an autonomous vehicle and its system architecture, in accordance with at least one embodiment;
FIG. 25A illustrates inference and/or training logic, in accordance with at least one embodiment;
FIG. 25B illustrates inference and/or training logic, in accordance with at least one embodiment;
FIG. 25C illustrates training and deployment of a neural network, in accordance with at least one embodiment;
FIG. 26 illustrates a network for communicating data within a 5G wireless communications network, according to at least one embodiment;
FIG. 27 illustrates a network architecture for a 5G LTE wireless network, according to at least one embodiment;
FIG. 28 is a diagram illustrating some basic functionality of a mobile telecommunications network/system operating in accordance with LTE and 5G principles, according to at least one embodiment;
FIG. 29 illustrates a radio access network which may be part of a 5G network architecture, according to at least one embodiment;
FIG. 30 provides an example illustration of a 5G mobile communications system in which a plurality of different types of devices is used, according to at least one embodiment;
FIG. 31 illustrates an example high level system, according to at least one embodiment;
FIG. 32 illustrates an architecture of a system of a network, according to at least one embodiment;
FIG. 33 illustrates example components of a device, according to at least one embodiment;
FIG. 34 illustrates example interfaces of baseband circuitry, according to at least one embodiment;
FIG. 35 illustrates an example of an uplink channel, according to at least one embodiment;
FIG. 36 illustrates an architecture of a system of a network, according to at least one embodiment;
FIG. 37 illustrates a control plane protocol stack, according to at least one embodiment; and
FIG. 38 illustrates a user plane protocol stack, according to at least one embodiment.

### DETAILED DESCRIPTION

In the following description, numerous specific details are set forth to provide a more thorough understanding of at least one embodiment. However, it will be apparent to one skilled in the art that the inventive concepts may be practiced without one or more of these specific details.

In at least one embodiment, a simulation process is performed by grouping wireless devices based on shared communication frequency bands. In at least one embodiment, a processor equipped with circuits is designed to simulate communication between multiple wireless devices and base stations by grouping devices according to shared frequency bands. In at least one embodiment, a grouping is based on orthogonality in time, frequency, or spatial domains. In at least one embodiment, a processor can categorize devices into orthogonal and non-orthogonal user equipment (UE) parameters. In at least one embodiment, a processor can optimize a UE simulation by using a single function for orthogonal parameters and mapping non-orthogonal parameters to separate virtual cells. In at least one embodiment, a concept of virtual channels is introduced, allowing for virtualization of channel processes, where a single virtual channel can simulate a communication process without creating multiple virtual channels. In at least one embodiment, a processor can simulate multiple UE devices with a single kernel launch of a simulator and does not need to simulate each UE device individually across all possible simulation parameters.

In at least one embodiment, a processor causes generation of a data structure that contains grouped UE parameters, distinguishing between orthogonal and non-orthogonal parameters. In at least one embodiment, a data structure facilitates simulation of channel conditions for each UE based on allocated frequency bands, ensuring that only relevant portions of bandwidth or other simulation parameters are processed.

In at least one embodiment, a wireless simulation system can handle both orthogonal and non-orthogonal scenarios in parallel. In at least one embodiment, a wireless simulation system allows for simultaneous processing of orthogonal UEs within a single virtual cell, while non-orthogonal UEs are managed through separate virtual cells. In at least one embodiment, a wireless simulation system uses a controller and scheduler to allocate resources and map them to specific UEs, enabling efficient channel simulation.

In at least one embodiment, in order to determine where to locate a base station, simulations are performed for different possible base station locations. In at least one embodiment, simulations involve creating virtual wireless devices and simulating how wireless signals between each wireless device and base station are affected by an environment. In at least one embodiment, a processor uses software that uses a kernel to simulate an effect of an environment on signals between a base station and multiple wireless devices, where said software selects a group so that no wireless device in said group uses a same frequency as any other wireless device in a group. In at least one embodiment, since each device in a group uses frequencies than other devices in said group do not use, simulation data corresponding to each frequency can only correspond to a single virtual wireless device. In at least one embodiment, this allows a single kernel to be used to simulate signals for multiple wireless devices in parallel (e.g., on different threads of a GPU in parallel, at a same time for all threads, or using a single GPU kernel). In at least one embodiment, a processor comprises circuits to cause one or more effects of an environment on two or more signals to be simulated based, at least in part, on two or more frequencies used to select said two or more wireless devices.

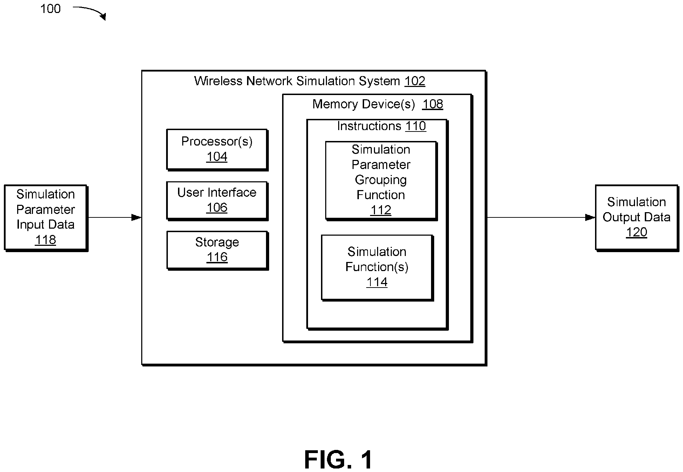

In at least one embodiment, FIG.1 illustrates an example 100 of a wireless network simulation system 102 designed to simulate communication between multiple wireless devices and base stations. In at least one embodiment, wireless network simulation system 102 includes a processor 104 that executes instructions to perform simulations by grouping wireless devices based on shared communication frequency bands. In at least one embodiment, processor 104 is connected to a user interface 106, allowing users to input simulation parameters and interact with a simulation process. In at least one embodiment, wireless network simulation system 102 is configured to handle both orthogonal and non-orthogonal scenarios. In at least one embodiment, wireless network simulation system 102 is capable of simulating multiple virtual channels simultaneously, enhancing efficiency of a simulation process. In at least one embodiment, wireless network simulation system 102 comprises memory devices 108 that store instructions 110, which include a simulation parameter grouping function 112. In at least one embodiment, simulation parameter grouping function 112 is responsible for categorizing devices into orthogonal and non-orthogonal user equipment (UE) parameters. In at least one embodiment, memory 108 contains simulation functions 114 that facilitate execution of simulations using grouped parameters. In at least one embodiment, wireless network simulation system 102 can simulate multiple UEs as a single UE pipeline when they are orthogonal such that they do not overlap in time, frequency, or spatial domains.

In at least one embodiment, wireless network simulation system 102 comprises storage 116 for retaining simulation data and results. In at least one embodiment, simulation parameter input data 118 is provided to wireless network simulation system 102, which is then processed by a simulation parameter grouping function 112 and simulation functions 114. In at least one embodiment, wireless network simulation system 102 ensures that only relevant portions of bandwidth or other simulation parameters are processed. In at least one embodiment, wireless network simulation system 102 generates a data structure that identifies which UE is using which portion of a bandwidth or other simulation parameters. In at least one embodiment, a data structure is used for distinguishing between orthogonal and non-orthogonal parameters, facilitating a simulation of channel conditions for each UE based on allocated frequency bands or other simulation parameters.

In at least one embodiment, wireless network simulation system 102 outputs simulation results as simulation output data 120. In at least one embodiment, simulation output data 120 reflects simulated channel conditions for each UE based on allocated frequency bands other simulation parameters. In at least one embodiment, wireless network simulation system 102 can handle both orthogonal and non-orthogonal scenarios in parallel and allows for simultaneous processing of orthogonal UEs within a single virtual cell, while managing non-orthogonal UEs through separate virtual cells.

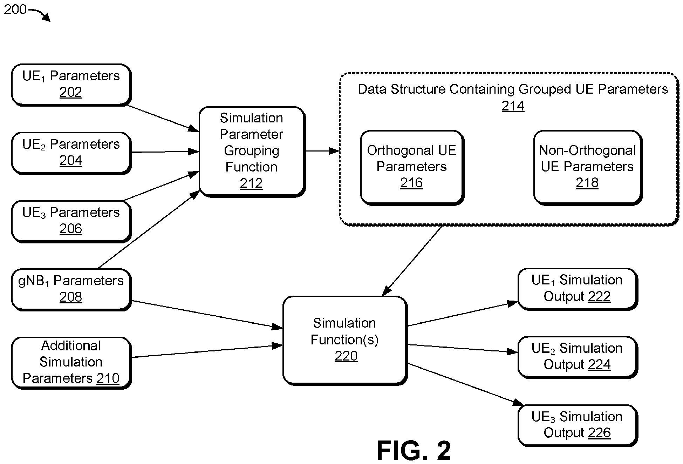

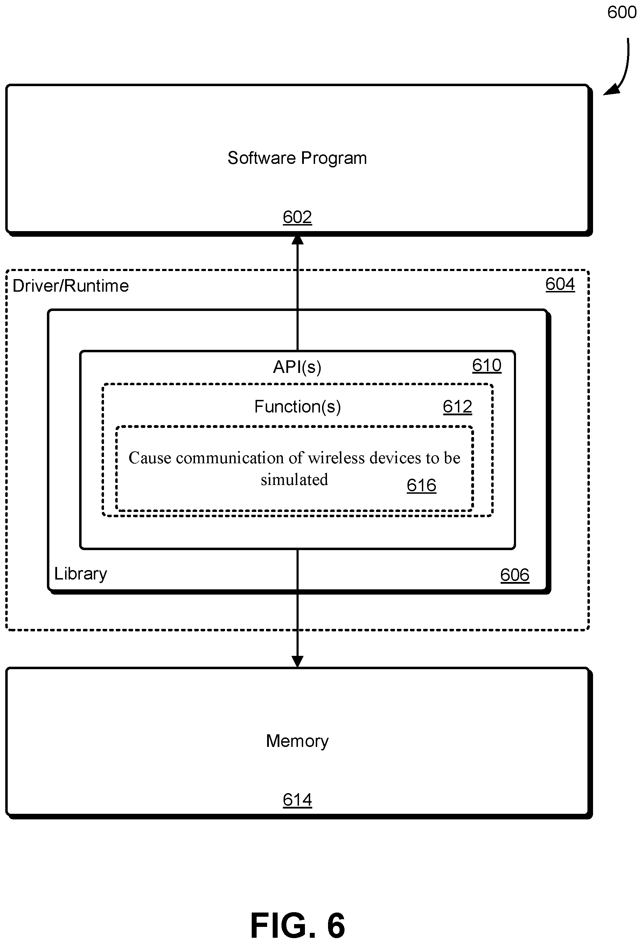

In at least one embodiment, processor(s) 104 may include one or more parallel processing units (PPU(s)), such as one or more graphics processing units (GPU(s)). In at least one embodiment, processor(s) 104 may include one or more massively parallel GPU(s). In at least one embodiment, massively parallel GPU(s) refer to a collection of one or more GPUs, or any suitable processing units, which may be utilized to perform various processes in parallel. In at least one embodiment, processor(s) 104 may be implemented, for example, using a main central processing unit (CPU) complex, one or more microprocessors, one or more microcontrollers, PPU(s) (e.g., GPU(s)), one or more data processing units (DPU(s)), one or more arithmetic logic units (ALU(s)). In at least one embodiment, processor(s) 104 may be any processor described in or used in connection with embodiments depicted in FIGS.6-37 . In at least one embodiment, memory devices 108 (e.g., one or more non-transitory processor-readable medium) may be implemented, using volatile memory (e.g., dynamic random-access memory (DRAM)) and/or nonvolatile memory (e.g., a hard drive, a solid-state device (SSD)). In at least one embodiment user interface 106 is one or more input output devices that allow a user to cause one or more instructions 110 to be performed by processor(s) 104. In at least one embodiment, user interface 106 may be any user interface described in or used in connection with embodiments depicted in FIGS.6-37. In at least one embodiment, at least a portion of example 100 is implemented using at least a portion of any system(s) depicted in and/or described with respect to FIGS. 2-37.

FIG. 2 illustrates an example 200 of a wireless network simulation system, according to at least one embodiment. In at least one embodiment, example 200 is a system that processes user equipment (UE) parameters to simulate communication with a base station. In at least one embodiment, example 200 includes UE parameters 202, 204, and 206, which are input into a simulation parameter grouping function 212 In at least one embodiment, UE simulation paraments are unique identifiers that can correspond to an assigned channel. In at least one embodiment, UE parameters 202, 204 and 206 represent multiple UEs to be in communication with a base station having gNB parameters 208. In at least one embodiment UE₁ parameters and UE₂ parameters are orthogonal such that they do not overlap, but UE₁ parameters and UE₃ parameters are non-orthogonal and may occupy conflicting time and/or frequency domains. In at least one embodiment, simulation parameter grouping function 212 categorizes parameters into orthogonal and non-orthogonal UE parameters, facilitating efficient simulation.

In at least one embodiment, example 200 incorporates gNB parameters 208 and additional simulation parameters 210, which are processed alongside UE parameters. In at least one embodiment, simulation parameter grouping function 212 generates a data structure 214 containing grouped UE parameters, distinguishing between orthogonal UE parameters 216 and non-orthogonal UE parameters 218. In at least one embodiment, orthogonal UE parameters 216 are used to simulate in parallel communication between UEs and gNBs. In at least one embodiment, data structure 214 is used to ensure that only relevant parameters are processed by simulation functions 220.

In at least one embodiment, simulation function(s) 220 utilize grouped parameters orthogonal UE parameters 216 and non-orthogonal UE parameters 218 stored in data structure 214 to execute simulations, producing simulation outputs for each UE. In at least one embodiment, simulations using orthogonal UE parameters 216 are performed from a single kernel launch of simulation functions 220. In at least one embodiment, outputs of simulation functions 220 include UE simulation output 222, 224, and 226, reflecting a simulated channel conditions based on an allocated frequency bands. In at least one embodiment, simulation function(s) 220 using grouped parameters orthogonal UE parameters 216 and non-orthogonal UE parameters 218 allows for simultaneous processing of orthogonal UEs within a single virtual cell, while managing non-orthogonal UEs through separate virtual cells.

In at least one embodiment, example 200 simulates channels and virtual UEs by processing UE parameters to facilitate communication with a base station. In at least one embodiment, example 200 includes UE parameters 202, 204, and 206, which are input into a simulation parameter grouping function 212. In at least one embodiment, these parameters represent multiple UEs communicating with a base station having gNB parameters 208.

In at least one embodiment, simulation parameter grouping function 212 categorizes parameters into orthogonal and non-orthogonal UE parameters, facilitating efficient simulation. In at least one embodiment, orthogonal UE parameters do not overlap in time, frequency, or spatial domains, allowing them to be processed in parallel within a single virtual cell. In at least one embodiment, non-orthogonal UE parameters, which may occupy conflicting domains, are managed through separate virtual cells.

In at least one embodiment, example 200 uses a data structure 214 to store grouped UE parameters, distinguishing between orthogonal UE parameters 216 and non-orthogonal UE parameters 218. In at least one embodiment, simulation functions 220 utilize these grouped parameters to execute simulations, producing outputs such as UE simulation outputs 222, 224, and 226. In at least one embodiment, this approach allows for simultaneous processing of orthogonal UEs and efficient management of non-orthogonal UEs, optimizing computational and memory resources.

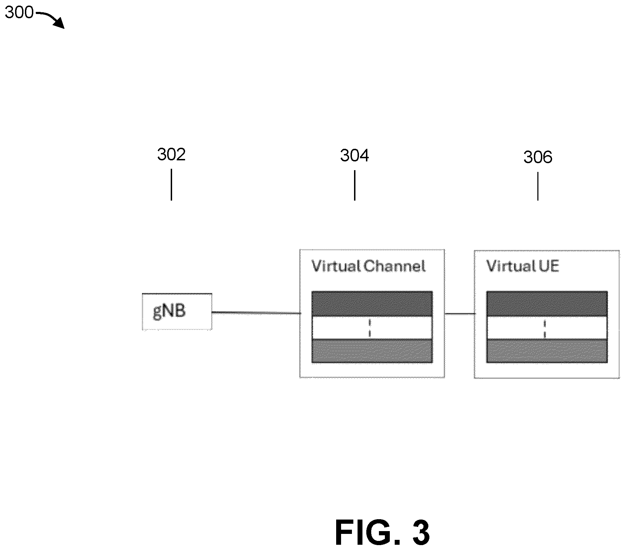

In at least one embodiment, system 200 may be performed by any of said components of FIG. 2, and any components of FIG. 1, may be used in connection with said subject matter of FIG. 2. In at least one embodiment, at least a portion of example 200 is implemented using at least a portion of any system(s) depicted in and/or described with respect to FIGS. 3 - FIG. 37. In at least one embodiment, at least a portion of example 200 is used to implement at least a portion of any system(s) depicted in and/or described with respect to FIGS. 3 - FIG. 37.

FIG. 3 illustrates a system 300 for simulating multiple channels and user equipment (UE) in a wireless communication network, according to at least one embodiment. In at least one embodiment, system 300 includes a base station, referred to as gNB 302, which can be either a physical or simulated entity. In at least one embodiment, gNB 302 interfaces with a virtual channel module 304 and a virtual UE module 306.

In at least one embodiment, virtual channel module 304 is configured to simulate multiple orthogonal channels simultaneously. In at least one embodiment, channels are orthogonal such that they do not overlap in time and/or frequency domains. In at least one embodiment, a total channel bandwidth is 1000 MHz, which can be divided among various UEs. In at least one embodiment, each UE may be allocated a 100 MHz portion of bandwidth, allowing for concurrent simulation of all channels. In at least one embodiment, channels can be indexed for simulation purposes, such that specific frequency ranges (e.g., 100-200 MHz for UE 1, 201-300 MHz for UE 2) are designated for individual UEs. In at least one embodiment a system including processors are to cause one or more channels of one or more base stations to be simulated in parallel based, at least in part, on assigning each portion of said one or more channels a unique identifier such that a virtual channel can simulate all channels at a same time. In at least one embodiment, said one or more processors are to cause one or more channels of one or more base stations to be simulated in parallel using a single kernel based, at least in part, on assigning each portion of said one or more channels a unique identifier.

In at least one embodiment, virtual UE module 306 simulates multiple UEs concurrently, corresponding to channels in virtual channel module 304. In at least one embodiment, system 300 enables comprehensive simulation of communication environment, facilitating testing and development of network functionalities.

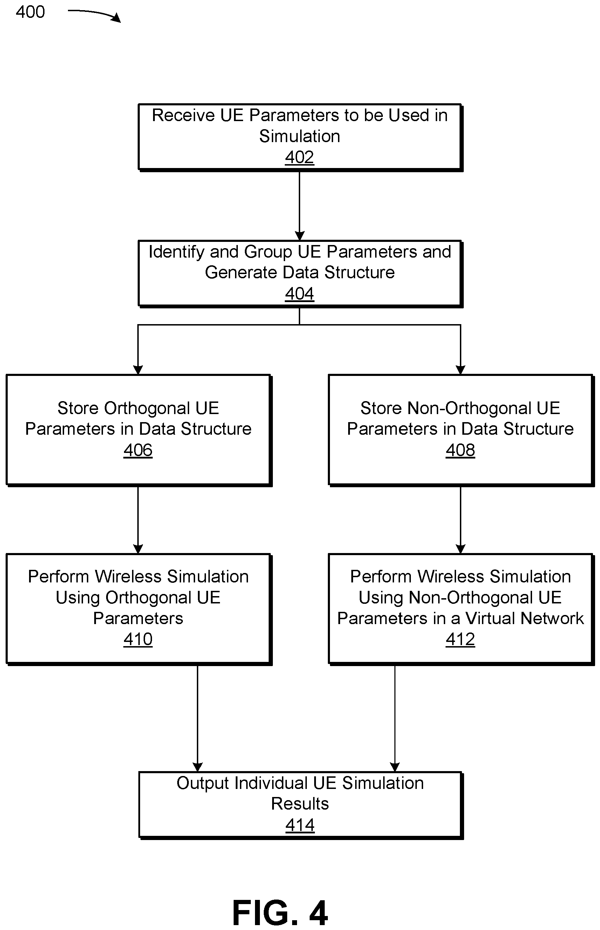

In at least one embodiment, method 300 may be performed by any components of FIGS. 1 or 2, and any components of FIGS. 1 or 2 may be used in connection with subject matter of FIG. 3. In at least one embodiment, at least a portion of method 300 is implemented using at least a portion of any system(s) depicted in and/or described with respect to FIGS. 4 - FIG. 37.

FIG. 4 illustrates a flowchart depicting a method 400 for simulating communication between wireless devices and base stations, in accordance with at least one embodiment. In at least one embodiment, method 400 is part of a wireless network simulation system designed to efficiently handle both orthogonal and non-orthogonal scenarios. In at least one embodiment, method 400 incorporates use of virtual channels to streamline simulation process, reducing computational overhead and improving simulation accuracy.

In at least one embodiment, method 400 begins with receiving user equipment (UE) parameters to be used in wireless simulation, as shown in block 402. In at least one embodiment, parameters are input through a user interface connected to a processor that executes instructions for wireless simulation. In at least one embodiment, method 400 is capable of handling multiple UEs by grouping them based on shared communication frequency bands.

In at least one embodiment, method 400 proceeds to identify and group UE parameters, generating a data structure, as depicted in block 404. This data structure categorizes UE parameters into orthogonal and non-orthogonal parameters using a simulation parameter grouping function. In at least one embodiment, orthogonal parameters are those that do not overlap in time, frequency, or spatial domains, allowing for efficient simulation.

In at least one embodiment, data structure stores identified and grouped UE parameters into orthogonal and non-orthogonal categories. In at least one embodiment, orthogonal UE parameters are stored in a data structure, as indicated in block 406, while non-orthogonal UE parameters are stored in a separate data structure, as shown in block 408, which facilitates simulation of channel conditions for each UE based on allocated frequency bands or other simulation parameters.

In at least one embodiment, method 400 includes performing wireless simulations using orthogonal UE parameters, as illustrated in block 410. In at least one embodiment, simulations can be executed from a single kernel launch, allowing for simultaneous processing of orthogonal UEs within a single virtual cell. In at least one embodiment, wireless simulations are performed using non-orthogonal UE parameters within a virtual network, as depicted in block 412, managing them through separate virtual cells.

In at least one embodiment, method 400 concludes with outputting individual UE simulation results, as shown in block 414. In at least one embodiment, simulation output data reflects simulated channel conditions for each UE based on an allocated frequency bands and other simulation parameters. In at least one embodiment, method 400 allows for efficient simulation by distinguishing between orthogonal and non-orthogonal parameters, facilitating parallel processing and optimizing resource allocation.

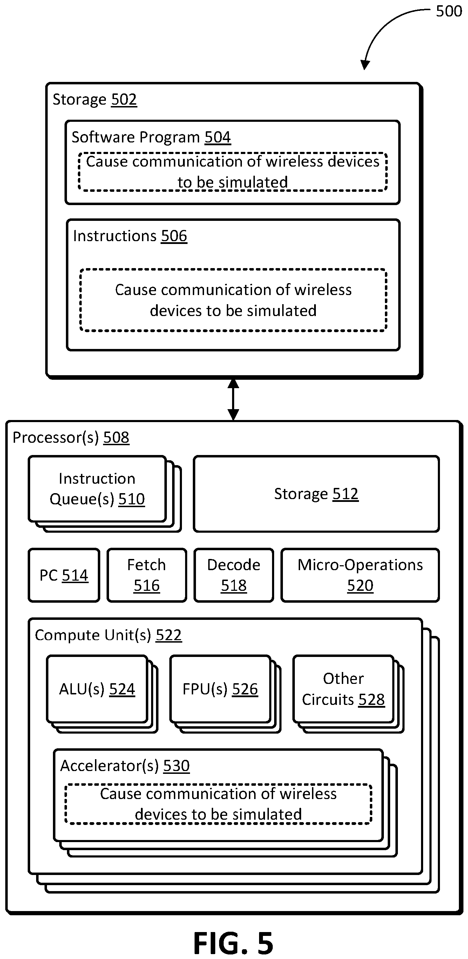

In at least one embodiment, method 400 may be performed by any components of FIGS. 1-3 and any components of FIGS. 1-3 may be used in connection with subject matter of FIG. 4. In at least one embodiment, at least a portion of method 400 is implemented using at least a portion of any system(s) depicted in and/or described with respect to FIGS. 5 - FIG. 38.

FIG. 5 illustrates an example of a system 500 that can include software and hardware to cause communication of a plurality of wireless devices with one or more base stations to be simulated based, at least in part, on grouping the plurality of wireless devices according to one or more shared communication frequency bands or otherwise perform any of the operations described herein, according to at least one embodiment. System 500 can include storage 502 and processor(s) 508. Storage 502 can include, for example, memory, cache, or other storage described further herein. Storage 502 can be separate from processor(s) 508, or storage 502 can be included in processor(s) 508 (e.g., in storage 512). In at least one embodiment, software program 504 and/or software libraries (or instructions) 506 can be stored in memory, cache, or other storage and provided to processor(s) 508 to cause one or more circuits of processor(s) 508 to perform operations described herein. In at least one embodiment, software program 504 and/or software libraries (or instructions) 506 can be integrated into one or more circuits of processor(s) 508. Software program 504, which can be used to perform any of the operations described herein, may be stored on storage 502.

In at least one embodiment, as used in any implementation described herein, unless otherwise clear from context or stated explicitly to contrary, a module refers to any combination of software logic, firmware logic, hardware logic, and/or circuitry configured to provide functionality described herein. In at least one embodiment, software is embodied as a software package, code and/or instruction set or instructions, and "hardware," as used in any implementation described herein, includes, for example, singly or in any combination, hardwired circuitry, programmable circuitry, state machine circuitry, fixed function circuitry, execution unit circuitry, and/or firmware that stores instructions performed by programmable circuitry. In at least one embodiment, modules are, collectively or individually, embodied as circuitry that forms part of a larger system, for example, an integrated circuit (IC), system on-chip (SoC), and so forth. In at least one embodiment, a module performs one or more processes in connection with any suitable processing unit and/or combination of processing units, such as one or more CPUs, GPUs, GPGPUs, PPUs, and/or variations thereof including those further described herein.

In at least one embodiment, software program 504 can include a collection of software code, commands, instructions, or other sequences of text to instruct a computing device to perform one or more computational operations and/or invoke one or more other sets of instructions, such as API(s) or API function(s) or Instruction Set Architecture (ISA) level instructions, to be executed or otherwise performed. Instructions (e.g., hardware instructions) or microcode can involve ISA level instructions, which can include native ISA instructions or non-native ISA instructions. Software program 504 and/or software libraries (or instructions) 506 (e.g., one or more modules) can be distributed among multiple processors that communicate over a bus, network, by writing to shared memory, and/or any suitable communication process such as those described herein.

In at least one embodiment, system 500 can include one or more software libraries 506 that can, for example, provide one or more APIs and/or ISA instructions. In at least one embodiment, one or more APIs and/or ISA instructions can be used cause communication of a plurality of wireless devices with one or more base stations to be simulated based, at least in part, on grouping the plurality of wireless devices according to one or more shared communication frequency bands. In at least one embodiment, one or more software libraries 506 can be included in drivers and/or runtimes. In at least one embodiment, software libraries 506 (e.g., including one or more APIs and/or ISA instructions) can include sets of software instructions that, if executed or otherwise performed, cause processor(s) 508 to perform one or more computational operations, such as any of the operations described herein. In at least one embodiment, one or more APIs and/or ISA instructions can be distributed or otherwise provided as a part of one or more software libraries 506, runtimes, drivers, and/or any other grouping of software and/or executable code further described herein. In at least one embodiment, one or more APIs and/or ISA instructions can perform one or more computational operations in response to invocation by software program 504.

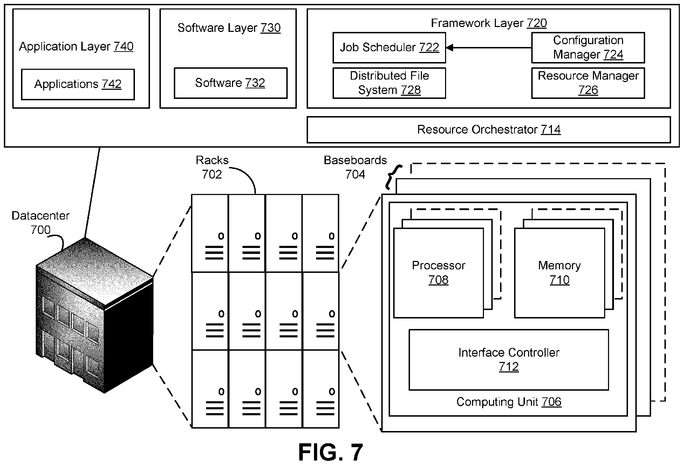

Processor(s) 508 may include any number of processors and any suitable processing unit and/or combination of processing units, such as, but not limited to, central processing units ("CPUs"), graphics processing units ("GPUs"), or other processors (including accelerators, field programmable gate arrays (FPGAs), graphics processors, parallel processors, GPGPUs, DPUs, and/or variations thereof including those further described herein), including any processors described herein, such as, but not limited to, processors in FIGS. 7-19. In at least one embodiment, processor(s) 508 can retrieve or fetch instructions (e.g., one or more APIs and/or ISA instructions) from storage 502 using, for example, instruction fetch 516 (e.g., for an Instruction Fetch stage). Instructions can include instructions to cause communication of a plurality of wireless devices with one or more base stations to be simulated based, at least in part, on grouping the plurality of wireless devices according to one or more shared communication frequency bands. In at least one embodiment, processor(s) 508 can include storage 512 and instruction queue 510 to store and queue instructions fetched from storage 502. In at least one embodiment, fetched instructions can be decoded by decode 518 to determine what operation should be performed by processor(s) 508 (e.g., in an Instruction Decode stage). In at least one embodiment, processor(s) 508 can fetch additional operands (data) that may be used for instructions, and operands can be stored, e.g., in registers or storage 512. In at least one embodiment, micro-operations 520 can perform operations on data stored in one or more registers or storage 512. For example, each step of instructions fetched by processor(s) 508 can be decomposed during execution so processor(s) 508 can execute instructions in steps through a series of micro-operations 520. In at least one embodiment, program counter (PC) 514 can hold an address for a next instruction and can be updated to point to the next instruction to be executed by processor(s) 508.

In at least one embodiment, processor(s) 508 can perform instructions (e.g., in an Execution stage). For example, processor(s) 508 can perform an operation specified by the instructions, such as an arithmetic operation, a logical operation, or a data transfer. In at least one embodiment, compute unit(s) 522 can execute instructions to perform any of the operations described herein. In at least one embodiment, compute unit(s) can include ALU(s) 524 (Arithmetic Logic Units), which may be used for performing arithmetic and logical operations. In at least one embodiment, compute unit(s) can include FPU(s) (Floating Point Units) 526, which may be used for performing floating-point calculations. In at least one embodiment, other circuits 528 can be used to perform other operations, such as vector and/or scalar operations. In at least one embodiment, accelerator(s) 530 can include one or more matrix multiplication accelerators, one or more parallel processing units (PPUs), such as GPUs, or any other accelerator or processor further described herein. In at least one embodiment, software program 504 can utilize one or more APIs and/or ISA instructions to perform various computing operations with accelerator(s) 530, such as matrix multiplication, arithmetic operations, or any other computing operation further described herein. In at least one embodiment, one or more computing operations using accelerator(s) 530 can include at least one or more groups of computing operations to be accelerated by execution at least in part by accelerator(s) 530, including to cause communication of a plurality of wireless devices with one or more base stations to be simulated based, at least in part, on grouping the plurality of wireless devices according to one or more shared communication frequency bands.

In at least one embodiment, system 500 can be used to perform one or more instructions that include functions or operations, such as those described in connection with FIGS. 1-4. In at least one embodiment, system 500 comprising one or more processors causes one or more circuits to cause communication of a plurality of wireless devices with one or more base stations to be simulated based, at least in part, on grouping the plurality of wireless devices according to one or more shared communication frequency bands and/or otherwise perform operations described herein. In at least one embodiment, system 500 is included in and/or otherwise includes systems illustrated in FIGS. 1-4 to cause one or more circuits to cause communication of a plurality of wireless devices with one or more base stations to be simulated based, at least in part, on grouping the plurality of wireless devices according to one or more shared communication frequency band sand/or otherwise perform operations described herein. In at least one embodiment, system 500 includes one or more hardware illustrated in FIGS. 7-38, such as to cause communication of a plurality of wireless devices with one or more base stations to be simulated based, at least in part, on grouping the plurality of wireless devices according to one or more shared communication frequency bands and/or otherwise perform operations described herein.

FIG. 6 is a block diagram 600 illustrating a driver and/or runtime including one or more libraries to provide one or more application programming interfaces (APIs), according to at least one embodiment. In at least one embodiment, a software program 602 is a software module. In at least one embodiment, a software program 602 includes one or more software modules. In at least one embodiment, one or more APIs 610 are sets of software instructions that, if executed, cause one or more processors to perform one or more computational operations. In at least one embodiment, one or more APIs 610 are distributed or otherwise provided as a part of one or more libraries 606, runtimes 604, drivers 604, and/or any other grouping of software and/or executable code further described herein. In at least one embodiment, one or more APIs 610 perform one or more computational operations in response to invocation by software programs 602. In at least one embodiment, a software program 602 is a collection of software code, commands, instructions, or other sequences of text to instruct a computing device to perform one or more computational operations and/or invoke one or more other sets of instructions, such as APIs 610 or API functions 612, to be executed.

In at least one embodiment, API functions 612 included but are not limited function to verify whether objects indicated in a description of an image are depicted in said image, functions to generate a textual description of visual content, functions to accept a natural language prompt to parse, edit, modify, and/or alter a description of an image, functions to identify whether objects descripted in a caption are depicted in an image sought to be described, and functions to generate an evaluation metric of a degree of similarity between an input image sought to be captioned and a generated caption. In at least one embodiment, functionality provided by one or more APIs 610 include software functions 612, such as those usable to accelerate one or more portions of software programs 602 using one or more parallel processing units (PPUs), such as graphics processing units (GPUs). In at least one embodiment, a software program is a compiler.

In at least one embodiment, APIs 610 are hardware interfaces to one or more circuits to perform one or more computational operations. In at least one embodiment, one or more software APIs 610 described herein are implemented as one or more circuits to perform one or more techniques described in conjunction with FIGS. 1-5. In at least one embodiment, one or more software programs 602 includes instructions that, if executed, cause one or more hardware devices and/or circuits to perform one or more techniques further described in conjunction with FIGS. 1-5.

In at least one embodiment, software programs 602, such as user-implemented software programs, utilize one or more application programming interfaces (APIs) 610 to perform various computing operations, such as memory reservation, matrix multiplication, arithmetic operations, or any computing operation performed by parallel processing units (PPUs), such as graphics processing units (GPUs), as further described herein. In at least one embodiment, one or more APIs 610 provide a set of callable functions 612, referred to herein as APIs, API functions, and/or functions, that individually perform one or more computing operations, such as computing operations related to parallel computing. In at least one embodiment, one or more APIs 610 provide functions 612 to adjusting a description of an image. In at least one embodiment, one or more APIs 610 provide functions 612 to cause a neural network to perform one or more operations, such as by returning a called function to a processor where said processor invokes said neural network. In at least one embodiment, one or more APIs 610 provide functions 612 to execute an application programming interface to cause software to be corrected based on a previous version of said software 616.

In at least one embodiment, one or more software programs 602 interact or otherwise communicate with one or more APIs 610 to perform one or more computing operations using one or more PPUs, such as GPUs. In at least one embodiment, one or more computing operations using one or more PPUs include at least one or more groups of computing operations to be accelerated by execution at least in part by said one or more PPUs. In at least one embodiment, one or more software programs 602 interact with one or more APIs 610 to facilitate parallel computing using a remote or local interface.

In at least one embodiment, an interface is software instructions that, if executed, provide access to one or more functions 612 provided by one or more APIs 610. In at least one embodiment, a software program 602 uses a local interface when a software developer compiles one or more software programs 602 in conjunction with one or more libraries 606 including or otherwise providing access to one or more APIs 610. In at least one embodiment, one or more software programs 602 are compiled statically in conjunction with pre-compiled libraries 606 or uncompiled source code including instructions to perform one or more APIs 610. In at least one embodiment, one or more software programs 602 are compiled dynamically and said one or more software programs utilize a linker to link to one or more pre-compiled libraries 606 including one or more APIs 610.

In at least one embodiment, a software program 602 uses a remote interface when a software developer executes a software program that utilizes or otherwise communicates with a library 606 including one or more APIs 610 over a network or other remote communication medium. In at least one embodiment, one or more libraries 606 including one or more APIs 610 are to be performed by a remote computing service, such as a computing resource services provider. In another embodiment, one or more libraries 606 including one or more APIs 610 are to be performed by any other computing host providing said one or more APIs 610 to one or more software programs 602.

In at least one embodiment, a processor performing or using one or more software programs 602 calls, uses, performs, or otherwise implements one or more APIs 610 to allocate and otherwise manage memory to be used by said software programs 602. In at least one embodiment, one or more software programs 602 utilize one or more APIs 610 to allocate and otherwise manage memory to be used by one or more portions of said software programs 602 to be accelerated using one or more PPUs, such as GPUs or any other accelerator or processor further described herein. Those software programs 602 request a neural network to generate a modified bounding box based, at least in part, on one or more second bounding boxes.

In at least one embodiment, an API 610 is an API to facilitate parallel computing. In at least one embodiment, an API 610 is any other API further described herein. In at least one embodiment, an API 610 is provided by a driver and/or runtime 604. In at least one embodiment, an API 610 is provided by a CUDA user-mode driver. In at least one embodiment, an API 610 is provided by a CUDA runtime. In at least one embodiment, a driver 604 is data values and software instructions that, if executed, perform or otherwise facilitate operation of one or more functions 612 of an API 610 during load and execution of one or more portions of a software program 602. In at least one embodiment, a runtime 604 is data values and software instructions that, if executed, perform or otherwise facilitate operation of one or more functions 612 of an API 610 during execution of a software program 602. In at least one embodiment, one or more software programs 602 utilize one or more APIs 610 implemented or otherwise provided by a driver and/or runtime 604 to perform combined arithmetic operations by said one or more software programs 602 during execution by one or more PPUs, such as GPUs.

In at least one embodiment, one or more software programs 602 utilize one or more APIs 610 provided by a driver and/or runtime 604 to perform combined arithmetic operations of one or more PPUs, such as GPUs. In at least one embodiment, one or more APIs 610 provide combined arithmetic operations through a driver and/or runtime 604, as described above. In at least one embodiment, one or more software programs 602 utilize one or more APIs 610 provided by a driver and/or runtime 604 to allocate or otherwise reserve one or more blocks of memory 614 of one or more PPUs, such as GPUs. In at least one embodiment, one or more software programs 602 utilize one or more APIs 610 provided by a driver and/or runtime 604 to allocate or otherwise reserve blocks of memory. In at least one embodiment, one or more APIs 610 are to perform combined arithmetic operations, as described below in conjunction with any FIGS. 1-5.

To improve software programs 602 usability and/or optimization of one or more portions of said software programs 602 to be accelerated by one or more PPUs, such as GPUs, in an embodiment, one or more APIs 610 provide one or more API functions 612 to perform a software correction system usable or used by one or more computing devices as described above and further described in conjunction with FIGS. 1-5. In at least one embodiment, a block diagram 600 depicts a processor, including one or more circuits to perform one or more software programs to combine two or more application programming interfaces (APIs) into a single API. In at least one embodiment, a block diagram 600 depicts a system, including one or more processors to perform one or more software programs to combine two or more application programming interfaces (APIs) into a single API.

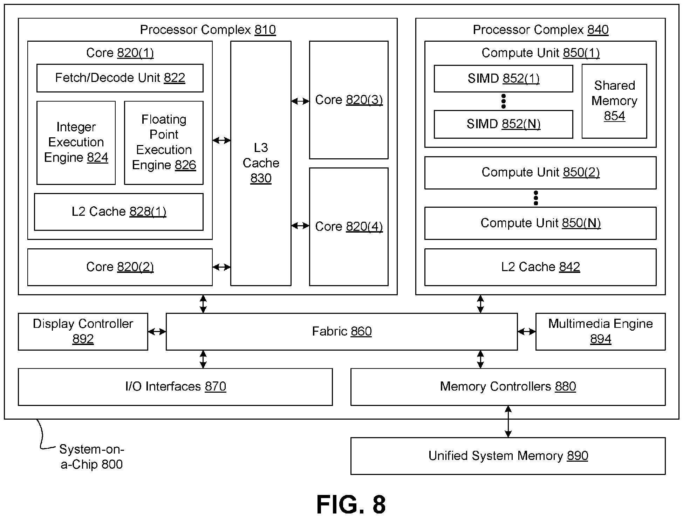

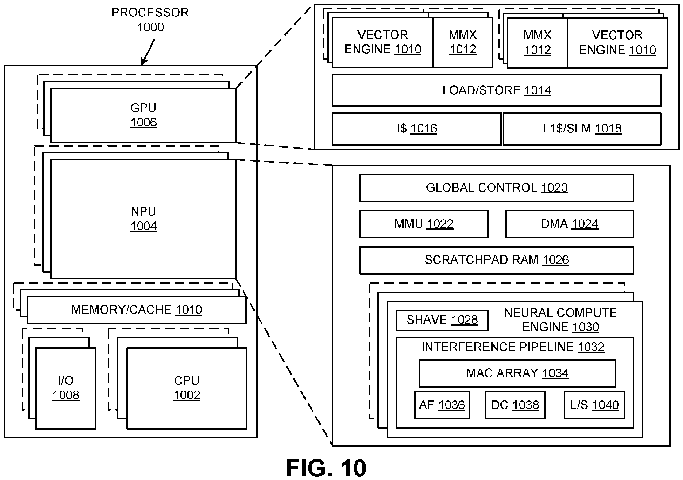

In at least one embodiment, at least a portion of block diagram 600 is implemented using at least a portion of any system(s) depicted in and/or described with respect to FIGS. 10-28C. In at least one embodiment, block diagram 600 is performed by processor(s) 104 of FIG. 1. In at least one embodiment, at least a portion of block diagram 600 is used to implement at least a portion of any system(s) depicted in and/or described with respect to FIGS. 8-26C.

### DATA CENTER

FIG. 7 illustrates an example data center 700, in accordance with at least one embodiment. Data center 700 may include one or more rooms having racks 702 and auxiliary equipment used to house one or more racks 702 and one or more baseboards 704. Rack 702 can include one or more baseboards 704. Rack 702 can include a housing that receives and supports individual baseboards 704. Operational aspects of rack 702 may be regulated at a rack level, corresponding to a group of baseboards 704, or at a baseboard level, corresponding to individual baseboards 704, among other options. Rack 702 or baseboards 704 can have particularly selected maximum operating parameters, such as, but not limited to, power consumption, operating frequencies, and others. Data center 700 can be supported by various cooling systems, such as, but not limited to, cooling towers, cooling loops, pumps, and other support systems. Cooling systems may include sensors and controllers to monitor and managing cooling properties for racks 702. Baseboards 704 within racks 702 can get operational power from one or more power distribution units (PDUs; not shown). PDUs may be arranged within racks 702, for example between racks 702 including baseboards 704, or within racks 702 that also house baseboards 704.

Racks 702 and baseboards 704 can include sub-systems, modules, add-in cards, and other semiconductor components. Baseboards 704 can include one or more computing units 706 that can include one or more processors 708, one or more memory 710, and an interface controller 712. Computing units 706 may include any number of processors, such as, but not limited to, central processing units ("CPUs"), graphics processing units ("GPUs"), or other processors (including accelerators, field programmable gate arrays (FPGAs), graphics processors, etc.), including any processors described herein, such as, but not limited to, processors in FIGs. 8-20. Computing units 706 can include one or more memory storage devices 710 (e.g., dynamic read-only memory, solid state storage or disk drives), as well as network input/output ("NW I/O") devices, network switches, virtual machines ("VMs"), power modules, and cooling modules, etc. One or more computing units 706 may be a server having one or more of above-mentioned computing resources.

Computing units 706 can include separate groupings of computing units housed within one or more racks (not shown), or many racks housed in data centers at various geographical locations (also not shown). Separate groupings of computing units may include grouped compute, network, memory or storage resources that may be configured or allocated to support one or more workloads. Several computing units (e.g., including CPUs and/or other processors) may be grouped within one or more racks to provide compute resources to support one or more workloads. A resource orchestrator 714 may configure or otherwise control one or more computing units 706 or groups of computing units. Resource orchestrator 714 may include a software design infrastructure ("SDI") management entity for data center 700. Resource orchestrator 714 may include hardware, software or some combination thereof.

Data center 700 can include any one of or any combination of a framework layer 720, a software layer 730 and an application layer 740. As shown in FIG. 7, framework layer 720 includes a job scheduler 722, a configuration manager 724, a resource manager 726 and a distributed file system 728. Framework layer 720 may include a framework to support software 732 of software layer 730 and/or one or more application(s) 742 of application layer 740. Software 732 or application(s) 742 may respectively include web-based service software or applications, such as, but not limited to, those provided by Amazon Web Services, Google Cloud and Microsoft Azure. Framework layer 720 may be a type of free and open-source software web application framework such as, but not limited to, Apache Spark^{™} (hereinafter "Spark") that may utilize distributed file system 728 for large-scale data processing (e.g., "big data"). Job scheduler 722 may include a Spark driver to facilitate scheduling of workloads supported by various layers of data center 700. Configuration manager 724 may be capable of configuring different layers such as, but not limited to, software layer 730 and framework layer 720 including Spark and distributed file system 728 for supporting large-scale data processing. Resource manager 726 may be capable of managing clustered or grouped computing units 706 mapped to or allocated for support of distributed file system 728 and job scheduler 722. Resource manager 726 may coordinate with resource orchestrator 714 to manage these mapped or allocated computing resources.

Software 732 can be included in software layer 730 and may include software used by at least portions of a computing unit 706, one or more computing units 706, groups of computing units 706, and/or distributed file system 728 of framework layer 720. One or more types of software may include, but are not limited to, Internet web page search software, e-mail virus scan software, database software, and streaming video content software.

Application(s) 742 can be included in application layer 740 and may include one or more types of applications used by at least portions of a computing unit 706, one or more computing units 706, groups of computing units 706, and/or distributed file system 728 of framework layer 720. One or more types of applications may include, but are not limited to, any number of a genomics application, a cognitive compute, application and a machine learning application, including training or inferencing software, machine learning framework software (e.g., PyTorch, TensorFlow, Caffe, etc.) or other machine learning applications used in conjunction with one or more embodiments.

Any of configuration manager 724, resource manager 726, and resource orchestrator 714 may implement any number and type of self-modifying actions based on any amount and type of data acquired in any technically feasible fashion. Self-modifying actions may relieve a data center operator of data center 700 from making possibly bad configuration decisions and possibly avoiding underutilized and/or poor performing portions of a data center.

Data center 700 may include tools, services, software or other resources to train one or more machine learning models or predict or infer information using one or more machine learning models in accordance with one or more embodiments described herein. For example, a machine learning model may be trained by calculating weight parameters in accordance with a neural network architecture using software and computing resources described above with respect to data center 700. Trained machine learning models corresponding to one or more neural networks may be used to infer or predict information using resources described above with respect to data center 700 by using weight parameters calculated through one or more training techniques described herein.

Data center 700 may use CPUs, application-specific integrated circuits (ASICs), GPUs, FPGAs, or other hardware (e.g., embodiments in FIGs. 8-20) to perform some or all of processes and techniques described elsewhere herein, such as, but not limited to, training and/or inferencing using above-described resources. Moreover, one or more software and/or hardware resources described above may be configured as a service to allow users to train or performing inferencing of information, such as, but not limited to, image recognition, speech recognition, or other artificial intelligence services.

In at least one embodiment, processor 708 can include one of the processors below and/or comprises one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. In at least one embodiment, processor 708 is configured by software 732 to causing communication of a plurality of wireless devices with one or more base stations to be simulated based, at least in part, on grouping the plurality of wireless devices according to one or more shared communication frequency bands or otherwise perform any of the operations described above or elsewhere herein. Data center 700 may use logic, CPUs, application-specific integrated circuits (ASICs), GPUs, FPGAs, or other hardware (e.g., embodiments in FIGs. 8-20) to perform any of the operations described above or elsewhere herein.

### PROCESSORS

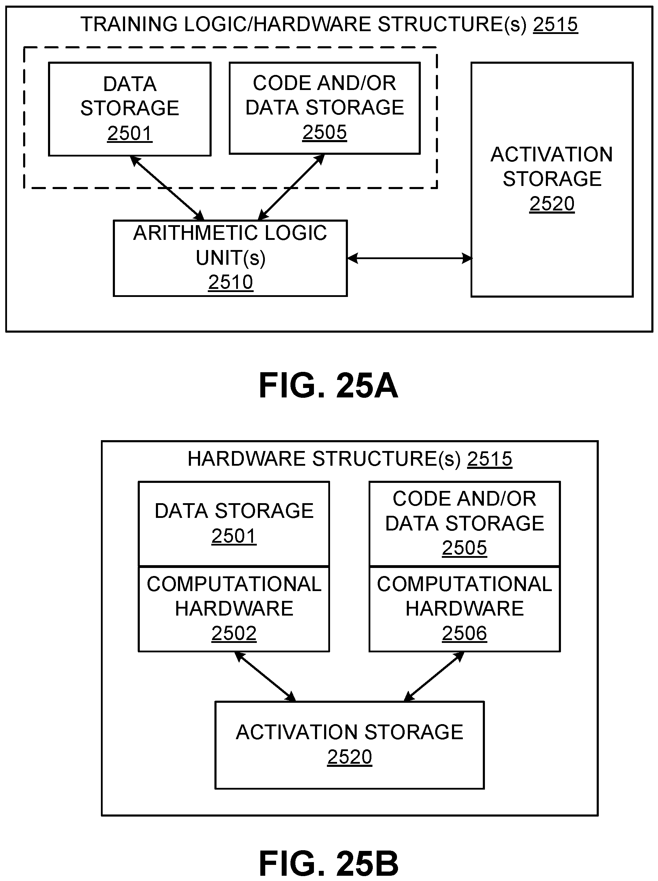

The following figures set forth, without limitation, example processors and processing systems that can be used to causing communication of a plurality of wireless devices with one or more base stations to be simulated based, at least in part, on grouping the plurality of wireless devices according to one or more shared communication frequency bands or otherwise perform some or all of processes, operations and/or and techniques described elsewhere herein. Example processors and processing systems can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein. Processors and processing systems can include logic, central processing units (CPUs), application-specific integrated circuits (ASICs), graphics processing units (GPUs), field programmable arrays (FPGAs), XPUs (i.e., any compute architecture that best fits the need of an application) or other hardware (e.g., embodiments in FIGs. 8-20) to perform any of the operations described above, below, or elsewhere herein. Processors and/or processing systems described herein can include one or more circuits that can be used to causing communication of a plurality of wireless devices with one or more base stations to be simulated based, at least in part, on grouping the plurality of wireless devices according to one or more shared communication frequency bands or otherwise perform any of the operations described above or elsewhere herein. As used herein, one or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein. FIGs. 25A and 25B illustrate logic 2515 which, as described elsewhere herein, can be used in one or more devices to perform operations such as, but not limited to, those discussed herein in accordance with at least one embodiment. Logic can refer, for example, to any combination of software logic, hardware logic, and/or firmware logic to provide functionality and/or operations described herein, wherein logic may be, collectively or individually, embodied as circuitry that forms part of a larger system, for example, an integrated circuit (IC), an application-specific integrated circuit (ASIC), a field programmable array (FPGA), system-on-chip (SoC), or one or processors (e.g., CPU, GPU).

FIG. 8 illustrates a processor which is a system-on-a-chip (SOC) 800 (which may be referred to as system-on-chip, a superchip, or another name), in accordance with at least one embodiment. SOC 800 can include processor complex 810 and processor complex 840. SOC 800 can include any number of processor complexes 810 and/or processor complexes 840 that may include any number of processors that are described herein, such as, but not limited to, those in FIGs. 8-20, in any combination. For example, processor 810 may include a central processing unit (CPU), and processor 840 may include a graphics processor. Alternatively, processor 810 may include a graphics processor, and processor 840 may include a graphics processor. SOC 800 may include any number of display controllers 892, any number of multimedia engines 894, any number of I/O Interfaces 870, any number of memory controllers 880, and any number of fabrics 860 in any combination. For explanatory purposes, multiple instances of like objects are denoted herein with reference numbers identifying the object and parenthetical numbers identifying the instance where needed. SOC 800 can include a processor from Broadcom in Palo Alto, CA.

Processor complex 810 can include a CPU, processor complex 840 can include a GPU, and SOC 800 can include a processing unit that integrates 810 and 840 onto a single chip. Some tasks may be assigned to processor complex 810 and other tasks may be assigned to processor complex 840. Processor complex 810 can be configured to execute main control software associated with SOC 800, such as, but not limited to, an operating system. Processor complex 810 can be the master processor of SOC 800, controlling and coordinating operations of other processors. Processor complex 810 can issue commands that control the operation of processor complex 840 to perform some or all of the operations described herein. Processor complex 810 can be configured to execute host executable code derived from CUDA or other source code (e.g., HIP source code), and processor complex 840 can be configured to execute device executable code derived from CUDA or other source code in order to perform any of the operations described herein.

Processor complex 810 can include cores 820(1)-820(4) and a cache (e.g., L3 cache) 830 to store information to perform operations described herein. Processor complex 810 may include any number of cores 820 and any number and type of caches in any combination. Cores 820 can be configured to execute instructions of a particular instruction set architecture ("ISA") to perform some or all of the operations described herein. Each core 820 can include a CPU core. Core 820(1)-820(4) can be referred to as a computing units or compute units. SOC 800 can includes any number of processor complexes 810, fabric 860, I/O interfaces 870, and memory controllers 880.

Each core 820 can include a fetch/decode unit 822, an integer execution engine 824, a floating point execution engine 826, and an L2 cache 828. Fetch/decode unit 822 can fetch instructions to perform some or all of the operations described herein (such as, but not limited to, an API that is compiled into instructions) and decode such instructions, generate micro-operations, and dispatch separate micro-instructions to integer execution engine 824 and/or floating point execution engine 826. Fetch/decode unit 822 can concurrently dispatch one micro-instruction to integer execution engine 824 and another micro-instruction to floating point execution engine 826. Integer execution engine 824 can execute integer and memory operations. Floating point engine 826 can execute floating point and vector operations. Fetch-decode unit 822 can dispatch micro-instructions to one or more execution engines that replaces both integer execution engine 824 and floating point execution engine 826.

Each core 820(i), where i is an integer representing a particular instance of core 820, may access L2 cache 828(i) included in core 820(i). Each core 820 included in core complex 810(j), where j is an integer representing a particular instance of core complex 810, can be connected to other cores 820 included in core complex 810(j) via L3 cache 830(j) included in core complex 810(j). Cores 820 included in core complex 810(j), where j is an integer representing a particular instance of core complex 810, can access all of L3 cache 830(j) included in core complex 810(j). L3 cache 830 may include any number of slices.

Processor complex 840 can be a graphics complex that can be configured to perform compute operations (e.g., compute operations involved in operations described herein) in a highly-parallel fashion. Processor complex 840 can be configured to execute graphics pipeline operations such as, but not limited to, draw commands, pixel operations, geometric computations, and other operations associated with rendering an image to a display. Processor complex 840 can be configured to execute operations unrelated to graphics, such as, but not limited to, neural network training and/or simulations. Processor complex 840 can be configured to execute both operations related to graphics and operations unrelated to graphics.

Processor complex 840 can include any number of compute units 850(1)-850(N), where N is any integer greater than 1, and an L2 cache 842. Compute units 850 can share L2 cache 842, which may store information to be used to perform some or all of the operations described herein. L2 cache 842 can be partitioned. Processor complex 840 can include any number of compute units 850 and any number (including zero) and type of caches. Processor complex 840 can include any amount of dedicated graphics hardware.

Each compute unit 850 can include any number of SIMD units 852(1)-852(N), where N is any integer greater than 1, and a shared memory 854. Each SIMD unit 852 can implement a SIMD architecture and can be configured to some or all of the operations described herein, in parallel. Each compute unit 850 may execute any number of thread blocks, but each thread block can execute on a single compute unit 850, although in some embodiments a thread block can execute on multiple compute units. A thread block can include any number of threads of execution. A workgroup can be a thread block. Each SIMD unit 852 can execute a group of threads. A group of threads (e.g., 16 threads), which can also be referred to as a warp, or subgroup, or wavefront (e.g., as used by AMD and Intel), where each thread in the warp, wave, subgroup, or wavefront can belong to a single thread block and is configured to process a different set of data based on a single set of instructions. Predication can be used to disable one or more threads in a warp, subgroup, or wavefront. A lane can be a thread. A work item can be a thread, such as, but not limited to, e.g., with OpenCL. Different warps, subgroups, or wavefronts in a thread block may synchronize together and communicate via shared memory 854. Each compute unit 850 can include one or more thread block clusters, where a thread block cluster can enable programmatic control of locality at a granularity larger than a single thread block of a single streaming multiprocessor (SM). Thread block clusters (also referred to as "clusters") can enable multiple thread blocks running concurrently across streaming multiprocessors to synchronize and collaboratively fetch, exchange, or otherwise use data. In at least one embodiment, streaming multiprocessors ("SMs") can be referred to streaming microprocessors, stream processors ("SPs"), stream processing units ("SPUs"), compute units ("CUs"), execution units ("EUs"), and/or slices, where a slice in this context can refer to a portion of processing resources in a processing unit (e.g., 16 cores, a ray tracing unit, a thread director or scheduler).

Fabric 860 can be a system interconnect that facilitates data and control transmissions across processor complex 810, processor complex 840, I/O interfaces 870, memory controllers 880, display controller 892, and multimedia engine 894, e.g., to perform some or all of the operations described herein. SOC 800 may include any amount and type of system interconnect in addition to or instead of fabric 860 that facilitates data and control transmissions across any number and type of directly or indirectly linked components that may be internal or external to SOC 800. I/O interfaces 870 can be representative of any number and type of I/O interfaces (e.g., PCI, PCI-Extended ("PCI-X"), PCIe, gigabit Ethernet ("GBE"), USB, etc.). Various types of peripheral devices can be coupled to I/O interfaces 870. Peripheral devices that can be coupled to I/O interfaces 870 may include keyboards, mice, printers, scanners, joysticks or other types of game controllers, media recording devices, external storage devices, network interface cards, and so forth.

Display controller 892 may display images on one or more display device(s), such as, but not limited to, a liquid crystal display ("LCD") device. Multimedia engine 894 can include any amount and type of circuitry that is related to multimedia, such as, but not limited to, a video decoder, a video encoder, an image signal processor, etc. Memory controllers 880 may facilitate data transfers between SOC 800 and a unified system memory 890. Processor complex 810 and processor complex 840 may share unified system memory 890. Unified system memory 890 can include various types of memory devices, including dynamic random access memory (DRAM) or graphics random access memory, such as, but not limited to, synchronous graphics random access memory (SGRAM), including graphics double data rate (GDDR) memory. Unified system memory 890 may include 3D stacked memory, including but not limited to high bandwidth memory (HBM), HBM2e, or HDM3.

SOC 800 may implement a memory subsystem that includes any amount and type of memory controllers 880 and memory devices (e.g., shared memory 854) that may be dedicated to one component or shared among multiple components in order to perform any of the operations described herein. SOC 800 can implement a cache subsystem that includes one or more cache memories (e.g., L2 caches 828, L3 cache 830, and L2 cache 842) that may each be private to or shared between any number of components (e.g., cores 820, core complex 810, SIMD units 852, compute units 850, and processor complex 840).

In at least one embodiment, SOC 800 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

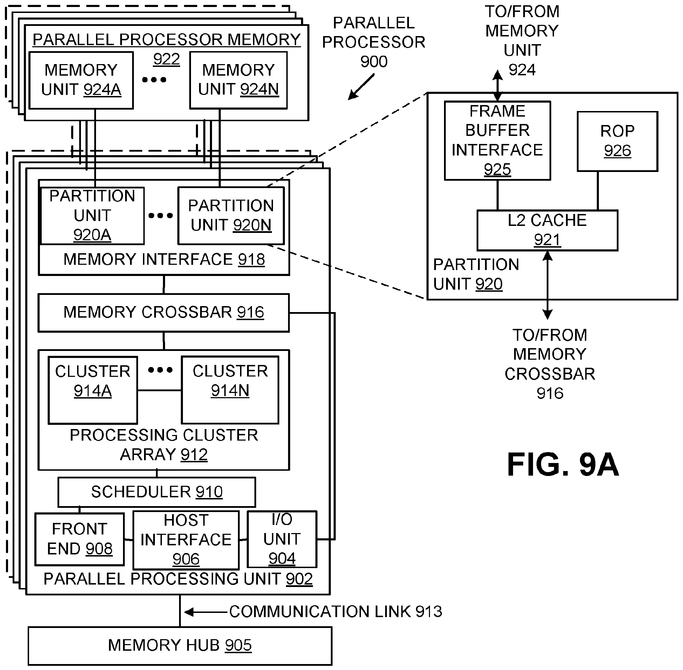

FIG. 9A illustrates a parallel processor 900, in accordance with at least one embodiment. Parallel processor 900 may be implemented using one or more circuits and may be referred to as a programmable processor (e.g., a CPU and/or GPU), logic, an application specific integrated circuit (ASIC), a field programmable gate array (FPGA) or other hardware (e.g., embodiments in FIGs. 8-20) to perform any of the operations described above or elsewhere herein.

Parallel processor 900 can include a parallel processing unit 902 to perform any of the operations described above or elsewhere herein. Parallel processing unit 902 can include an I/O unit 904 that enables communication with other devices, including other instances of parallel processing unit 902. I/O unit 904 may be directly connected to other devices. I/O unit 904 may connect with other devices via use of a hub or switch interface, such as, but not limited to, a memory hub 905. Connections between memory hub 905 and I/O unit 904 can form a communication link 913. I/O unit 904 may connect with a host interface 906 and a memory crossbar 916, where host interface 906 receives commands directed to performing processing operations and memory crossbar 916 receives commands directed to performing memory operations.

When host interface 906 receives a command buffer via I/O unit 904, host interface 906 can direct work operations to perform those commands to a front end 908. Front end 908 can couple with a scheduler 910 (which may be referred to as a sequencer), which is configured to distribute commands or other work items to a processing cluster array 912. Scheduler 910 can ensure that processing cluster array 912 is properly configured and in a valid state before tasks may be distributed to a cluster of processing cluster array 912. Scheduler 910 may be implemented via firmware logic executing on a microcontroller. Microcontroller-implemented scheduler 910 can be configurable to perform complex scheduling and work distribution operations at coarse and fine granularity, enabling rapid preemption and context switching of threads executing on processing array 912. Host software can prove workloads for scheduling on processing cluster array 912 via one of multiple graphics processing paths. Workloads can then be automatically distributed across processing array cluster 912 by scheduler 910 logic within a microcontroller including scheduler 910.

Processing cluster array 912 can perform any of the operations described above or elsewhere herein and can include up to "N" processing clusters (e.g., cluster 914A, cluster 914B, through cluster 914N), where "N" represents a positive integer (which may be a different integer "N" than used in other figures). Each cluster 914A-914N of processing cluster array 912 can execute a large number of concurrent threads. Scheduler 910 can allocate work to clusters 914A-914N of processing cluster array 912 using various scheduling and/or work distribution algorithms, which may vary depending on workload arising for each type of program or computation. Scheduling can be handled dynamically by scheduler 910, or can be assisted in part by compiler logic during compilation of program logic configured for execution by processing cluster array 912. Different clusters 914A-914N of processing cluster array 912 can be allocated for processing different types of programs or for performing different types of computations.

Processing cluster array 912 can be configured to perform various types of parallel processing operations, such as, but not limited to, any of the operations described above or elsewhere herein. Processing cluster array 912 can be configured to perform general-purpose parallel compute operations. For example, processing cluster array 912 can include logic to execute processing tasks including filtering of video and/or audio data, performing modeling operations, including physics operations, and performing data transformations.

Processing cluster array 912 can be configured to perform parallel graphics processing operations. Processing cluster array 912 can include additional logic to support execution of such graphics processing operations, including but not limited to, texture sampling logic to perform texture operations, as well as tessellation logic and other vertex processing logic. Processing cluster array 912 can be configured to execute graphics processing related shader programs such as, but not limited to, vertex shaders, tessellation shaders, geometry shaders, and pixel shaders. Parallel processing unit 902 can transfer data from system memory via I/O unit 904 for processing. During processing, transferred data can be stored to on-chip memory (e.g., parallel processor memory 922) during processing, then written back to system memory.

When parallel processing unit 902 is used to perform graphics processing, scheduler 910 can be configured to divide a processing workload into approximately equal sized tasks, to better enable distribution of graphics processing operations to multiple clusters 914A-914N of processing cluster array 912. Portions of processing cluster array 912 can be configured to perform different types of processing. For example, a first portion may be configured to perform vertex shading and topology generation, a second portion may be configured to perform tessellation and geometry shading, and a third portion may be configured to perform pixel shading or other screen space operations, to produce a rendered image for display. Intermediate data produced by one or more of clusters 914A-914N may be stored in buffers to allow intermediate data to be transmitted between clusters 914A-914N for further processing.

Processing cluster array 912 can receive processing tasks to be executed via scheduler 910, which receives commands defining processing tasks from front end 908. Processing tasks can include indices of data to be processed, e.g., surface (patch) data, primitive data, vertex data, and/or pixel data, as well as state parameters and commands defining how data is to be processed (e.g., what program is to be executed). Scheduler 910 may be configured to fetch indices corresponding to tasks or may receive indices from front end 908. Front end 908 can be configured to ensure processing cluster array 912 is configured to a valid state before a workload specified by incoming command buffers (e.g., batch-buffers, push buffers, etc.) is initiated.

Each of one or more instances of parallel processing unit 902 can couple with a parallel processor memory 922 to perform any of the operations described above or elsewhere herein. Parallel processor memory 922 can be accessed via memory crossbar 916, which can receive memory requests from processing cluster array 912 as well as I/O unit 904. Memory crossbar 916 can access parallel processor memory 922 via a memory interface 918. Memory interface 918 can include multiple partition units (e.g., partition unit 920A, partition unit 920B, through partition unit 920N) that can each couple to a portion (e.g., memory unit) of parallel processor memory 922. A number of partition units 920A-920N can be configured to be equal to a number of memory units, such that a first partition unit 920A has a corresponding first memory unit 924A, a second partition unit 920B has a corresponding memory unit 924B, and an N-th partition unit 920N has a corresponding N-th memory unit 924N. A number of partition units 920A-920N may not be equal to a number of memory units.

Memory units 924A-924N can include various types of memory devices, including dynamic random access memory (DRAM) or graphics random access memory, such as, but not limited to, synchronous graphics random access memory (SGRAM), including graphics double data rate (GDDR) memory. Memory units 924A-924N may also include 3D stacked memory, including but not limited to high bandwidth memory (HBM), HBM2e, or HDM3. Render targets, such as, but not limited to, frame buffers or texture maps may be stored across memory units 924A-924N, allowing partition units 920A-920N to write portions of each render target in parallel to efficiently use available bandwidth of parallel processor memory 922. A local instance of parallel processor memory 922 may be excluded in favor of a unified memory design that utilizes system memory in conjunction with local cache memory.

Any one of clusters 914A-914N of processing cluster array 912 can process data that will be written to any of memory units 924A-924N within parallel processor memory 922. Memory crossbar 916 can be configured to transfer an output of each cluster 914A-914N to any partition unit 920A-920N or to another cluster 914A-914N, which can perform additional processing operations on an output. Each cluster 914A-914N can communicate with memory interface 918 through memory crossbar 916 to read from or write to various external memory devices. Memory crossbar 916 can have a connection to memory interface 918 to communicate with I/O unit 904, as well as a connection to a local instance of parallel processor memory 922, enabling processing units within different processing clusters 914A-914N to communicate with system memory or other memory that is not local to parallel processing unit 902. Memory crossbar 916 can use virtual channels to separate traffic streams between clusters 914A-914N and partition units 920A-920N.

Multiple instances of parallel processing unit 902 can be provided on a single add-in card, or multiple add-in cards can be interconnected. Different instances of parallel processing unit 902 can be configured to interoperate even if different instances have different numbers of processing cores, different amounts of local parallel processor memory, and/or other configuration differences. For example, some instances of parallel processing unit 902 can include higher precision floating point units relative to other instances. Systems incorporating one or more instances of parallel processing unit 902 or parallel processor 900 can be implemented in a variety of configurations and form factors, including but not limited to desktop, laptop, or handheld personal computers, servers, workstations, game consoles, and/or embedded systems.

FIG. 9A further includes a block diagram of a partition unit 920, in accordance with at least one embodiment. Partition unit 920 is an instance of one of partition units 920A-920N of FIG. 9A. Partition unit 920 can include an L2 cache 921, a frame buffer interface 925, and a ROP 926 (raster operations unit). L2 cache 921 can be a read/write cache that is configured to perform load and store operations received from memory crossbar 916 and ROP 926. Read misses and urgent write-back requests can be output by L2 cache 921 to frame buffer interface 925 for processing. Updates can also be sent to a frame buffer via frame buffer interface 925 for processing. Frame buffer interface 925 may interface with one of memory units in parallel processor memory, such as, but not limited to, memory units 924A-924N (shown as 924) of FIG. 9A (e.g., within parallel processor memory 922).

ROP 926 can be a processing unit that performs raster operations such as, but not limited to, stencil, z test, blending, etc. ROP 926 can then output processed graphics data that is stored in graphics memory. ROP 926 can include compression logic to compress depth or color data that is written to memory and decompress depth or color data that is read from memory. Compression logic can be lossless compression logic that makes use of one or more of multiple compression algorithms. A type of compression that is performed by ROP 926 can vary based on statistical characteristics of data to be compressed. For example, delta color compression is performed on depth and color data on a pertile basis.

ROP 926 can be included within each processing cluster (e.g., cluster 914A-914N of FIG. 9A) instead of within partition unit 920. Read and write requests for pixel data may be transmitted over memory crossbar 916 instead of pixel fragment data. Processed graphics data may be displayed on a display routed for further processing by processor(s), or routed for further processing by one of processing entities within parallel processor 900 of FIG. 9A.

In at least one embodiment, parallel processor 900 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

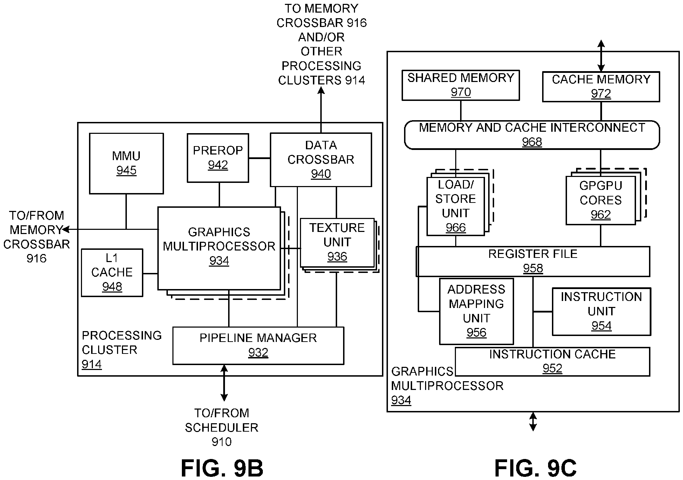

FIG. 9B includes a block diagram of a processing cluster 914 within a parallel processing unit, in accordance with at least one embodiment. A processing cluster can be an instance of one of processing clusters 914A-914N of FIG. 9A that can be used to perform any of the operations described above or elsewhere herein. Processing cluster 914 can be configured to execute many threads in parallel, where "thread" refers to an instance of a particular program executing on a particular set of input data. Single-instruction, multiple-data (SIMD) instruction issue techniques can be used to support parallel execution of a large number of threads without providing multiple independent instruction units. Single-instruction, multiple-thread (SIMT) techniques may be used to support parallel execution of a large number of generally synchronized threads, using a common instruction unit configured to issue instructions to a set of processing engines within each one of processing clusters.

Operation of processing cluster 914 can be controlled via a pipeline manager 932 that distributes processing tasks to SIMT parallel processors. Pipeline manager 932 can receive instructions from scheduler 910 of FIG. 9A and manages execution of those instructions via a graphics multiprocessor 934 and/or a texture unit 936. Graphics multiprocessor 934 may be an example instance of a SIMT parallel processor. However, various types of SIMT parallel processors of differing architectures may be included within processing cluster 914. One or more instances of graphics multiprocessor 934 can be included within a processing cluster 914. Graphics multiprocessor 934 can process data and a data crossbar 940 can be used to distribute processed data to one of multiple possible destinations, including other shader units. Pipeline manager 932 can facilitate distribution of processed data by specifying destinations for processed data to be distributed via data crossbar 940.

Each graphics multiprocessor 934 within processing cluster 914 can include an identical set of functional execution logic (e.g., arithmetic logic units, load-store units, etc.) to perform computations for any of the operations described above or elsewhere herein. Functional execution logic can be configured in a pipelined manner in which new instructions can be issued before previous instructions may be complete. Functional execution logic can support a variety of operations including integer and floating point arithmetic, comparison operations, Boolean operations, bit-shifting, and computation of various algebraic functions. Same functional-unit hardware can be leveraged to perform different operations and any combination of functional units may be present.

Instructions transmitted to processing cluster 914 may constitute a thread, which can also be referred to as a warp, subgroup, wave, or a wavefront. A set of threads executing across a set of parallel processing engines can be referred to as a thread group. A thread group can execute a common program on different input data. Each thread within a thread group can be assigned to a different processing engine within a graphics multiprocessor 934. A thread group may include fewer threads than a number of processing engines within graphics multiprocessor 934. When a thread group includes fewer threads than a number of processing engines, one or more of processing engines may be idle during cycles in which that thread group is being processed. A thread group may also include more threads than a number of processing engines within graphics multiprocessor 934. When a thread group includes more threads than number of processing engines within graphics multiprocessor 934, processing can be performed over consecutive clock cycles. Multiple thread groups can be executed concurrently on a graphics multiprocessor 934.

Graphics multiprocessor 934 includes an internal cache memory to perform load and store operations, such as, but not limited to, any of the operations described above or elsewhere herein. Graphics multiprocessor 934 can forego an internal cache and use a cache memory (e.g., L1 cache 948) within processing cluster 914. Each graphics multiprocessor 934 may also have access to L2 caches within partition units (e.g., partition units 920A-920N of FIG. 9A) that can be shared among all processing clusters 914 and may be used to transfer data between threads. Graphics multiprocessor 934 may also access off-chip global memory, which can include one or more of local parallel processor memory and/or system memory. Any memory external to parallel processing unit 902 may be used as global memory. Processing cluster 914 can include multiple instances of graphics multiprocessor 934 and can share common instructions and data, which may be stored in L1 cache 948.

Each processing cluster 914 may include an MMU 945 (memory management unit) that can be configured to map virtual addresses into physical addresses. One or more instances of MMU 945 may reside within memory interface 918 of FIG. 9A. MMU 945 can include a set of page table entries (PTEs) used to map a virtual address to a physical address of a tile and optionally a cache line index. MMU 945 may include address translation lookaside buffers (TLB) or caches that may reside within graphics multiprocessor 934 or L1 948 cache or processing cluster 914. A physical address can be processed to distribute surface data access locally to allow for efficient request interleaving among partition units. A cache line index may be used to determine whether a request for a cache line is a hit or miss.

A processing cluster 914 may be configured such that each graphics multiprocessor 934 is coupled to a texture unit 936 for performing texture mapping operations, e.g., determining texture sample positions, reading texture data, and filtering texture data. Texture data can be read from an internal texture L1 cache (not shown) or from an L1 cache within graphics multiprocessor 934 and can be fetched from an L2 cache, local parallel processor memory, or system memory, as needed. Each graphics multiprocessor 934 can output processed tasks to data crossbar 940 to provide processed task to another processing cluster 914 for further processing or to store processed task in an L2 cache, local parallel processor memory, or system memory via memory crossbar 916. A preROP 942 (pre-raster operations unit) can be configured to receive data from graphics multiprocessor 934, and direct data to ROP units, which may be located with partition units as described herein (e.g., partition units 920A-920N of FIG. 9A). PreROP 942 unit can perform optimizations for color blending, organizing pixel color data, and performing address translations.

In at least one embodiment, processing cluster 914 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

FIG. 9C shows a graphics multiprocessor 934, in accordance with at least one embodiment, e.g., to perform any of the operations described above or elsewhere herein. Graphics multiprocessor 934 can couple with pipeline manager 932 of processing cluster 914. Graphics multiprocessor 934 can include an execution pipeline including but not limited to an instruction cache 952 (that, e.g., can store instructions, such as, not limited to compiled API instructions), an instruction unit 954, an address mapping unit 956, a register file 958, one or more general purpose graphics processing unit (GPGPU) cores 962, and one or more load/store units 966, where one or more load/store units 966 can perform load/store operations to load/store instructions corresponding to performing an operation. GPGPU cores 962 and load/store units 966 can be coupled with cache memory 972 and shared memory 970 via a memory and cache interconnect 968. GPGPU cores 962 can be part of an SoC such as, but not limited to, part of integrated circuit 800 in FIG. 8.

Instruction cache 952 can receive a stream of instructions (e.g., to perform any of the operations described above or elsewhere herein) to execute from pipeline manager 932. Instructions can be cached in instruction cache 952 and dispatched for execution by an instruction unit 954. Instruction unit 954 can dispatch instructions as thread groups (e.g., warps, subgroups, wavefronts, or waves), with each thread of thread group assigned to a different execution unit within GPGPU cores 962. An instruction can access any of a local, shared, or global address space by specifying an address within a unified address space. Address mapping unit 956 can be used to translate addresses in a unified address space into a distinct memory address that can be accessed by load/store units 966.

Register file 958 can provide a set of registers for functional units of graphics multiprocessor 934. Register file 958 may provide temporary storage for operands connected to data paths of functional units (e.g., GPGPU cores 962, load/store units 966) of graphics multiprocessor 934. Register file 958 may be divided between each of functional units such that each functional unit is allocated a dedicated portion of register file 958. Register file 958 can be divided between different warps (which may be referred to as wavefronts, subgroups, and/or waves or threads) being executed by graphics multiprocessor 934.

GPGPU cores 962 can each include floating point units (FPUs) and/or integer arithmetic logic units (ALUs) that can be used to execute instructions of graphics multiprocessor 934. GPGPU cores 962 can be similar in architecture or can differ in architecture. A first portion of GPGPU cores 962 can include a single precision FPU and an integer ALU while a second portion of GPGPU cores include a double precision FPU. FPUs can implement IEEE 754-2008 standard floating point arithmetic or enable variable precision floating point arithmetic. Graphics multiprocessor 934 can additionally include one or more fixed function or special function units to perform specific functions such as, but not limited to, copy rectangle or pixel blending operations. One or more of GPGPU cores 962 can also include fixed or special function logic.

GPGPU cores 962 can include SIMD logic capable of performing a single instruction on multiple sets of data. GPGPU cores 962 can physically execute SIMD4, SIMD8, and SIMD16 instructions and logically execute SIMD1, SIMD2, and SIMD32 instructions. SIMD instructions for GPGPU cores can be generated at compile time by a shader compiler or automatically generated when executing programs written and compiled for single program multiple data (SPMD) or SIMT architectures. Multiple threads of a program can be configured for an SIMT execution model that can be executed via a single SIMD instruction. For example, eight SIMT threads that perform same or similar operations can be executed in parallel via a single SIMD8 logic unit.

Memory and cache interconnect 968 can include an interconnect network that connects each functional unit of graphics multiprocessor 934 to register file 958 and to shared memory 970. Memory and cache interconnect 968 may be a crossbar interconnect that allows load/store unit 966 to implement load and store operations between shared memory 970 and register file 958. register file 958 can operate at a same frequency as GPGPU cores 962, thus data transfer between GPGPU cores 962 and register file 958 can have very low latency. Shared memory 970 can be used to enable communication between threads that execute on functional units within graphics multiprocessor 934. Cache memory 972 can be used as a data cache for example, to cache texture data communicated between functional units and texture unit 936. Shared memory 970 can also be used as a program managed cache. Threads executing on GPGPU cores 962 can programmatically store data within shared memory in addition to automatically cached data that is stored within cache memory 972.

A parallel processor or GPGPU as described herein may be communicatively coupled to host/processor cores to accelerate graphics operations, machine-learning operations, pattern analysis operations, and various general purpose GPU (GPGPU) functions. A GPU may be communicatively coupled to host processor/cores over a bus or other interconnect (e.g., a high-speed interconnect such as, but not limited to, PCIe or NVLink). An SoC may include a parallel processor or GPGPU as described herein, where said parallel processor or said GPGPU is performed on said SoC. A GPU may be integrated on a package or chip as cores and communicatively coupled to cores over an internal processor bus/interconnect internal to a package or chip. Regardless a manner in which a GPU is connected, processor cores may allocate work to such GPU in a form of sequences of commands/instructions contained in a work descriptor. GPU then may use dedicated circuitry/logic for efficiently processing these commands/instructions to perform any of the operations described above or elsewhere herein.

In at least one embodiment, graphics multiprocessor 934 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

FIG. 10 shows a processor 1000, in accordance with at least one embodiment. Processor 1000 can include a processor with hybrid architecture (e.g., Lunar Lake or Meteor Lake) from Intel Corporation in Santa Clara, CA or another processor that shares at least some of the components described herein. Processor 1000 can include one or more Central Processing Unit(s) (CPU 1002), one or more Graphics Processing Unit(s) (GPU 1006), and/or one or more Neural Processing Unit(s) (NPU 1008) that can be, e.g., a dedicated AI accelerator that offloads artificial intelligence (AI) workloads from CPU 1002 and GPU 1006. Processor 1000 can use instructions that, if executed cause processor 1000 and/or any of its components to perform some or all of processes and techniques described elsewhere herein. Processor 1000 may include any number of memory and cache units 1010 to facilitate processing amongst different components of processor 1000. Memory and cache 1010 on processor 1000 may include one or more levels of cache (e.g., L1, L2, L3, and/or last-level cache) and high-bandwidth memory (e.g., HBM2e or HBM3) in any combination. With respect to processor 1000 and any of its components described above or elsewhere herein, one or more of APIs described herein can, for example, get compiled into instructions, which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of processor 1000 (e.g., in cache and/or memory). A result of API(s) can then be stored in storage within or outside of processor 1000, including registers, DRAM, flash, SRAM, cache, or other memory. One or more of APIs described herein can include a call.

Processor 1000 can include compute engines as CPUs 1002 and can include any number of cores, such as, but not limited to, up to 16 cores/22 threads. Cores in CPU 1002 can include P-cores (Performance), E- cores (Efficient) & LP-E cores (Low-power Efficient). Performance-cores can be used for low latency single-threaded, compute-intensive workloads, while Efficient-cores can be used for multi-threaded, less compute-intensive workloads. Low-power Efficient cores can be used for scalable multithreaded performance and offloading background tasks. P-cores can be used for single & limited threading performance, whereas E- and LP-E cores can be used for multi-threaded throughput and power efficiency.

GPU 1006 can include any number of graphics engines, such as, but not limited to, Intel^{®} Arc^{™} graphics engines (Xe LPG) with 8 Xe cores (up to 128 Execution Units or EUs). As shown in FIG. 10, GPU 1006 can include vector engines 1010 and matrix engines 1012, that, for example, can run FP, INT, and matrix operation tasks all at the same time or separately or in batches. GPU 1006 can include a load/store unit 1014, as well as other memory, such as, but not limited to, an instruction cache (I$) 1016 and L1 cache/subsystem local memory (SLM) 1018 that can, e.g., store instructions to perform any of the operations described above or elsewhere herein.

NPU 1004 can include one or more Intel^{®} AI Boost built-in neural processing unit(s) (NPUs). NPU 1004 can be enumerated to a host processor as an integrated PCIe device. NPU 1004 can include one or more (e.g., two) Neural Compute Engine (NCE) tiles 1030. Each tile can be configured with any combination of, but not limited to, (e.g., 2000) Multiply Accumulate (MAC) Engines 1034, a Post Processing Engine (not shown), a AI DSP Processor (not shown), and memory (2 MB of dedicated SRAM) per tile as shown in FIG. 10. For general compute needs, Neural Compute Engines 1030 can include interference pipeline 1032, activation function (AF) 1036, data conversion 1038, load/store 1040, and Streaming Hybrid Architecture Vector Engines (SHAVE) 1028 for high performance parallel computing, which can include DMA (Direct Memory Access) engines 1024 to shuttle data between system memory DRAM (Dynamic Random Access Memory) 1026 and a software managed cache. Built-in device MMU (Memory Management Unit) 1022 plus IOMMU (Input-Output Memory Management Unit) (not shown) can support multiple simultaneous hardware contexts and provide security isolation between execution contexts as per MCDM (Microsoft Compute Driver Model) architecture. Processor 1000 can also include a media unit (not shown) that is included on or separately from XCDs or other components of processor 1000 to enable video playback and video processing of compressed or non-compressed data, such using HEVC, AV1, VP9 and AVC HW accelerated decode support and HEVC, VP9 and AVC HW accelerated encode support.

A Intel^{®} Thread Director, which includes firmware that is built into processor 1000, can prioritize and manage distribution of workloads, sending tasks to optimized cores. For example, Thread Director can tie P-cores, E-cores and/or LP-E cores (described above) together with task-scheduling capabilities and ability to send less-demanding tasks to E-cores or LP-E cores. Intel^{®} Deep Learning Boost (Intel^{®} DL Boost) (not shown) can provide built in AI acceleration for training and inference workloads, and may include VNNI (for CPU) and DP4a (for GPU) instruction set support. This instruction set may be optimized with OpenVINO^{™} Toolkit and oneAPI to accelerate INT8 inferencing. A software stack, e.g., as described elsewhere herein, can be used to enable AI inference using Open VINO^{™} toolkit. Processor 1000 can be configured to execute an application program, such as, but not limited to, a CUDA program.

In at least one embodiment, processor 1000 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

Processor 1000 can alternatively include a processor based on AI Engine Direct architecture from Qualcomm Corporation in Santa Clara, CA or another processor that shares at least some of the components described herein. that may include any number of NPUs, GPUs, CPUs and other related components, such as, but not limited to, NPU 1004 as a Hexagon NPU, GPU 1006 as a Adreno GPU, CPU 1002 as a Kryo or Qualcomm Oryon CPU, as well as a Qualcomm Sensing Hub (not shown) and a memory subsystem 1010, in any combination. Hexagon NPU 1004 can include a power rail a micro-tile inferencing unit, a hardware acceleration unit, a tensor unit, a scalar unit, and a vector unit (all not shown), which can have dedicated memory or share memory (e.g., cache or memory, such HBM3) for, e.g., storing instructions to perform any of the operations described above or elsewhere herein. Adreno GPU 1006 can provide graphics and parallel processing for AI in formats, such as, but not limited to, 32-bit floating point (FP32), 16-bit floating point (FP16), and 8-bit integer (INT8). Kryo or Qualcomm Oryon CPUs 1002 can perform AI workloads, and can handle contextualization for pervasive generative AI applications. CPU 1002 can also include an instruction fetch unit, a rename and retire unit, a memory management unit, a vector execution unit, an integer execution unit, and a load and store unit for processing and instruction management. With respect to processor 1000 and any of its components described above or elsewhere herein, one or more of APIs described herein can, for example, get compiled into instructions, which may be fetched by instruction fetch unit, decoded by a processor decoder or equivalents, scheduled (e.g., in order or out of order) for execution by a scheduler or equivalents, executed by execution logic or equivalents, reordered, and then retired by rename and retire unit. API(s) (and/or compiled instructions including API(s)) can be stored in any storage outside or inside of processor 1000 (e.g., in cache and/or memory). Any number of CPU cores 1002 may be included in any number of CPU cluster(s) that can be coupled to memory and/or cache, such as, but not limited to a shared L2 cache. Memory can be separate or shared, e.g., CPU clusters of CPU cores 1002 can couple to memory subsystem 1010 that can include fabric, system level cache and any number of memory management units that can, for example, read and write memory (e.g., DRAM). Qualcomm Sensing Hub (not shown) includes micro NPUs, a power rail, and traditional sensors (a gyrometer, accelerometer, even a barometer) with voice and data streams. Memory subsystem 1010 can include memory and cache on processor 1000, which may include one or more levels of cache (e.g., L1, L2, L3, and/or last-level cache) and high-bandwidth memory (e.g., HBM2e or HBM3) in any combination, e.g., for storing information and/or instructions to perform any of the operations described above or elsewhere herein. All or some of memory and/or cache in memory subsystem 1010 can be shared or used individually by any one or combinations of components (e.g., GPU 1006, NPU 1004, and CPU 1002) on processor 1000.

Qualcomm AI Engine 1000 may be programmed and controlled with an a software stack to perform some or all of the operations described herein, and include, e.g., a Qualcomm^{®} Neural Processing SDK for inferencing with versions for Android, Linux, and Windows. Developer libraries and services support programming languages, virtual platforms, and compilers. At a lower level of software stack, system software includes basic real-time operating system (RTOS), system interfaces, and drivers. Software stack supports different operating systems, including Android, Windows, Linux, and QNX, and deployment and monitoring infrastructure like Prometheus, Kubernetes, and Docker. For direct cross-platform access to GPU 1006, OpenCL and DirectML may be supported. For CPU 1002, a LLVM compiler infrastructure optimizations enable accelerated and efficient AI inference. With respect to Qualcomm AI Engine 1000 and any of its components described above or elsewhere herein, one or more of APIs described herein can, for example, get compiled into instructions, which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of Qualcomm AI Engine 1000 (e.g., in cache and/or memory). A result of API(s) can then be stored in storage within or outside of Qualcomm AI Engine 1000, including registers, DRAM, flash, SRAM, cache, or other memory.

In at least one embodiment, processor 1000 or Qualcomm AI Engine 1000 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

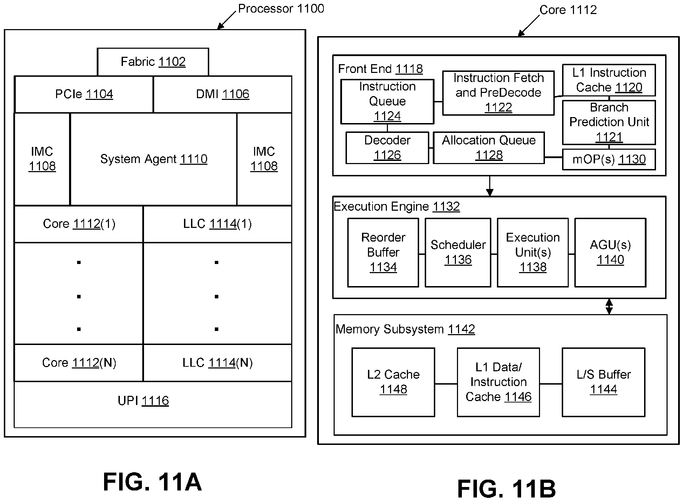

FIG. 11A illustrates a processor 1100, in accordance with at least one embodiment. Processor 1100 can include an processor with scalable family from Intel Corporation in Santa Clara, CA or another processor that shares at least some of the components described herein. Processor 1100 can include one or more cores 1112(1)-1112(N), where N is any integer greater than 1 that can perform the operations described elsewhere herein. Cores 1112(1)-1112(N) can be interlinked together using ring and/or mesh interconnects. With a mesh interconnects architecture, an array of vertical and horizontal communication paths may allow traversal from one core to another 1112(1)-1112(N) through a shortest path (hop on vertical path to correct row, and hop across horizontal path to correct column). For mesh interconnects, a die can house cores 1112(1)-1112(N) and can include a grid of converged mesh stops (CMS) that may be associated (e.g., 1:1) with cores 1112(1)-1112(N). Each core can be associated with one lower level cache (LLC) slice 1114(1)-1114(N), or cores 1112(1)-1112(N) can share cache, e.g., lower level cache. LLCs 1114(1)-1114(N) can be inclusive by incorporating blocks in higher level cache (e.g., L2 cache) or non-inclusive (having blocks that may be not present in higher level cache). Each core and LLC slice can include a Caching and Home Agent (CHA) (not shown) that can maintain cache coherency by providing scalability of resources across mesh interconnects for Intel^{®} Ultra Path Interconnect (Intel^{®} UPI 1116) cache coherency functionality. UPI 1116 can provide a coherent interconnect for scalable systems and can allow for multiple processors to share a single shared address space through links, such as, but not limited to, two or three UPI links per processor.

Processor 1100 can also include System Agent 1110 that can house and/or perform various functionalities, such as, but not limited to, memory management, display functions, and/or input/output (I/O) functions. For example, processor 1100 can include one or more integrated memory controller(s) (IMC) 1108. IMC 1108 can control and manage memory, such as, but not limited to, different memory types e.g., DDR ram, like DDR4 or others described elsewhere herein. System Agent 1110 can include a display controller (not shown) to support display(s). System Agent 1110 can also incorporate PCIe 1104 (e.g., up to 20 lanes of PCIe), e.g., that can connect with an external dedicated graphics hookup over DMI bus (e.g., Intel's DMI 3.0 bus) 1106. System Agent 1110 can include an Image Processing Unit (IPU) (not shown) which incorporates an image signal processor (ISP) on-die. Fabric 1102 can provide scalability for connecting to other nodes (e.g., processors, such as processor 1100), and can, for example, be used with Cornelis Networks, an element of Intel^{®} Scalable System Framework, that delivers the performance for high performance computing (HPC) workloads and the ability to scale to tens of thousands of nodes.

FIG. 11B illustrates components within core 1112, in accordance with at least one embodiment. Core 1112 can include front-end 1118, back-end or execution engine 1132, and memory subsystem 1142. Front-end 1118 can provide execution engine 1132 with operations (e.g., operations described elsewhere herein) by decoding instructions stored in memory. For example, front-end 1118 can include a micro-operations (µOps) cache path and/or a legacy path, along with branch prediction unit 1121 that can determine paths instructions. A legacy path for instructions may include fetching variable-length (e.g., x86) instructions from L1 instruction cache 1120 with instruction fetch and predecode 1122, queuing the instructions in instruction queue 1124, and decoding instructions using decoder 1126 into µOps that can be provided to allocation queue 1128. Alternatively, a µOPs cache path may include a cache containing already decoded µOps (µOps 1130) that can be sent to allocation queue 1128. Allocation queue 1128 can perform as an interface between front-end 1118 and execution engine 1132, and can provide instructions to execution engine 1132. One or more of API(s) described herein can, for example, get compiled into instructions that can be stored, processed, and executed by front-end 1118, execution engine 1132, and stored in memory subsystem 1142.

Execution engine 1132 can receive micro-operations into reorder buffer 1134, which can register allocation, rename, and retire µOPs. From reorder buffer, µOPs can be sent to scheduler 1136 that can be connected one or more different execution units 1138, which can be connected to address generation unit (AGU) 1140. Execution units 1138 can perform, e.g., basic arithmetic logic unit (ALU) operations, multiplication, division, and/or more complex operations, such as, but not limited to, various vector operations. Scheduler 1136 may manage queuing µOPs for one or more of execution units 1138 depending, e.g., on operations needed to be performed.

Memory subsystem 1142 can process load and store requests as well as ordering operations. For example, µOPs may relate to memory access (e.g. load and store), and those can be sent on dedicated scheduler ports that can perform those memory operations. Store and load operations, for example, can be sent to load and store buffer(s) 1144. Memory subsystem 1142 can also include shared or separate L1 data and instruction cache 1146, as well as L2 cache 1148 that can be used and shared by L1 data and instruction cache 1146. As described above for FIG. 11A, each core 1112 can be connected to a slice of a third level of cache (e.g., LLC 1114) that can be shared by all core 1112.

In at least one embodiment, processor 1100 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

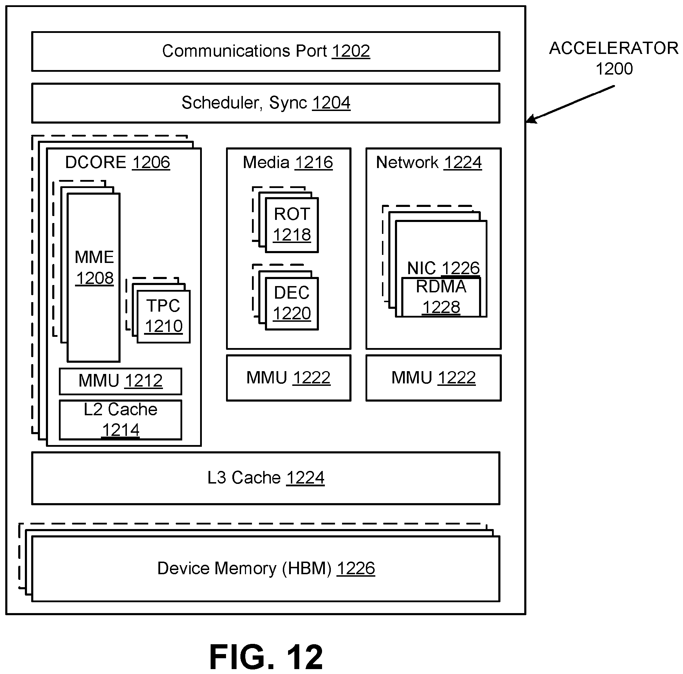

FIG. 12 illustrates an AI accelerator 1200, in accordance with at least one embodiment. Processor 1200 can include a processor with AI accelerator architecture from Intel Corporation in Santa Clara, CA or another processor that shares at least some of the components described herein. AI accelerator 1200 may use instructions that, if executed by AI accelerator 1200, cause AI accelerator 1200 to perform some or all of processes and techniques described elsewhere herein. For example, with respect to AI accelerator 1200 and any of its components described above or elsewhere herein, one or more of APIs described herein can, for example, get compiled into instructions, which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of AI accelerator 1200 (e.g., in cache and/or memory). A result of API(s) can then be stored in storage within or outside of AI accelerator 1200, including registers, DRAM, flash, SRAM, cache, or other memory. AI accelerator 1200 may include one or more compute dies that can include homogeneous or heterogeneous processors. Compute dies may include one or more central processing units (CPU), one or more graphics processing units (GPU), or combinations of both.

In at least one embodiment, compute dies may include compute engines to perform AI computations. In at least one embodiment, AI accelerator 1200 compute dies may be split into any number of (e.g., four) clusters that may be referred to as a DCORE (Deep Learning Core) 1206 and contain any number of Matrix Multiplication Engines (MMEs) 1208, Tensor Processor Cores (TPCs) 1210, memory management unit 1212, and L2 Cache 1214, in any combination. MME(s) 1208 can perform operations that use Matrix Multiplication, like fully connected layers, convolutions and batched-General Matrix Multiplications (GEMMs). MMEs 1208 may be equipped with Multiply - Accumulate Units (MACs) (not shown) that, for example, may perform General Matrix Multiplication (GEMM) operations, such as, but not limited to, an AxB multiplication that involves generating tensor C[NxM] from two input tensors, A[NxK] and B[KxN]. MME(s) 1208 may be programmed with array dimensions, locations, data types, and various execution operands. MME(s) 1208 can retrieve tensors A and B from memory, pulling them into its streaming buffers for matrix multiplication to be performed in parallel by MACs. MME(s) 1208 may push tensor C back to memory upon completion. TPC(s) 1210 may include any number of scalar units for performing scalar operations, any number of vector units for performing vector operations, any number of register files or local memory units (e.g., a vector local memory), and load and store components for instructions, which can be coupled to memory or cache (e.g., HBM, L3 cache and/or L2 cache) (all not shown). TPCs can support different types of parallel processing, e.g., Very Long Instruction Word (VLIW) Single-Instruction Multiple-Data (SIMD) that supports data types, such as, but not limited to, FP32, BF16, FP16 & FP8 (both E4M3 and E5M2), UINT32, INT32, UINT16, INT16, UINT8 and INT8 datatypes. Any number of compute dies may be connected through an interconnect. An interconnect that can connect compute dies can be over an interposer bridge that, e.g., is transparent to software.

Memory on AI Accelerator 1200 may include one or more levels of cache (e.g., L1, L2, L3, and/or last-level cache) and high-bandwidth memory (e.g., HBM2e or HBM3) in any combination. Memory and/or cache systems can be unified or separate. Compute dies of AI accelerator 1200 may include on-die memory that includes one or more levels (e.g., two-levels) of cache. On-die SRAM or other memory described elsewhere herein can be used as a uniformly accessible last-level cache (L3) or split to slices of L2 cache that may be accessible to groups of MMEs 1208 and TPCs 1210. Using on-die memory as L2 or L3 cache can be fully configurable by software, which dynamically may decide per I/O tensor its optimal cache allocation. AI Accelerator 1200 may include one or more Memory Management Units (MMUs) 1222 for managing memory, such as allowing AI accelerator 1200 memory subsystem to operate in a virtual space when accessing VRAM.

AI accelerator 1200 may include a communications port (e.g., a PCIe Gen5 X16 port) 1202 for communicating with a host and Scheduling and Synchronization Unit 1204. AI accelerator 1200 may include Media Unit 1216 that may include any number or combinations of Media Decoder Engines (DECs) 1220 and Rotator Engines (ROT) 1218. AI accelerator 1200 may include a network unit 1224 that may include any number or combinations of network ports 1226 and accompanied RDMA Engine(s) 1228, L2 Cache, and memory (e.g., HBM2e or HBM3) stacks. AI accelerator 1200 can incorporate a programmable Control Path entity (not shown) to manage parallel and efficient execution of various engines. Control Path can include Submission Queues (SQs) that may be issued by runtime system, Completion Queues (CQs) that may be used for job completion reporting, a Programmable Scheduling Mechanism that may be utilized for task scheduling, a Programmable Hardware Synchronization Mechanism or `Sync Manager (SM)' that may be used for hardware synchronization, a Programmable Interrupt Service Mechanism or `Interrupt Manager (INTR)' that can enable passing of asynchronous events to drivers.

AI accelerator 1200 may include media decoding units that support Video Formats, such as, but not limited to, HEVC, Progressive H.264, SVC base layer, MVC, VP9, JPEG, Progressive JPEG. AI accelerator 1200 may support post processing of decoded media streams, such as, but not limited to, image down-scaling (resizing an image), vertical and horizontal scaling at different scaling ratios, Image up-scaling, Image cropping, bilinear scaling, and Lancos scaling. AI accelerator 1200 may implement two post processing channels per decoder unit, one with scalar (up and down) and one just to output the original image. AI accelerator 1200 may include a hardware rotator engine that performs the following transformations of an input image: 2D rotation, 3D rotation, Projection, distorting and undistorting images, resampling input data at user-defined coordinates, and rescaling.

RDMA 1228 over Converged Ethernet on AI accelerator 1200 may enable scaling from a single node (i.e., a single AI Accelerator 1200 to hundreds or thousands of nodes or AI Accelerators 1200). NW Subsystem 1224 can include an Intel^{®} Gaudi^{®} Communication Library (IGCL), a master conductor that orchestrates data movement, and a programable scheduling mechanism that can enable smooth activation of engines while maintaining task dependencies. A accelerator networking subsystem can include Gigabit Ethernet NIC ports 1226, a Layer2 MAC (not shown), and RDMA Engines 1228. AI Accelerator 1200 can include Aggregation Engines for performing summing activities. All engines in processor 1200 can operate in parallel, e.g., MME(s) 1208, TPC(s) 1210 and NIC(s) 1226 can all work at the same time. There can be dependency between operations running on different engines, e.g., output of one engine can be used as input of another engine, and/or MME, TPC and NIC can be scheduled to run in parallel. When one engine has completed its executing operation, another engine can be scheduled to start working on the next operation (immediately upon readiness of its inputs).

AI Accelerator 1200 can be operated and controlled using software layer 1228 that may include low-level components, such as, but not limited to, a graph compiler, an automatic kernel fuser and a library of precompiled kernels, as well as integration to AI ecosystems, such as, but not limited to, PyTorch, DeepSpeed, Hugging Face, vLLM, Ray and more, or as described elsewhere herein with respect to software and programming platforms. Software layer 1228 may include implementations of algorithms, such as, but not limited to, Paged Attention, Flash Attention and more. Software layer 1228 may generate optimized binary code that implements a given model topology, such as, but not limited to, performing operator fusion, data layout management, parallelization, pipelining and memory management, and graph-level optimizations.

In at least one embodiment, AI accelerator 1200 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

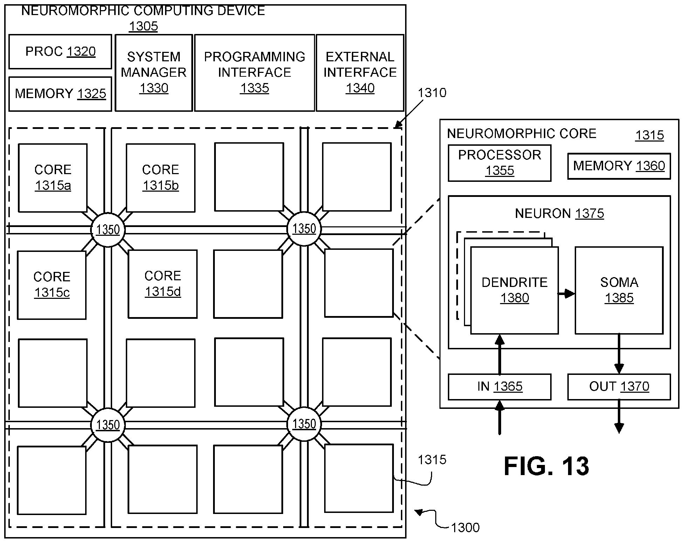

A neuromorphic computing system is described that adopts a multicore architecture where each core houses computing elements including neurons, synapses with on-chip learning capability, and local memory to store synaptic weights and routing tables. FIG. 13 is a simplified block diagram 1300 illustrating an example of at least a portion of such a neuromorphic computing device 1305, in accordance with at least one embodiment. Neuromorphic computing device 1305 can include a neuromorphic processor from Intel Corporation in Santa Clara, CA or another processor that shares at least some of the components described herein. As shown in this example, a device 1305 may be provided with a network 1310 of multiple neural network cores interconnected by an on-device network such that multiple different connections may be potentially defined between cores. For instance, a network 1310 of spiking neural network cores may be provided in device 1305 and may each communicate via short packetized spike messages sent from core to core over network channels. Each core (e.g., 1315) may possess processing and memory resources and logic to implement some number of primitive nonlinear temporal computing elements, such as, but not limited to, multiple (e.g., 1000+) distinct artificial neurons (referred to herein as "neurons"). For instance, each core may be capable of concurrently implementing multiple neurons such that neuromorphic cores may implement many multiples of neurons using device 1305. With respect to neuromorphic computing device 1305 and any of its components described above or elsewhere herein, one or more of APIs or equivalents described herein can, for example, get compiled into instructions or equivalents, which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of neuromorphic computing device 1305 (e.g., in cache and/or memory). A result of API(s) can then be stored in storage within or outside of neuromorphic computing device 1305, including registers, DRAM, flash, SRAM, cache, or other memory equivalents.

Continuing with the example of FIG. 13, neuromorphic computing device 1305 may additionally include processor 1320 and system memory 1325 to implement one or more components to manage and provide functionality of neuromorphic computing device 1305. For instance, system manager 1330 may be provided to manage global attributes and operations of neuromorphic computing device 1305 (e.g., attributes affecting network of cores 1310, multiple cores in network 1310, interconnections of neuromorphic computing device 1305 with other devices, manage access to global system memory 1325, among other potential examples). In one example, system manager 1330 may manage the definition and provisioning of a specific routing tables to various routers in network 1310, orchestration of a network definition and attributes (e.g., weights, decay rates, etc.) to be applied in network 1310, core synchronization and time multiplexing management, routing of inputs to appropriate cores, among other potential functions.

As another example, neuromorphic computing device 1305 may additionally include programming interface 1335 through which a user or system may specify a neural network definition to be applied (e.g., through a routing table and individual neuron properties) and implemented by mesh 1310 of neuromorphic cores. A software-based programming tool may be provided with or separate from neuromorphic computing device 1305 through which a user may provide a definition for a particular neural network to be implemented using network 1310 of neuromorphic cores. Programming interface 1335 may take an input of a programmer to then generate corresponding routing tables and populate local memory of individual neuromorphic cores (e.g., 1315) with specified parameters to implement a corresponding, customized network of artificial neurons implemented by neuromorphic cores 1315.

In some cases, neuromorphic computing device 1305 may advantageously interface with and interoperate with other devices, including general purpose computing devices, to realize certain applications and use cases. Accordingly, external interface logic 1340 may be provided in some cases to communicate (e.g., over one or more defined communication protocols) with one or more other devices. An external interface 1340 may be utilized to accept input data from another device or external memory controller acting as a source of input data. External interface 1340 may be additionally or alternatively utilized to allow results or output of computations of a neural network implemented using neuromorphic computing device 1305 to be provided to another device (e.g., another general purpose processor implementing a machine learning algorithm) to realize additional applications and enhancements, among other examples.

As shown in FIG. 13, network 1310 of multiple neural network cores interconnected by an on-device network is shown illustrating a portion of a network fabric interconnecting multiple neuromorphic cores (e.g., 1315 a-d). For instance, a number of neuromorphic cores (e.g., 1315 a-d) may be provided in a mesh, with each core being interconnected by a network including a number of routers (e.g., 1350). In one implementation, each neuromorphic core (e.g., 1315 a-d) may be connected to a single one of routers (e.g., 1350) and routers may be connected to at least one other router (as shown at 1310 in FIG. 13). As an example, in one particular implementation, four neuromorphic cores (e.g., 1315 a-d) may be connected to a single router (e.g., 1350) and each of routers 1350 may be connected to two or more other routers to form a manycore mesh, allowing each neuromorphic core to interconnect with each other neuromorphic core in neuromorphic computing device 1305. Moreover, as each neuromorphic core may be configured to implement multiple distinct neurons, router network of neuromorphic computing device 1305 may similarly enable connections, or artificial synapses (or, simply, "synapses"), to be defined between any two of potentially many (e.g., 30,000+) neurons defined using network of neuromorphic cores 1310 provided in neuromorphic computing device 1305.

FIG. 13 shows a block diagram illustrating internal components of one example implementation of neuromorphic core 1315. In one example, a single neuromorphic core may implement some number of neurons (e.g. 1024) that share architectural resources of neuromorphic core 1315 in a time-multiplexed manner. In one example, each neuromorphic core 1315 may include processor block 1355 capable of performing arithmetic functions and routing in connection with the realization of a digitally implemented artificial neuron, such as, but not limited to, explained herein. Each neuromorphic core 1315 may additionally provide local memory in which a routing table may be stored and accessed for a neural network, accumulated potential of each soma of each neuron implemented using core 1315 may be tracked, parameters of each neuron implemented by core may 1315 be recorded, among other data and usage. Components, or architectural resources, of neuromorphic core 1315 may further include input interface 1365 to accept input spike messages generated by other neurons on other neuromorphic cores and output interface 1370 to send spike messages to other neuromorphic cores over mesh network 1310. In some instances, routing logic for neuromorphic core 1315 may be at least partially implemented using output interface 1370. Further, in some cases, core (e.g., 1315) may implement multiple neurons within an example SNN and some of these neurons may be interconnected. In such instances, spike messages sent between neurons hosted on core 1315 may forego communication over routing fabric of neuromorphic computing device 1305 and may instead by managed locally at particular neuromorphic core 1315.

Each neuromorphic core may additionally include logic to implement, for each neuron 1375, artificial dendrite 1380 and artificial soma 1385 (referred to herein, simply, as "dendrite" and "soma" respectively). Dendrite 1380 may be a hardware-implemented process that receives spikes from network 1310. Soma 1385 may be a hardware-implemented process that receives each dendrite's accumulated neurotransmitter amounts for the current time and evolves each dendrite and soma's potential state to generate outgoing spike messages at the appropriate times. Dendrite 1380 may be defined for each connection receiving inputs from another source (e.g., another neuron). In one implementation, dendrite process 1380 may receive and handle spike messages as they serially arrive in time-multiplexed fashion from network 1310. As spikes are received, neuron's activation (tracked using soma 1385 (and local memory 1360)) may increase. When neuron's activation exceeds a threshold set for neuron 1375, neuron 1375 may generate a spike message that is propagated to a fixed set of fanout neurons via output interface 1370. Network distributes spike messages to all destination neurons, and in response those neurons, in turn, may update their activations in a transient, time-dependent manner, and so on, potentially causing the activation of some of these destination neurons to also surpass corresponding thresholds and trigger further spike messages, as in real biological neural networks.

As noted above, neuromorphic computing device 1305 may reliably implement a spike-based model of neural computation. Such models may also be referred to as Spiking Neural Networks (SNNs). In addition to neuronal and synaptic state, SNNs also incorporate the concept of time. For instance, in an SNN, communication occurs over event-driven action potentials, or spikes, that convey no explicit information other than the spike time as well as an implicit source and destination neuron pair corresponding to the transmission of the spike. Computation occurs in each neuron as a result of the dynamic, nonlinear integration of weighted spike input. In some implementations, recurrence and dynamic feedback may be incorporated within an SNN computational model. Further, a variety of network connectivity models may be adopted to model various real world networks or relationships, including fully connected (all-to-all) networks, feed-forward trees, fully random projections, "small world" networks, among other examples. A homogeneous, two-dimensional network of neuromorphic cores, such as, but not limited to, shown in the example of FIG. 13 may advantageously supports all of these network models. As some or all cores of neuromorphic computing device 1305 may be connected, some or all neurons defined in cores may be therefore also fully connected through some number of router hops. Neuromorphic computing device 1305 may further include fully configurable routing tables to define a variety of different neural networks by allowing each core's neurons to distribute their spikes to any number of cores in mesh 1310 to realize fully arbitrary connectivity graphs.

In an improved implementation of a system capable of supporting SNNs, such as, but not limited to, a very large scale integration (VLSI) hardware device illustrated in the example of FIG. 13, high speed and reliable circuits may be provided to implement SNNs to model information processing algorithms as employed by a brain, but in a more programmable manner. For instance, while a biological brain can only implement a specific set of defined behaviors, as conditioned by years of development, a neuromorphic processor device may provide a capability to rapidly reprogram all neural parameters. Accordingly, a single neuromorphic processor may be utilized to realize a broader range of behaviors than those provided by a single slice of biological brain tissue. This distinction may be realized by adopting a neuromorphic processor with neuromorphic design realizations that differ markedly from those of neural circuits found in nature.

As an example, a neuromorphic processor may utilize time-multiplexed computation in both a spike communication network and neuron machinery of neuromorphic computing device 1305 to implement SNNs. Accordingly, physical circuitry of neuromorphic computing device 1305 may be shared among many neurons to realize higher neuron density. With time multiplexing, a network can connect N cores with O(N) total wiring length, whereas discrete point-to-point wiring would scale as O(N²), realizing a significant reduction in wiring resources to accommodate planar and non-plastic VLSI wiring technologies, among other examples. In neuromorphic cores, time multiplexing may be implemented through dense memory allocation, for instance, using Static Random Access Memory (SRAM), with shared buses, address decoding logic, and other multiplexed logic elements. State of each neuron may be stored in processor's memory, with data describing each neuron state including state of each neuron's collective synapses, all currents and voltages over its membrane, among other example information (such as, but not limited to, configuration and other information).

A neuromorphic processor may adopt a "digital" implementation that diverts from other processors adopting more "analog" or "isomorphic" neuromorphic approaches. For instance, a digital implementation may implement integration of synaptic current using digital adder and multiplier circuits, as opposed to analog isomorphic neuromorphic approaches that accumulate charge on capacitors in an electrically analogous manner to how neurons accumulate synaptic charge on their lipid membranes. Accumulated synaptic charge may be stored, for instance, for each neuron in local memory of a corresponding core. Further, at an architectural level of an example digital neuromorphic processor, reliable and deterministic operation may be realized by synchronizing time across a network of cores such that any two executions of a design, given same initial conditions and configuration, will produce identical results. Asynchrony may be preserved at a circuit level to allow individual cores to operate as fast and freely as possible, while maintaining determinism at a system level. Accordingly, a notion of time as a temporal variable may be abstracted away in neural computations, separating it from a "wall clock" time that the hardware utilized to perform the computation. Accordingly, in some implementation, a time synchronization mechanism may be provided that globally synchronizes neuromorphic cores at discrete time intervals. A synchronization mechanism allows neural computation to complete as fast as circuitry allows, with a divergence between run time and biological time that a neuromorphic system models.

In operation, neuromorphic computing device 1305 may begin in an idle state with all neuromorphic cores inactive. As each core asynchronously cycles through its neurons, it generates spike messages that a mesh interconnect routes to appropriate destination cores containing all destination neurons. Implementation of multiple neurons on a single neuromorphic core may be time-multiplexed, and a time step may be defined in which all spikes involving multiple neurons may be processed and considered using shared resources of a corresponding core. As each core finishes servicing its neurons for a respective time step, cores may, in some implementations, communicate (e.g., using a handshake) with neighboring cores using synchronization messages to flush a mesh of all spike messages in flight, allowing cores to safely determine that all spikes have been serviced for a time step. At that point all cores may be considered synchronized, allowing them to advance their time step and return to an initial state and begin a next time step.

Given this context, and as introduced above, a device (e.g., 1305) implementing a mesh 1310 of interconnected neuromorphic cores may be provided, with core 1315 implementing potentially multiple artificial neurons capable of being interconnected to implement an SNN. Each neuromorphic core (e.g., 1315) may provide two loosely coupled asynchronous processes: an input dendrite process (e.g., 1380) that receives spikes from network 1310 and applies them to an appropriate destination dendrite compartments at the appropriate future times, and output soma process (e.g., 1385) that receives each dendrite compartment's accumulated neurotransmitter amounts for the current time and evolves each dendrite and soma's membrane potential state, generating outgoing spike messages at appropriate times (e.g., when a threshold potential of a soma has been reached). Note that, from a biological perspective, dendrite and soma names used here only approximate a role of these functions and should not be interpreted too literally.

In at least one embodiment, neuromorphic computing device 1305 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

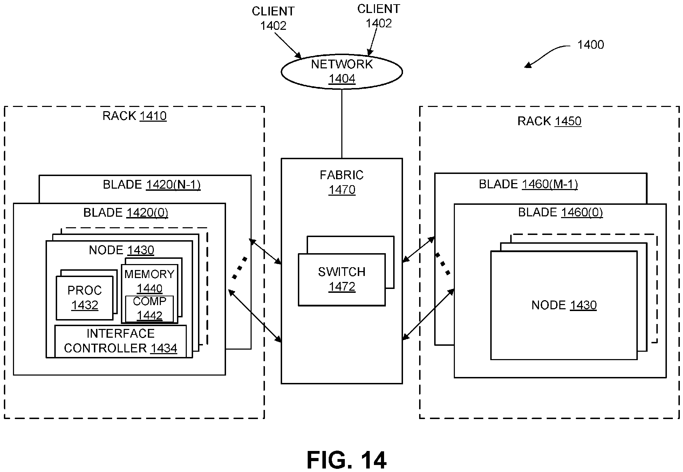

FIG. 14 is a block diagram of an embodiment of a multi-node network in which remote memory computation can be implemented, in accordance with any embodiment. System 1400 may represent a network of nodes described herein that can, e.g., be used to perform some or all of the operations described herein. System 1400 can represent a data center. System 1400 may represent a server farm. System 1400 may represent a data cloud or a processing cloud. System 1400 can represent a supercomputer. System 14 may include tens, hundreds, or thousands of nodes. Nodes of system 1400 may include processors, such as, but not limited to, central processing units (CPUs), graphics processing units (GPUs), or any combination of processors described herein, such as, but not limited to, other processors in FIGs. 8-20. With respect to any of processors in system 1400 and any of its components described above or elsewhere herein, one or more of APIs or equivalents described herein can, for example, get compiled into instructions or equivalents, which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of a processor or node (e.g., in cache and/or memory). A result of API(s) can then be stored in storage within or outside of a processor or node, including registers, DRAM, flash, SRAM, cache, or other memory equivalents. System 1400 may include over nine thousand nodes, with each node including two Intel Xeon Max processors, six Intel Max series GPUs and a unified memory architecture, such as, but not limited to, that used in Intel Aurora Supercomputer from Intel Corporation in Santa Clara, CA or another supercomputer that shares at least some of the components described herein.

One or more clients 1402 make requests over network 1404 to system 1400. Network 1404 represents one or more local networks, or wide area networks, or a combination. Clients 1402 can be human or machine clients, which generate requests for execution of operations by system 1400. System 1400 executes applications or data computation tasks requested by clients 1402.

System 1400 can include one or more racks, which represent structural and interconnect resources to house and interconnect multiple computation nodes. Rack 1410 can include multiple nodes 1430. Rack 1410 may host multiple blade components 1420(0) to 1420(N-1), where N is an integer greater than or equal to 2. Hosting can refer to providing power, structural or mechanical support, and interconnection. Blades 1420(0) to 1420(N-1) can refer to computing resources on printed circuit boards (PCBs), where a PCB houses hardware components for one or more nodes 1430. Blades 1420(0) to 1420(N-1) may or may not include a chassis or housing or other "box" other than that provided by rack 1410. Blades 1420(0) to 1420(N-1) may include housing with exposed connector to connect into rack 1410. System 1400 may or may not include rack 1410, and each blade (e.g., 1420(0)) can include a chassis or housing that can stack or otherwise reside in close proximity to other blades and allow interconnection of nodes 1430. System 1400 may include 10,624 compute blades, which include 63,744 Intel Max Series GPUs and 21,248 Intel Xeon Max CPUs across 166 racks.

System 1400 can include fabric 1470, which represents one or more interconnectors for nodes 1430. Fabric 1470 can include multiple switches 1472 or routers or other hardware to route signals among nodes 1430. Additionally, fabric 1470 can couple system 1400 to network 1404 for access by clients 1402. In addition to routing equipment, fabric 1470 can be considered to include cables or ports or other hardware equipment to couples nodes 1430 together. Fabric 1470 can have one or more associated protocols to manage routing of signals through system 1400. A protocol or protocols is at least partly dependent on hardware equipment used in system 1400.

As illustrated, rack 1410 can include N blades (e.g., 1420(0) to 1420(N-1)). In addition to rack 1410, system 1400 can include rack 1450. As illustrated, rack 1450 may include M blades (e.g., 1460(0) to 1460(M-1)). M is not necessarily the same as N; thus, it will be understood that various different hardware equipment components could be used, and coupled together into system 1400 over fabric 1470. Blades 1460(0) to 1460(M-1) can be the same or similar to blades 1420(0) to 1420(N-1). Nodes 1430 can be any type of node as described herein, and may not be necessarily all the same type of node. System 1400 is not limited to being homogenous, nor is it limited to not being homogenous.

A node in blade 1420(0) is illustrated in detail. However, other nodes in system 1400 can be the same or similar. At least some nodes 1430 may be computation nodes, with processor 1432 and memory 1440. A computation node refers to a node with processing resources (e.g., one or more processors) that executes an operating system and can receive and process one or more tasks. At least some nodes 1430 can include storage server nodes with a server as processing resources 1432 and memory 1440. A storage server refers to a node with more storage resources than a computation node, and rather than having processors for execution of tasks, a storage server includes processing resources to manage access to storage nodes within a storage server.

Node 1430 can include interface controller 1434, which can represent logic to control access by node 1430 to fabric 1470. Logic can include hardware resources to interconnect to physical interconnection hardware. Logic can include software or firmware logic to manage interconnection. Interface controller 1434 can include a host fabric interface, which can include a fabric interface in accordance with any embodiment described herein.

Node 1430 may include memory subsystem 1440. Memory 1440 can include memory computation resources (comp) 1442, which represent one or more capabilities by memory 1440 to perform memory computations. System 1400 enables remote memory operations, such as, but not limited to, the operations described elsewhere herein. Thus, nodes 1430 can request memory computations by remote nodes, where data for computation remains local to an executing node instead of being sent over fabric 1470 or instead of being sent from memory to a fabric interface. In response to execution of memory computation, executing node can provide a result to a requesting node.

Processor 1432 can include one or more separate processors. Each separate processor can include a single processing unit, a multicore processing unit, or a combination. A processing unit can include a primary processor such as, but not limited to, a CPU (central processing unit), a peripheral processor such as, but not limited to, a GPU (graphics processing unit), or a combination. Memory 1440 can be or include memory devices and a memory controller.

Reference to memory devices can apply to different memory types. Memory devices generally refer to volatile memory technologies. Volatile memory is memory whose state (and therefore data stored on it) is indeterminate if power is interrupted. Nonvolatile memory refers to memory whose state is determinate even if power is interrupted. Dynamic volatile memory can refresh data stored in a device to maintain state. One example of dynamic volatile memory includes DRAM (dynamic random access memory), or some variant such as, but not limited to, synchronous DRAM (SDRAM). A memory subsystem as described herein may be compatible with a number of memory technologies, such as, but not limited to, DDR3 (dual data rate version 3, original release by JEDEC (Joint Electronic Device Engineering Council) on June 27, 2007, currently on release 21), DDR4 (DDR version 4, initial specification published in September 2012 by JEDEC), DDR4E (DDR version 4, extended, currently in discussion by JEDEC), LPDDR3 (low power DDR version 3, JESD209-3B, Aug 2013 by JEDEC), LPDDR4 (LOW POWER DOUBLE DATA RATE (LPDDR) version 4, JESD209-4, originally published by JEDEC in August 2014), WIO2 (Wide I/O 2 (WideI02), JESD229-2, originally published by JEDEC in August 2014), HBM (HIGH BANDWIDTH MEMORY DRAM, JESD235, originally published by JEDEC in October 2013), DDR5 (DDR version 5, currently in discussion by JEDEC), LPDDR5 (currently in discussion by JEDEC), HBM2 (HBM version 2), currently in discussion by JEDEC), or others or combinations of memory technologies, and technologies based on derivatives or extensions of such specifications.

In addition to, or alternatively to, volatile memory, in one embodiment, reference to memory devices can refer to a nonvolatile memory device whose state is determinate even if power is interrupted. In one embodiment, nonvolatile memory device is a block addressable memory device, such as, but not limited to, NAND or NOR technologies. Thus, a memory device can also include a future generation nonvolatile devices, such as, but not limited to, a three dimensional crosspoint (3DXP) memory device, other byte addressable nonvolatile memory devices, or memory devices that use chalcogenide phase change material (e.g., chalcogenide glass). In one embodiment, a memory device can be or include multi-threshold level NAND flash memory, NOR flash memory, single or multi-level phase change memory (PCM) or phase change memory with a switch (PCMS), a resistive memory, nanowire memory, ferroelectric transistor random access memory (FeTRAM), magnetoresistive random access memory (MRAM) memory that incorporates memristor technology, or spin transfer torque (STT)-MRAM, or a combination of any of the above, or other memory.

In at least one embodiment, system 1400 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

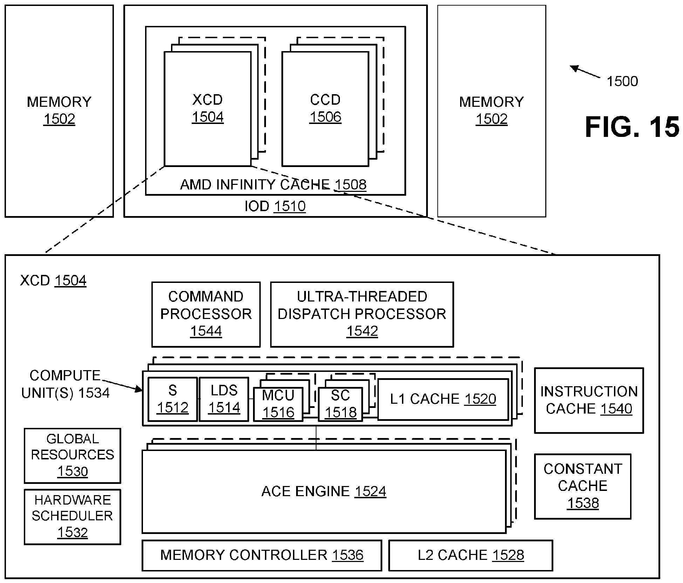

FIG. 15 illustrates accelerated processing unit 1500, in accordance with at least one embodiment. Accelerated processing unit 1500 can include a processor based on CDNA architecture from AMD Corporation in Santa Clara, CA or another processor that shares at least some of the components described herein. Accelerated processing unit 1500 can include one or more accelerator complex dies (XCDs) 1504 for performing operations described elsewhere herein, such as, but not limited to, graphics processing and/or parallel processing as well as computations with instruction-level parallelism, including support for a broad range of precisions (INT8, FP8, BF16, FP16, TF32, FP32, and FP64) and sparse matrix data (i.e. sparsity). XCDs may, in some instances, be referred to as Graphics Compute Dies (GCDs). Accelerated processing unit 1500 can include one or more complex compute dies (CCDs) 1506 for performing operations described elsewhere herein, such as, but not limited to, those operations performed by host processors. CCDs may, in some instances, be referred to as core complexes or CCXs, such as, but not limited to, CCXs used in AMD Ryzen processors. XCDs and CCDs can share any type of cache or memory (e.g., one or more memory units 1502), or have cache or memory allocated to each XCD or CCD or groups of XCDs or CCDs. For example, on-package AMD Infinity Fabric connects XCDs and CCD into shared AMD Infinity Cache 1508 and, in some embodiments, high-bandwidth memory (e.g., HMB3). Accelerated processing unit 1500 can include an AMD MI300a processor that includes three CPU chiplets (or CCDs) and six accelerator chiplets (XCDs) on top of four input-output dies (IODs) that may be layered on a piece of silicon that links them together (e.g., via AMD Infinity Fabric) to eight stacks of high-bandwidth DRAM that ring a superchip. An AMD MI300x processor substitutes CCDs for two more XCDs, for an accelerator-only system.

Accelerated processing unit 1500 can include one or more input/output (I/O) interfaces. For example, XCDs 1504 and CCDs 1506 can be together on one or more input-output dies (IODs) 1510 that can include one or more I/O interfaces. IODs 1510 can include of any number and type of I/O interfaces (e.g., PCI, PCI-Extended ("PCI-X"), PCIe, gigabit Ethernet ("GBE"), USB, etc.). Various types of peripheral devices can be coupled to I/O interfaces 1570. I/O interfaces from IODs 1510 can also be used for connected one or more accelerated processing units 1500, e.g., in a server architecture.

Accelerated processing unit 1500 can include one or more memory units 1502 for storing instructions and other information used to perform operations described elsewhere herein. Memory units 1502 can include any volatile memory, such as, but not limited to, memory types described elsewhere herein and can include, e.g., high-bandwidth memory (e.g., HMB3) or high-bandwidth DRAM. Memory associated with accelerated processing unit 1500 (e.g., memory units 1502) can include system memory that can be used, for example, for commands, instructions and constants, and inputs and outputs. Memory units 1502 can also include device memory that can be used as storage and, for example, for commands, instructions and constants, and inputs and outputs, as return buffer(s) and for private data. Memory units 1502 can be linked to one or more IODs 1510. In at least on embodiment, L1 cache 1520 starts a memory hierarchy that includes shared L2 cache 1528, e.g., within XCDs. AMD Infinity Cache^{™}, which is a last level cache (LLC) located on an active I/O die (IOD). CCDs 1506 and XCDs 1504 may have separate or shared memory. AMD Infinity Architecture and AMD Infinity Fabric^{™} technology can enable coherent, high-throughput unification of GPU and CPU chiplet technologies (e.g., XCDs, CCDs, and/or CCXs) with memory (e.g., stacked HBM3 memory) in single devices and across multi-device platforms.

As shown in FIG. 15, an XCD 1504 can include a shared set of global resources 1530, which can include hardware scheduler 1532 and Asynchronous Compute Engines (ACE) 1524 that send tasks (e.g., compute shader workgroups) to Compute Units (CUs or cores) 1534. ACEs 1524 (e.g., four) can be each associated with CUs 1534 (e.g., 40 CUs), and some of CUs 1534 can be disabled for yield management. CUs 1534 can have dedicated cache or share cache (e.g., L2 cache) 1528 that may be used to coalesce all memory traffic for a die. CUs 1534 can include threaded and parallel processor cores including instruction fetching and scheduling with Scheduler (S) 1512, matrix core unit (MCU) 1516 and shader core (SC) 1518 (e.g., execution units for scalar, vector and matrix data types), as well as load/store pipelines with an L1 cache 1520 and Local Data Share (LDS) 1514. Local data share can include, for example, a scratch RAM with built-in arithmetic capabilities that allow data to be shared between threads in a workgroup. An instruction cache 1540 (e.g., for storing and providing instructions for performing operations described elsewhere herein) and a constant cache 1538 can be connected to one or more CUs and can be shared between two CUs. Matrix cores 1516 can process a variety of data types, such as, but not limited to, INT8, FP8, FP16, BF16 and TF32 data types. Accelerated processing unit 1500 can include compute units 1534 that may be arranged in an array format, e.g., as a data-parallel-processor (DPP) array. Ultra-threaded dispatch processor 1542 can communicate with compute units 1534, and command processor 1544 can read commands that a host has written to memory-mapped registers in a system-memory address space (not shown). Command processor 1544 can send hardware-generated interrupts to a host processor (e.g., a CCD) when a command is completed. Memory controller 1536 can also have direct access to all device memory and host-specified areas of system memory. To satisfy read and write requests, memory controller 1536 can perform functions of a direct-memory access (DMA) controller, including computing memory-address offsets based on a format of requested data in memory. For example, one or more of APIs described herein can, for example, get compiled into instructions that can be stored in instruction cache 1540 and then fetched by instruction fetch logic in processor 1540, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of processor 1500 (e.g., in cache and/or memory). A result of API(s) can then be stored in storage within or outside of processor 1500, including registers, DRAM, flash, SRAM, cache, or other memory equivalents.

An application can include a program running on a host processor (e.g., a CCD) and programs, called kernels, running on one or more XCDs. Programs can be controlled by host commands that set internal base-address and other configuration registers, specify a data domain on which accelerated processing unit 1500 can operate, invalidate and flush caches on accelerated processing unit 1500, and cause accelerated processing unit 1500 to begin execution of a program. Kernels can be referred to as programs executed by accelerated processing unit 1500. A kernel can be executed independently on every work item, or as groups of work-items that can be referred to as a wavefront, which can execute a kernel on all work-items in a group (e.g., 64) in one pass. Compute units 1534 can include a scalar arithmetic logic unit (ALU), which can operates on one value per wavefront (common to all work items), a vector ALU, which can operate on unique values per work-item, a local data share 1514, which can allow work-items within a workgroup to communicate and share data, a scalar memory (not shown), which can transfer data between scalar general-purpose registers (SGPRs) and memory through a cache, and vector memory, which can transfer data between vector general-purpose registers (VGPRs) and memory, including sampling texture maps. Kernel control flow can be handled using scalar ALU instructions, which can includes if/else, branches and looping. Scalar ALU (SALU) and memory instructions can work on an entire wavefront and operate on one or more SGPRs. Vector memory and ALU instructions can operate on all work-items in a wavefront at one time.

In at least one embodiment, accelerated processing unit 1500 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

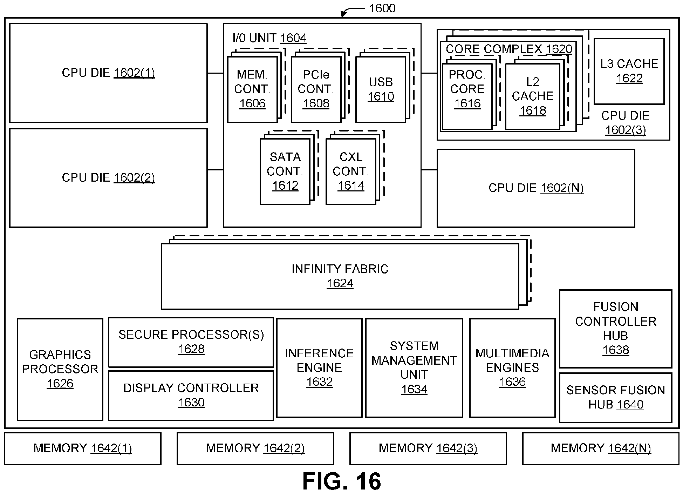

FIG. 16 illustrates a processor 1600, such as, but not limited to, a processor based on a Zen architecture (such as, e.g., Zen 1, 2, 3, 4, 5 or other) from AMD Corporation in Santa Clara, CA or another processor that shares at least some of the components described herein. Processor 1600 includes one or more CPU dies 1602(1)-1602(N), where N is any integer greater than 1. CPU die 1602 can include any number of processor cores 1616 (e.g., to perform any of the operations described elsewhere herein) and any number of cache memories (e.g., to store instructions and other information to perform any of the operations described elsewhere herein), in any combination. For example, L2 Cache units 1618 can be coupled to processor core(s) 1616, which can share and/or couple individually to L2 Cache units 1618. Processor cores 1616 can couple to L3 cache 1622 individually and/or share L3 Cache, which can be a lowest level cache (LLC) 1622 for access to data and other information used by processor cores 1616. One or more processor cores 1616 and one or more L2 Cache units 1618 can be included in a core complex (CCX) 1620 that can include (e.g., a 32 MB) shared cache (e.g., L3 cache 1622). Core complex 1620 can be fabricated onto a die (CCD or CPU die) 1602. For example, up to 12 core complexes 1620 can be configured into a processor along with 8 CPU dies 1602 to provide up to 96 processor cores 1616 for processor 1600. A `Zen 4c' core complex 1620, for example, can include up to eight cores 1616 and a shared 16 MB L3 cache 1622. Two of these core complexes 1620 can be combined onto a single CPU die 1602 for 16 cores per die and a total of 32 MB of L3 cache 1622 per die. Up to eight of CPU dies 1602 may be combined with an I/O unit 1604 to provide CPUs with up to 128 processor cores 1616. Up to four `Zen 4c' dies described above can be combined to provide CPUs with up to 64 processor cores 1616.

Processor 1600 can include a variety of configurations for input/output operations that are described further herein. I/O unit 1604 can include one or more memory controllers 1606 that can manage memory usage (e.g., DDR5 memory) for processor 1600. I/O unit 1604 may include one or more SATA disk controllers for managing storage 1612 and one or more Compute Express Link (CXL^{™}) 1.1+ memory controllers 1614 that can provide CPU-to-device and CPU-to-memory connections and can be flexibly assigned to specific functions at server design time. I/O unit 1604 may include PCIe controller 1608 for connecting peripherals and other components connected to processor 1600. I/O unit 1604 may include USB ports 1610 for connecting to other components separate from processor 1600. CPU dies 1602 can support any number of connections, e.g., one or two connections, to I/O unit 1604. As shown, I/O unit 1604 can include components described further herein, and I/O unit 1604 can be a I/O die that houses several different components. Memory controller 1606, PCIe controller 1608, USB ports 1610, SATA controller 1612, and/or CXL controller 1614 can be integrated anywhere within processor 1600 either separately or in any groups or combinations thereof.

Processor 1600 can include Infinity Fabric 1624 interconnects (which can be similar to or based on PCIe architectures) that can provide connections among CPUs (e.g., CPU dies 1602(1)-1602(N)), graphics processor(s) 1626, inference engine(s) 1632, and other components in a multi-chip architecture, such as secure processor(s) 1628 and I/O unit 1604. One or more AMD Infinity Fabric^{™} interconnects 1610 can connect to CPU dies 1602(1)-1602(N) and serve as a connection that is used between CPUs. One or more Infinity Fabric connections 1610 can connect each CPU die 1602 to I/O unit 1610.

In at least one embodiment, processor 1600 can include central processing units (CPUs) and other associated hardware and software described above and further herein. Processor 1600 can also include graphics processor(s) 1626. Graphics processor 1626 can be used for image generation and processing, as well as other computations and operations described further herein. Graphics processor 1626 can be based on RDNA 3 or 3.5 architecture from AMD in Santa Clara, CA. Graphics processor 1626 can include graphics compute dies (GCDs) and memory cache dies (MCDs). GCDs can include any number of compute units (CUs) for graphics or other processing, such as operations performed by arithmetic logic units (ALUs) that are described further herein. Graphics processor 1626 can include L2 cache that can be used by compute units. MCDs (not shown) can include any number of memory units and can include cache, such as L3 cache, as well as memory interfaces for coupling to memory, such as memory 1642(1)-(N), where N is an integer. Components within graphics processor 1626 can be connected using various approaches, such as using Infinity Fabric 1624 interconnects outside or within graphics processor 1626.

Inference engine 1632 can provide neural processing capabilities for processor 1600 for computational processes that are used for neural networks, deep learning, and other artificial intelligence-related operations described further herein. Processor 1600 can include secure processor(s) 1628 for managing security of processor 1600, display controller 1630 for controlling displays, a system management unit 1634 for managing and operating some or all of the components on processor 1600, multimedia engines 1636 for audio and video operations, fusion controller hub 1638 for managing USB, SATA and PCIe connections to processor 1600, and sensor fusion hub 1640 for managing sensors, such as accelerometers. Processor 1600 can also include memory 1642(1)-(N), where N is any integer. Memory can include different memory types, such as LPDDR5 and/or DDR5, or others described elsewhere herein.

For performing operations described further herein, processor 1600 can include an execution pipeline including a front-end that can include a cache (e.g., L1 cache) that stores instructions (not shown). Flow of instructions can be modified by a branch predictor. Instructions can be decoded by a decoder, dispatched to a back-end for execution, and renamed. Instruction fetch and decode pipes, for example, can be dispatched to integer or floating point execution operations that can be scheduled by a scheduler and transferred to vector and/or general-purpose registers. Floating point multiplier and/or add operations can be processed, and arithmetic logic units (ALUs) can also be used to perform computations, such as arithmetic and logic operations. Outputs from computation units can be coupled to a load/store queue, which can be connected to cache, such as L1 cache and/or L2 cache.

With respect to processor 1600 and any of its components described above or elsewhere herein, one or more of APIs or equivalents described herein can, for example, get compiled into instructions or equivalents (e.g., AVX-512 instructions based on an SIMD model), which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of processor 1600 (e.g., in cache and/or memory). A result of API(s) can then be stored in storage within or outside of processor 1600, including registers, DRAM, flash, SRAM, cache, or other memory equivalents.

In at least one embodiment, processor 1600 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

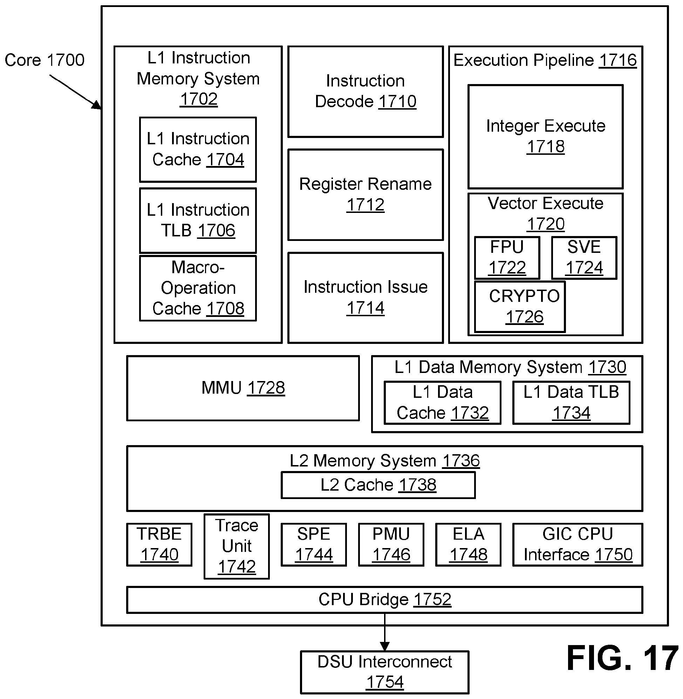

FIG. 17 illustrates an example of a processing core 1700 that may implement Arm architecture (e.g., v9.0-A) or another processor that shares at least some of the components described herein. Neoverse^{™} V2 core 1700 can be implemented inside a DynamIQ Shared Unit (DSU) cluster via DSU-110 interconnect 1754 for connected one or more cores, e.g., for parallel processing. Neoverse^{™} V2 core may be implemented as a single core in a DSU cluster that is configured for Direct connect, with or without L3 cache, snoop filter, or Snoop Control Unit (SCU) logic (not shown). Neoverse^{™} V2 core can include a CPU bridge 1752 that connects core 1700 to DSU-110 interconnect, which can also connect core 1700 to an external memory system and the rest of a system-on-a-chip. L1 instruction memory system 1702 can fetch instructions from an instruction cache 1704 and deliver instructions (e.g., one or more APIs described herein that may be compiled into instructions) to an instruction decode unit 1710, e.g., to perform some or all of operations described above or elsewhere herein. L1 instruction memory system 1702 may include L1 instruction cache 1704, e.g., with 64-byte cache lines, L1 instruction Translation Lookaside Buffer (TLB) 1706, e.g., with native support for 4KB, 16KB, 64KB, and 2MB page sizes, Macro-Operation Cache (MOP) 1708 (e.g., 1536-entry, 4-way skewed associative L0 MOP cache), which can contain decoded and optimized instructions for higher performance. Instruction decode unit 1710 can decode AArch64 instructions into internal format. Register rename unit 1712 can perform register renaming to facilitate out-of-order execution and dispatches decoded instructions to various issue queues. Instruction issue unit 1714 can control when decoded instructions may be dispatched to execution pipelines, and it can include issue queues for storing instructions pending dispatch to execution pipelines. Integer execution pipeline 1716 can be included in an execution pipeline and include integer execute unit 1718 that can perform arithmetic and logical data processing operations. Vector execute unit 1720 can be included in an execution pipeline and can perform Advanced SIMD and floating-point operations (FPU) 1722, execute Scalable Vector Extension (SVE) and Scalable Vector Extension 2 (SVE2) instructions 1724, and can optionally execute cryptographic instructions (Crypto) 1726. Advanced SIMD can include media and signal processing architecture that adds instructions primarily for audio, video, 3D graphics, image, and speech processing. A floating-point architecture provides support for single-precision and double-precision floating-point operations. L1 data memory system 1730 can execute load and store instructions, as well as service memory coherency requests. L1 data memory system 1730 can include an L1 data cache 1732 and a fully associative L1 data TLB 1734 with native support for 4KB, 16KB and 64KB page sizes and 2MB and 512MB block sizes. Memory Management Unit (MMU) 1728 can provide fine-grained memory system control through a set of virtual-to-physical address mappings and memory attributes that can be held in translation tables, which can be saved into TLB 1734 when an address is translated. L2 memory system 1736 can include L2 cache 1738, and it can be connected to DSU-110 1754 through an asynchronous CPU bridge 1752. Neoverse^{™} V2 core 1700 can support a range of debug, test, and trace options including a trace unit 1742 and a trace buffer 1740, and an Embedded Logic Analyzer (ELA) 1748. Neoverse^{™} V2 core 1700 can implement Statistical Profiling Extension (SPE) 1744 to provide a statistical view of the performance characteristics of executed instructions that software writers can use to optimize their code for better performance. Performance Monitoring Unit (PMU) 1746 can provide performance monitors that can be configured to gather statistics on operation of each core and memory system. Information can be used for debug and code profiling. Generic Interrupt Controller (GIC) CPU interface 1750, when integrated with an external distributor component, can be a resource for supporting and managing interrupts in a cluster system. In a cluster, there can be one CPU bridge 1752 between each Neoverse^{™} V2 core 1700 and DSU-110 1754. CPU bridge 1752 can control buffering and synchronization between core 1700 and DSU-1101754. CPU bridge 1752 can be asynchronous to allow different frequency, power, and area implementation points for each core 1700. CPU bridge 1752 can run synchronously without affecting other interfaces such as, but not limited to, debug and trace which can be asynchronous.

In at least one embodiment, core 1700 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

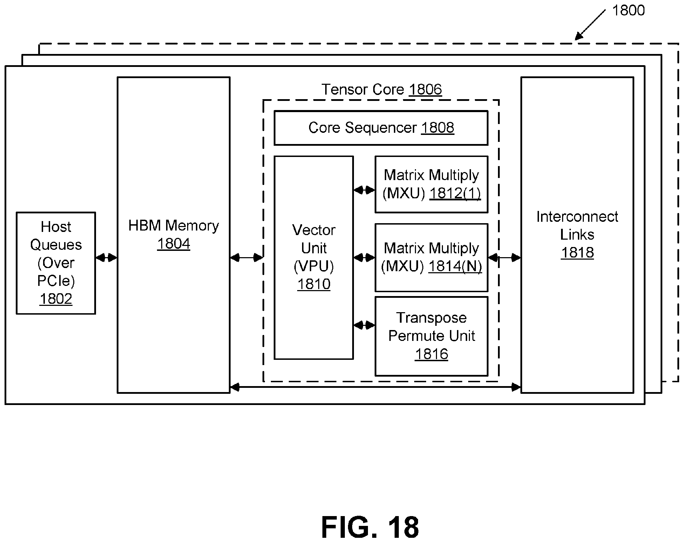

FIG. 18 illustrates one or more chips including one or more tensor processing units (TPUs) 1800, in accordance with at least one embodiment. TPUs 1800 in FIG. 18 can include application specific integrated circuits (ASICs), e.g., to perform some or all of the operations described above or elsewhere herein, such as, but not limited to, accelerate machine learning workloads performing matrix operations. TPUs 1800 may be ASICs from Alphabet Corporation in Mountain View, CA. Cloud TPU includes a cloud service that makes TPUs available as a scalable resource for processing tasks, such as, but not limited to, machine learning workloads that can run on frameworks such as, but not limited to, TensorFlow, Pytorch, and JAX.

Chip 1800 can include any number of TPUs that can include tensor cores 1806. Tensor core 1806 can include one or more core sequencer 1808, vector processing unit (VPU) 1810, matrix multiply unit (MXU) 1812(A)-1814(N), where N is any integer greater than 1, and a transpose permute unit 1816. Core Sequencer 1808 can fetch (e.g., VLIW (Very Long Instruction Word)) instructions from core's 1806 Instruction Memory (Imem), execute scalar operations using a scalar data memory (Smem) and scalar registers (Sregs) (not shown), and forward vector instructions to Vector Processing Unit (VPU) (1810. Instructions can, for example, launch eight operations: two scalar, two vector ALU, vector load and store, and a pair of slots that queue data to and from matrix multiply and transpose units. VPU 1810 can perform vector operations using a large on-chip vector memory (Vmem), and vector registers (Vregs). VPU 1810 can stream data to and from MXU through decoupling FIFOs. VPU 1810 can collect and distribute data to Vmem via data-level parallelism (2D matrix and vector functional units) and instruction-level parallelism (8 operations per instruction). A large two-dimensional matrix multiply unit (MXU) 1812(A)-1812(N) can, e.g., use a systolic array to reduce area and energy plus large, software-controlled on-chip memories instead of caches. Transpose Reduction Permute Unit 1816 can do (e.g., 128x128) matrix transposes, reductions, and permutations of VPU 1810 lanes. High Bandwidth Memory 1804 can be used for applications on chip, and it can be coupled to host queue(s) 1802, e.g., over PCIe. One or more chips 1800 can be connected together for computing. For example, one or more chips 1800 can be connected as a torus, e.g., a 2D torus. Chip 1800 can also include any number (e.g., four) Inter-Core Interconnect (ICI) links 1818 that can enable direct connections between chips to form a supercomputer.

With respect to any processors in chip 1800 and any of its components described above or elsewhere herein, one or more of APIs or equivalents described herein can, for example, get compiled into instructions or equivalents, which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of any processors in chip 1800 (e.g., in cache and/or memory). A result of API(s) can then be stored in storage within or outside of any processors in chip 1800, including registers, DRAM, flash, SRAM, cache, or other memory equivalents.

In at least one embodiment, chip 1800 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

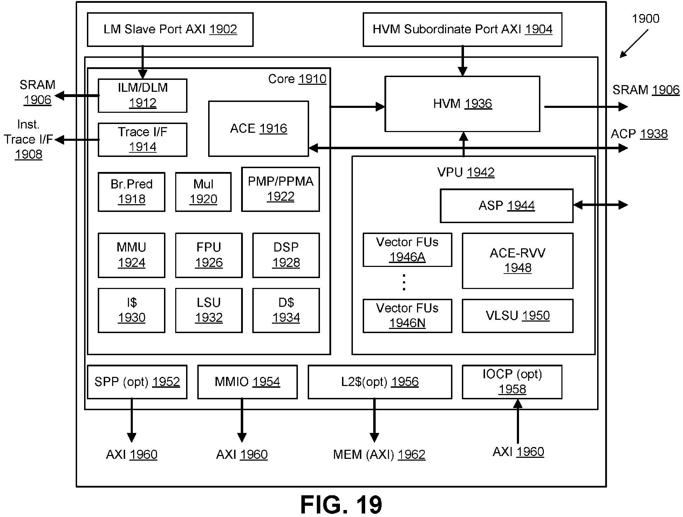

FIG. 19 illustrates a vector processor, in accordance with at least one embodiment. Vector processor 1900 may support a RISC-V standard. Vector processor 1900 can include one more cores 1910 (e.g., scalar units) with one or more Vector Processing Units (VPUs) 1942 (e.g., vector units) that can, e.g., perform some or all of the operations described above or elsewhere herein. Core 1910 may include Andes Custom Extension (ACE) 1916 that can be used for communication of customized instructions for processor 1900, for example, via ACP 1938. Core 1910 may include 1-cycle multiplier and 1-cycle instruction/data local memory (ILM/DLM) for increased parallelism by allowing simultaneous instruction fetches and data accesses. Memory management unit (MMU) 1924 may manage system memory and cache, and provide for branch execution, issuance of instruction pairs, L1 instruction/data caches and local memory storage. Core 1910 can include Physical memory protection and programmable physical memory attribute unit (PMP/PPMA) 1922. Core 1910 can include a digital signal processor (DSP) 1928, and a floating-point unit (FPU) 1926 as well as load-store unit (LSU) 1932 to interface with memory hierarchy (D$ 1934 and I$ 1930). Core 1910 can include branch prediction unit 1918 and multiplier unit 1920.

Vector processing unit (VPU) 1942 can include one or more vector functional units (FUs) 1946(A)-1946(N) that can be chained together for parallel processing, independent memory paths for RISC-V vector (RW) load/store via ACE-RW 1948 and Andes Streaming port (ASP) 1944 load/store, and a vector load/store unit (VLSU) 1950.

Vector processor 1900 can include bus interfaces, such as, but not limited to, L2 cache memory port 1956 for cacheable access, a MMIO port 1954 for non-cacheable access, an input-output coherence Port (IOCP) 1958 for cacheless bus master, local memory access ports for ILM/DLM 1912, which can be coupled to SRAM 1906, and high-bandwidth vector memory (HVM) 1936 access, a shared peripheral port (SPP) 1952 for external peripherals. Other memory ports include LM slave port AXI 1902, HVM subordinate port AXI 1904, MEM (AXI) 1962, and AXI 1960. Trace I/F 1914 can capture, encode, and transmit off-chip via Inst. Trace I/F 1908, e.g., a record of executed processor instructions, which software tools can use to reconstruct the exact execution sequence of a program.

With respect to any processors in processor 1900 and any of its components described above or elsewhere herein, one or more of APIs or equivalents described herein can, for example, get compiled into instructions or equivalents, which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of processor 1900 (e.g., in cache and/or memory). A result of API(s) can then be stored in storage within or outside of processor 1900, including registers, DRAM, flash, SRAM, cache, or other memory equivalents.

In at least one embodiment, vector processor 1900 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

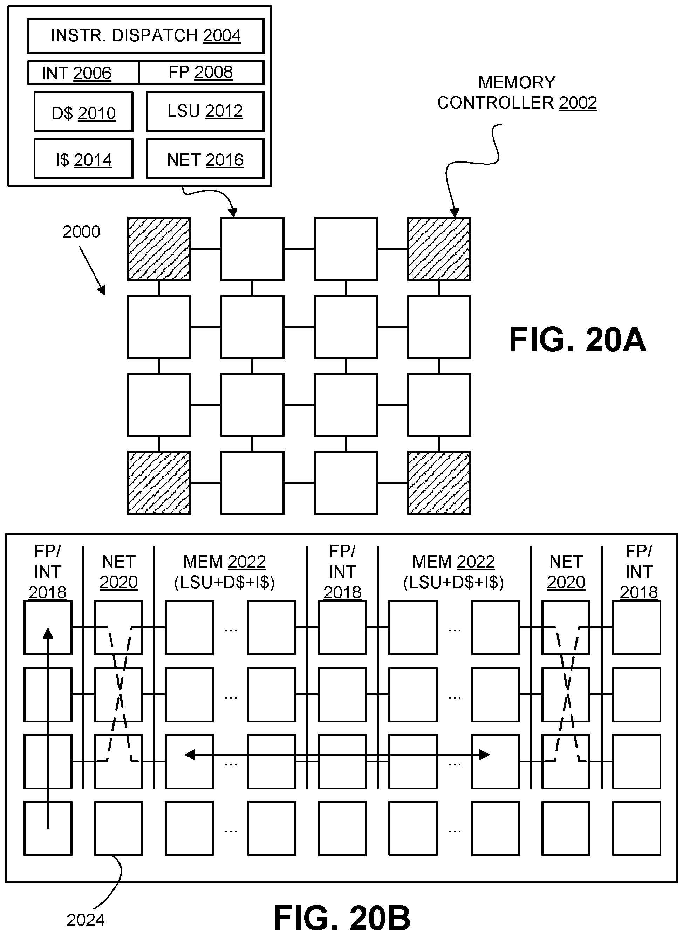

FIG. 20A illustrates a diagram of an example many-core tiled processor microarchitecture. Many-core tiled processor in FIG. 20A can include a language processing processor. As illustrated in FIG. 20A, each "tile" of a processor architecture is a processing element tied together using a network-on-chip (NoC) that can be used, e.g., to perform some or all of the operations described above or elsewhere herein. For example, each tile may have an instruction dispatch 2004 and an integer (INT) 2006 and floating-point (FP) unit 2008 as well as load-store unit (LSU) 2012 to interface with memory hierarchy (data cache (D$) 2010 and instruction cache (I$) 2014) and network (NET) 2016 interface for communication with other tiles. Some tiles in processor 2000 may include memory controller 2002 for managing and controlling memory, as described further herein. Processor 2000 can have a functional slice architecture. Processor 2000 may be located on an application specific integrated circuit (ASIC), and FIG. 20A may represent a layout of an ASIC. Processor 2000 can include a coprocessor that is designed to execute instructions for a predictive model. A predictive model is any model that is configured to make a prediction from input data. A predictive model can use a classifier to make a classification prediction. A predictive model may be a machine learning model such as, but not limited to, a tensor flow model, and processor 2000 is a tensor streaming processor.

Processor 2000 can employ different microarchitectures, which disaggregates functional units shown in each tile in FIG. 20B. Instead, functional tiles 2024 of processor 2000 may be aggregated into a plurality of functional process units (hereafter referred to as "slices") 2004, each corresponding to a particular function type (e.g., FP/INT 2018, NET 2020, MEM 2022). For example, as illustrated in FIG. 20B, each slice may correspond to a column of functional tiles extending in a north-south direction. In addition, processor 2000 also may include communication lanes to carry data between tiles of different slices, each running horizontally in an east-west direction. Each communication lane may be connected to each of slices 2004 of processor 2000.

Slices 2004 of processor 2000 may each correspond to a different function, and may include arithmetic logic slices (e.g., FPIINT2018), lane switching slices (e.g., NET 2020), and memory slices (e.g., MEM 2022). Arithmetic logic units may execute one or more arithmetic and/or logic operations on data received via communication lanes to generate output data. Examples of arithmetic logic units may be matrix multiplication units and vector multiplication units. Memory slices include memory cells that store data. Memory slices can provide data to other slices through communication lanes. Memory slices can also receive data from other slices through communication lanes. Lane switching slices can configurably route data from one communication lane to any other communication lane. For example, data from a first lane can be provided to a second lane through a lane switching slice. In some embodiments, a lane switching slice can be implemented as a crossbar switch. Each slice 2004 also includes its own instruction queue (not shown) that stores instructions, and an instruction control unit (ICU) to control execution of instructions. Instructions in a given instruction queue may be executed only by tiles in its associated functional slice and may not be executed by other slice(s) of processor 2000.

By arranging tiles of processor 2000 into different functional slices 2004, on-chip instruction and control flow of processor 2000 can be decoupled from data flow. For example, one arrow in FIG. 20B illustrates flow of instructions within processor architecture, in accordance with some embodiments. Another arrow in FIG. 20B illustrates data flow within processor architecture, in accordance with at least one embodiment. As illustrated, instructions and control flow can flow in a first direction across tiles of processor 2000 (e.g., north-south, along a length of functional slices, as shown by the first arrow), while data flows flow in a second direction across tiles of processor 2000 (e.g., east-west, across functional slices, as shown by the second arrow) that is perpendicular to the first direction.

Different functional slices of processor 2000 may correspond to MEM 2022 (memory), VXM (vector execution module), NIW (matrix execution module), NIM (numerical interpretation module), and SXM (switching and permutation module). Each slice may include N tiles that may all be controlled by a same instruction control unit (ICU) (not shown). Each slice may operate completely independently and can only be coordinated using barrier-like synchronization primitives or through a compiler by exploiting "tractable determinism." Each tile of processor 2000 can correspond to an execution unit organized as an ×M SIMD tile. For example, each tile of on-chip memory of processor 2000 may be organized to store an L-element vector atomically. As such, a MEM slice having N tiles may work together to store or process a large vector (e.g., having a total of N×M elements).

Tiles in a slice may execute instructions in a "staggered" fashion where instructions may be issued tile-by-tile within a slice over a period of N cycles. Functional slices may be arranged physically on-chip to allow efficient data-flow for pipelined execution across hundreds of cycles for common patterns. Data flows can perform a single "u-turn" (change in direction) corresponding to a single matrix operation before being written back to memory, in some embodiments, a particular data flow may change direction multiple times (due to multiple matrix and vector operations) before resulting data is written back into memory.

When using processor 2000 (e.g., TSP) having a functional slice architecture, TSP compiler (not shown) generates an explicit plan for how processor 2000 can execute a program (e.g., a microprogram). Compiler can specify when each operation will be executed, which functional slices will perform work, and which STREAM registers hold operands. Compiler can maintain a high-fidelity (cycle accurate) model of processor 2000 (e.g., TSP) hardware state so a microprogram can orchestrate data flow.

Processor 2000 (e.g., TSP) can use a Web-hosted compiler that takes as its input a model (e.g., a ML model such as, but not limited to, a TensorFlow model) and emits a proprietary instruction stream targeting processor 2000 (e.g., TSP). Compiler is responsible for coordinating control and data flow of a program, and specifies any instruction-level parallelism by explicitly bundling instructions that can and should execute concurrently so that they may be dispatched together. Primary hardware structure includes an architecturally-visible streaming register file (STREAMs), described in greater detail below, which serves as a conduit through which operands flow from MEM slices (e.g., SRAM) to functional slices and vice versa.

MEM 2022 of processor 2000 can serve as: (1) storage for model parameters, microprograms and data on which they operate, and (2) network-on-chip (NoC) for communicating data operands from MEM to functional slices and computed results back to MEM. In some embodiments, on-chip memory can consumes ≈75% of chip area of processor 2000. In some embodiments, due to bandwidth requirements of processor 2000, on-chip memory of MEM tiles may include SRAM, and not DRAM. On-chip memory capacity of processor 2000 can determine (i) number of ML models that can simultaneously reside on-chip, (ii) size of any given model, and (iii) partitioning of large models to fit into multi-chip systems. In some embodiments, MEM system of processor 2000 can provide a plurality of memory slices organized into two different hemispheres (referred to as "MEM WEST" and "MEM EAST", respectively).

Memory slices of each hemisphere may be mirrored, such that slices may be physically numbered {0, ... L} in an East hemisphere, and {L, ... 0} in a West hemisphere, such that memory slice 0 for each hemisphere corresponds to a slice closest to VXM slices between hemispheres, where each hemisphere comprises L slices. Direction of data transfer towards the center of a chip may be referred to as inwards, while data transfer toward the outer (Eastern or Western most) edge of a chip may be referred to as outwards. Although hemispheres of memory of processor 2000 may be referred to as east and west, it is understood that in other embodiments, other names may be used to refer to different hemispheres of memory.

In some embodiments, a streaming register file, referred to as STREAMS, transfers operands and results between SRAM of MEM slices and functional slices of processor 2000. In some embodiments, a plurality of MEM slices (e.g., between 2 and 10 adjacent MEM slices) may be physically organized as a set. Each set of slices may be located between a pair of STREAM register files, such that each slice is able to read or write to STREAM registers in either direction. By placing STREAM register files between sets of MEM slices, a number of cycles needed for data operands to be transmitted across a hemisphere is decreased (e.g., by a factor corresponding to a number of slices per set). A number of slices per set may be configured based upon a distance over which data may be transmitted over a single clock cycle.

With respect to any processors in FIG. 20 and any components described above or elsewhere herein, one or more of APIs or equivalents described herein can, for example, get compiled into instructions or equivalents, which may be fetched by instruction fetch logic or equivalents, decoded by a processor decoder or equivalents, scheduled (e.g., in order or out of order) for execution by a scheduler or equivalents, executed by execution logic or equivalents, reordered, and then retired by retirement logic or equivalents. API(s) (and/or compiled instructions including API(s)) can be stored in any storage outside or inside of processor 2000 (e.g., in cache and/or memory). A result of API(s) can then be stored in storage within or outside of processor 2000, including registers, DRAM, flash, SRAM, cache, or other memory equivalents.

In at least one embodiment, processor 2000 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

### SOFTWARE CONSTRUCTIONS

The following figures set forth, without limitation, examples of software constructs for implementing at least one embodiment.

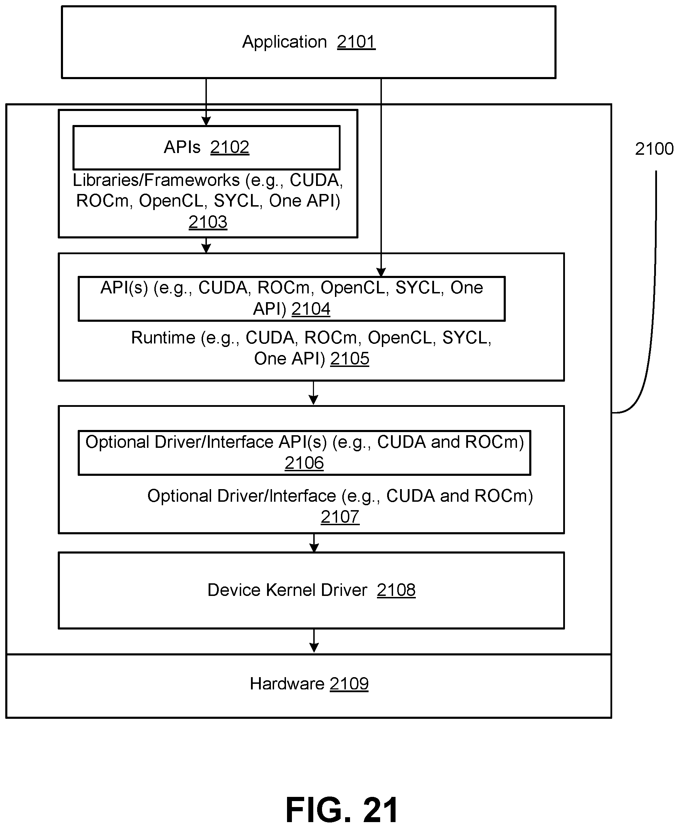

FIG. 21 illustrates a software stack of a programming platform, in accordance with at least one embodiment. A programming platform can include a platform for leveraging hardware on a computing system to accelerate computational tasks. A programming platform may be accessible to software developers through libraries, compiler directives, and/or extensions to programming languages, in at least one embodiment. A programming platform may be CUDA, Radeon Open Compute Platform ("ROCm"), OpenCL (OpenCL^{™} is developed by Khronos group), SYCL, or Intel oneAPI.

A software stack 2100 of a programming platform can provide an execution environment for an application 2101. Application 2101 may include any computer software capable of being launched on software stack 2100. Application 2101 may include an artificial intelligence ("AI")/machine learning ("MI,") application, a high performance computing ("HPC") application, a virtual desktop infrastructure ("VDI"), or a data center workload.

Application 2101 and software stack 2100 run on hardware 2108. Hardware 2108 may include one or more GPUs, CPUs, FPGAs, AI engines, and/or other types of compute devices that support a programming platform. Software stack 2100 may be vendor specific and compatible with only devices from particular vendor(s), such as CUDA, ROCm, OneAPI, OpenCL, or other implementations. Hardware 2108 can include a host connected to one more devices that can be accessed to perform computational tasks via application programming interface ("API") calls. A device within hardware 2108 may include a GPU, FPGA, AI engine, or other compute device (but may also include a CPU) and its memory, as opposed to a host within hardware 2108 that may include a CPU (but may also include a compute device) and its memory, in at least one embodiment. With respect to any hardware 2108 described above or elsewhere herein, one or more of APIs described herein can, for example, get compiled into instructions, which may be fetched by instruction fetch logic, decoded by a processor decoder, scheduled (e.g., in order or out of order) for execution by a scheduler, executed by execution logic, reordered, and then retired by retirement logic. API(s) (and/or compiled instructions including API(s)) can be stored in any storage outside or inside of hardware 2108 (e.g., in cache and/or memory). A result of API(s) can then be stored in storage within or outside of hardware 2108, including registers, DRAM, flash, SRAM, cache, or other memory. One or more of APIs described herein can receive a call. One or more of APIs described herein can communicate with a library or a portion of a library to perform a function described by the call. One or more of APIs described herein can receive a call and communicate with a library or portion of a library to perform a function described by the call.

Software stack 2100 of a programming platform can include a number of libraries 2103, a runtime 2105, an optional driver/interface 2107, and a device kernel driver 2108. Each of libraries 2103 may include data and programming code that can be used by computer programs and leveraged during software development. Libraries 2103 may include pre-written code and subroutines, classes, values, type specifications, configuration data, documentation, help data, and/or message templates. Libraries 2103 can include functions that may be optimized for execution on one or more types of devices. Libraries 2103 may include functions for performing mathematical, deep learning, and/or other types of operations on devices. Libraries 2103 can be associated with corresponding APIs 2102, which may include one or more APIs, that expose functions implemented in libraries 2103. A processor (e.g. CPU, GPU) may perform, call, or otherwise use one or more APIs to prioritize kernels. For example, a first kernel (e.g., parent) can launch a second kernel (e.g., child kernel), and said second kernel can be used by a processor to launch additional kernels (e.g., grandchildren kernels) independent of said first kernel. A processor may perform an API or calls an API from memory to be performed to support dynamic stream priority (e.g., updating priority while a stream is being used to perform operations). For example, when a processor performs said API, it allows a programmer to copy stream priority from one stream to one or more other streams.

Software stack 2100 may include an API to support dynamic stream priority (e.g., updating priority while a stream is being used to perform operations), which can allow a programmer to set priority of a stream at any time after creation. Software stack 2100 can include an API to support dynamic stream priority (e.g., updating priority while the stream is being used to perform operations), which may allow a programmer to obtain current priority of a stream, where the priority is one of a plurality of attributes of a stream. Software stack 2100 can include an API to support dynamic stream priority (e.g., updating priority while the stream is being used to perform operations), which may allow a programmer to obtain current priority of a stream as a single attribute. Software stack 2100 can include an API to support dynamic stream priority (e.g., updating priority while the stream is being used to perform operations), which allows a programmer to launch a kernel to perform operations on a stream at a set priority, which may be different from the stream priority. Software stack 2100 may include an API to indicate whether an object (e.g., a thread synchronization object such as, but not limited to, a barrier) tracks whether all data movement operations for a set of threads operating on a GPU may be complete has a specified state after a specified period of time, where a specified state can be a state indicating that data has been moved and is ready for use, and is specified using an expected parity value as an input to the API.

Software stack 2100 can include one or more APIs to updated kernels. A processor can perform an API or call an API from memory to be performed to update to an existing API is to support context-free kernels, which may allow a programmer to add a kernel node to a graph without a graphics context, so that a graphics context can be dynamically associated with a kernel at runtime. Software stack 2100 may include one or more APIs to allow a programmer to obtain a kernel identifier and a graphics context as separate parameters from a kernel node, so that parameters to be obtained from kernels and from context-free kernels. Software stack 2100 can include one or more APIs to use parallel processor(s), such as, but not limited to, one or more graphics processing units, to launch task graphs (e.g., task graphs) and to execute one or more task graphs (e.g., including one or more programs).

Software stack 2100 may include one or more APIs to associate one or more instructions with one or more memory ordering operations, such as, but not limited to, a fence or membar operation. Instructions can be associated with one or more domains such that a memory ordering operation is executed in association to one or more particular domains without interfering with instructions of other domains. An API can indicate a thread has arrived (e.g., at a thread synchronization barrier), or finished a stage of work in relation to asynchronous data movement operations on a GPU. Software stack 2100 may include one or more to allow programmers to manually indicate an expected transaction count when a thread has finished a stage of work, which can be used to update an object that tracks whether all data movement operations for a set of threads may be complete.

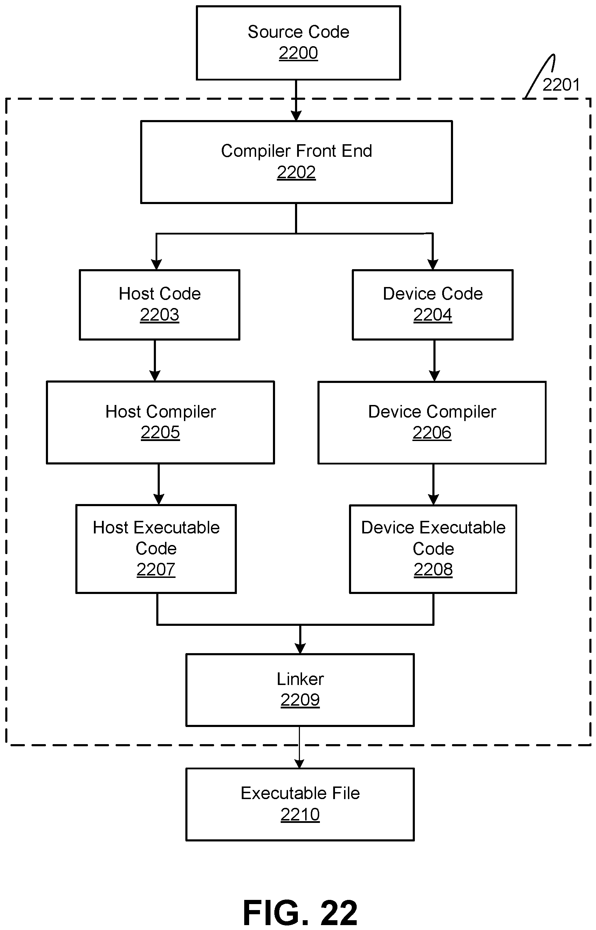

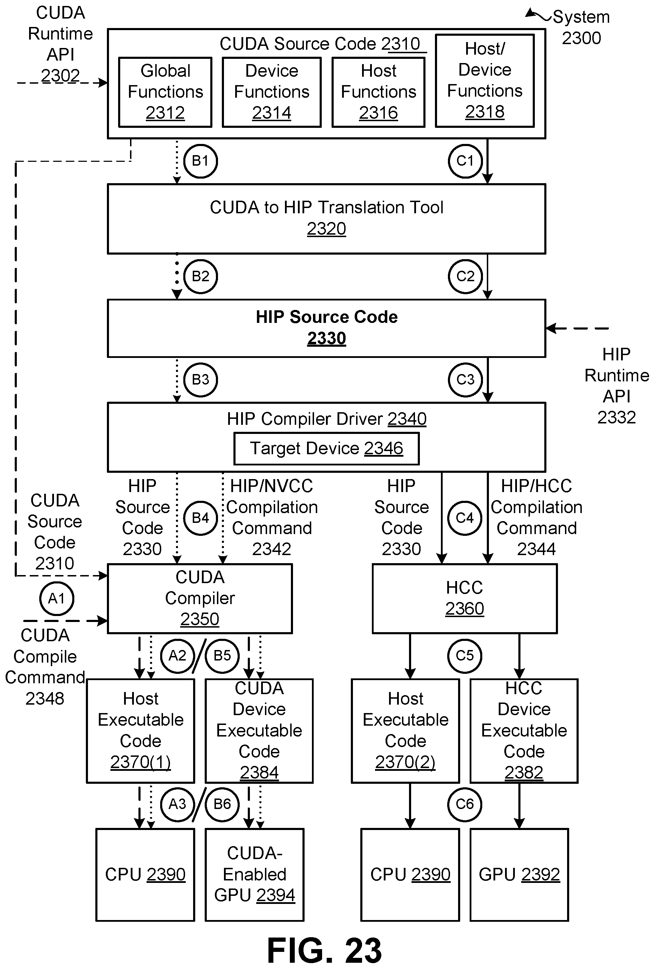

Application 2101 can be written as source code that is compiled into executable code, as discussed in greater detail below in conjunction with FIGs. 22 and 23. Executable code of application 2101 may run, at least in part, on an execution environment provided by software stack 2100. During execution of application 2101, code may be reached that needs to run on a device, as opposed to a host. In such a case, runtime 2105 may be called to load and launch requisite code on a device. Runtime 2105 may include any technically feasible runtime system that is able to support execution of application 2101.

Runtime 2105 can be implemented as one or more runtime libraries associated with corresponding APIs, which are shown as API(s) 2104. One or more of such runtime libraries may include functions for memory management, execution control, device management, error handling, and/or synchronization, among other things,. Memory management functions may include functions to allocate, deallocate, and copy device memory, as well as transfer data between host memory and device memory. Execution control functions may include functions to launch a function (sometimes referred to as a "kernel" when a function is a global function callable from a host) on a device and set attribute values in a buffer maintained by a runtime library for a given function to be executed on a device.

Runtime libraries and corresponding API(s) 2104 may be implemented in any technically feasible manner. One (or any number of) API may expose a low-level set of functions for fine-grained control of a device, while another (or any number of) API may expose a higher-level set of such functions. A high-level runtime API may be built on top of a low-level API. One or more of runtime APIs may be language-specific APIs that may be layered on top of a language-independent runtime API.

An optional driver or interface 2107 may be implemented, e.g., for CUDA and ROCm implementations, that are described further below. Optional driver/interface 2107 may be associated with optional driver or interface API(s), such as, but not limited to, CUDA and/or ROCm API(s).

One or more processors disclosed in "processing systems" can perform, access, or otherwise use software stack 2100. For example, system-on-a-chip 800, parallel processor 900, graphics multiprocessor 934, processor 1000, processor 1100, accelerator 1200, neuromorphic processor 1305, supercomputer 1400, acceleration processing unit 1500, processor 1600, processor 1700, tensor processing unit 1800, processor 1900, and language processing unit 2000 can perform, use, call, or otherwise implement (e.g., through accessing a memory) one or more APIs included in software stack 2100.

Device kernel driver 2108 can be configured to facilitate communication with an underlying device. Device kernel driver 2108 may provide low-level functionalities upon which APIs, such as, but not limited to, API(s) 2104, and/or other software relies. Device kernel driver 2108 may be configured to compile intermediate representation ("IR") code into binary code at runtime. For CUDA or other implementations such as, but not limited to, ROCm, OneAPI, or OpenCL, device kernel driver 2108 may compile Parallel Thread Execution ("PTX") IR code that is not hardware specific into binary code for a specific target device at runtime (with caching of compiled binary code), which is also sometimes referred to as "finalizing" code. Doing so may permit finalized code to run on a target device, which may not have existed when source code was originally compiled into PTX code. Alternatively, device source code may be compiled into binary code offline, without requiring device kernel driver 2108 to compile IR code at runtime.

Processors described elsewhere herein, such as, but not limited to, processors in FIGs. 8-20 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software, e.g., software stack 2100 to causing communication of a plurality of wireless devices with one or more base stations to be simulated based, at least in part, on grouping the plurality of wireless devices according to one or more shared communication frequency bands or otherwise perform any of the operations described above or elsewhere herein.

In accordance with at least one embodiment, software stack 2100 of FIG. 21 can be performed in a CUDA implementation. A CUDA software stack 2100, on which an application 2101 may be launched, may include CUDA libraries 2103, a CUDA runtime 2105, a CUDA driver 2107, and a device kernel driver 2108. CUDA software stack 2100 can execute on hardware (e.g., graphics multiprocessor 934 that may include a GPU that supports CUDA and is developed by NVIDIA Corporation of Santa Clara, CA.

Application 2101, CUDA runtime 2105, and device kernel driver 2108 can perform functionalities that are described above and elsewhere herein. CUDA driver 2107 can include a library (libcuda.so) that may implement a CUDA driver API 2106. Similar to a CUDA runtime API 2104 implemented by a CUDA runtime library (cudart), CUDA driver API 2106 may expose functions for memory management, execution control, device management, error handling, synchronization, and/or graphics interoperability, among other things. CUDA driver API 2106 can differ from CUDA runtime API 2104 in that CUDA runtime API 2104 simplifies device code management by providing implicit initialization, context (analogous to a process) management, and module (analogous to dynamically loaded libraries) management. In contrast to high-level CUDA runtime API 2104, CUDA driver API 2106 can be a low-level API providing more fine-grained control of a device, particularly with respect to contexts and module loading. CUDA driver API 2106 may expose functions for context management that may be not exposed by CUDA runtime API 2104. CUDA driver API 2106 may also be language-independent and support, e.g., OpenCL, in addition to CUDA runtime API 2104. Further, development libraries, including CUDA runtime 2105, may be considered as separate from driver components, including user-mode CUDA driver 2107 and kernel-mode device driver 2108 (also sometimes referred to as a "display" driver).

CUDA libraries 2103 may include mathematical libraries, deep learning libraries, parallel algorithm libraries, and/or signal/image/video processing libraries, which parallel computing applications such as, but not limited to, application 2101 may utilize. CUDA libraries 2103 may include mathematical libraries such as, but not limited to, a cuBLAS library that is an implementation of Basic Linear Algebra Subprograms ("BLAS") for performing linear algebra operations, a cuFFT library for computing fast Fourier transforms ("FFTs"), and a cuRAND library for generating random numbers, among others. CUDA libraries 2103 may include deep learning libraries such as, but not limited to, a cuDNN library of primitives for deep neural networks and a TensorRT platform for high-performance deep learning inference, among others.

In at least one embodiment, processors described elsewhere herein, such as, but not limited to, processors in FIGs. 8-20 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software, e.g., software stack 2100 to causing communication of a plurality of wireless devices with one or more base stations to be simulated based, at least in part, on grouping the plurality of wireless devices according to one or more shared communication frequency bands or otherwise perform any of the operations described above or elsewhere herein.

In accordance with at least one embodiment, software stack 2100 of FIG. 21 can be performed in a ROCm implementation. A ROCm software stack 2100, on which an application 2101 may be launched, includes a language runtime 2103, a system runtime 2105, a thunk 2107, and a ROCm kernel driver 2108. ROCm software stack 2100 executes on hardware 2109, which may include a GPU that supports ROCm and is developed by AMD Corporation of Santa Clara, CA.

Application 2101 may perform similar functionalities as discussed above in conjunction with FIG. 21. In addition, language runtime 2103 and system runtime 2105 may perform similar functionalities as runtime 2105 discussed above in conjunction with FIG. 21. Language runtime 2103 and system runtime 2105 may differ in that system runtime 2105 is a language-independent runtime that implements a ROCr system runtime API 2104 and makes use of a Heterogeneous System Architecture ("HSA") Runtime API. HSA runtime API can include a thin, user-mode API that exposes interfaces to access and interact with an AMD GPU, including functions for memory management, execution control via architected dispatch of kernels, error handling, system and agent information, and runtime initialization and shutdown, among other things. In contrast to system runtime 2105, language runtime 2103 can be an implementation of a language-specific runtime API 2102 layered on top of ROCr system runtime API 2104. Language runtime API may include a Heterogeneous compute Interface for Portability ("HIP") language runtime API, a Heterogeneous Compute Compiler ("HCC") language runtime API, or an OpenCL API, among others. HIP language in particular is an extension of C++ programming language with functionally similar versions of CUDA mechanisms, and a HIP language runtime API may include functions that may be similar to those of CUDA runtime API discussed above in conjunction with FIG. 21, such as, but not limited to, functions for memory management, execution control, device management, error handling, and synchronization, among other things.

Thunk (ROCt) 2107 can be an interface 2106 that can be used to interact with underlying ROCm driver 2108. ROCm driver 2108 can be a ROCk driver, which is a combination of an AMDGPU driver and a HSA kernel driver (amdkfd). AMDGPU driver can be a device kernel driver for GPUs developed by AMD that performs similar functionalities as device kernel driver 2109 discussed above in conjunction with FIG. 21. HSA kernel driver can be a driver permitting different types of processors to share system resources more effectively via hardware features.

Various libraries (not shown) may be included in ROCm software stack 2100 above language runtime 2103 and provide functionality similar to CUDA libraries 2103, discussed above in conjunction with FIG. 21. Various libraries may include mathematical, deep learning, and/or other libraries such as, but not limited to, a hipBLAS library that implements functions similar to those of CUDA cuBLAS, a rocFFT library for computing FFTs that is similar to CUDA cuFFT, among others.

Processors described elsewhere herein, such as, but not limited to, processors in FIGs. 8-20 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software, e.g., software stack 2100 to causing communication of a plurality of wireless devices with one or more base stations to be simulated based, at least in part, on grouping the plurality of wireless devices according to one or more shared communication frequency bands or otherwise perform any of the operations described above or elsewhere herein.

In accordance with at least one embodiment, software stack 2100 of FIG. 21 can be performed in a OpenCL implementation. An OpenCL software stack 2100, on which an application 2101 may be launched, can include an OpenCL framework 2103, an OpenCL runtime 2105, and a driver 2108. OpenCL software stack 2100 may execute on hardware 2109 that is not vendor-specific. As OpenCL is supported by devices developed by different vendors, specific OpenCL drivers may be required to interoperate with hardware from such vendors.

Application 2101, OpenCL runtime 2105, device kernel driver 2108, and hardware 2109 may perform similar functionalities as other implementations of application 2101, runtime 2105, device kernel driver 2108, and hardware 2109, respectively, that are discussed above in conjunction with FIG. 21. Application 2101 can further include an OpenCL kernel (not shown) with code that is to be executed on a device.

OpenCL may define a "platform" that allows a host to control devices connected to a host. An OpenCL framework can provide a platform layer API and a runtime API, shown as platform API 2102 and runtime API 2104. Runtime API 2104 can use contexts to manage execution of kernels on devices. Each identified device may be associated with a respective context, which runtime API 2104 may use to manage command queues, program objects, and kernel objects, share memory objects, among other things, for that device. Platform API 2102 can expose functions that permit device contexts to be used to select and initialize devices, submit work to devices via command queues, and enable data transfer to and from devices, among other things. In addition, OpenCL framework can provide various built-in functions (not shown), including math functions, relational functions, and image processing functions, among others.

A compiler (not shown) can also be included in OpenCL framework 2103. Source code may be compiled offline prior to executing an application or online during execution of an application. In contrast to CUDA and ROCm, OpenCL applications may be compiled online by a compiler that is representative of any number of compilers that may be used to compile source code and/or IR code, such as, but not limited to, Standard Portable Intermediate Representation ("SPIR-V") code, into binary code. Alternatively, OpenCL applications may be compiled offline, prior to execution of such applications.

In at least one embodiment, processors described elsewhere herein, such as, but not limited to, processors in FIGs. 8-20 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software, e.g., software stack 2100 to causing communication of a plurality of wireless devices with one or more base stations to be simulated based, at least in part, on grouping the plurality of wireless devices according to one or more shared communication frequency bands or otherwise perform any of the operations described above or elsewhere herein.

In accordance with at least one embodiment, software can be supported by a programming platform that is configured to support various programming models, middlewares and/or libraries, and frameworks that an application may rely upon. Application may be an AI/ML application implemented using, for example, a deep learning framework such as, but not limited to, MXNet, PyTorch, or TensorFlow, which may rely on libraries such as, but not limited to, cuDNN, NVIDIA Collective Communications Library ("NCCL"), and/or NVIDA Developer Data Loading Library ("DALI") CUDA libraries to provide accelerated computing on underlying hardware.

Programming platform may be one of a CUDA, ROCm, or OpenCL platform described above in conjunction with FIG. 21. Programming platform can support multiple programming models, which may be abstractions of an underlying computing system permitting expressions of algorithms and data structures. Programming models may expose features of underlying hardware in order to improve performance. Programming models may include CUDA, HIP, OpenCL, C++ Accelerated Massive Parallelism ("C++AMP"), Open Multi-Processing ("OpenMP"), Open Accelerators ("OpenACC"), and/or Vulkan Compute.

Libraries and/or middlewares may provide implementations of abstractions of programming models. Such libraries can include data and programming code that may be used by computer programs and leveraged during software development. Such middlewares can include software that provides services to applications beyond those available from programming platform. Libraries and/or middlewares may include cuBLAS, cuFFT, cuRAND, and other CUDA libraries, or rocBLAS, rocFFT, rocRAND, and other ROCm libraries. In addition, libraries and/or middlewares may include NCCL and ROCm Communication Collectives Library ("RCCL") libraries providing communication routines for GPUs, a MIOpen library for deep learning acceleration, and/or an Eigen library for linear algebra, matrix and vector operations, geometrical transformations, numerical solvers, and related algorithms.

Application frameworks may depend on libraries and/or middlewares. Each of application frameworks can be a software framework used to implement a standard structure of application software. Returning to the AI/ML example discussed above, an AI/ML application may be implemented using a framework such as, but not limited to, Caffe, Caffe2, TensorFlow, Keras, PyTorch, or MxNet deep learning frameworks, for example.

In at least one embodiment, processors described elsewhere herein, such as, but not limited to, processors in FIGs. 8-20 can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits can be configured by software, e.g., programming platforms described herein, to causing communication of a plurality of wireless devices with one or more base stations to be simulated based, at least in part, on grouping the plurality of wireless devices according to one or more shared communication frequency bands or otherwise perform any of the operations described above or elsewhere herein.

FIG. 22 illustrates compiling code to execute on one of programming platforms of FIGS. 21 described above, in accordance with at least one embodiment. A compiler 2201 is configured to receive source code 2200, compile source code 2200, and output an executable file 2210. Compiler 2201 can be configured to convert source code 2200 into host executable code 2207 for execution on a host and device executable code 2208 for execution on a device. Source code 2200 may either be compiled offline prior to execution of an application, or online during execution of an application. Source code 2200 may include code in any programming language supported by compiler 2201, such as, but not limited to, C++, C, Fortran, etc. Source code 2200 may be included in a single-source file having a mixture of host code and device code, with locations of device code being indicated therein. A single-source file may be a .cu file that includes CUDA code or a .hip.cpp file that includes HIP code or a file in another format that includes both host code and device code. Alternatively, source code 2200 may include multiple source code files, rather than a single-source file, into which host code and device code may be separated. Compiler 2201 includes or has access to one or more libraries to recognize a sequence of API calls to perform a single fused API, where a single fused API is a combined API for two or more APIs. In at least one embodiment, compiler 2201 may be an NVIDIA CUDA compiler ("NVCC") for compiling CUDA code in .cu files, or a HCC compiler for compiling HIP code in .hip.cpp files, or other compilers.

Compiler 2201 can be configured to compile source code 2200 into host executable code 2207 for execution on a host and device executable code 2208 for execution on a device. Compiler 2201 performs operations including parsing source code 2200 into an abstract system tree (AST), performing optimizations, and generating executable code. When source code 2200 includes a single-source file, compiler 2201 may separate device code from host code in such a single-source file, compile device code and host code into device executable code 2208 and host executable code 2207, respectively, and link device executable code 2208 and host executable code 2207 together in a single file.

Compiler 2201 can include a compiler front end 2202, a host compiler 2205, a device compiler 2206, and a linker 2209. Compiler front end 2202 can be configured to separate device code 2204 from host code 2203 in source code 2200. Device code 2204 may be compiled by device compiler 2206 into device executable code 2208, which as described may include binary code or IR code, in at least one embodiment. Separately, host code 2203 may be compiled by host compiler 2205 into host executable code 2207. For NVCC other compilers, such as, but not limited to, those for oneAPI, ROCm, and OpenCL, host compiler 2205 may be a general purpose C/C++ compiler that outputs native object code, while device compiler 2206 may be a Low Level Virtual Machine ("LLVM")-based compiler that forks a LLVM compiler infrastructure and outputs PTX code or binary code. For HCC, both host compiler 2205 and device compiler 2206 may be LLVM-based compilers that output target binary code.

Subsequent to compiling source code 2200 into host executable code 2207 and device executable code 2208, linker 2209 can link host and device executable code 2207 and 2208 together in executable file 2210. Native object code for a host and PTX or binary code for a device may be linked together in an Executable and Linkable Format ("ELF") file, which is a container format used to store object code. Host executable code 2207 and device executable code 2208 may be in any suitable format, such as, but not limited to, binary code and/or IR code. In the case of CUDA, host executable code 2207 may include native object code and device executable code 2208 may include code in PTX intermediate representation, in at least one embodiment. In the case of ROCm, both host executable code 2207 and device executable code 2208 may include target binary code, in at least one embodiment. Other implementations, such as, but not limited to, oneAPI, OpenCL are contemplated and can be performed similarly to the CUDA and ROCm implementations above.

Source code 2200 may be translated prior to compiling source code. Source code is passed through a translation tool (not shown), which translates source code 2200 into translated source code. A compiler 2201 can be used to compile translated source code into host executable code 2207 and device executable code 2208 in a process that is similar to compilation of source code 2200 by compiler 2201 into host executable code 2207 and device executable code 2208, as discussed above in conjunction with FIG. 22.

A translation performed by translation tool can be used to port source code 2200 for execution in a different environment than that in which it was originally intended to run. Translation tool may include a HIP translator that is used to "hipify" CUDA code intended for a CUDA platform into HIP code that can be compiled and executed on a ROCm platform. Translation of source code 2200 may include parsing source code 2200 and converting calls to API(s) provided by one programming model (e.g., CUDA) into corresponding calls to API(s) provided by another programming model (e.g., HIP), as discussed in greater detail below in conjunction with FIG. 23. Returning to the example of hipifying CUDA code, calls to CUDA runtime API, CUDA driver API, and/or CUDA libraries may be converted to corresponding HIP API calls. Automated translations performed by translation tool 2201 may sometimes be incomplete, requiring additional, manual effort to fully port source code 2200.

One or more techniques described herein may utilize other methods of converting one type of code to another type of code to enable interchangeability between different device architectures. In at least one embodiment, an application for one platform (e.g., a CUDA application) can be compiled into code for implementation on another platform (e.g., an AMD processor, Intel processor, or other processor). For example, source code 2200 can include source code for one platform (e.g., CUDA). Compiler 2201 can compile the source 2200 into an executable file 2210 that can be used by another platform (e.g., AMD or Intel). Programming toolkits can allow applications for one platform (e.g., CUDA) to be compiled (e.g., natively) for another platform (e.g., AMD or Intel). For example, a GPGPU programming toolkit can allow for CUDA applications to be natively compiled for AMD GPUs. Programs (e.g., CUDA programs) or its build system do not have to be modified or translated to another language before compiling to code for another platform. A compiler may accept the same command-line options and programming dialect (e.g., CUDA dialect) as another compiler (e.g., nvcc for CUDA), serving as a drop-in replacement to impersonate an installation of a toolkit (e.g., NVIDIA CUDA Toolkit), so existing build tools and scripts (e.g., like cmake) work without further modification. In at least one embodiment, an nvcc-compatible compiler can be used to compile nvcc-dialect CUDA for AMD GPUs, including PTX asm. Implementations of CUDA runtime and driver APIs for AMD GPUs can be used. Libraries (e.g., open source wrapper libraries) can provide APIs, such as "CUDA-X" APIs by delegating to the corresponding ROCm libraries. An example implementation includes SCALE from Spectral Compute in London, England. Instead of providing a new way to write GPGPU software, SCALE allows programs written using the widely-popular CUDA language to be directly compiled for AMD GPUs. Additional implementations can include a Clang compiler that provides a language front-end and tooling infrastructure for languages in the C language family (C, C++, Objective C/C++, OpenCL, CUDA, and RenderScript). In at least one embodiment, compilers described herein, such as, but not limited to compiler 2201, compiler 2205, and/or compiler 2206 can include one or more circuits to compile code (e.g., CUDA, HIP, OpenCL, OneAPI, or others) to causing communication of a plurality of wireless devices with one or more base stations to be simulated based, at least in part, on grouping the plurality of wireless devices according to one or more shared communication frequency bands and/or perform any of the operations described above or elsewhere herein.

FIG. 23 illustrates a system 2300 configured to compile and execute CUDA source code 2310 using different types of processing units, in accordance with at least one embodiment. System 2300 includes CUDA source code 2310, a CUDA compiler 2350, host executable code 2370(1), host executable code 2370(2), CUDA device executable code 2384, a CPU 2390, a CUDA-enabled GPU 2394, a GPU 2392, a CUDA to HIP translation tool 2320, HIP source code 2330, a HIP compiler driver 2340, an HCC 2360, and HCC device executable code 2382.

CUDA source code 2310 may be a collection of human-readable code in a CUDA programming language. A CUDA programming language can be an extension of the C++ programming language that includes mechanisms to define device code and distinguish between device code and host code. Device code can include source code that, after compilation, is executable in parallel on a device. A device may be a processor that is optimized for parallel instruction processing, such as, but not limited to, CUDA-enabled GPU 2390, GPU 2392, or another GPGPU, etc. Host code is source code that, after compilation, is executable on a host. A host is a processor that is optimized for sequential instruction processing, such as, but not limited to, CPU 2390.

CUDA source code 2310 can include any number (including zero) of global functions 2312, any number (including zero) of device functions 2314, any number (including zero) of host functions 2316, and any number (including zero) of host/device functions 2318. Global functions 2312, device functions 2314, host functions 2316, and host/device functions 2318 may be mixed in CUDA source code 2310. Each of global functions 2312 may be executable on a device and callable from a host. One or more of global functions 2312 may therefore act as entry points to a device. Each of global functions 2312 can be a kernel. In a technique known as dynamic parallelism, one or more of global functions 2312 can define a kernel that is executable on a device and callable from such a device. A kernel can be executed N (where N is any positive integer) times in parallel by N different threads on a device during execution.

Each of device functions 2314 can be executed on a device and callable from such a device only. Each of host functions 2316 can be executed on a host and callable from such a host only. Each of host/device functions 2316 may define both a host version of a function that is executable on a host and callable from such a host only and a device version of the function that is executable on a device and callable from such a device only.

CUDA source code 2310 may also include any number of calls to any number of functions that may be defined via a CUDA runtime API 2302. CUDA runtime API 2302 may include any number of functions that execute on a host to allocate and deallocate device memory, transfer data between host memory and device memory, manage systems with multiple devices, etc. CUDA source code 2310 may also include any number of calls to any number of functions that may be specified in any number of other CUDA APIs. A CUDA API may be any API that is designed for use by CUDA code. CUDA APIs can include CUDA runtime API 2302, a CUDA driver API, APIs for any number of CUDA libraries, etc, including any API(s) described elsewhere herein. Relative to CUDA runtime API 2302, a CUDA driver API can be a lower-level API but can provide finer-grained control of a device. Examples of CUDA libraries include cuBLAS, cuFFT, cuRAND, cuDNN, etc.

CUDA compiler 2350 may compile input CUDA code (e.g., CUDA source code 2310) to generate host executable code 2370(1) and CUDA device executable code 2384. CUDA compiler 2350 may be, but is not limited to, NVCC. Host executable code 2370(1) can be a compiled version of host code included in input source code that is executable on CPU 2390. CPU 2390 may be any processor that is optimized for sequential instruction processing.

CUDA device executable code 2384 may be a compiled version of device code included in input source code that is executable on CUDA-enabled GPU 2394. CUDA device executable code 2384 may include binary code. CUDA device executable code 2384 can include IR code, such as, but not limited to, PTX code, that is further compiled at runtime into binary code for a specific target device (e.g., CUDA-enabled GPU 2394) by a device driver. CUDA-enabled GPU 2394 may include any processor that is optimized for parallel instruction processing and that supports CUDA. CUDA-enabled GPU 2394 may be developed by NVIDIA Corporation of Santa Clara, CA.

CUDA to HIP translation tool 2320 can be configured to translate CUDA source code 2310 to functionally similar HIP source code 2330. HIP source code 2330 may include a collection of human-readable code in a HIP programming language. HIP code can include human-readable code in a HIP programming language. A HIP programming language can include an extension of the C++ programming language that includes functionally similar versions of CUDA mechanisms to define device code and distinguish between device code and host code. A HIP programming language may include a subset of functionality of a CUDA programming language. For example, a HIP programming language includes mechanism(s) to define global functions 2312, but such a HIP programming language may lack support for dynamic parallelism and therefore global functions 2312 defined in HIP code may be callable from a host only.

HIP source code 2330 may include any number (including zero) of global functions 2312, any number (including zero) of device functions 2314, any number (including zero) of host functions 2316, and any number (including zero) of host/device functions 2318. HIP source code 2330 may also include any number of calls to any number of functions that may be specified in a HIP runtime API 2332. HIP runtime API 2332 may include functionally similar versions of a subset of functions included in CUDA runtime API 2302. HIP source code 2330 may also include any number of calls to any number of functions that may be specified in any number of other HIP APIs. A HIP API may be any API that is designed for use by HIP code and/or ROCm. HIP APIs may include HIP runtime API 2332, a HIP driver API, APIs for any number of HIP libraries, APIs for any number of ROCm libraries, etc.

CUDA to HIP translation tool 2320 can convert each kernel call in CUDA code from a CUDA syntax to a HIP syntax and can convert any number of other CUDA calls in CUDA code to any number of other functionally similar HIP calls. A CUDA call can include a call to a function specified in a CUDA API, and a HIP call can include a call to a function specified in a HIP API. CUDA to HIP translation tool 2320 may convert any number of calls to functions specified in CUDA runtime API 2302 to any number of calls to functions specified in HIP runtime API 2332.

CUDA to HIP translation tool 2320 can include a tool known as hipify-perl that executes a text-based translation process. CUDA to HIP translation tool 2320 can include a tool known as hipify-clang that, relative to hipify-perl, executes a more complex and more robust translation process that involves parsing CUDA code using clang (a compiler front-end) and then translating resulting symbols. Converting CUDA code to HIP code may include modifications (e.g., manual edits) in addition to those performed by CUDA to HIP translation tool 2320.

HIP compiler driver 2340 can include a front end that determines a target device 2346 and then configures a compiler that is compatible with target device 2346 to compile HIP source code 2330. Target device 2346 can include a processor that is optimized for parallel instruction processing. HIP compiler driver 2340 may determine target device 2346 in any technically feasible fashion.

If target device 2346 is compatible with CUDA (e.g., CUDA-enabled GPU 2394), then HIP compiler driver 2340 can generate a HIP/NVCC compilation command 2342. HIP/NVCC compilation command 2342 can configure CUDA compiler 2350 to compile HIP source code 2330 using a HIP to CUDA translation header and a CUDA runtime library. In response to HIP/NVCC compilation command 2342, CUDA compiler 2350 may generate host executable code 2370(1) and CUDA device executable code 2384.

If target device 2346 is not compatible with CUDA, then HIP compiler driver 2340 may generate a HIP/HCC compilation command 2344. HIP/HCC compilation command 2344 can configure HCC 2360 to compile HIP source code 2330 using an HCC header and a HIP/HCC runtime library. In response to HIP/HCC compilation command 2344, HCC 2360 may generate host executable code 2370(2) and HCC device executable code 2382. HCC device executable code 2382 may be a compiled version of device code included in HIP source code 2330 that is executable on GPU 2392. GPU 2392 may be any processor that is optimized for parallel instruction processing, is not compatible with CUDA, and is compatible with HCC. GPU 2392 can be developed by AMD Corporation of Santa Clara, CA. GPU 2392 can include a non-CUDA-enabled GPU 2392.

For explanatory purposes only, three different flows that may be implemented in at least one embodiment to compile CUDA source code 2310 for execution on CPU 2390 and different devices are depicted in FIG. 23. A direct CUDA flow can compile CUDA source code 2310 for execution on CPU 2390 and CUDA-enabled GPU 2394 without translating CUDA source code 2310 to HIP source code 2330. An indirect CUDA flow can translate CUDA source code 2310 to HIP source code 2330 and then compiles HIP source code 2330 for execution on CPU 2390 and CUDA-enabled GPU 2394. A CUDA/HCC flow can translate CUDA source code 2310 to HIP source code 2330 and then can compile HIP source code 2330 for execution on CPU 2390 and GPU 2392.

A direct CUDA flow that may be implemented is depicted via dashed lines and a series of bubbles annotated A1-A3. As depicted with bubble annotated A1, CUDA compiler 2350 can receive CUDA source code 2310 and a CUDA compile command 2348 that can configure CUDA compiler 2350 to compile CUDA source code 2310. CUDA source code 2310 that can be used in a direct CUDA flow can be written in a CUDA programming language that is based on a programming language other than C++ (e.g., C, Fortran, Python, Java, etc.). In response to CUDA compile command 2348, CUDA compiler 2350 can generate host executable code 2370(1) and CUDA device executable code 2384 (depicted with bubble annotated A2). As depicted with bubble annotated A3, host executable code 2370(1) and CUDA device executable code 2384 may be executed on, respectively, CPU 2390 and CUDA-enabled GPU 2394. CUDA device executable code 2384 can include binary code. CUDA device executable code 2384 can include PTX code and can be further compiled into binary code for a specific target device at runtime.

An indirect CUDA flow that may be implemented is depicted via dotted lines and a series of bubbles annotated B1-B6. As depicted with bubble annotated B1, CUDA to HIP translation tool 2320 can receive CUDA source code 2310. As depicted with bubble annotated B2, CUDA to HIP translation tool 2320 can translate CUDA source code 2310 to HIP source code 2330. As depicted with bubble annotated B3, HIP compiler driver 2340 can receive HIP source code 2330 and can determine that target device 2346 is CUDA-enabled.

As depicted with bubble annotated B4, HIP compiler driver 2340 can generate HIP/NVCC compilation command 2342 and can transmit both HIP/NVCC compilation command 2342 and HIP source code 2330 to CUDA compiler 2350. HIP/NVCC compilation command 2342 can configure CUDA compiler 2350 to compile HIP source code 2330 using a HIP to CUDA translation header and a CUDA runtime library. HIP to CUDA translation header can translate any number of mechanisms (e.g., functions) specified in any number of HIP APIs to any number of mechanisms specified in any number of CUDA APIs. CUDA compiler 2350 may use HIP to CUDA translation header in conjunction with a CUDA runtime library corresponding to CUDA runtime API 2302 to generate host executable code 2370(1) and CUDA device executable code 2384. In response to HIP/NVCC compilation command 2342, CUDA compiler 2350 can generate host executable code 2370(1) and CUDA device executable code 2384 (depicted with bubble annotated B5). As depicted with bubble annotated B6, host executable code 2370(1) and CUDA device executable code 2384 may be executed on, respectively, CPU 2390 and CUDA-enabled GPU 2394. CUDA device executable code 2384 can include binary code. CUDA device executable code 2384 can include PTX code and can be further compiled into binary code for a specific target device at runtime.

A CUDA/HCC flow that may be implemented is depicted via solid lines and a series of bubbles annotated C1-C6. As depicted with bubble annotated C1, CUDA to HIP translation tool 2320 can receive CUDA source code 2310. As depicted with bubble annotated C2, CUDA to HIP translation tool 2320 can translate CUDA source code 2310 to HIP source code 2330. As depicted with bubble annotated C3, HIP compiler driver 2340 can receive HIP source code 2330 and can determine that target device 2346 is not CUDA-enabled.

HIP compiler driver 2340 may generate HIP/HCC compilation command 2344 and may transmit both HIP/HCC compilation command 2344 and HIP source code 2330 to HCC 2360 (depicted with bubble annotated C4). HIP/HCC compilation command 2344 can configure HCC 2360 to compile HIP source code 2330 using an HCC header and a HIP/HCC runtime library. HIP/HCC runtime library can correspond to HIP runtime API 2332. HCC header may include any number and type of interoperability mechanisms for HIP and HCC. In response to HIP/HCC compilation command 2344, HCC 2360 can generate host executable code 2370(2) and HCC device executable code 2382 (depicted with bubble annotated C5). As depicted with bubble annotated C6, host executable code 2370(2) and HCC device executable code 2382 may be executed on, respectively, CPU 2390 and GPU 2392.

After CUDA source code 2310 is translated to HIP source code 2330, HIP compiler driver 2340 may subsequently be used to generate executable code for either CUDA-enabled GPU 2394 or GPU 2392 without re-executing CUDA to HIP translation tool 2320. CUDA to HIP translation tool 2320 can translate CUDA source code 2310 to HIP source code 2330 that is then stored in memory. HIP compiler driver 2340 can then configure HCC 2360 to generate host executable code 2370(2) and HCC device executable code 2382 based on HIP source code 2330. In at least one embodiment, HIP compiler driver 2340 subsequently configures CUDA compiler 2350 to generate host executable code 2370(1) and CUDA device executable code 2384 based on stored HIP source code 2330.

An example kernel may be translated by CUDA-to-HIP translation tool 2320 of FIG. 23, in accordance with at least one embodiment. CUDA source code 2310 partitions an overall problem that a given kernel is designed to solve into relatively coarse sub-problems that can independently be solved using thread blocks. Each thread block includes any number of threads. Each sub-problem can be partitioned into relatively fine pieces that can be solved cooperatively in parallel by threads within a thread block. Threads within a thread block can cooperate by sharing data through shared memory and by synchronizing execution to coordinate memory accesses.

CUDA source code 2310 can organize thread blocks associated with a given kernel into a one-dimensional, a two-dimensional, or a three-dimensional grid of thread blocks. Each thread block includes any number of threads, and a grid includes any number of thread blocks.

A kernel can be a function in device code that is defined using a "_global_" declaration specifier. The dimension of a grid that executes a kernel for a given kernel call and associated streams may be specified using a CUDA kernel launch syntax. CUDA kernel launch syntax is specified as "KernelName<<<GridSize, BlockSize, SharedMemorySize, Stream>>>(KernelArguments);". An execution configuration syntax can include a "«<...»>" construct that is inserted between a kernel name ("KernelName") and a parenthesized list of kernel arguments ("KernelArguments"). CUDA kernel launch syntax can include a CUDA launch function syntax instead of an execution configuration syntax.

"GridSize" can be of a type dim3 and specify the dimension and size of a grid. Type dim3 may be a CUDA-defined structure that includes unsigned integers x, y, and z. If z is not specified, then z may default to one. If y is not specified, then y may default to one. The number of thread blocks in a grid can be equal to the product of GridSize.x, GridSize.y, and GridSize.z. "BlockSize" can be of type dim3 and specify the dimension and size of each thread block. The number of threads per thread block may be equal to the product of BlockSize.x, BlockSize.y, and BlockSize.z. Each thread that executes a kernel may be given a unique thread ID that is accessible within the kernel through a built-in variable (e.g., "threadIdx").

With respect to CUDA kernel launch syntax, "SharedMemorySize" may be an optional argument that may specify a number of bytes in a shared memory that is dynamically allocated per thread block for a given kernel call in addition to statically allocated memory. With respect to CUDA kernel launch syntax, SharedMemorySize may default to zero. With respect to CUDA kernel launch syntax, "Stream" may be an optional argument that specifies an associated stream and defaults to zero to specify a default stream. A stream may be a sequence of commands (possibly issued by different host threads) that execute in order. Different streams may execute commands out of order with respect to one another or concurrently.

CUDA source code 2310 may include a kernel definition for an example kernel "MatAdd" and a main function. Main function may be host code that executes on a host and includes a kernel call that causes kernel MatAdd to execute on a device. Kernel MatAdd can add two matrices A and B of size NxN, where N is a positive integer, and store the result in a matrix C. Main function can define a threadsPerBlock variable as 16 by 16 and a numBlocks variable as N/16 by N/16. Main function can then specify kernel call "MatAdd«<numBlocks, threadsPerBlock»>(A, B, C);". As per CUDA kernel launch syntax, kernel MatAdd can be executed using a grid of thread blocks having a dimension N/16 by N/16, where each thread block has a dimension of 16 by 16. Each thread block can include 256 threads, a grid can be created with enough blocks to have one thread per matrix element, and each thread in such a grid may execute kernel MatAdd to perform one pair-wise addition.

While translating CUDA source code 2310 to HIP source code 2330, CUDA to HIP translation tool 2320 may translate each kernel call in CUDA source code 2310 from CUDA kernel launch syntax to a HIP kernel launch syntax and may convert any number of other CUDA calls in source code 2310 to any number of other functionally similar HIP calls. HIP kernel launch syntax can be specified as "hipLaunchKernelGGL(KernelName,GridSize, BlockSize, SharedMemorySize, Stream, KernelArguments);". Each of KernelName, GridSize, BlockSize, ShareMemorySize, Stream, and KernelArguments can have the same meaning in HIP kernel launch syntax as in CUDA kernel launch syntax (described previously herein). Arguments SharedMemorySize and Stream can be required in HIP kernel launch syntax and can be optional in CUDA kernel launch syntax.

A portion of HIP source code 2330 can be identical to a portion of CUDA source code 2310 depicted except for a kernel call that causes kernel MatAdd to execute on a device. Kernel MatAdd may be defined in HIP source code 2330 with the same "_global_" declaration specifier with which kernel MatAdd is defined in CUDA source code 2310. A kernel call in HIP source code 2330 may be "hipLaunchKernelGGL(MatAdd, numBlocks, threadsPerBlock, 0, 0, A, B, C);", while a corresponding kernel call in CUDA source code 2310 is "MatAdd«<numBlocks, threadsPerBlock»>(A, B, C);".

Other implementations are contemplated and can be performed similarly to the CUDA and HIP implementations above, such as oneAPI, OpenCL, and other programming platforms. Code can be translated in any direction. For example, CUDA can be translated to HIP, and CUDA can be translated to OpenCL. SnuCL-Tr and CUCL can be used to translate OpenCL to CUDA or CUDA to OpenCL, respectively. Compiled code or intermediate representations (e.g., CUDA PTX code) can also be translated to run on other processor platforms (e.g., AMD or Intel). For example, PTX code can be translated to run on Intel or AMD processors using a translation tool, such as ZLUDA.

One or more techniques described herein can utilize a oneAPI programming model. A oneAPI programming model can refer to a programming model for interacting with various compute accelerator architectures. OneAPI may refer to an application programming interface (API) designed to interact with various compute accelerator architectures. A oneAPI programming model may utilize a DPC++ programming language. A DPC++ programming language may refer to a high-level language for data parallel programming productivity. A DPC++ programming language can be based at least in part on C and/or C++ programming languages. A oneAPI programming model can be a programming model such as, but not limited to, those developed by Intel Corporation of Santa Clara, CA.

OneAPI and/or oneAPI programming model can be utilized to interact with various accelerator, GPU, processor, and/or variations thereof, architectures. OneAPI may include a set of libraries that implement various functionalities. OneAPI may include at least a oneAPI DPC++ library, a oneAPI math kernel library, a oneAPI data analytics library, a oneAPI deep neural network library, a oneAPI collective communications library, a oneAPI threading building blocks library, a oneAPI video processing library, and/or variations thereof.

A oneAPI DPC++ library, also referred to as oneDPL, can be a library that implements algorithms and functions to accelerate DPC++ kernel programming. OneDPL may implement one or more standard template library (STL) functions. OneDPL can implement one or more parallel STL functions. OneDPL can provide a set of library classes and functions such as, but not limited to, parallel algorithms, iterators, function object classes, range-based API, and/or variations thereof. OneDPL can implement one or more classes and/or functions of a C++ standard library. OneDPL can implement one or more random number generator functions.

A oneAPI math kernel library, also referred to as oneMKL, can be a library that implements various optimized and parallelized routines for various mathematical functions and/or operations. OneMKL can implement one or more basic linear algebra subprograms (BLAS) and/or linear algebra package (LAPACK) dense linear algebra routines. OneMKL may implement one or more sparse BLAS linear algebra routines. OneMKI, can implement one or more random number generators (RNGs). OneMKL may implement one or more vector mathematics (VM) routines for mathematical operations on vectors. OneMKL may implement one or more Fast Fourier Transform (FFT) functions.

A oneAPI data analytics library, also referred to as oneDAL, can include a library that implements various data analysis applications and distributed computations. OneDAL can implement various algorithms for preprocessing, transformation, analysis, modeling, validation, and decision making for data analytics, in batch, online, and distributed processing modes of computation. OneDAL can implement various C++ and/or Java APIs and various connectors to one or more data sources. OneDAL may implement DPC++ API extensions to a traditional C++ interface and enables GPU usage for various algorithms.

A oneAPI deep neural network library, also referred to as oneDNN, can include a library that implements various deep learning functions. OneDNN may implement various neural network, machine learning, and deep learning functions, algorithms, and/or variations thereof.

A oneAPI collective communications library, also referred to as oneCCL, can include a library that implements various applications for deep learning and machine learning workloads. OneCCL can be built upon lower-level communication middleware, such as, but not limited to, message passing interface (MPI) and libfabrics. OneCCL can enable a set of deep learning specific optimizations, such as, but not limited to, prioritization, persistent operations, out of order executions, and/or variations thereof. OneCCL can implement various CPU and GPU functions.

A oneAPI threading building blocks library, also referred to as oneTBB, can include a library that implements various parallelized processes for various applications. OneTBB can be utilized for task-based, shared parallel programming on a host. OneTBB may implement generic parallel algorithms. OneTBB may implement concurrent containers. OneTBB may implement a scalable memory allocator. OneTBB may implement a work-stealing task scheduler. OneTBB may implement low-level synchronization primitives. OneTBB may be compiler-independent and usable on various processors, such as, but not limited to, GPUs, PPUs, CPUs, and/or variations thereof.

A oneAPI video processing library, also referred to as oneVPL, can include a library that is utilized for accelerating video processing in one or more applications. OneVPL can implement various video decoding, encoding, and processing functions. OneVPL can implement various functions for media pipelines on CPUs, GPUs, and other accelerators. OneVPL can implement device discovery and selection in media centric and video analytics workloads. OneVPL can implement API primitives for zero-copy buffer sharing.

A oneAPI programming model may utilize a DPC++ programming language. A DPC++ programming language can include a programming language that can include functionally similar versions of CUDA mechanisms to define device code and distinguish between device code and host code. A DPC++ programming language may include a subset of functionality of a CUDA programming language. One or more CUDA programming model operations may be performed using a oneAPI programming model using a DPC++ programming language.

Any application programming interface (API) described herein can be compiled into one or more instructions, operations, or any other signal by a compiler, interpreter, or other software tool. Compilation can include generating one or more machine-executable instructions, operations, or other signals from source code. An API compiled into one or more instructions, operations, or other signals, when performed, can cause one or more processors such as, but not limited to, processors described, e.g., in FIGs. 8-20, or any other logic circuit further described herein to perform one or more computing operations.

In at least one embodiment, translation tools described elsewhere herein, such as, but not limited to, can include one or more circuits to translate CUDA code to causing communication of a plurality of wireless devices with one or more base stations to be simulated based, at least in part, on grouping the plurality of wireless devices according to one or more shared communication frequency bands to HIP, oneAPI, OpenCL, or any other language used to perform any of the operations described above or elsewhere herein. One or more circuits can be configured by software to translate CUDA code to causing communication of a plurality of wireless devices with one or more base stations to be simulated based, at least in part, on grouping the plurality of wireless devices according to one or more shared communication frequency bands to HIP, oneAPI, OpenCL, or any other language used to perform any of the operations described above or elsewhere herein.

### AUTONOMOUS VEHICLE

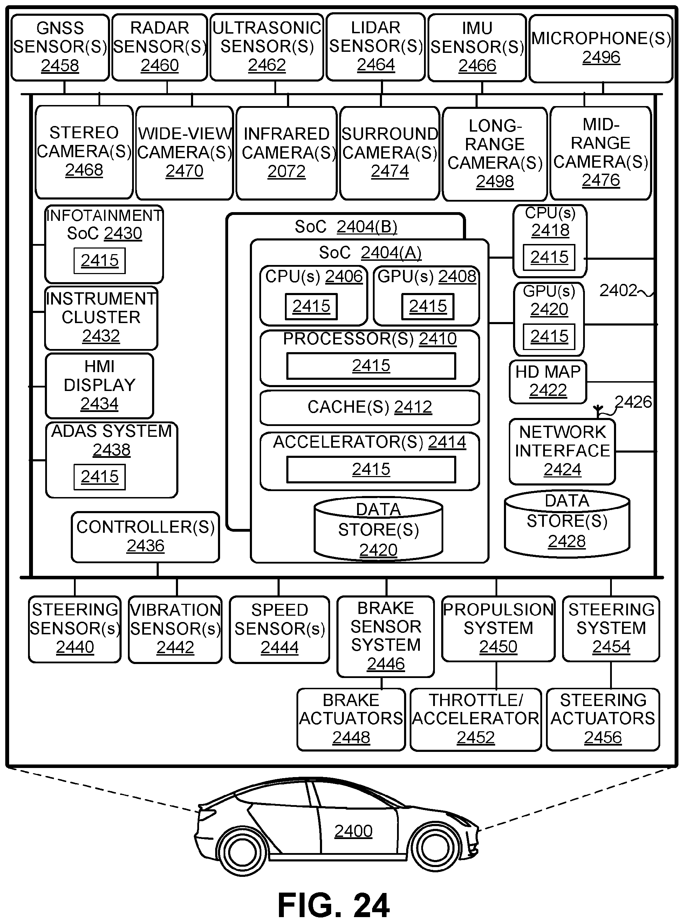

FIG. 24 illustrates an example of an autonomous vehicle 2400, in accordance with at least one embodiment. Autonomous vehicle 2400 (alternatively referred to herein as "vehicle 2400") may be a passenger vehicle, such as, but not limited to, a car, a truck, a bus, and/or another type of vehicle that accommodates one or more passengers. In at least one embodiment, vehicle 2400 may be a semi-tractor-trailer truck used for hauling cargo. Vehicle 2400 may be an airplane, robotic vehicle, or other kind of vehicle.

Autonomous vehicles may be described in terms of automation levels, defined by National Highway Traffic Safety Administration ("NHTSA"), a division of US Department of Transportation, and Society of Automotive Engineers ("SAE") "Taxonomy and Definitions for Terms Related to Driving Automation Systems for On-Road Motor Vehicles" (e.g., Standard No. J3016-201806, published on June 15, 2018, Standard No. J3016-201609, published on September 30, 2016, and previous and future versions of this standard). In at least one embodiment, vehicle 2400 may be capable of functionality in accordance with one or more of Level 1 through Level 5 of autonomous driving levels. For example, in at least one embodiment, vehicle 2400 may be capable of conditional automation (Level 3), high automation (Level 4), and/or full automation (Level 5), depending on embodiment.

Vehicle 2400 may include components such as, but not limited to, a chassis, a vehicle body, wheels (e.g., 2, 4, 6, 8, 18, etc.), tires, axles, and other components of a vehicle. Vehicle 2400 may include a propulsion system 2450, such as, but not limited to, an internal combustion engine, hybrid electric power plant, an all-electric engine, and/or another propulsion system type. Propulsion system 2450 may be connected to a drive train of vehicle 2400, which may include a transmission, to enable propulsion of vehicle 2400. Propulsion system 2450 may be controlled in response to receiving signals from a throttle/accelerator(s) 2452.

A steering system 2454, which may include a steering wheel, is used to steer vehicle 2400 (e.g., along a desired path or route) when propulsion system 2450 is operating (e.g., when vehicle 2400 is in motion). Steering system 2454 may receive signals from steering actuator(s) 2456. A steering wheel may be optional for full automation (Level 5) functionality. A brake sensor system 2446 may be used to operate vehicle brakes in response to receiving signals from brake actuator(s) 2448 and/or brake sensors.

Controller(s) 2436, which may include one or more system on chips ("SoCs") and/or graphics processing unit(s) ("GPU(s)"), can provide signals (e.g., representative of commands) to one or more components and/or systems of vehicle 2400. For instance, controller(s) 2436 may send signals to operate vehicle brakes via brake actuator(s) 2448, to operate steering system 2454 via steering actuator(s) 2456, to operate propulsion system 2450 via throttle/accelerator(s) 2452. Controller(s) 2436 may include one or more onboard (e.g., integrated) computing devices that process sensor signals, and output operation commands (e.g., signals representing commands) to enable autonomous driving and/or to assist a human driver in driving vehicle 2400. Controller(s) 2436 may include a first controller for autonomous driving functions, a second controller for functional safety functions, a third controller for artificial intelligence functionality (e.g., computer vision), a fourth controller for infotainment functionality, a fifth controller for redundancy in emergency conditions, and/or other controllers. A single controller may handle two or more of above functionalities, two or more controllers may handle a single functionality, and/or any combination thereof.

Controller(s) 2436 may provide signals for controlling one or more components and/or systems of vehicle 2400 in response to sensor data received from one or more sensors (e.g., sensor inputs). Sensor data may be received from, for example, global navigation satellite systems ("GNSS") sensor(s) 2458 (e.g., Global Positioning System sensor(s)), RADAR sensor(s) 2460, ultrasonic sensor(s) 2462, LIDAR sensor(s) 2464, inertial measurement unit ("IMU") sensor(s) 2466 (e.g., accelerometer(s), gyroscope(s), a magnetic compass or magnetic compasses, magnetometer(s), etc.), microphone(s) 2496, stereo camera(s) 2468, wide-view camera(s) 2470 (e.g., fisheye cameras), infrared camera(s) 2472, surround camera(s) 2474 (e.g., 360 degree cameras), long-range cameras 2498, mid-range camera(s) 2476, speed sensor(s) 2444 (e.g., for measuring speed of vehicle 2400), vibration sensor(s) 2442, steering sensor(s) 2440, brake sensor(s) (e.g., as part of brake sensor system 2446), and/or other sensor types.

One or more of controller(s) 2436 may receive inputs (e.g., represented by input data) from an instrument cluster 2432 of vehicle 2400 and provide outputs (e.g., represented by output data, display data, etc.) via a human-machine interface ("HMI") display 2434, an audible annunciator, a loudspeaker, and/or via other components of vehicle 2400. Outputs may include information such as, but not limited to, vehicle velocity, speed, time, map data (e.g., a High Definition map (not shown), location data (e.g., vehicle's 2400 location, such as, but not limited to, on a map), direction, location of other vehicles (e.g., an occupancy grid), information about objects and status of objects as perceived by controller(s) 2436, etc. For example, HMI display 2434 may display information about presence of one or more objects (e.g., a street sign, caution sign, traffic light changing, etc.), and/or information about driving maneuvers vehicle has made, is making, or will make (e.g., changing lanes now, taking exit 34B in two miles, etc.).

Each of components, features, and systems of vehicle 2400 in FIG. 24 may be connected via a bus 2402. Bus 2402 may include a CAN data interface (alternatively referred to herein as a "CAN bus"). A CAN may be a network inside vehicle 2400 used to aid in control of various features and functionality of vehicle 2400, such as, but not limited to, actuation of brakes, acceleration, braking, steering, windshield wipers, etc. Bus 2402 may be configured to have dozens or even hundreds of nodes, each with its own unique identifier (e.g., a CAN ID). Bus 2402 may be read to find steering wheel angle, ground speed, engine revolutions per minute ("RPMs"), button positions, and/or other vehicle status indicators. Bus 2402 may be a CAN bus that is ASIL B compliant.

In addition to, or alternatively from CAN, FlexRay and/or Ethernet protocols may be used. There may be any number of busses forming bus 2402, which may include zero or more CAN busses, zero or more FlexRay busses, zero or more Ethernet busses, and/or zero or more other types of busses using different protocols. Two or more busses may be used to perform different functions, and/or may be used for redundancy. For example, a first bus may be used for collision avoidance functionality and a second bus may be used for actuation control. Each bus of bus 2402 may communicate with any of components of vehicle 2400, and two or more busses of bus 2402 may communicate with corresponding components. Each of any number of system(s) on chip(s) ("SoC(s)") 2404 (such as, but not limited to, SoC 2404(A) and SoC 2404(B)), each of controller(s) 2436, and/or each computer within vehicle may have access to same input data (e.g., inputs from sensors of vehicle 2400), and may be connected to a common bus, such CAN bus.

Any number of cameras can be positioned at any choice of camera locations and fields of view for autonomous vehicle 2400 of FIG. 24A, in accordance with at least one embodiment. Cameras and respective fields of view may be one example embodiment and are not intended to be limiting. For instance, additional and/or alternative cameras may be included and/or cameras may be located at different locations on vehicle 2400.

Camera types for cameras may include digital cameras that may be adapted for use with components and/or systems of vehicle 2400. Camera(s) may operate at automotive safety integrity level ("ASIL") B and/or at another ASIL. Camera types may be capable of any image capture rate, such as, but not limited to, 60 frames per second (fps), 1220 fps, 240 fps, etc., depending on embodiment. Cameras may be capable of using rolling shutters, global shutters, another type of shutter, or a combination thereof. In at least one embodiment, color filter array may include a red clear clear clear ("RCCC") color filter array, a red clear clear blue ("RCCB") color filter array, a red blue green clear ("RBGC") color filter array, a Foveon X3 color filter array, a Bayer sensors ("RGGB") color filter array, a monochrome sensor color filter array, and/or another type of color filter array. Clear pixel cameras, such as, but not limited to, cameras with an RCCC, an RCCB, and/or an RBGC color filter array, may be used in an effort to increase light sensitivity.

One or more of camera(s) may be used to perform advanced driver assistance systems ("ADAS") functions (e.g., as part of a redundant or fail-safe design). For example, a Multi-Function Mono Camera may be installed to provide functions including lane departure warning, traffic sign assist and intelligent headlamp control. One or more of camera(s) (e.g., all cameras) may record and provide image data (e.g., video) simultaneously.

One or more cameras may be mounted in a mounting assembly, such as, but not limited to, a custom designed (three-dimensional ("3D") printed) assembly, in order to cut out stray light and reflections from within vehicle 2400 (e.g., reflections from dashboard reflected in windshield mirrors) which may interfere with camera image data capture abilities. With reference to wing-mirror mounting assemblies, wing-mirror assemblies may be custom 3D printed so that a camera mounting plate matches a shape of a wing-mirror. Camera(s) may be integrated into wing-mirrors. For side-view cameras, camera(s) may also be integrated within four pillars at each corner of a cabin.

Cameras with a field of view that include portions of an environment in front of vehicle 2400 (e.g., front-facing cameras) may be used for surround view, to help identify forward facing paths and obstacles, as well as aid in, with help of one or more of controller(s) 2436 and/or control SoCs, providing information critical to generating an occupancy grid and/or determining preferred vehicle paths. Front-facing cameras may be used to perform many similar ADAS functions as LIDAR, including emergency braking, pedestrian detection, and collision avoidance. Front-facing cameras may also be used for ADAS functions and systems including Lane Departure Warnings ("LDW"), Autonomous Cruise Control ("ACC"), and/or other functions such as, but not limited to, traffic sign recognition.

A variety of cameras may be used in a front-facing configuration, including, for example, a monocular camera platform that includes a CMOS ("complementary metal oxide semiconductor") color imager. A wide-view camera 2470 may be used to perceive objects coming into view from a periphery (e.g., pedestrians, crossing traffic or bicycles). There may be any number (including zero) wide-view cameras 2470 on vehicle 2400. Any number of long-range camera(s) 2498 (e.g., a long-view stereo camera pair) may be used for depth-based object detection, especially for objects for which a neural network has not yet been trained. Long-range camera(s) 2498 may also be used for object detection and classification, as well as basic object tracking.

Any number of stereo camera(s) 2468 may also be included in a front-facing configuration. One or more of stereo camera(s) 2468 may include an integrated control unit comprising a scalable processing unit, which may provide a programmable logic ("FPGA") and a multi-core microprocessor with an integrated Controller Area Network ("CAN") or Ethernet interface on a single chip. Such a unit may be used to generate a 3D map of an environment of vehicle 2400, including a distance estimate for all points in an image. One or more of stereo camera(s) 2468 may include compact stereo vision sensor(s) that may include two camera lenses (one each on left and right) and an image processing chip that may measure distance from vehicle 2400 to target object and use generated information (e.g., metadata) to activate autonomous emergency braking and lane departure warning functions. Other types of stereo camera(s) 2468 may be used in addition to, or alternatively from, those described herein.

Cameras with a field of view that include portions of environment to sides of vehicle 2400 (e.g., side-view cameras) may be used for surround view, providing information used to create and update an occupancy grid, as well as to generate side impact collision warnings. For example, surround camera(s) 2474 (e.g., four surround cameras) could be positioned on vehicle 2400. Surround camera(s) 2474 may include any number and combination of wide-view cameras, fisheye camera(s), 360 degree camera(s), and/or similar cameras. For instance, four fisheye cameras may be positioned on a front, a rear, and sides of vehicle 2400. Vehicle 2400 may use three surround camera(s) 2474 (e.g., left, right, and rear), and may leverage one or more other camera(s) (e.g., a forward-facing camera) as a fourth surround-view camera.

Cameras with a field of view that include portions of an environment behind vehicle 2400 (e.g., rear-view cameras) may be used for parking assistance, surround view, rear collision warnings, and creating and updating an occupancy grid. A wide variety of cameras may be used including, but not limited to, cameras that may be also suitable as a front-facing camera(s) (e.g., long-range cameras 2498 and/or mid-range camera(s) 2476, stereo camera(s) 2468, infrared camera(s) 2472, etc.,) as described herein.

Vehicle 2400 may include any number of SoCs 2404 or other processors described elsewhere herein, such as, but not limited to, processors and/or components illustrated and described for FIGs. 8-20. Each of SoCs 2404 may include central processing units ("CPU(s)") 2406, graphics processing units ("GPU(s)") 2408, processor(s) 2410, cache(s) 2412, accelerator(s) 2414, data store(s) 2416, and/or other components and features not illustrated. SoC(s) 2404 may be used to control vehicle 2400 in a variety of platforms and systems. For example, SoC(s) 2404 may be combined in a system (e.g., system of vehicle 2400) with a High Definition ("HD") map 2422 which may obtain map refreshes and/or updates via network interface 2424 from one or more servers (not shown). SoCs 2404 may include logic 2415 that can include any combination of software logic, hardware logic, and/or firmware logic to provide functionality or operations described herein, wherein logic may be, collectively or individually, embodied as circuitry that forms part of a larger system, for example, an integrated circuit (IC), system-on-chip (SoC), or one or processors (e.g., CPU, GPU).

CPU(s) 2406 may include a CPU cluster or CPU complex (alternatively referred to herein as a "CCPLEX"). CPU(s) 2406 may include multiple cores and/or level two ("L2") caches. For instance, CPU(s) 2406 may include eight cores in a coherent multi-processor configuration. CPU(s) 2406 may include four dual-core clusters where each cluster has a dedicated L2 cache (e.g., a 2 megabyte (MB) L2 cache). CPU(s) 2406 (e.g., CCPLEX) may be configured to support simultaneous cluster operations enabling any combination of clusters of CPU(s) 2406 to be active at any given time.

One or more of CPU(s) 2406 may implement power management capabilities that include one or more of following features: individual hardware blocks may be clock-gated automatically when idle to save dynamic power; each core clock may be gated when such core is not actively executing instructions due to execution of Wait for Interrupt ("WFI")/Wait for Event ("WFE") instructions; each core may be independently power-gated; each core cluster may be independently clock-gated when all cores may be clock-gated or power-gated; and/or each core cluster may be independently power-gated when all cores may be power-gated. CPU(s) 2406 may further implement an enhanced algorithm for managing power states, where allowed power states and expected wakeup times may be specified, and hardware/microcode determines which best power state to enter for core, cluster, and CCPLEX. Processing cores may support simplified power state entry sequences in software with work offloaded to microcode.

GPU(s) 2408 may include an integrated GPU (alternatively referred to herein as an "iGPU"). GPU(s) 2408 may be programmable and may be efficient for parallel workloads. GPU(s) 2408 may use an enhanced tensor instruction set. GPU(s) 2408 may include one or more streaming microprocessors, where each streaming microprocessor may include a level one ("L1") cache (e.g., an L1 cache with at least 96 KB storage capacity), and two or more streaming microprocessors may share an L2 cache (e.g., an L2 cache with a 512 KB storage capacity). GPU(s) 2408 may include at least eight streaming microprocessors. GPU(s) 2408 may use compute application programming interface(s) (API(s)). GPU(s) 2408 may use one or more parallel computing platforms and/or programming models (e.g., NVIDIA's CUDA model). Streaming microprocessors may be referred to as streaming multiprocessors ("SMs"), stream processors ("SPs"), stream processing units ("SPUs"), compute units ("CUs"), execution units ("EUs"), and/or slices, where a slice in this context can refer to a portion of processing resources in a processing unit (e.g., 16 cores, a ray tracing unit, a thread director or scheduler).

One or more of GPU(s) 2408 may be power-optimized for best performance in automotive and embedded use cases. For example, GPU(s) 2408 could be fabricated on Fin field-effect transistor ("FinFET") circuitry. Each streaming microprocessor may incorporate a number of mixed-precision processing cores partitioned into multiple blocks. For example, 64 PF32 cores and 32 FP64 cores could be partitioned into four processing blocks. Each processing block could be allocated 16 FP32 cores, 8 FP64 cores, 16 INT32 cores, two mixed-precision NVIDIA Tensor cores for deep learning matrix arithmetic, a level zero ("L0") instruction cache, a scheduler (e.g., warp scheduler) or sequencer, a dispatch unit, and/or a 64 KB register file. Streaming microprocessors may include independent parallel integer and floating-point data paths to provide for efficient execution of workloads with a mix of computation and addressing calculations. Streaming microprocessors may include independent thread scheduling capability to enable finer-grain synchronization and cooperation between parallel threads. Streaming microprocessors may include a combined L1 data cache and shared memory unit in order to improve performance while simplifying programming.

One or more of GPU(s) 2408 may include a high bandwidth memory ("HBM") and/or a 16 GB HBM2 memory subsystem to provide, in some examples, about 900 GB/second peak memory bandwidth. In addition to, or alternatively from, HBM memory, a synchronous graphics random-access memory ("SGRAM") may be used, such as, but not limited to, a graphics double data rate type five synchronous random-access memory ("GDDR5").

GPU(s) 2408 may include unified memory technology. Address translation services ("ATS") support may be used to allow GPU(s) 2408 to access CPU(s) 2406 page tables directly. When a GPU of GPU(s) 2408 memory management unit ("MMU") experiences a miss, an address translation request may be transmitted to CPU(s) 2406. In response, 2 CPU of CPU(s) 2406 may look in its page tables for a virtual-to-physical mapping for an address and transmit translation back to GPU(s) 2408. Unified memory technology may allow a single unified virtual address space for memory of both CPU(s) 2406 and GPU(s) 2408, thereby simplifying GPU(s) 2408 programming and porting of applications to GPU(s) 2408.

GPU(s) 2408 may include any number of access counters that may keep track of frequency of access of GPU(s) 2408 to memory of other processors. Access counter(s) may help ensure that memory pages may be moved to physical memory of a processor that is accessing pages most frequently, thereby improving efficiency for memory ranges shared between processors.

One or more of SoC(s) 2404 may include any number of cache(s) 2412, including those described herein. For example, cache(s) 2412 could include a level three ("L3") cache that is available to both CPU(s) 2406 and GPU(s) 2408 (e.g., that is connected to CPU(s) 2406 and GPU(s) 2408). Cache(s) 2412 may include a write-back cache that may keep track of states of lines, such as, but not limited to, by using a cache coherence protocol (e.g., MEI, MESI, MSI, etc.). A L3 cache may include 4 MB of memory or more, depending on embodiment, although smaller cache sizes may be used.

One or more of SoC(s) 2404 may include one or more accelerator(s) 2414 (e.g., hardware accelerators, software accelerators, or a combination thereof). SoC(s) 2404 may include a hardware acceleration cluster that may include optimized hardware accelerators and/or large on-chip memory. Large on-chip memory (e.g., 4 MB of SRAM), may enable a hardware acceleration cluster to accelerate neural networks and other calculations. A hardware acceleration cluster may be used to complement GPU(s) 2408 and to off-load some of tasks of GPU(s) 2408 (e.g., to free up more cycles of GPU(s) 2408 for performing other tasks). Accelerator(s) 2414 could be used for targeted workloads (e.g., perception, convolutional neural networks ("CNNs"), recurrent neural networks ("RNNs"), etc.) that may be stable enough to be amenable to acceleration. A CNN may include a region-based or regional convolutional neural networks ("RCNNs") and Fast RCNNs (e.g., as used for object detection) or other type of CNN.

Accelerator(s) 2414 (e.g., hardware acceleration cluster) may include one or more deep learning accelerator ("DLA"). DLA(s) may include one or more Tensor processing units ("TPUs") that may be configured to provide an additional ten trillion operations per second for deep learning applications and inferencing, such as TPU(s) described herein, e.g., in FIG. 18. TPUs may be accelerators configured to, and optimized for, performing image processing functions (e.g., for CNNs, RCNNs, etc.). DLA(s) may further be optimized for a specific set of neural network types and floating point operations, as well as inferencing. Design of DLA(s) may provide more performance per millimeter than a typical general-purpose GPU, and typically vastly exceeds performance of a CPU. TPU(s) may perform several functions, including a single-instance convolution function, supporting, for example, INT8, INT16, and FP16 data types for both features and weights, as well as post-processor functions. DLA(s) may quickly and efficiently execute neural networks, especially CNNs, on processed or unprocessed data for any of a variety of functions, including, for example: a CNN for object identification and detection using data from camera sensors; a CNN for distance estimation using data from camera sensors; a CNN for emergency vehicle detection and identification and detection using data from microphones; a CNN for facial recognition and vehicle owner identification using data from camera sensors; and/or a CNN for security and/or safety related events.

DLA(s) may perform any function of GPU(s) 2408, and by using an inference accelerator, for example, a designer may target either DLA(s) or GPU(s) 2408 for any function. For example, a designer may focus processing of CNNs and floating point operations on DLA(s) and leave other functions to GPU(s) 2408 and/or accelerator(s) 2414.

Accelerator(s) 2414 may include programmable vision accelerator ("PVA"), which may alternatively be referred to herein as a computer vision accelerator. PVA may be designed and configured to accelerate computer vision algorithms for advanced driver assistance system ("ADAS") 2438, autonomous driving, augmented reality ("AR") applications, and/or virtual reality ("VR") applications. PVA may provide a balance between performance and flexibility. For example, each PVA may include, for example, any number of reduced instruction set computer ("RISC") cores, direct memory access ("DMA"), and/or any number of vector processors.

RISC cores may interact with image sensors (e.g., image sensors of any cameras described herein), image signal processor(s), etc. Each RISC core may include any amount of memory. RISC cores may use any of a number of protocols, depending on embodiment. RISC cores may execute a real-time operating system ("RTOS"). RISC cores may be implemented using one or more integrated circuit devices, application specific integrated circuits ("ASICs"), and/or memory devices. For example, RISC cores could include an instruction cache and/or a tightly coupled RAM.

DMA may enable components of PVA to access system memory independently of CPU(s) 2406. DMA may support any number of features used to provide optimization to a PVA including supporting multi-dimensional addressing and/or circular addressing. DMA may support up to six or more dimensions of addressing, which may include block width, block height, block depth, horizontal block stepping, vertical block stepping, and/or depth stepping.

Vector processors may be programmable processors that may be designed to efficiently and flexibly execute programming for computer vision algorithms and provide signal processing capabilities. A PVA may include a PVA core and two vector processing subsystem partitions. A PVA core may include a processor subsystem, DMA engine(s) (e.g., two DMA engines), and/or other peripherals. A vector processing subsystem may operate as a primary processing engine of a PVA, and may include a vector processing unit ("VPU"), an instruction cache, and/or vector memory (e.g., "VMEM"). VPU core may include a digital signal processor such as, but not limited to, a single instruction, multiple data ("SIMD"), very long instruction word ("VLIW") digital signal processor. A combination of SIMD and VLIW may enhance throughput and speed.

Each of vector processors may include an instruction cache and may be coupled to dedicated memory. As a result, each of vector processors may be configured to execute independently of other vector processors. Vector processors that may be included in a particular PVA may be configured to employ data parallelism. For instance, plurality of vector processors included in a single PVA may execute a common computer vision algorithm, but on different regions of an image. Vector processors included in a particular PVA may simultaneously execute different computer vision algorithms, on one image, or even execute different algorithms on sequential images or portions of an image. Among other things, any number of PVAs may be included in hardware acceleration cluster and any number of vector processors may be included in each PVA. PVA may include additional error correcting code ("ECC") memory, to enhance overall system safety.

Accelerator(s) 2414 may include a computer vision network on-chip and static random-access memory ("SRAM"), for providing a high-bandwidth, low latency SRAM for accelerator(s) 2414. On-chip memory may include at least 4 MB SRAM, including, for example, eight field-configurable memory blocks, that may be accessible by both a PVA and a DLA. Each pair of memory blocks may include an advanced peripheral bus ("APB") interface, configuration circuitry, a controller, and a multiplexer. Any type of memory may be used. A PVA and a DLA may access memory via a backbone that provides a PVA and a DLA with high-speed access to memory. A backbone may include a computer vision network on-chip that interconnects a PVA and a DLA to memory (e.g., using APB).

A computer vision network on-chip may include an interface that determines, before transmission of any control signal/address/data, that both a PVA and a DLA provide ready and valid signals. An interface may provide for separate phases and separate channels for transmitting control signals/addresses/data, as well as burst-type communications for continuous data transfer. An interface may comply with International Organization for Standardization ("ISO") 26262 or International Electrotechnical Commission ("IEC") 61508 standards, although other standards and protocols may be used.

One or more of SoC(s) 2404 may include a real-time ray-tracing hardware accelerator. Real-time ray-tracing hardware accelerator may be used to quickly and efficiently determine positions and extents of objects (e.g., within a world model), to generate real-time visualization simulations, for RADAR signal interpretation, for sound propagation synthesis and/or analysis, for simulation of SONAR systems, for general wave propagation simulation, for comparison to LIDAR data for purposes of localization and/or other functions, and/or for other uses.

Accelerator(s) 2414 can have a wide array of uses for autonomous driving. A PVA may be used for key processing stages in ADAS and autonomous vehicles. A PVA's capabilities may be a good match for algorithmic domains needing predictable processing, at low power and low latency. In other words, a PVA can perform well on semi-dense or dense regular computation, even on small data sets, which might require predictable run-times with low latency and low power. In vehicle 2400, PVAs might be designed to run classic computer vision algorithms, as they can be efficient at object detection and operating on integer math. For example, a PVA is used to perform computer stereo vision. A semi-global matching-based algorithm may be used in some examples, although this is not intended to be limiting. Applications for Level 3-5 autonomous driving use motion estimation/stereo matching on-the-fly (e.g., structure from motion, pedestrian recognition, lane detection, etc.). A PVA may perform computer stereo vision functions on inputs from two monocular cameras. A PVA may be used to perform dense optical flow. For example, a PVA could process raw RADAR data (e.g., using a 4D Fast Fourier Transform) to provide processed RADAR data. A PVA is used for time of flight depth processing, by processing raw time of flight data to provide processed time of flight data, for example.

A DLA may be used to run any type of network to enhance control and driving safety, including, for example, a neural network that outputs a measure of confidence for each object detection. Confidence may be represented or interpreted as a probability, or as providing a relative "weight" of each detection compared to other detections. A confidence measure enables a system to make further decisions regarding which detections should be considered as true positive detections rather than false positive detections. A system may set a threshold value for confidence and consider only detections exceeding threshold value as true positive detections. When an automatic emergency braking ("AEB") system is used, false positive detections can cause vehicle to automatically perform emergency braking, which is obviously undesirable. Highly confident detections may be considered as triggers for AEB. a DLA may run a neural network for regressing confidence value. A neural network may take as its input at least some subset of parameters, such as, but not limited to, bounding box dimensions, ground plane estimate obtained (e.g., from another subsystem), output from IMU sensor(s) 2466 that correlates with vehicle 2400 orientation, distance, 3D location estimates of object obtained from neural network and/or other sensors (e.g., LIDAR sensor(s) 2464 or RADAR sensor(s) 2460), among others.

One or more of SoC(s) 2404 may include data store(s) 2416 (e.g., memory). Data store(s) 2416 may be on-chip memory of SoC(s) 2404, which may store neural networks to be executed on GPU(s) 2408 and/or a DLA. Data store(s) 2416 may be large enough in capacity to store multiple instances of neural networks for redundancy and safety. Data store(s) 2416 may comprise L2 or L3 cache(s).

One or more of SoC(s) 2404 may include any number of processor(s) 2410 (e.g., embedded processors). Processor(s) 2410 may include a boot and power management processor that may be a dedicated processor and subsystem to handle boot power and management functions and related security enforcement. A boot and power management processor may be a part of a boot sequence of SoC(s) 2404 and may provide runtime power management services. A boot power and management processor may provide clock and voltage programming, assistance in system low power state transitions, management of SoC(s) 2404 thermals and temperature sensors, and/or management of SoC(s) 2404 power states. Each temperature sensor may be implemented as a ring-oscillator whose output frequency is proportional to temperature, and SoC(s) 2404 may use ring-oscillators to detect temperatures of CPU(s) 2406, GPU(s) 2408, and/or accelerator(s) 2414. If temperatures may be determined to exceed a threshold, then a boot and power management processor may enter a temperature fault routine and put SoC(s) 2404 into a lower power state and/or put vehicle 2400 into a chauffeur to safe stop mode (e.g., bring vehicle 2400 to a safe stop).

Processor(s) 2410 may further include a set of embedded processors that may serve as an audio processing engine which may be an audio subsystem that enables full hardware support for multi-channel audio over multiple interfaces, and a broad and flexible range of audio I/O interfaces. An audio processing engine is a dedicated processor core with a digital signal processor with dedicated RAM.

Processor(s) 2410 may further include an always-on processor engine that may provide necessary hardware features to support low power sensor management and wake use cases. An always-on processor engine may include a processor core, a tightly coupled RAM, supporting peripherals (e.g., timers and interrupt controllers), various I/O controller peripherals, and routing logic.

Processor(s) 2410 may further include a safety cluster engine that may include a dedicated processor subsystem to handle safety management for automotive applications. A safety cluster engine may include two or more processor cores, a tightly coupled RAM, support peripherals (e.g., timers, an interrupt controller, etc.), and/or routing logic. In a safety mode, two or more cores may operate, in a lockstep mode and function as a single core with comparison logic to detect any differences between their operations. Processor(s) 2410 may further include a real-time camera engine that may include a dedicated processor subsystem for handling real-time camera management. Processor(s) 2410 may further include a high-dynamic range signal processor that may include an image signal processor that is a hardware engine that is part of a camera processing pipeline.

Processor(s) 2410 may include a video image compositor that may be a processing block (e.g., implemented on a microprocessor) that implements video post-processing functions needed by a video playback application to produce a final image for a player window. A video image compositor may perform lens distortion correction on wide-view camera(s) 2470, surround camera(s) 2474, and/or on in-cabin monitoring camera sensor(s). In-cabin monitoring camera sensor(s) may be preferably monitored by a neural network running on another instance of SoC 2404, configured to identify in cabin events and respond accordingly. An in-cabin system may perform lip reading to activate cellular service and place a phone call, dictate emails, change a vehicle's destination, activate or change a vehicle's infotainment system and settings, or provide voice-activated web surfing. Certain functions may be available to a driver when a vehicle is operating in an autonomous mode and may be disabled otherwise.

A video image compositor may include enhanced temporal noise reduction for both spatial and temporal noise reduction. For example, where motion occurs in a video, noise reduction weights spatial information appropriately, decreasing weights of information provided by adjacent frames. Where an image or portion of an image does not include motion, temporal noise reduction performed by video image compositor may use information from a previous image to reduce noise in a current image.

A video image compositor may also be configured to perform stereo rectification on input stereo lens frames. A video image compositor may further be used for user interface composition when an operating system desktop is in use, and GPU(s) 2408 may not be required to continuously render new surfaces. When GPU(s) 2408 are powered on and active doing 3D rendering, a video image compositor may be used to offload GPU(s) 2408 to improve performance and responsiveness.

One or more SoC of SoC(s) 2404 may further include a mobile industry processor interface ("MIPI") camera serial interface for receiving video and input from cameras, a high-speed interface, and/or a video input block that may be used for a camera and related pixel input functions. One or more of SoC(s) 2404 may further include an input/output controller(s) that may be controlled by software and may be used for receiving I/O signals that may be uncommitted to a specific role.

One or more SoC of SoC(s) 2404 may further include a broad range of peripheral interfaces to enable communication with peripherals, audio encoders/decoders ("codecs"), power management, and/or other devices. SoC(s) 2404 may be used to process data from cameras (e.g., connected over Gigabit Multimedia Serial Link and Ethernet channels), sensors (e.g., LIDAR sensor(s) 2464, RADAR sensor(s) 2460, etc. that may be connected over Ethernet channels), data from bus 2402 (e.g., speed of vehicle 2400, steering wheel position, etc.), data from GNSS sensor(s) 2458 (e.g., connected over a Ethernet bus or a CAN bus), etc. One or more SoC of SoC(s) 2404 may further include dedicated high-performance mass storage controllers that may include their own DMA engines, and that may be used to free CPU(s) 2406 from routine data management tasks.

SoC(s) 2404 may be an end-to-end platform with a flexible architecture that spans automation Levels 3-5, thereby providing a comprehensive functional safety architecture that leverages and makes efficient use of computer vision and ADAS techniques for diversity and redundancy, and provides a platform for a flexible, reliable driving software stack, along with deep learning tools. SoC(s) 2404 may be faster, more reliable, and even more energy-efficient and space-efficient than conventional systems. For example, accelerator(s) 2414, when combined with CPU(s) 2406, GPU(s) 2408, and data store(s) 2416, may provide for a fast, efficient platform for Level 3-5 autonomous vehicles.

Computer vision algorithms may be executed on CPUs, which may be configured using a high-level programming language, such as, but not limited to, C, to execute a wide variety of processing algorithms across a wide variety of visual data. However, CPUs may be oftentimes unable to meet performance requirements of many computer vision applications, such as, but not limited to, those related to execution time and power consumption, for example. Many CPUs may be unable to execute complex object detection algorithms in real-time, which is used in in-vehicle ADAS applications and in practical Level 3-5 autonomous vehicles.

Embodiments described herein allow for multiple neural networks to be performed simultaneously and/or sequentially, and for results to be combined together to enable Level 3-5 autonomous driving functionality. For example, a CNN executing on a DLA or a discrete GPU (e.g., GPU(s) 2420) may include text and word recognition, allowing reading and understanding of traffic signs, including signs for which a neural network has not been specifically trained. A DLA may further include a neural network that is able to identify, interpret, and provide semantic understanding of a sign, and to pass that semantic understanding to path planning modules running on a CPU Complex.

Multiple neural networks may be run simultaneously, as for Level 3, 4, or 5 driving. For example, a warning sign stating "Caution: flashing lights indicate icy conditions," along with an electric light, may be independently or collectively interpreted by several neural networks. Such warning sign itself may be identified as a traffic sign by a first deployed neural network (e.g., a neural network that has been trained), text "flashing lights indicate icy conditions" may be interpreted by a second deployed neural network, which informs a vehicle's path planning software (preferably executing on a CPU Complex) that when flashing lights may be detected, icy conditions exist. A flashing light may be identified by operating a third deployed neural network over multiple frames, informing a vehicle's path-planning software of a presence (or an absence) of flashing lights. All three neural networks may run simultaneously, such as, but not limited to, within a DLA and/or on GPU(s) 2408.

A CNN for facial recognition and vehicle owner identification may use data from camera sensors to identify presence of an authorized driver and/or owner of vehicle 2400. An always-on sensor processing engine may be used to unlock a vehicle when an owner approaches a driver door and turns on lights, and, in a security mode, to disable such vehicle when an owner leaves such vehicle. In this way, SoC(s) 2404 can provide for security against theft and/or carjacking.

A CNN for emergency vehicle detection and identification may use data from microphones 2496 to detect and identify emergency vehicle sirens. SoC(s) 2404 use a CNN for classifying environmental and urban sounds, as well as classifying visual data. A CNN running on a DLA is trained to identify a relative closing speed of an emergency vehicle (e.g., by using a Doppler effect). A CNN may also be trained to identify emergency vehicles specific to a local area in which a vehicle is operating, as identified by GNSS sensor(s) 2458. When operating in Europe, a CNN may seek to detect European sirens, and when in North America, a CNN may seek to identify only North American sirens. Once an emergency vehicle is detected, a control program may be used to execute an emergency vehicle safety routine, slowing a vehicle, pulling over to a side of a road, parking a vehicle, and/or idling a vehicle, with assistance of ultrasonic sensor(s) 2462, until emergency vehicles pass.

Vehicle 2400 may include CPU(s) 2418 (e.g., discrete CPU(s), or dCPU(s)), that may be coupled to SoC(s) 2404 via a high-speed interconnect (e.g., PCIe). CPU(s) 2418 may include an X86 processor, for example. CPU(s) 2418 may be used to perform any of a variety of functions, including arbitrating potentially inconsistent results between ADAS sensors and SoC(s) 2404, and/or monitoring status and health of controller(s) 2436 and/or an infotainment system on a chip ("infotainment SoC") 2430, for example. SoC(s) 2404 may include one or more interconnects, and an interconnect can include a peripheral component interconnect express (PCIe).

Vehicle 2400 may include GPU(s) 2420 (e.g., discrete GPU(s), or dGPU(s)), that may be coupled to SoC(s) 2404 via a high-speed interconnect (e.g., NVIDIA's NVLINK channel). GPU(s) 2420 may provide additional artificial intelligence functionality, such as, but not limited to, by executing redundant and/or different neural networks, and may be used to train and/or update neural networks based at least in part on input (e.g., sensor data) from sensors of a vehicle 2400.

Vehicle 2400 may further include network interface 2424 which may include wireless antenna(s) (e.g., one or more wireless antennas 2426 for different communication protocols, such as, but not limited to, a cellular antenna, a Bluetooth antenna, etc.). Network interface 2424 may be used to enable wireless connectivity to Internet cloud services (e.g., with server(s) and/or other network devices), with other vehicles, and/or with computing devices (e.g., client devices of passengers). To communicate with other vehicles, a direct link may be established between vehicle 2400 and another vehicle and/or an indirect link may be established (e.g., across networks and over the Internet). Direct links may be provided using a vehicle-to-vehicle communication link. A vehicle-to-vehicle communication link may provide vehicle 2400 information about vehicles in proximity to vehicle 2400 (e.g., vehicles in front of, on a side of, and/or behind vehicle 2400). Such aforementioned functionality may be part of a cooperative adaptive cruise control functionality of vehicle 2400.

Network interface 2424 may include an SoC that provides modulation and demodulation functionality and enables controller(s) 2436 to communicate over wireless networks. Network interface 2424 may include a radio frequency front-end for up-conversion from baseband to radio frequency, and down conversion from radio frequency to baseband. Frequency conversions may be performed in any technically feasible fashion. For example, frequency conversions could be performed through well-known processes, and/or using super-heterodyne processes. Radio frequency front end functionality may be provided by a separate chip. Network interfaces may include wireless functionality for communicating over LTE, WCDMA, UMTS, GSM, CDMA2000, Bluetooth, Bluetooth LE, Wi-Fi, Z-Wave, ZigBee, LoRaWAN, and/or other wireless protocols.

Vehicle 2400 may further include data store(s) 2428 which may include off-chip (e.g., off SoC(s) 2404) storage. Data store(s) 2428 may include one or more storage elements including RAM, SRAM, dynamic random-access memory ("DRAM"), video random-access memory ("VRAM"), flash memory, hard disks, and/or other components and/or devices that may store at least one bit of data.

Vehicle 2400 may further include GNSS sensor(s) 2458 (e.g., GPS and/or assisted GPS sensors), to assist in mapping, perception, occupancy grid generation, and/or path planning functions. Any number of GNSS sensor(s) 2458 may be used, including, for example, a GPS using a USB connector with an Ethernet-to-Serial (e.g., RS-232) bridge.

Vehicle 2400 may further include RADAR sensor(s) 2460. RADAR sensor(s) 2460 may be used by vehicle 2400 for long-range vehicle detection, even in darkness and/or severe weather conditions. RADAR functional safety levels may be ASIL B. RADAR sensor(s) 2460 may use a CAN bus and/or bus 2402 (e.g., to transmit data generated by RADAR sensor(s) 2460) for control and to access object tracking data, with access to Ethernet channels to access raw data in some examples. A wide variety of RADAR sensor types may be used. For example, RADAR sensor(s) 2460 may be suitable for front, rear, and side RADAR use. One or more sensor of RADAR sensors(s) 2460 is a Pulse Doppler RADAR sensor.

RADAR sensor(s) 2460 may include different configurations, such as, but not limited to, long-range with narrow field of view, short-range with wide field of view, short-range side coverage, etc. Long-range RADAR may be used for adaptive cruise control functionality. Long-range RADAR systems may provide a broad field of view realized by two or more independent scans, such as, but not limited to, within a 250 m (meter) range. RADAR sensor(s) 2460 may help in distinguishing between static and moving objects, and may be used by ADAS system 2438 for emergency brake assist and forward collision warning. Sensors 2460(s) included in a long-range RADAR system may include monostatic multimodal RADAR with multiple (e.g., six or more) fixed RADAR antennae and a high-speed CAN and FlexRay interface. With six antennae, a central four antennae may create a focused beam pattern, designed to record vehicle's 2400 surroundings at higher speeds with minimal interference from traffic in adjacent lanes. Another two antennae may expand field of view, making it possible to quickly detect vehicles entering or leaving a lane of vehicle 2400.

Mid-range RADAR systems may include, as an example, a range of up to 160 m (front) or 80 m (rear), and a field of view of up to 42 degrees (front) or 150 degrees (rear). Short-range RADAR systems may include any number of RADAR sensor(s) 2460 designed to be installed at both ends of a rear bumper. When installed at both ends of a rear bumper, a RADAR sensor system may create two beams that constantly monitor blind spots in a rear direction and next to a vehicle. Short-range RADAR systems may be used in ADAS system 2438 for blind spot detection and/or lane change assist.

Vehicle 2400 may further include ultrasonic sensor(s) 2462. Ultrasonic sensor(s) 2462, which may be positioned at a front, a back, and/or side location of vehicle 2400, may be used for parking assist and/or to create and update an occupancy grid. A wide variety of ultrasonic sensor(s) 2462 may be used, and different ultrasonic sensor(s) 2462 may be used for different ranges of detection (e.g., 2.5 m, 4 m). Ultrasonic sensor(s) 2462 may operate at functional safety levels of ASIL B.

Vehicle 2400 may include LIDAR sensor(s) 2464. LIDAR sensor(s) 2464 may be used for object and pedestrian detection, emergency braking, collision avoidance, and/or other functions. LIDAR sensor(s) 2464 may operate at functional safety level ASIL B. Vehicle 2400 may include multiple LIDAR sensors 2464 (e.g., two, four, six, etc.) that may use an Ethernet channel (e.g., to provide data to a Gigabit Ethernet switch).

LIDAR sensor(s) 2464 may be capable of providing a list of objects and their distances for a 360-degree field of view. Commercially available LIDAR sensor(s) 2464 may have an advertised range of approximately 100 m, with an accuracy of 2 cm to 3 cm, and with support for a 100 Mbps Ethernet connection, for example. One or more non-protruding LIDAR sensors may be used. LIDAR sensor(s) 2464 may include a small device that may be embedded into a front, a rear, a side, and/or a corner location of vehicle 2400. LIDAR sensor(s) 2464, in such an embodiment, may provide up to a 120-degree horizontal and 35-degree vertical field-of-view, with a 200 m range even for low-reflectivity objects. Front-mounted LIDAR sensor(s) 2464 may be configured for a horizontal field of view between 45 degrees and 135 degrees.

LIDAR technologies, such as, but not limited to, 3D flash LIDAR, may also be used. 3D flash LIDAR uses a flash of a laser as a transmission source, to illuminate surroundings of vehicle 2400 up to approximately 200 m. A flash LIDAR unit may include a receptor, which records laser pulse transit time and reflected light on each pixel, which in turn corresponds to a range from vehicle 2400 to objects. Flash LIDAR may allow for highly accurate and distortion-free images of surroundings to be generated with every laser flash. Four flash LIDAR sensors may be deployed, one at each side of vehicle 2400. 3D flash LIDAR systems include a solid-state 3D staring array LIDAR camera with no moving parts other than a fan (e.g., a non-scanning LIDAR device). Flash LIDAR device may use a 5 nanosecond class I (eye-safe) laser pulse per frame and may capture reflected laser light as a 3D range point cloud and co-registered intensity data.

Vehicle 2400 may further include IMU sensor(s) 2466. IMU sensor(s) 2466 may be located at a center of a rear axle of vehicle 2400. IMU sensor(s) 2466 may include, for example, accelerometer(s), magnetometer(s), gyroscope(s), a magnetic compass, magnetic compasses, and/or other sensor types. In six-axis applications, but not limited to, IMU sensor(s) 2466 may include accelerometers and gyroscopes. In nine-axis applications, but not limited to, IMU sensor(s) 2466 may include accelerometers, gyroscopes, and magnetometers.

IMU sensor(s) 2466 may be implemented as a miniature, high performance GPS-Aided Inertial Navigation System ("GPS/INS") that combines micro-electro-mechanical systems ("MEMS") inertial sensors, a high-sensitivity GPS receiver, and advanced Kalman filtering algorithms to provide estimates of position, velocity, and attitude. IMU sensor(s) 2466 may enable vehicle 2400 to estimate its heading without requiring input from a magnetic sensor by directly observing and correlating changes in velocity from a GPS to IMU sensor(s) 2466. IMU sensor(s) 2466 and GNSS sensor(s) 2458 may be combined in a single integrated unit.

Vehicle 2400 may include microphone(s) 2496 placed in and/or around vehicle 2400. Microphone(s) 2496 may be used for emergency vehicle detection and identification, among other things.

Vehicle 2400 may further include any number of camera types, including stereo camera(s) 2468, wide-view camera(s) 2470, infrared camera(s) 2472, surround camera(s) 2474, long-range camera(s) 2498, mid-range camera(s) 2476, and/or other camera types. Cameras may be used to capture image data around an entire periphery of vehicle 2400. Types of cameras used may depend on vehicle 2400. Any combination of camera types may be used to provide necessary coverage around vehicle 2400. A number of cameras deployed may differ depending on embodiment. For example, vehicle 2400 could include six cameras, seven cameras, ten cameras, twelve cameras, or another number of cameras. Cameras may support, as an example, Gigabit Multimedia Serial Link ("GMSL") and/or Gigabit Ethernet communications. Each camera might be as described with more detail previously herein.

Vehicle 2400 may further include vibration sensor(s) 2442. Vibration sensor(s) 2442 may measure vibrations of components of vehicle 2400, such as, but not limited to, axle(s). For example, changes in vibrations may indicate a change in road surfaces. When two or more vibration sensors 2442 may be used, differences between vibrations may be used to determine friction or slippage of road surface (e.g., when a difference in vibration is between a power-driven axle and a freely rotating axle).

Vehicle 2400 may include ADAS system 2438. ADAS system 2438 may include an SoC, in some examples. ADAS system 2438 may include any number and combination of an autonomous/adaptive/automatic cruise control ("ACC") system, a cooperative adaptive cruise control ("CACC") system, a forward crash warning ("FCW") system, an automatic emergency braking ("AEB") system, a lane departure warning ("LDW") system, a lane keep assist ("LKA") system, a blind spot warning ("BSW") system, a rear cross-traffic warning ("RCTW") system, a collision warning ("CW") system, a lane centering ("LC") system, and/or other systems, features, and/or functionality.

ACC system may use RADAR sensor(s) 2460, LIDAR sensor(s) 2464, and/or any number of camera(s). ACC system may include a longitudinal ACC system and/or a lateral ACC system. A longitudinal ACC system monitors and controls distance to another vehicle immediately ahead of vehicle 2400 and automatically adjusts speed of vehicle 2400 to maintain a safe distance from vehicles ahead. A lateral ACC system performs distance keeping, and advises vehicle 2400 to change lanes when necessary. A lateral ACC is related to other ADAS applications, such as, but not limited to, LC and CW.

A CACC system uses information from other vehicles that may be received via network interface 2424 and/or wireless antenna(s) 2426 from other vehicles via a wireless link, or indirectly, over a network connection (e.g., over the Internet). Direct links may be provided by a vehicle-to-vehicle ("V2V") communication link, while indirect links may be provided by an infrastructure-to-vehicle ("I2V") communication link. In general, V2V communication provides information about immediately preceding vehicles (e.g., vehicles immediately ahead of and in same lane as vehicle 2400), while I2V communication provides information about traffic further ahead. A CACC system may include either or both I2V and V2V information sources. Given information of vehicles ahead of vehicle 2400, a CACC system may be more reliable and it has potential to improve traffic flow smoothness and reduce congestion on road.

An FCW system is designed to alert a driver to a hazard, so that such driver may take corrective action. An FCW system uses a front-facing camera and/or RADAR sensor(s) 2460, coupled to a dedicated processor, DSP, FPGA, and/or ASIC, that is electrically coupled to provide driver feedback, such as, but not limited to, a display, speaker, and/or vibrating component. An FCW system may provide a warning, such as, but not limited to, in form of a sound, visual warning, vibration and/or a quick brake pulse.

An AEB system detects an impending forward collision with another vehicle or other object, and may automatically apply brakes if a driver does not take corrective action within a specified time or distance parameter. AEB system may use front-facing camera(s) and/or RADAR sensor(s) 2460, coupled to a dedicated processor, DSP, FPGA, and/or ASIC. When an AEB system detects a hazard, it will typically first alert a driver to take corrective action to avoid collision and, if that driver does not take corrective action, that AEB system may automatically apply brakes in an effort to prevent, or at least mitigate, an impact of a predicted collision. An AEB system may include techniques such as, but not limited to, dynamic brake support and/or crash imminent braking.

An LDW system provides visual, audible, and/or tactile warnings, such as, but not limited to, steering wheel or seat vibrations, to alert driver when vehicle 2400 crosses lane markings. An LDW system does not activate when a driver indicates an intentional lane departure, such as, but not limited to, by activating a turn signal. An LDW system may use front-side facing cameras, coupled to a dedicated processor, DSP, FPGA, and/or ASIC, that is electrically coupled to provide driver feedback, such as, but not limited to, a display, speaker, and/or vibrating component. An LKA system is a variation of an LDW system. An LKA system provides steering input or braking to correct vehicle 2400 if vehicle 2400 starts to exit its lane.

A BSW system detects and warns a driver of vehicles in an automobile's blind spot. A BSW system may provide a visual, audible, and/or tactile alert to indicate that merging or changing lanes is unsafe. A BSW system may provide an additional warning when a driver uses a turn signal. A BSW system may use rear-side facing camera(s) and/or RADAR sensor(s) 2460, coupled to a dedicated processor, DSP, FPGA, and/or ASIC, that is electrically coupled to driver feedback, such as, but not limited to, a display, speaker, and/or vibrating component.

An RCTW system may provide visual, audible, and/or tactile notification when an object is detected outside a rear-camera range when vehicle 2400 is backing up. An RCTW system includes an AEB system to ensure that vehicle brakes may be applied to avoid a crash. An RCTW system may use one or more rear-facing RADAR sensor(s) 2460, coupled to a dedicated processor, DSP, FPGA, and/or ASIC, that is electrically coupled to provide driver feedback, such as, but not limited to, a display, speaker, and/or vibrating component.

Conventional ADAS systems may be prone to false positive results which may be annoying and distracting to a driver, but typically may not be catastrophic, because conventional ADAS systems alert a driver and allow that driver to decide whether a safety condition truly exists and act accordingly. Vehicle 2400 itself decides, in case of conflicting results, whether to heed result from a primary computer or a secondary computer (e.g., a first controller or a second controller of controllers 2436). For example, ADAS system 2438 may be a backup and/or secondary computer for providing perception information to a backup computer rationality module. A backup computer rationality monitor may run redundant diverse software on hardware components to detect faults in perception and dynamic driving tasks. Outputs from ADAS system 2438 may be provided to a supervisory MCU. If outputs from a primary computer and outputs from a secondary computer conflict, a supervisory MCU can determine how to reconcile conflict to ensure safe operation.

A primary computer may be configured to provide a supervisory MCU with a confidence score, indicating that primary computer's confidence in a chosen result. If that confidence score exceeds a threshold, that supervisory MCU may follow that primary computer's direction, regardless of whether that secondary computer provides a conflicting or inconsistent result. Where a confidence score does not meet a threshold, and where primary and secondary computers indicate different results (e.g., a conflict), a supervisory MCU may arbitrate between computers to determine an appropriate outcome.

A supervisory MCU may be configured to run a neural network(s) that is trained and configured to determine, based at least in part on outputs from a primary computer and outputs from a secondary computer, conditions under which that secondary computer provides false alarms. Neural network(s) in a supervisory MCU may learn when a secondary computer's output may be trusted, and when it cannot. For example, when that secondary computer is a RADAR-based FCW system, a neural network(s) in that supervisory MCU may learn when an FCW system is identifying metallic objects that may not be, in fact, hazards, such as, but not limited to, a drainage grate or manhole cover that triggers an alarm. When a secondary computer is a camera-based LDW system, a neural network in a supervisory MCU may learn to override LDW when bicyclists or pedestrians may be present and a lane departure is, in fact, a safest maneuver. A supervisory MCU may include at least one of a DLA or a GPU suitable for running neural network(s) with associated memory. A supervisory MCU may comprise and/or be included as a component of SoC(s) 2404.

ADAS system 2438 may include a secondary computer that performs ADAS functionality using traditional rules of computer vision, and that secondary computer may use classic computer vision rules (if-then), and presence of a neural network(s) in a supervisory MCU may improve reliability, safety and performance. For example, diverse implementation and intentional non-identity makes an overall system more fault-tolerant, especially to faults caused by software (or software-hardware interface) functionality. For example, if there is a software bug or error in software running on a primary computer, and non-identical software code running on a secondary computer provides a consistent overall result, then a supervisory MCU may have greater confidence that an overall result is correct, and a bug in software or hardware on that primary computer is not causing a material error.

An output of ADAS system 2438 may be fed into a primary computer's perception block and/or a primary computer's dynamic driving task block. For example, if ADAS system 2438 indicates a forward crash warning due to an object immediately ahead, a perception block may use this information when identifying objects. A secondary computer may have its own neural network that is trained and thus reduces a risk of false positives, as described herein.

Vehicle 2400 may further include infotainment SoC 2430 (e.g., an in-vehicle infotainment system (IVI)). Although illustrated and described as an SoC, infotainment system SoC 2430, may not be an SoC, and may include two or more discrete components. Infotainment SoC 2430 may include a combination of hardware and software that may be used to provide audio (e.g., music, a personal digital assistant, navigational instructions, news, radio, etc.), video (e.g., TV, movies, streaming, etc.), phone (e.g., hands-free calling), network connectivity (e.g., LTE, WiFi, etc.), and/or information services (e.g., navigation systems, rear-parking assistance, a radio data system, vehicle related information such as, but not limited to, fuel level, total distance covered, brake fuel level, oil level, door open/close, air filter information, etc.) to vehicle 2400. For example, infotainment SoC 2430 could include radios, disk players, navigation systems, video players, USB and Bluetooth connectivity, carputers, in-car entertainment, WiFi, steering wheel audio controls, hands free voice control, a heads-up display ("HUD"), HMI display 2434, a telematics device, a control panel (e.g., for controlling and/or interacting with various components, features, and/or systems), and/or other components. Infotainment SoC 2430 may further be used to provide information (e.g., visual and/or audible) to user(s) of vehicle 2400, such as, but not limited to, information from ADAS system 2438, autonomous driving information such as, but not limited to, planned vehicle maneuvers, trajectories, surrounding environment information (e.g., intersection information, vehicle information, road information, etc.), and/or other information.

Infotainment SoC 2430 may include any amount and type of GPU functionality. Infotainment SoC 2430 may communicate over bus 2402 with other devices, systems, and/or components of vehicle 2400. Infotainment SoC 2430 may be coupled to a supervisory MCU such that a GPU of an infotainment system may perform some self-driving functions in event that primary controller(s) 2436 (e.g., primary and/or backup computers of vehicle 2400) fail. Infotainment SoC 2430 may put vehicle 2400 into a chauffeur to safe stop mode, as described herein.

Vehicle 2400 may further include instrument cluster 2432 (e.g., a digital dash, an electronic instrument cluster, a digital instrument panel, etc.). Instrument cluster 2432 may include a controller and/or supercomputer (e.g., a discrete controller or supercomputer). Instrument cluster 2432 may include any number and combination of a set of instrumentation such as, but not limited to, a speedometer, fuel level, oil pressure, tachometer, odometer, turn indicators, gearshift position indicator, seat belt warning light(s), parking-brake warning light(s), engine-malfunction light(s), supplemental restraint system (e.g., airbag) information, lighting controls, safety system controls, navigation information, etc. Information may be displayed and/or shared among infotainment SoC 2430 and instrument cluster 2432. Instrument cluster 2432 may be included as part of infotainment SoC 2430, or vice versa.

System may include server(s), network(s), and any number and type of vehicles, including vehicle 2400. Server(s) may include a plurality of GPUs, PCIe switches, and/or CPUs. GPUs, CPUs, and PCIe switches may be interconnected with high-speed interconnects such as, but not limited to, for example, NVLink interfaces developed by NVIDIA and/or PCIe connections. GPUs can be connected via any interconnects, such as NVLink and/or NVSwitch SoC, and GPUs and PCIe switches can be, for example, connected via PCIe interconnects. Each of server(s) may include any number of GPUs, CPUs, and/or PCIe switches, in any combination. For example, server(s) could each include eight, sixteen, thirty-two, and/or more GPUs.

Server(s) may receive, over network(s) and from vehicles, image data representative of images showing unexpected or changed road conditions, such as, but not limited to, recently commenced road-work. Server(s) may transmit, over network(s) and to vehicles, neural networks, updated or otherwise, and/or map information, including information regarding traffic and road conditions. Updates to map information may include updates for HD map, such as, but not limited to, information regarding construction sites, potholes, detours, flooding, and/or other obstructions. Neural networks, and/or map information may have resulted from new training and/or experiences represented in data received from any number of vehicles in an environment, and/or based at least in part on training performed at a data center (e.g., using server(s) and/or other servers).

Server(s) may be used to train machine learning models (e.g., neural networks) based at least in part on training data. Training data may be generated by vehicles, and/or may be generated in a simulation (e.g., using a game engine). Any amount of training data can be tagged (e.g., where associated neural network benefits from supervised learning) and/or undergoes other pre-processing. Any amount of training data may not be tagged and/or pre-processed (e.g., where associated neural network does not require supervised learning). Once machine learning models are trained, machine learning models may be used by vehicles (e.g., transmitted to vehicles over network(s)), and/or machine learning models may be used by server(s) to remotely monitor vehicles.

Server(s) may receive data from vehicles and apply data to up-to-date real-time neural networks for real-time intelligent inferencing. Server(s) may include deep-learning supercomputers and/or dedicated AI computers powered by GPU(s), such as, but not limited to, a DGX and DGX Station machines developed by NVIDIA. Alternatively, server(s) may include deep learning infrastructure that uses CPU-powered data centers.

Deep-learning infrastructure of server(s) may be capable of fast, real-time inferencing, and may use that capability to evaluate and verify health of processors, software, and/or associated hardware in vehicle 2400. For example, deep-learning infrastructure may receive periodic updates from vehicle 2400, such as, but not limited to, a sequence of images and/or objects that vehicle 2400 has located in that sequence of images (e.g., via computer vision and/or other machine learning object classification techniques). Deep-learning infrastructure may run its own neural network to identify objects and compare them with objects identified by vehicle 2400 and, if results do not match and deep-learning infrastructure concludes that AI in vehicle 2400 is malfunctioning, then server(s) may transmit a signal to vehicle instructing a fail-safe computer of vehicle 2400 to assume control, notify passengers, and complete a safe parking maneuver.

Server(s) may include GPU(s) and one or more programmable inference accelerators (e.g., NVIDIA's TensorRT 3 devices). A combination of GPU-powered servers and inference acceleration may make real-time responsiveness possible. Where performance is less critical, servers powered by CPUs, FPGAs, and other processors may be used for inferencing.

In at least one embodiment, autonomous vehicle 2400 described elsewhere herein, can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits in autonomous vehicle 2400 can be configured by software, e.g., programming platforms described herein, to causing communication of a plurality of wireless devices with one or more base stations to be simulated based, at least in part, on grouping the plurality of wireless devices according to one or more shared communication frequency bands or otherwise perform any of the operations described above or elsewhere herein.

### CLOUD AND WEB-BASED SERVICES

The following description sets forth, without limitation, cloud-based and/or web-based services and/or systems that can be used to causing communication of a plurality of wireless devices with one or more base stations to be simulated based, at least in part, on grouping the plurality of wireless devices according to one or more shared communication frequency bands or otherwise perform some or all of processes, operations and/or and techniques described elsewhere herein. cloud-based and/or web-based services and/or systems can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

Cloud computing can include a style of computing in which dynamically scalable and often virtualized resources are provided as a service over the Internet. Users need not have knowledge of, expertise in, or control over technology infrastructure, which can be referred to as "in the cloud," that supports them. Cloud computing may incorporate infrastructure as a service, platform as a service, software as a service, and other variations that have a common theme of reliance on the Internet for satisfying computing needs of users. A typical cloud deployment, such as in a private cloud (e.g., enterprise network), or a data center (DC) in a public cloud (e.g., Internet) can include thousands of servers (or alternatively, VMs), hundreds of Ethernet, Fiber Channel or Fiber Channel over Ethernet (FCoE) ports, switching and storage infrastructure, etc. A cloud can also include network services infrastructure like IPsec VPN hubs, firewalls, load balancers, wide area network (WAN) optimizers etc. Remote subscribers can access cloud applications and services securely by connecting via a VPN tunnel, such as an IPsec VPN tunnel.

Cloud computing may include a model for enabling convenient, on-demand network access to a shared pool of configurable computing resources (e.g., networks, servers, storage, applications, and services) that can be rapidly provisioned and released with minimal management effort or service provider interaction.

Cloud computing may be characterized by on-demand self-service, in which a consumer can unilaterally provision computing capabilities, such as server time and network storage, as needed automatically without requiring human inter-action with each service's provider. Cloud computing may be characterized by broad network access, in which capabilities are available over a network and accessed through standard mechanisms that promote use by heterogeneous thin or thick client platforms (e.g., mobile phones, laptops, and PDAs). Cloud computing may be characterized by resource pooling, in which a provider's computing resources are pooled to serve multiple consumers using a multi-tenant model, with different physical and virtual resources dynamically as-signed and reassigned according to consumer demand. In at least one embodiment, there is a sense of location independence in that a customer generally has no control or knowledge over an exact location of provided resources, but may be able to specify location at a higher level of abstraction (e.g., country, state, or datacenter). Examples of resources include storage, processing, memory, network bandwidth, and virtual machines. Cloud computing may be characterized by rapid elasticity, in which capabilities can be rapidly and elastically provisioned, in some cases automatically, to quickly scale out and rapidly released to quickly scale in. In at least one embodiment, to a consumer, capabilities available for provisioning often appear to be unlimited and can be purchased in any quantity at any time. Cloud computing may be characterized by measured service, in which cloud systems automatically control and optimize resource use by leveraging a metering capability at some level of abstraction appropriate to a type of service (e.g., storage, processing, bandwidth, and active user accounts). Resource usage can be monitored, controlled, and reported providing transparency for both a provider and consumer of a utilized service.

Cloud computing may be associated with various services. Cloud Software as a Service (SaaS) may refer to as service in which a capability provided to a consumer is to use a provider's applications running on a cloud infrastructure. Applications can be accessible from various client devices through a thin client interface such as a web browser (e.g., web-based email). In at least one embodiment, consumer does not manage or control underlying cloud infrastructure including network, servers, operating systems, storage, or even individual application capabilities, with a possible exception of limited user-specific application configuration settings.

Cloud Platform as a Service (PaaS) may refer to a service in which a capability provided to consumer is to deploy onto cloud infrastructure consumer-created or acquired applications created using programming languages and tools supported by a provider. In at least one embodiment, a consumer does not manage or control underlying cloud infrastructure including networks, servers, operating systems, or storage, but has control over deployed applications and possibly application hosting environment configurations.

Cloud Infrastructure as a Service (IaaS) may refer to a service in which a capability provided to a consumer is to provision processing, storage, networks, and other fundamental computing resources where a consumer is able to deploy and run arbitrary software, which can include operating systems and applications. In at least one embodiment, consumer does not manage or control underlying cloud infrastructure, but has control over operating systems, storage, deployed applications, and possibly limited control of select networking components (e.g., host firewalls).

Cloud computing may be deployed in various ways. A private cloud may refer to a cloud infrastructure that is operated solely for an organization. A private cloud may be managed by an organization or a third party and may exist on-premises or off-premises. A community cloud may refer to a cloud infrastructure that is shared by several organizations and supports a specific community that has shared concerns (e.g., mission, security requirements, policy, and compliance considerations). A community cloud may be managed by organizations or a third party and may exist on-premises or off-premises. A public cloud may refer to a cloud infrastructure that is made available to a general public or a large industry group and is owned by an organization providing cloud services. A hybrid cloud may refer to a cloud infrastructure that is a composition of two or more clouds (private, community, or public) that remain unique entities, but are bound together by standardized or proprietary technology that enables data and application portability (e.g., cloud bursting for load-balancing between clouds). A cloud computing environment is service oriented with a focus on statelessness, low coupling, modularity, and semantic interoperability.

### LOGIC AND NEURAL NETWORK TRAINING AND DEPLOYMENT

The following figures set forth, without limitation, examples of logic and artificial intelligence-based systems that can be used to implement functionality and/or operations described herein.

FIGs. 25A and 25B illustrate logic 2515 which, as described elsewhere herein, can be used in one or more devices or systems (e.g., such as any of the processors (e.g., any processor in FIGs. 8-20), data centers, cloud or web-based services described herein) to perform operations such as, but not limited to, those discussed herein, in accordance with at least one embodiment. Logic can refer to any combination of software logic, hardware logic, and/or firmware logic to provide functionality and/or operations described herein, wherein logic may be, collectively or individually, embodied as circuitry that forms part of a larger system, for example, an integrated circuit (IC), an application-specific integrated circuit (ASIC), a field programmable array (FPGA), system-on-chip (SoC), or one or processors (e.g., CPU, GPU). Logic 2515 illustrated in FIGs. 25A and 25B may be used in conjunction with an application-specific integrated circuit ("ASIC"), such as, but not limited to, a TensorFlow^{®} Processing Unit from Google, an inference processing unit (IPU) from Graphcore^{™}, or a Nervana^{®} (e.g., "Lake Crest") processor from Intel Corp. Logic 2515 illustrated in FIG. 25A and 25B may be used in conjunction with central processing unit ("CPU") hardware, graphics processing unit ("GPU") hardware or other hardware, such as, but not limited to, field programmable gate arrays ("FPGAs").

Logic 2515 can be used to perform inferencing and/or training operations associated with one or more embodiments. Logic 2515 may be inference and/or training logic. In at least one embodiment, FIG. 25A illustrates inference and/or training logic 2515 used to perform inferencing and/or training operations associated with one or more embodiments. Inference and/or training logic 2515 may include code and/or data storage 2501 to store forward and/or output weight and/or input/output data, and/or other parameters to configure neurons or layers of a neural network trained and/or used for inferencing in aspects of one or more embodiments. Training logic 2515 may include, or be coupled to code and/or data storage 2501 to store graph code or other software to control timing and/or order, in which weight and/or other parameter information is to be loaded to configure, logic, including integer and/or floating point units (collectively, arithmetic logic units (ALUs). Code, such as, but not limited to, graph code, can load weight or other parameter information into processor ALUs based on an architecture of a neural network to which such code corresponds. Code and/or data storage 2501 can store weight parameters and/or input/output data of each layer of a neural network trained or used in conjunction with one or more embodiments during forward propagation of input/output data and/or weight parameters during training and/or inferencing using aspects of one or more embodiments. Any portion of code and/or data storage 2501 may be included with other on-chip or off-chip data storage, including a processor's L1, L2, or L3 cache or system memory.

Any portion of code and/or data storage 2501 may be internal or external to one or more processors or other hardware logic devices or circuits. Code and/or code and/or data storage 2501 may be cache memory, dynamic randomly addressable memory ("DRAM"), static randomly addressable memory ("SRAM"), non-volatile memory (e.g., flash memory), or other storage. A choice of whether code and/or code and/or data storage 2501 is internal or external to a processor, for example, or comprising DRAM, SRAM, flash or some other storage type may depend on available storage on-chip versus off-chip, latency requirements of training and/or inferencing functions being performed, batch size of data used in inferencing and/or training of a neural network, or some combination of these factors.

Inference and/or training logic 2515 may include a code and/or data storage 2505 to store backward and/or output weight and/or input/output data corresponding to neurons or layers of a neural network trained and/or used for inferencing in aspects of one or more embodiments. Code and/or data storage 2505 can store weight parameters and/or input/output data of each layer of a neural network trained or used in conjunction with one or more embodiments during backward propagation of input/output data and/or weight parameters during training and/or inferencing using aspects of one or more embodiments. Training logic 2515 may include, or be coupled to code and/or data storage 2505 to store graph code or other software to control timing and/or order, in which weight and/or other parameter information is to be loaded to configure, logic, including integer and/or floating point units (collectively, arithmetic logic units (ALUs).

Code, such as, but not limited to, graph code, may cause loading of weight or other parameter information into processor ALUs based on an architecture of a neural network to which such code corresponds. Any portion of code and/or data storage 2505 may be included with other on-chip or off-chip data storage, including a processor's L1, L2, or L3 cache or system memory. Any portion of code and/or data storage 2505 may be internal or external to one or more processors or other hardware logic devices or circuits. Code and/or data storage 2505 may be cache memory, DRAM, SRAM, non-volatile memory (e.g., flash memory), or other storage. A choice of whether code and/or data storage 2505 is internal or external to a processor, for example, or comprising DRAM, SRAM, flash memory or some other storage type may depend on available storage on-chip versus off-chip, latency requirements of training and/or inferencing functions being performed, batch size of data used in inferencing and/or training of a neural network, or some combination of these factors.

Code and/or data storage 2501 and code and/or data storage 2505 may be separate storage structures. Code and/or data storage 2501 and code and/or data storage 2505 may be a combined storage structure. Code and/or data storage 2501 and code and/or data storage 2505 may be partially combined and partially separate. Any portion of code and/or data storage 2501 and code and/or data storage 2505 may be included with other on-chip or off-chip data storage, including a processor's L1, L2, or L3 cache or system memory.

Inference and/or training logic 2515 may include one or more arithmetic logic unit(s) ("ALU(s)") 2510, including integer and/or floating point units, to perform logical and/or mathematical operations based, at least in part on, or indicated by, training and/or inference code (e.g., graph code), a result of which may produce activations (e.g., output values from layers or neurons within a neural network) stored in an activation storage 2520 that may be functions of input/output and/or weight parameter data stored in code and/or data storage 2501 and/or code and/or data storage 2505. Activations stored in activation storage 2520 may be generated according to linear algebraic and or matrix-based mathematics performed by ALU(s) 2510 in response to performing instructions or other code, wherein weight values stored in code and/or data storage 2505 and/or data storage 2501 may be used as operands along with other values, such as, but not limited to, bias values, gradient information, momentum values, or other parameters or hyperparameters, any or all of which may be stored in code and/or data storage 2505 or code and/or data storage 2501 or another storage on or off-chip.

ALU(s) 2510 can be included within one or more processors or other hardware logic devices or circuits, whereas in another embodiment, ALU(s) 2510 may be external to a processor or other hardware logic device or circuit that uses them (e.g., a co-processor). ALUs 2510 may be included within a processor's execution units or otherwise within a bank of ALUs accessible by a processor's execution units either within same processor or distributed between different processors of different types (e.g., central processing units, graphics processing units, fixed function units, etc.). Code and/or data storage 2501, code and/or data storage 2505, and activation storage 2520 may share a processor or other hardware logic device or circuit, whereas in another embodiment, they may be in different processors or other hardware logic devices or circuits, or some combination of same and different processors or other hardware logic devices or circuits. Any portion of activation storage 2520 may be included with other on-chip or off-chip data storage, including a processor's L1, L2, or L3 cache or system memory. Furthermore, inferencing and/or training code may be stored with other code accessible to a processor or other hardware logic or circuit and fetched and/or processed using a processor's fetch, decode, scheduling, execution, retirement and/or other logical circuits.

Activation storage 2520 may be cache memory, DRAM, SRAM, non-volatile memory (e.g., flash memory), or other storage. Activation storage 2520 may be completely or partially within or external to one or more processors or other logical circuits. A choice of whether activation storage 2520 is internal or external to a processor, for example, or comprising DRAM, SRAM, flash memory or some other storage type may depend on available storage on-chip versus off-chip, latency requirements of training and/or inferencing functions being performed, batch size of data used in inferencing and/or training of a neural network, or some combination of these factors.

In at least one embodiment, inference and/or training logic 2515 illustrated in FIG. 25A may be used in conjunction with an application-specific integrated circuit ("ASIC"), such as, but not limited to, a TensorFlow^{®} Processing Unit from Google, an inference processing unit (IPU) from Graphcore^{™}, or a Nervana^{®} (e.g., "Lake Crest") processor from Intel Corp. In at least one embodiment, inference and/or training logic 2515 illustrated in FIG. 25A may be used in conjunction with central processing unit ("CPU") hardware, graphics processing unit ("GPU") hardware or other hardware, such as, but not limited to, field programmable gate arrays ("FPGAs").

FIG. 25B illustrates inference and/or training logic 2515, in accordance with at least one embodiment. Inference and/or training logic 2515 may include hardware logic in which computational resources may be dedicated or otherwise exclusively used in conjunction with weight values or other information corresponding to one or more layers of neurons within a neural network. Inference and/or training logic 2515 illustrated in FIG. 25B may be used in conjunction with an application-specific integrated circuit (ASIC), such as, but not limited to, TensorFlow^{®} Processing Unit from Google, an inference processing unit (IPU) from Graphcore^{™}, or a Nervana^{®} (e.g., "Lake Crest") processor from Intel Corp. Inference and/or training logic 2515 illustrated in FIG. 25B may be used in conjunction with central processing unit (CPU) hardware, graphics processing unit (GPU) hardware or other hardware, such as, but not limited to, field programmable gate arrays (FPGAs). Inference and/or training logic 2515 can include code and/or data storage 2501 and code and/or data storage 2505, which may be used to store code (e.g., graph code), weight values and/or other information, including bias values, gradient information, momentum values, and/or other parameter or hyperparameter information. In FIG. 25B, for example, each of code and/or data storage 2501 and code and/or data storage 2505 is associated with a dedicated computational resource, such as, but not limited to, computational hardware 2502 and computational hardware 2506, respectively. Each of computational hardware 2502 and computational hardware 2506 can include one or more ALUs that perform mathematical functions, such as, but not limited to, linear algebraic functions, only on information stored in code and/or data storage 2501 and code and/or data storage 2505, respectively, result of which is stored in activation storage 2520.

Each of code and/or data storage 2501 and 2505 and corresponding computational hardware 2502 and 2506, respectively, correspond to different layers of a neural network, such that resulting activation from one storage/computational pair 2501/2502 of code and/or data storage 2501 and computational hardware 2502 is provided as an input to a next storage/computational pair 2505/2506 of code and/or data storage 2505 and computational hardware 2506, in order to mirror a conceptual organization of a neural network. Each of storage/computational pairs 2501/2502 and 2505/2506 may correspond to more than one neural network layer. Additional storage/computation pairs (not shown) subsequent to or in parallel with storage/computation pairs 2501/2502 and 2505/2506 may be included in inference and/or training logic 2515.

In at least one embodiment, logic 2515 described elsewhere herein, can include one or more circuits to causing communication of a plurality of wireless devices with one or more base stations to be simulated based, at least in part, on grouping the plurality of wireless devices according to one or more shared communication frequency bands or otherwise perform any of the operations described above or elsewhere herein. One or more circuits in logic 2515 can be configured by software described herein, to causing communication of a plurality of wireless devices with one or more base stations to be simulated based, at least in part, on grouping the plurality of wireless devices according to one or more shared communication frequency bands or otherwise perform any of the operations described above or elsewhere herein.

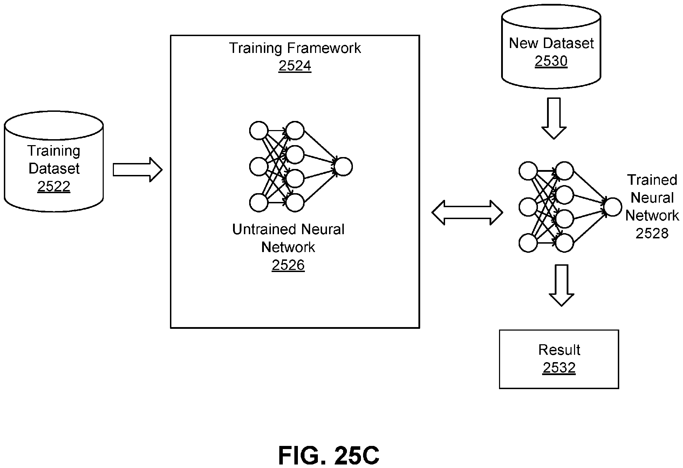

FIG. 25C illustrates training and deployment of a deep neural network, in accordance with at least one embodiment. An untrained neural network 2526 can be trained using a training dataset 2522. Training framework 2524 can be a PyTorch framework, and/or a training framework 2504 can include a TensorFlow, Boost, Caffe, Microsoft Cognitive Toolkit/CNTK, MXNet, Chainer, Keras, Deeplearning4j, or other training framework. Training framework 2524 can train an untrained neural network 2526 and enables it to be trained using processing resources described herein to generate a trained neural network 2528. Weights may be chosen randomly or by pre-training using a deep belief network. Training may be performed in either a supervised, partially supervised, or unsupervised manner.

Untrained neural network 2526 can be trained using supervised learning, wherein training dataset 2522 includes an input paired with a desired output for an input, or where training dataset 2522 includes input having a known output and an output of neural network 2526 is manually graded. Untrained neural network 2526 can be trained in a supervised manner and processes inputs from training dataset 2522 and compares resulting outputs against a set of expected or desired outputs. Errors can then be propagated back through untrained neural network 2526. Training framework 2524 can adjust weights that control untrained neural network 2526. Training framework 2524 can include tools to monitor how well untrained neural network 2526 is converging towards a model, such as, but not limited to, trained neural network 2528, suitable to generating correct answers, such as, but not limited to, in result 2532, based on input data such as, but not limited to, a new dataset 2530. Training framework 2524 can train untrained neural network 2526 repeatedly while adjust weights to refine an output of untrained neural network 2526 using a loss function and adjustment algorithm, such as, but not limited to, stochastic gradient descent. Training framework 2524 can train untrained neural network 2526 until untrained neural network 2526 achieves a desired accuracy. Trained neural network 2528 can then be deployed to implement any number of machine learning operations.

Untrained neural network 2526 can be trained using unsupervised learning, wherein untrained neural network 2526 attempts to train itself using unlabeled data. Unsupervised learning training dataset 2522 can include input data without any associated output data or "ground truth" data. Untrained neural network 2526 can learn groupings within training dataset 2522 and can determine how individual inputs may be related to untrained dataset 2522. Unsupervised training can be used to generate a self-organizing map in trained neural network 2528 capable of performing operations useful in reducing dimensionality of new dataset 2530. Unsupervised training can also be used to perform anomaly detection, which allows identification of data points in new dataset 2530 that deviate from normal patterns of new dataset 2530.

Semi-supervised learning may be used, which is a technique in which in training dataset 2522 includes a mix of labeled and unlabeled data. Training framework 2524 may be used to perform incremental learning, such as, but not limited to, through transferred learning techniques. Incremental learning can enable trained neural network 2528 to adapt to new dataset 2530 without forgetting knowledge instilled within trained neural network 2528 during initial training.

Training framework 2524 can include a framework processed in connection with a software development toolkit such as, but not limited to, an Open VINO (Open Visual Inference and Neural network Optimization) toolkit. An Open VINO toolkit can include a toolkit such as, but not limited to, those developed by Intel Corporation of Santa Clara, CA.

Open VINO can include a toolkit for facilitating development of applications, specifically neural network applications, for various tasks and operations, such as, but not limited to, human vision emulation, speech recognition, natural language processing, recommendation systems, and/or variations thereof. Open VINO can support neural networks such as, but not limited to, convolutional neural networks (CNNs), recurrent and/or attention-based neural networks, and/or various other neural network models. Open VINO can support various software libraries such as, but not limited to, OpenCV, OpenCL, and/or variations thereof.

Open VINO can support neural network models for various tasks and operations, such as, but not limited to, classification, segmentation, object detection, face recognition, speech recognition, pose estimation (e.g., humans and/or objects), monocular depth estimation, image inpainting, style transfer, action recognition, colorization, and/or variations thereof.

Open VINO can include one or more software tools and/or modules for model optimization, also referred to as a model optimizer. A model optimizer can include a command line tool that facilitates transitions between training and deployment of neural network models. A model optimizer may optimize neural network models for execution on various devices and/or processing units, such as, but not limited to, a GPU, CPU, PPU, GPGPU, and/or variations thereof. A model optimizer can generate an internal representation of a model, and can optimize said model to generate an intermediate representation. A model optimizer may reduce a number of layers of a model. A model optimizer can remove layers of a model that may be utilized for training. A model optimizer may perform various neural network operations, such as, but not limited to, modifying inputs to a model (e.g., resizing inputs to a model), modifying a size of inputs of a model (e.g., modifying a batch size of a model), modifying a model structure (e.g., modifying layers of a model), normalization, standardization, quantization (e.g., converting weights of a model from a first representation, such as, but not limited to, floating point, to a second representation, such as, but not limited to, integer), and/or variations thereof.

Open VINO can include one or more software libraries for inferencing, also referred to as an inference engine. An inference engine can include a C++ library, or any suitable programming language library. An inference engine can be utilized to infer input data. An inference engine may implement various classes to infer input data and generate one or more results. An inference engine can implement one or more API functions to process an intermediate representation, set input and/or output formats, and/or execute a model on one or more devices.

Open VINO may provide various abilities for heterogeneous execution of one or more neural network models. Heterogeneous execution, or heterogeneous computing, can refer to one or more computing processes and/or systems that utilize one or more types of processors and/or cores. OpenVINO can provide various software functions to execute a program on one or more devices. OpenVINO may provide various software functions to execute a program and/or portions of a program on different devices. OpenVINO may provide various software functions to, for example, run a first portion of code on a CPU and a second portion of code on a GPU and/or FPGA. OpenVINO may provide various software functions to execute one or more layers of a neural network on one or more devices (e.g., a first set of layers on a first device, such as, but not limited to, a GPU, and a second set of layers on a second device, such as, but not limited to, a CPU).

OpenVINO can include various functionality similar to functionalities associated with a CUDA programming model, such as, but not limited to, various neural network model operations associated with frameworks such as, but not limited to, TensorFlow, PyTorch, and/or variations thereof. One or more CUDA programming model operations may be performed using OpenVINO. Various systems, methods, and/or techniques described herein may be implemented using OpenVINO.

In at least one embodiment, one or more circuits can be used to cause one or more neural networks and training frameworks described elsewhere herein to causing communication of a plurality of wireless devices with one or more base stations to be simulated based, at least in part, on grouping the plurality of wireless devices according to one or more shared communication frequency bands or otherwise perform any of the operations described above or elsewhere herein. One or more neural networks and training frameworks can be configured by software to causing communication of a plurality of wireless devices with one or more base stations to be simulated based, at least in part, on grouping the plurality of wireless devices according to one or more shared communication frequency bands or otherwise perform any of the operations described above or elsewhere herein.

### NETWORKS

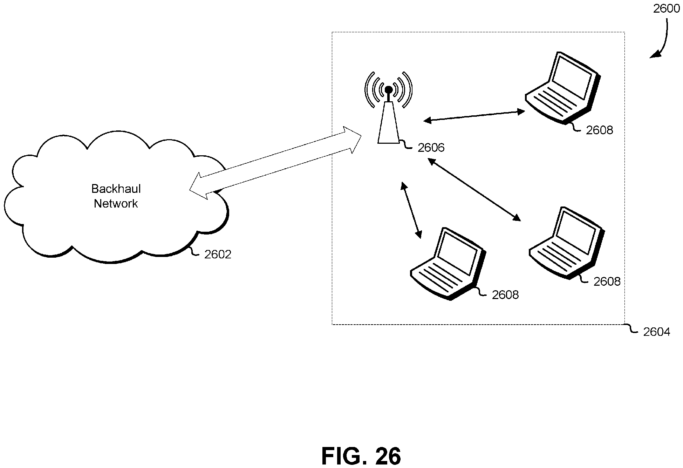

FIG. 26 illustrates a network 2600 for communicating data within a 5G wireless communications network, in accordance with at least one embodiment. In at least one embodiment, network 2600 comprises a base station 2606 having a coverage area 2604, a plurality of mobile devices 2608, and a backhaul network 2602. In at least one embodiment, as shown, base station 2606 establishes uplink and/or downlink connections with mobile devices 2608, which serve to carry data from mobile devices 2608 to base station 2606 and vice-versa. In at least one embodiment, data carried over uplink/downlink connections may include data communicated between mobile devices 2608, as well as data communicated to/from a remote-end (not shown) by way of backhaul network 2602. In at least one embodiment, term "base station" refers to any component (or collection of components) configured to provide wireless access to a network, such as an enhanced base station (eNB), a macrocell, a femtocell, a Wi-Fi access point (AP), or other wirelessly enabled devices. In at least one embodiment, base stations may provide wireless access in accordance with one or more wireless communication protocols, e.g., long term evolution (LTE), LTE advanced (LTE-A), High Speed Packet Access (HSPA), Wi-Fi 802.11a/b/g/n/ac, etc. In at least one embodiment, term "mobile device" refers to any component (or collection of components) capable of establishing a wireless connection with a base station, such as a user equipment (UE), a mobile station (STA), and other wirelessly enabled devices. In some embodiments, network 2600 may comprise various other wireless devices, such as relays, low power nodes, etc.

In at least one embodiment, network 2900 can include or otherwise implement one or more circuits to causing communication of a plurality of wireless devices with one or more base stations to be simulated based, at least in part, on grouping the plurality of wireless devices according to one or more shared communication frequency bands Language that includes the claim language and any other important concepts (e.g., API for an API case)] and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands Language that includes the claim language and any other important concepts (e.g., API for an API case)] and/or otherwise perform any of the operations described above or elsewhere herein.

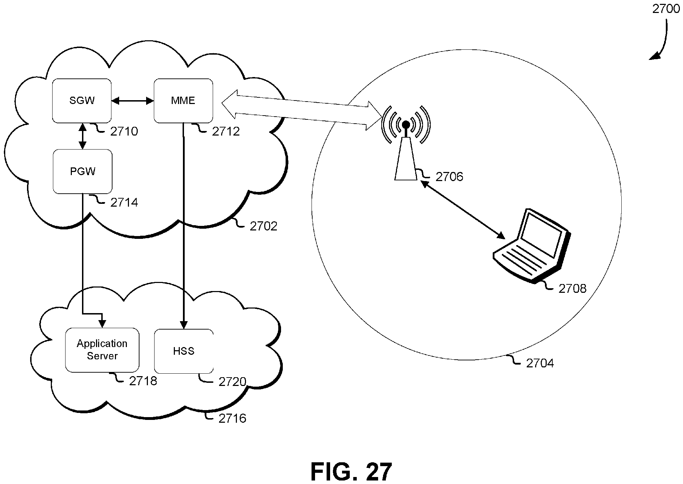

FIG. 27 illustrates a network architecture 2700 for a 5G wireless network, in accordance with at least one embodiment. In at least one embodiment, as shown, network architecture 2700 includes a radio access network (RAN) 2704, an evolved packet core (EPC) 2702, which may be referred to as a core network, and a home network 2716 of a UE 2708 attempting to access RAN 2704. In at least one embodiment, RAN 2704 and EPC 2702 form a serving wireless network. In at least one embodiment, RAN 2704 includes a base station 2706, and EPC 2702 includes a mobility management entity (MME) 2712, a serving gateway (SGW) 2710, and a packet data network (PDN) gateway (PGW) 2714. In at least one embodiment, home network 2716 includes an application server 2718 and a home subscriber server (HSS) 2720. In at least one embodiment, HSS 2720 may be part of home network 2716, EPC 2702, and/or variations thereof.

In at least one embodiment, MME 2712 is a termination point in a network for ciphering/integrity protection for NAS signaling and handles security key management. In at least one embodiment, it should be appreciated that term "MME" is used in 4G LTE networks, and that 5G LTE networks may include a Security Anchor Node (SEAN) or a Security Access Function (SEAF) that performs similar functions. In at least one embodiment, terms "MME," "SEAN," and "SEAF" may be used interchangeably. In at least one embodiment, MME 2712 also provides control plane function for mobility between LTE and 2G/3G access networks, as well as an interface to home networks of roaming UEs. In at least one embodiment, SGW 2710 routes and forwards user data packets, while also acting as a mobility anchor for a user plane during handovers. In at least one embodiment, PGW 2714 provides connectivity from UEs to external packet data networks by being a point of exit and entry of traffic for UEs. In at least one embodiment, HSS 2720 is a central database that contains user-related and subscription-related information. In at least one embodiment, application server 2718 is a central database that contains user-related information regarding various applications that may utilize and communicate via network architecture 2700.

In at least one embodiment, network architecture 3000 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

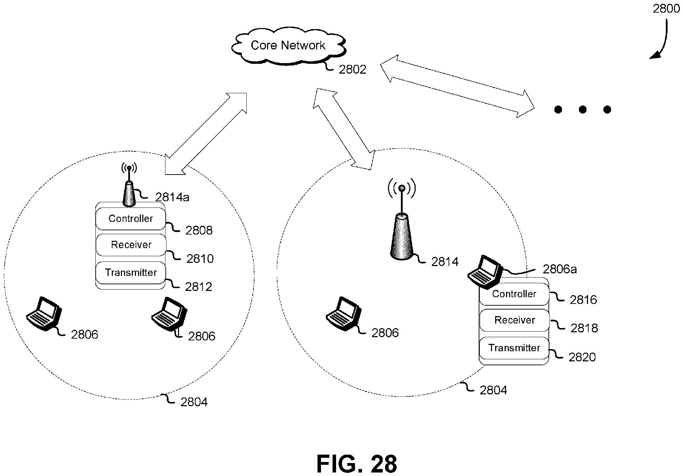

FIG. 28 is a diagram illustrating some basic functionality of a mobile telecommunications network/system operating in accordance with LTE and 5G principles, in accordance with at least one embodiment. In at least one embodiment, a mobile telecommunications system 2800 includes infrastructure equipment comprising base stations 2814 which are connected to a core network 2802, which operates in accordance with a conventional arrangement which will be understood by those acquainted with communications technology. In at least one embodiment, infrastructure equipment 2814 may also be referred to as a base station, network element, enhanced NodeB (eNodeB) or a coordinating entity for example, and provides a wireless access interface to one or more communications devices within a coverage area or cell represented by a broken line 2804, which may be referred to as a radio access network. In at least one embodiment, one or more mobile communications devices 2806 may communicate data via transmission and reception of signals representing data using a wireless access interface. In at least one embodiment, core network 2802 may also provide functionality including authentication, mobility management, charging and so on for communications devices served by a network entity.

In at least one embodiment, mobile communications devices of FIG. 28 may also be referred to as communications terminals, user equipment (UE), terminal devices and so forth, and are configured to communicate with one or more other communications devices served by a same or a different coverage area via a network entity. In at least one embodiment, these communications may be performed by transmitting and receiving signals representing data using a wireless access interface over two way communications links.

In at least one embodiment, as shown in FIG. 28, one of eNodeBs 2814a is shown in more detail to include a transmitter 2812 for transmitting signals via a wireless access interface to one or more communications devices or UEs 2806, and a receiver 2810 to receive signals from one or more UEs within coverage area 2804. In at least one embodiment, controller 2808 controls transmitter 2812 and receiver 2810 to transmit and receive signals via a wireless access interface. In at least one embodiment, controller 2808 may perform a function of controlling allocation of communications resource elements of a wireless access interface and may in some examples include a scheduler for scheduling transmissions via a wireless access interface for both uplink and downlink.

In at least one embodiment, an example UE 2806a is shown in more detail to include a transmitter 2820 for transmitting signals on an uplink of a wireless access interface to eNodeB 2814 and a receiver 2818 for receiving signals transmitted by eNodeB 2814 on a downlink via a wireless access interface. In at least one embodiment, transmitter 2820 and receiver 2818 are controlled by a controller 2816.

In at least one embodiment, mobile telecommunications system 2800 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

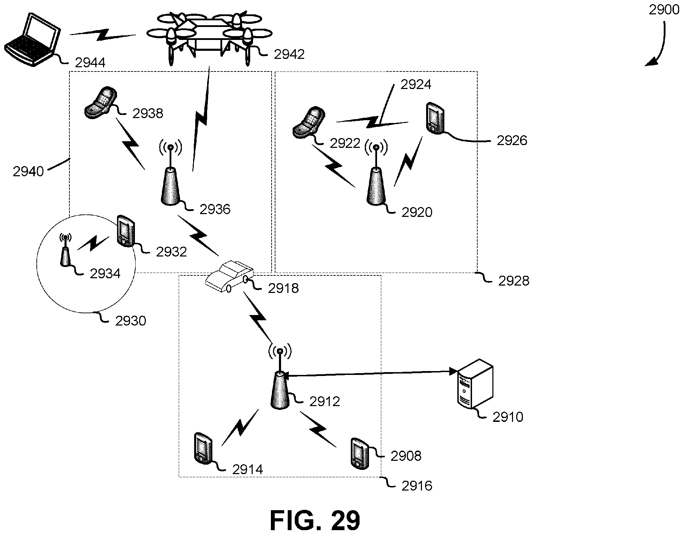

FIG. 29 illustrates a radio access network 2900, which may be part of a 5G network architecture, in accordance with at least one embodiment. In at least one embodiment, radio access network 2900 covers a geographic region divided into a number of cellular regions (cells) that can be uniquely identified by a user equipment (UE) based on an identification broadcasted over a geographical area from one access point or base station. In at least one embodiment, macrocells 2940, 2928, and 2916, and a small cell 2930, may include one or more sectors. In at least one embodiment, a sector is a sub-area of a cell and all sectors within one cell are served by a same base station. In at least one embodiment, a single logical identification belonging to that sector can identify a radio link within a sector. In at least one embodiment, multiple sectors within a cell can be formed by groups of antennas with each antenna responsible for communication with UEs in a portion of a cell.

In at least one embodiment, each cell is served by a base station (BS). In at least one embodiment, a base station is a network element in a radio access network responsible for radio transmission and reception in one or more cells to or from a UE. In at least one embodiment, a base station may also be referred to as a base transceiver station (BTS), a radio base station, a radio transceiver, a transceiver function, a basic service set (BSS), an extended service set (ESS), an access point (AP), a Node B (NB), an eNode B (eNB), a gNode B (gNB), or some other suitable terminology. In at least one embodiment, base stations may include a backhaul interface for communication with a backhaul portion of a network. In at least one embodiment, a base station has an integrated antenna or is connected to an antenna or remote radio head (RRH) by feeder cables.

In at least one embodiment, a backhaul may provide a link between a base station and a core network, and in some examples, a backhaul may provide interconnection between respective base stations. In at least one embodiment, a core network is a part of a wireless communication system that is generally independent of radio access technology used in a radio access network. In at least one embodiment, various types of backhaul interfaces, such as a direct physical connection, a virtual network, or like using any suitable transport network, may be employed. In at least one embodiment, some base stations may be configured as integrated access and backhaul (IAB) nodes, where a wireless spectrum may be used both for access links (i.e., wireless links with UEs), and for backhaul links, which is sometimes referred to as wireless self-backhauling. In at least one embodiment, through wireless self-backhauling, a wireless spectrum utilized for communication between a base station and UE may be leveraged for backhaul communication, enabling fast and easy deployment of highly dense small cell networks, as opposed to requiring each new base station deployment to be outfitted with its own hard-wired backhaul connection.

In at least one embodiment, high-power base stations 2936 and 2920 are shown in cells 2940 and 2928, and a high-power base station 2910 is shown controlling a remote radio head (RRH) 2912 in cell 2916. In at least one embodiment, cells 2940, 2928, and 2916 may be referred to as large size cells or macrocells. In at least one embodiment, a low-power base station 2934 is shown in small cell 2930 (e.g., a microcell, picocell, femtocell, home base station, home Node B, home eNode B, etc.) which may overlap with one or more macrocells, and may be referred to as a small cell or small size cell. In at least one embodiment, cell sizing can be done according to system design as well as component constraints. In at least one embodiment, a relay node may be deployed to extend size or coverage area of a given cell. In at least one embodiment, radio access network 2900 may include any number of wireless base stations and cells. In at least one embodiment, base stations 2936, 2920, 2910, 2934 provide wireless access points to a core network for any number of mobile apparatuses.

In at least one embodiment, a quadcopter or drone 2942 may be configured to function as a base station. In at least one embodiment, a cell may not necessarily be stationary, and a geographic area of a cell may move according to a location of a mobile base station such as quadcopter 2942.

In at least one embodiment, radio access network 2900 supports wireless communications for multiple mobile apparatuses. In at least one embodiment, a mobile apparatus is commonly referred to as user equipment (UE), but may also be referred to as a mobile station (MS), a subscriber station, a mobile unit, a subscriber unit, a wireless unit, a remote unit, a mobile device, a wireless device, a wireless communications device, a remote device, a mobile subscriber station, an access terminal (AT), a mobile terminal, a wireless terminal, a remote terminal, a handset, a terminal, a user agent, a mobile client, a client, or some other suitable terminology. In at least one embodiment, a UE may be an apparatus that provides a user with access to network services.

In at least one embodiment, a "mobile" apparatus need not necessarily have a capability to move and may be stationary. In at least one embodiment, mobile apparatus or mobile device broadly refers to a diverse array of devices and technologies. In at least one embodiment, a mobile apparatus may be a mobile, a cellular (cell) phone, a smart phone, a session initiation protocol (SIP) phone, a laptop, a personal computer (PC), a notebook, a netbook, a smartbook, a tablet, a personal digital assistant (PDA), a broad array of embedded systems, e.g., corresponding to an "Internet of things" (IoT), an automotive or other transportation vehicle, a remote sensor or actuator, a robot or robotics device, a satellite radio, a global positioning system (GPS) device, an object tracking device, a drone, a multi-copter, a quad-copter, a remote control device, a consumer and/or wearable device, such as eyewear, a wearable camera, a virtual reality device, a smart watch, a health or fitness tracker, a digital audio player (e.g., MP3 player), a camera, a game console, a digital home or smart home device such as a home audio, video, and/or multimedia device, an appliance, a vending machine, intelligent lighting, a home security system, a smart meter, a security device, a solar panel or solar array, a municipal infrastructure device controlling electric power (e.g., a smart grid), lighting, water, etc., an industrial automation and enterprise device, a logistics controller, agricultural equipment, military defense equipment, vehicles, aircraft, ships, and weaponry, etc. In at least one embodiment, a mobile apparatus may provide for connected medicine or telemedicine support, i.e., health care at a distance. In at least one embodiment, telehealth devices may include telehealth monitoring devices and telehealth administration devices, whose communication may be given preferential treatment or prioritized access over other types of information, e.g., in terms of prioritized access for transport of critical service data, and/or relevant QoS for transport of critical service data.

In at least one embodiment, cells of radio access network 2900 may include UEs that may be in communication with one or more sectors of each cell. In at least one embodiment, UEs 2914 and 2908 may be in communication with base station 2910 by way of RRH 2912; UEs 2922 and 2926 may be in communication with base station 2920; UE 2932 may be in communication with low-power base station 2934; UEs 2938 and 2918 may be in communication with base station 2936; and UE 2944 may be in communication with mobile base station 2942. In at least one embodiment, each base station 2910, 2920, 2934, 2936, and 2942 may be configured to provide an access point to a core network (not shown) for all UEs in respective cells and transmissions from a base station (e.g., base station 2936) to one or more UEs (e.g., UEs 2938 and 2918) may be referred to as downlink (DL) transmission, while transmissions from a UE (e.g., UE 2938) to a base station may be referred to as uplink (UL) transmissions. In at least one embodiment, downlink may refer to a point-to-multipoint transmission, which may be referred to as broadcast channel multiplexing. In at least one embodiment, uplink may refer to a point-to-point transmission.

In at least one embodiment, quadcopter 2942, which may be referred to as a mobile network node, may be configured to function as a UE within cell 2940 by communicating with base station 2936. In at least one embodiment, multiple UEs (e.g., UEs 2922 and 2926) may communicate with each other using peer to peer (P2P) or sidelink signals 2924, which may bypass a base station such as base station 2920.

In at least one embodiment, ability for a UE to communicate while moving, independent of its location, is referred to as mobility. In at least one embodiment, a mobility management entity (MME) sets up, maintains, and releases various physical channels between a UE and a radio access network. In at least one embodiment, DL-based mobility or UL-based mobility may be utilized by a radio access network 2900 to enable mobility and handovers (i.e., transfer of a UE's connection from one radio channel to another). In at least one embodiment, a UE, in a network configured for DL-based mobility, may monitor various parameters of a signal from its serving cell as well as various parameters of neighboring cells, and, depending on a quality of these parameters, a UE may maintain communication with one or more neighboring cells. In at least one embodiment, if signal quality from a neighboring cell exceeds that from a serving cell for a given amount of time, or if a UE moves from one cell to another, a UE may undertake a handoff or handover from a serving cell to a neighboring (target) cell. In at least one embodiment, UE 2918 (illustrated as a vehicle, although any suitable form of UE may be used) may move from a geographic area corresponding to a cell, such as serving cell 2940, to a geographic area corresponding to a neighbor cell, such as neighbor cell 2916. In at least one embodiment, UE 2918 may transmit a reporting message to its serving base station 2936 indicating its condition when signal strength or quality from a neighbor cell 2916 exceeds that of its serving cell 2940 for a given amount of time. In at least one embodiment, UE 2918 may receive a handover command, and may undergo a handover to cell 2916.

In at least one embodiment, UL reference signals from each UE may be utilized by a network configured for UL-based mobility to select a serving cell for each UE. In at least one embodiment, base stations 2936, 2920, and 2910/2912 may broadcast unified synchronization signals (e.g., unified Primary Synchronization Signals (PSSs), unified Secondary Synchronization Signals (SSSs) and unified Physical Broadcast Channels (PBCH)). In at least one embodiment, UEs 2938, 2918, 2922, 2926, 2914, and 2908 may receive unified synchronization signals, derive a carrier frequency and slot timing from synchronization signals, and in response to deriving timing, transmit an uplink pilot or reference signal. In at least one embodiment, two or more cells (e.g., base stations 2936 and 2910/2912) within radio access network 2900 may concurrently receive an uplink pilot signal transmitted by a UE (e.g., UE 2918). In at least one embodiment, cells may measure a strength of a pilot signal, and a radio access network (e.g., one or more of base stations 2936 and 2910/2912 and/or a central node within a core network) may determine a serving cell for UE 2918. In at least one embodiment, a network may continue to monitor an uplink pilot signal transmitted by UE 2918 as UE 2918 moves through radio access network 2900. In at least one embodiment, a network 2900 may handover UE 2918 from a serving cell to a neighboring cell, with or without informing UE 2918, when a signal strength or quality of a pilot signal measured by a neighboring cell exceeds that of a signal strength or quality measured by a serving cell.

In at least one embodiment, synchronization signals transmitted by base stations 2936, 2920, and 2910/2912 may be unified, but may not identify a particular cell and rather may identify a zone of multiple cells operating on a same frequency and/or with a same timing. In at least one embodiment, zones in 5G networks or other next generation communication networks enable uplink-based mobility framework and improves efficiency of both a UE and a network, since amounts of mobility messages that need to be exchanged between a UE and a network may be reduced.

In at least one embodiment, air interface in a radio access network 2900 may utilize unlicensed spectrum, licensed spectrum, or shared spectrum. In at least one embodiment, unlicensed spectrum provides for shared use of a portion of a spectrum without need for a government-granted license, however, while compliance with some technical rules is generally still required to access an unlicensed spectrum, generally, any operator or device may gain access. In at least one embodiment, licensed spectrum provides for exclusive use of a portion of a spectrum, generally by virtue of a mobile network operator purchasing a license from a government regulatory body. In at least one embodiment, shared spectrum may fall between licensed and unlicensed spectrum, wherein technical rules or limitations may be required to access a spectrum, but a spectrum may still be shared by multiple operators and/or multiple RATs. In at least one embodiment, a holder of a license for a portion of licensed spectrum may provide licensed shared access (LSA) to share that spectrum with other parties, e.g., with suitable licensee-determined conditions to gain access.

In at least one embodiment, radio access network 2900 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

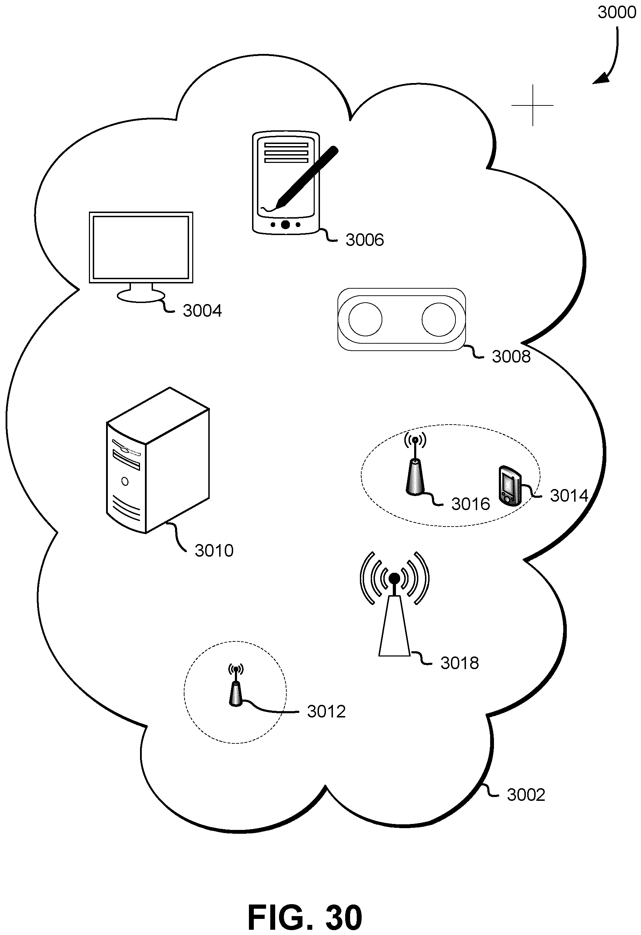

FIG. 30 provides an example illustration of a 5G mobile communications system 3000 in which a plurality of different types of devices 3002 is used, in accordance with at least one embodiment. In at least one embodiment, as shown in FIG. 30, a first base station 3018 may be provided to a large cell or macro cell in which transmission of signals is over several kilometers. In at least one embodiment, however, system may also support transmission via a very small cell such as transmitted by a second infrastructure equipment 3016 which transmits and receives signals over a distance of hundreds of meters thereby forming a so called "Pico" cell. In at least one embodiment, a third type of infrastructure equipment 3012 may transmit and receive signals over a distance of tens of meters and therefore can be used to form a so called "Femto" cell.

In at least one embodiment, also shown in FIG. 30, different types of communications devices may be used to transmit and receive signals via different types of infrastructure equipment 3012, 3016, 3018 and communication of data may be adapted in accordance with different types of infrastructure equipment using different communications parameters. In at least one embodiment, conventionally, a mobile communications device may be configured to communicate data to and from a mobile communications network via available communication resources of network. In at least one embodiment, a wireless access system is configured to provide highest data rates to devices such as smart phones 3006. In at least one embodiment, "internet of things" may be provided in which low power machine type communications devices transmit and receive data at very low power, low bandwidth and may have a low complexity. In at least one embodiment, an example of such a machine type communication device 3014 may communicate via a Pico cell 3016. In at least one embodiment, a very high data rate and a low mobility may be characteristic of communications with, for example, a television 3004 which may be communicating via a Pico cell. In at least one embodiment, a very high data rate and low latency may be required by a virtual reality headset 3008. In at least one embodiment, a relay device 3010 may be deployed to extend size or coverage area of a given cell or network.

In at least one embodiment, 5G mobile communications system 3000 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

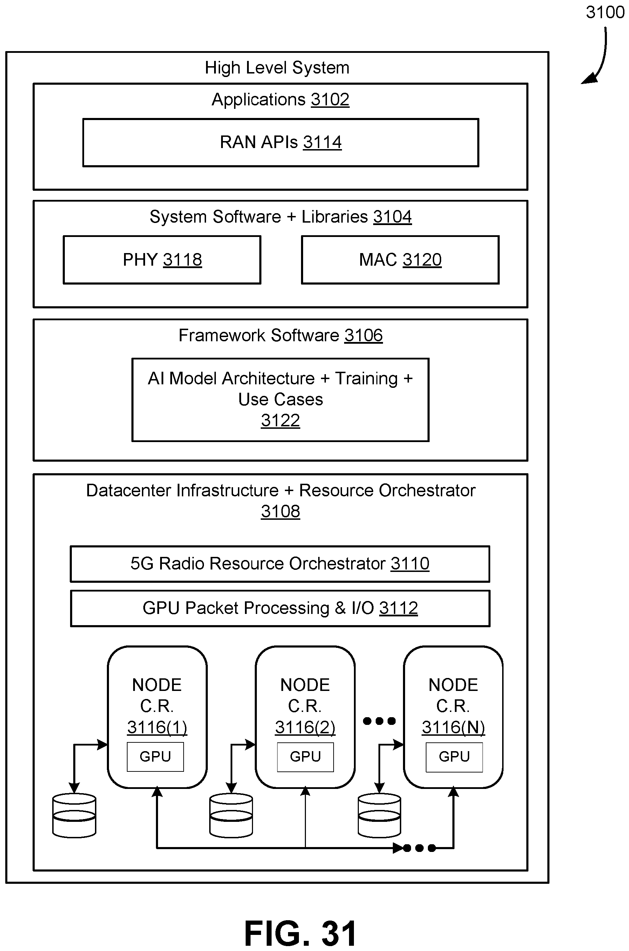

FIG. 31 illustrates an example high level system 3100, in which at least one embodiment may be used. In at least one embodiment, high level system 3100 includes applications 3102, system software + libraries 3104, framework software 3106 and a datacenter infrastructure + resource orchestrator 3108. In at least one embodiment, high level system 3100 may be implemented as a cloud service, physical service, virtual service, network service, and/or variations thereof.

In at least one embodiment, as shown in FIG. 31, datacenter infrastructure + resource orchestrator 3108 may include 5G radio resource orchestrator 3110, GPU packet processing & I/O 3112, and node computing resources ("node C.R.s") 3116(1)-3116(N), where "N" represents any whole, positive integer. In at least one embodiment, node C.R.s 3116(1)-3116(N) may include, but are not limited to, any number of central processing units ("CPUs") or other processors (including accelerators, field programmable gate arrays (FPGAs), graphics processors ("GPUs"), etc.), memory devices (e.g., dynamic read-only memory), storage devices (e.g., solid state or disk drives), network input/output ("NW I/O") devices, network switches, virtual machines ("VMs"), power modules, and cooling modules, etc. In at least one embodiment, one or more node C.R.s from among node C.R.s 3116(1)-3116(N) may be a server having one or more of above-mentioned computing resources.

In at least one embodiment, 5G radio resource orchestrator 3110 may configure or otherwise control one or more node C.R.s 3116(1)-3116(N) and/or other various components and resources a 5G network architecture may comprise. In at least one embodiment, 5G radio resource orchestrator 3110 may include a software design infrastructure ("SDI") management entity for high level system 3100. In at least one embodiment, 5G radio resource orchestrator 3110 may include hardware, software, or some combination thereof. In at least one embodiment, 5G radio resource orchestrator 3110 may be utilized to configure or otherwise control various medium access control sublayers, radio access networks, physical layers or sublayers, and/or variations thereof, which may be part of a 5G network architecture. In at least one embodiment, 5G radio resource orchestrator 3110 may configure or allocate grouped compute, network, memory or storage resources to support one or more workloads which may be executed as part of a 5G network architecture.

In at least one embodiment, GPU packet processing & I/O 3112 may configure or otherwise process various inputs and outputs, as well as packets such as data packets, which may be transmitted/received as part of a 5G network architecture, which may be implemented by high level system 3100. In at least one embodiment, a packet may be data formatted to be provided by a network and may be typically divided into control information and payload (i.e., user data). In at least one embodiment, types of packets may include Internet Protocol version 4 (IPv4) packets, Internet Protocol version 6 (IPv6) packets, and Ethernet II frame packets. In at least one embodiment, control data of a data packet may be classified into data integrity fields and semantic fields. In at least one embodiment, network connections that a data packet may be received upon include a local area network, a wide-area network, a virtual private network, Internet, an intranet, an extranet, a public switched telephone network, an infrared network, a wireless network, a satellite network, and any combination thereof.

In at least one embodiment, framework software 3106 includes an AI Model Architecture + Training + Use Cases 3122. In at least one embodiment, AI Model Architecture + Training + Use Cases 3122 may include tools, services, software, or other resources to train one or more machine learning models or predict or infer information using one or more machine learning models according to one or more embodiments. For example, in at least one embodiment, a machine learning model may be trained by calculating weight parameters according to a neural network architecture using software and computing resources described above with respect to high level system 3100. In at least one embodiment, trained machine learning models corresponding to one or more neural networks may be used to infer or predict information using resources described above with respect to high level system 3100 by using weight parameters calculated through one or more training techniques. In at least one embodiment, framework software 3106 may include a framework to support system software + libraries 3104 and applications 3102.

In at least one embodiment, system software + libraries 3104 or applications 3102 may respectively include web-based service software or applications, such as those provided by Amazon Web Services, Google Cloud and Microsoft Azure. In at least one embodiment, framework software 3106 may include, but is not limited to, a type of free and open-source software web application framework such as Apache SparkTM (hereinafter "Spark"). In at least one embodiment, system software + libraries 3104 may include software used by at least portions of node C.R.s 3116(1)-3116(N). In at least one embodiment, one or more types of software may include, but are not limited to, Internet web page search software, e-mail virus scan software, database software, and streaming video content software.

In at least one embodiment, PHY 3118 is a set of system software and libraries configured to provide an interface with a physical layer of a wireless technology, which may be a physical layer such as a 5G New Radio (NR) physical layer. In at least one embodiment, an NR physical layer utilizes a flexible and scalable design and may comprise various components and technologies, such as modulation schemes, waveform structures, frame structures, reference signals, multi-antenna transmission and channel coding.

In at least one embodiment, a NR physical layer supports quadrature phase shift keying (QPSK), 16 quadrature amplitude modulation (QAM), 64 QAM and 256 QAM modulation formats. In at least one embodiment, different modulation schemes for different user entity (UE) categories may also be included in a NR physical layer. In at least one embodiment, a NR physical layer may utilize cyclic prefix orthogonal frequency division multiplexing (CP-OFDM) with a scalable numerology (subcarrier spacing, cyclic prefix) in both uplink (UL) and downlink (DL) up to at least 52.6GHz. In at least one embodiment, a NR physical layer may support discrete Fourier transform spread orthogonal frequency division multiplexing (DFT-SOFDM) in UL for coverage-limited scenarios, with single stream transmissions (that is, without spatial multiplexing).

In at least one embodiment, a NR frame supports time division duplex (TDD) and frequency division duplex (FDD) transmissions and operation in both licensed and unlicensed spectrum, which enables very low latency, fast hybrid automatic repeat request (HARQ) acknowledgements, dynamic TDD, coexistence with LTE and transmissions of variable length (for example, short duration for ultra-reliable low-latency communications (URLLC) and long duration for enhanced mobile broadband (eMBB)). In at least one embodiment, NR frame structure follows three key design principles to enhance forward compatibility and reduce interactions between different features.

In at least one embodiment, a first principle is that transmissions are self-contained, which can refer to a scheme in which data in a slot and in a beam are decodable on its own without dependency on other slots and beams. In at least one embodiment, this implies that reference signals required for demodulation of data are included in a given slot and a given beam. In at least one embodiment, a second principle is that transmissions are well confined in time and frequency, which results in a scheme in which new types of transmissions in parallel with legacy transmissions may be introduced. In at least one embodiment, a third principle is avoiding static and/or strict timing relations across slots and across different transmission directions. In at least one embodiment, usage of a third principle can entail utilizing asynchronous hybrid automatic repeat request (HARQ) instead of predefined retransmission time.

In at least one embodiment, NR frame structure also allows for rapid HARQ acknowledgement, in which decoding is performed during reception of DL data and HARQ acknowledgement is prepared by a UE during a guard period, when switching from DL reception to UL transmission. In at least one embodiment, to obtain low latency, a slot (or a set of slots in case of slot aggregation) is front-loaded with control signals and reference signals at a beginning of a slot (or set of slots).

In at least one embodiment, NR has an ultra-lean design that minimizes always-on transmissions to enhance network energy efficiency and ensure forward compatibility. In at least one embodiment, reference signals in NR are transmitted only when necessary. In at least one embodiment, four main reference signals are demodulation reference signal (DMRS), phase-tracking reference signal (PTRS), sounding reference signal (SRS) and channel-state information reference signal (CSI-RS).

In at least one embodiment, DMRS is used to estimate a radio channel for demodulation. In at least one embodiment, DMRS is UE-specific, can be beamformed, confined in a scheduled resource, and transmitted only when necessary, both in DL and UL. In at least one embodiment, to support multiple-layer multiple-input, multiple-output (MIMO) transmission, multiple orthogonal DMRS ports can be scheduled, one for each layer. In at least one embodiment, a basic DMRS pattern is front loaded, as a DMRS design takes into account an early decoding requirement to support low-latency applications. In at least one embodiment, for low-speed scenarios, DMRS uses low density in a time domain. In at least one embodiment, however, for high-speed scenarios, a time density of DMRS is increased to track fast changes in a radio channel.

In at least one embodiment, PTRS is introduced in NR to enable compensation of oscillator phase noise. In at least one embodiment, typically, phase noise increases as a function of oscillator carrier frequency. In at least one embodiment, PTRS can therefore be utilized at high carrier frequencies (such as mmWave) to mitigate phase noise. In at least one embodiment, PTRS is UE-specific, confined in a scheduled resource and can be beamformed. In at least one embodiment, PTRS is configurable depending on a quality of oscillators, carrier frequency, OFDM sub-carrier spacing, and modulation and coding schemes used for transmission.

In at least one embodiment, SRS is transmitted in UL to perform channel state information (CSI) measurements mainly for scheduling and link adaptation. In at least one embodiment, for NR, SRS is also utilized for reciprocity-based precoder design for massive MIMO and UL beam management. In at least one embodiment, SRS has a modular and flexible design to support different procedures and UE capabilities. In at least one embodiment, an approach for channel state information reference signal (CSI-RS) is similar.

In at least one embodiment, NR employs different antenna solutions and techniques depending on which part of a spectrum is used for its operation. In at least one embodiment, for lower frequencies, a low to moderate number of active antennas (up to around 32 transmitter chains) is assumed and FDD operation is common. In at least one embodiment, acquisition of CSI requires transmission of CSI-RS in a DL and CSI reporting in an UL. In at least one embodiment, limited bandwidths available in this frequency region require high spectral efficiency enabled by multi-user MIMO (MU-MIMO) and higher order spatial multiplexing, which is achieved via higher resolution CSI reporting compared with LTE.

In at least one embodiment, for higher frequencies, a larger number of antennas can be employed in a given aperture, which increases a capability for beamforming and multiuser (MU)-MIMO. In at least one embodiment, here, spectrum allocations are of TDD type and reciprocity-based operation is assumed. In at least one embodiment, high-resolution CSI in a form of explicit channel estimations is acquired by UL channel sounding. In at least one embodiment, such high-resolution CSI enables sophisticated precoding algorithms to be employed at a base station (BS). In at least one embodiment, for even higher frequencies (in mmWave range) an analog beamforming implementation is typically required currently, which limits transmission to a single beam direction per time unit and radio chain. In at least one embodiment, since an isotropic antenna element is very small in this frequency region owing to a short carrier wavelength, a great number of antenna elements is required to maintain coverage. In at least one embodiment, beamforming needs to be applied at both transmitter and receiver ends to combat increased path loss, even for control channel transmission.

In at least one embodiment, to support these diverse use cases, NR features a highly flexible but unified CSI framework, in which there is reduced coupling between CSI measurement, CSI reporting and an actual DL transmission in NR compared with LTE. In at least one embodiment, NR also supports more advanced schemes such as multi-point transmission and coordination. In at least one embodiment, control and data transmissions follow a self-contained principle, where all information required to decode a transmission (such as accompanying DMRS) is contained within a transmission itself. In at least one embodiment, as a result, a network can seamlessly change a transmission point or beam as a UE moves in a network.

In at least one embodiment, MAC 3120 is a set of system software and libraries configured to provide an interface with a medium access control (MAC) layer, which may be part of a 5G network architecture. In at least one embodiment, a MAC layer controls hardware responsible for interaction with a wired, optical, or wireless transmission medium. In at least one embodiment, MAC provides flow control and multiplexing for a transmission medium.

In at least one embodiment, a MAC sublayer provides an abstraction of a physical layer such that complexities of a physical link control are invisible to a logical link control (LLC) and upper layers of a network stack. In at least one embodiment, any LLC sublayer (and higher layers) may be used with any MAC. In at least one embodiment, any MAC can be used with any physical layer, independent of transmission medium. In at least one embodiment, a MAC sublayer, when sending data to another device on a network, encapsulates higher-level frames into frames appropriate for a transmission medium, adds a frame check sequence to identify transmission errors, and then forwards data to a physical layer as soon as appropriate channel access method permits it. In at least one embodiment, MAC is also responsible for compensating for collisions if a jam signal is detected, in which a MAC may initiate retransmission.

In at least one embodiment, applications 3102 may include one or more types of applications used by at least portions of node C.R.s 3116(1)-3116(N)and/or framework software 3106. In at least one embodiment, one or more types of applications may include, but are not limited to, any number of a genomics application, a cognitive compute, and a machine learning application, including training or inferencing software, machine learning framework software (e.g., PyTorch, TensorFlow, Caffe, etc.) or other machine learning applications used in conjunction with one or more embodiments.

In at least one embodiment, RAN APIs 3114 may be a set of subroutine definitions, communication protocols, and/or software tools that provide a method of communication with components of a radio access network (RAN) which may be part of a 5G network architecture. In at least one embodiment, a radio access network is part of a network communications system and may implement a radio access technology. In at least one embodiment, radio access network functionality is typically provided by a silicon chip residing in both a core network as well as user equipment. Further information regarding a radio access network can be found in the description of FIG. 29.

In at least one embodiment, high level system 3100 may use CPUs, application-specific integrated circuits (ASICs), GPUs, FPGAs, or other hardware to perform training, inferencing, and/or other various processes using above-described resources. In at least one embodiment, moreover, one or more software and/or hardware resources described above may be configured as a service to allow users to train or performing inferencing of information, such as image recognition, speech recognition, or other artificial intelligence services, as well as other services such as services that allow users to configure and implement various aspects of a 5G network architecture.

In at least one embodiment, high level system 3100 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

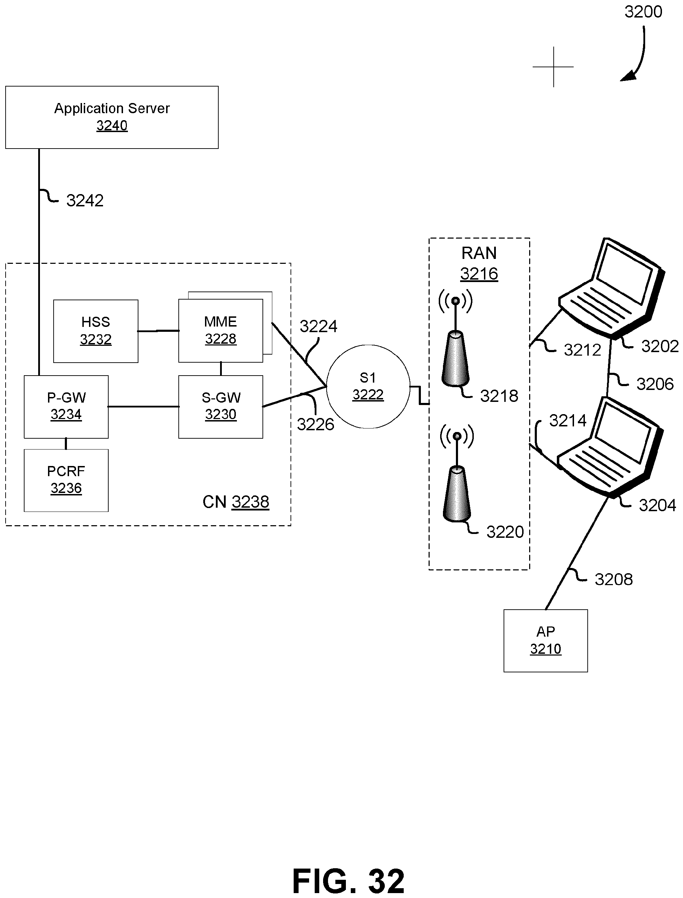

FIG. 32 illustrates an architecture of a system 3200 of a network, in accordance with at least one embodiment. In at least one embodiment, system 3200 is shown to include a user equipment (UE) 3202 and a UE 3204. In at least one embodiment, UEs 3202 and 3204 are illustrated as smartphones (e.g., handheld touchscreen mobile computing devices connectable to one or more cellular networks) but may also comprise any mobile or non-mobile computing device, such as Personal Data Assistants (PDAs), pagers, laptop computers, desktop computers, wireless handsets, or any computing device including a wireless communications interface.

In at least one embodiment, any of UEs 3202 and 3204 can comprise an Internet of Things (IoT) UE, which can comprise a network access layer designed for low-power IoT applications utilizing short-lived UE connections. In at least one embodiment, an IoT UE can utilize technologies such as machine-to-machine (M2M) or machine-type communications (MTC) for exchanging data with an MTC server or device via a public land mobile network (PLMN), Proximity-Based Service (ProSe) or device-to-device (D2D) communication, sensor networks, or IoT networks. In at least one embodiment, a M2M or MTC exchange of data may be a machine-initiated exchange of data. In at least one embodiment, an IoT network describes interconnecting IoT UEs, which may include uniquely identifiable embedded computing devices (within Internet infrastructure), with short-lived connections. In at least one embodiment, an IoT UEs may execute background applications (e.g., keep alive messages, status updates, etc.) to facilitate connections of an IoT network.

In at least one embodiment, UEs 3202 and 3204 may be configured to connect, e.g., communicatively couple, with a radio access network (RAN) 3216. In at least one embodiment, RAN 3216 may be, for example, an Evolved Universal Mobile Telecommunications System (UMTS) Terrestrial Radio Access Network (E-UTRAN), a NextGen RAN (NG RAN), or some other type of RAN. In at least one embodiment, UEs 3202 and 3204 utilize connections 3212 and 3214, respectively, each of which comprises a physical communications interface or layer. In at least one embodiment, connections 3212 and 3214 are illustrated as an air interface to enable communicative coupling, and can be consistent with cellular communications protocols, such as a Global System for Mobile Communications (GSM) protocol, a code-division multiple access (CDMA) network protocol, a Push-to-Talk (PTT) protocol, a PTT over Cellular (POC) protocol, a Universal Mobile Telecommunications System (UMTS) protocol, a 3GPP Long Term Evolution (LTE) protocol, a fifth generation (5G) protocol, a New Radio (NR) protocol, and variations thereof.

In at least one embodiment, UEs 3202 and 3204 may further directly exchange communication data via a ProSe interface 3206. In at least one embodiment, ProSe interface 3206 may alternatively be referred to as a sidelink interface comprising one or more logical channels, including but not limited to a Physical Sidelink Control Channel (PSCCH), a Physical Sidelink Shared Channel (PSSCH), a Physical Sidelink Discovery Channel (PSDCH), and a Physical Sidelink Broadcast Channel (PSBCH).

In at least one embodiment, UE 3204 is shown to be configured to access an access point (AP) 3210 via connection 3208. In at least one embodiment, connection 3208 can comprise a local wireless connection, such as a connection consistent with any IEEE 802.11 protocol, wherein AP 3210 would comprise a wireless fidelity (WiFi^{®}) router. In at least one embodiment, AP 3210 is shown to be connected to an Internet without connecting to a core network of a wireless system.

In at least one embodiment, RAN 3216 can include one or more access nodes that enable connections 3212 and 3214. In at least one embodiment, these access nodes (ANs) can be referred to as base stations (BSs), NodeBs, evolved NodeBs (eNBs), next Generation NodeBs (gNB), RAN nodes, and so forth, and can comprise ground stations (e.g., terrestrial access points) or satellite stations providing coverage within a geographic area (e.g., a cell). In at least one embodiment, RAN 3216 may include one or more RAN nodes for providing macrocells, e.g., macro RAN node 3218, and one or more RAN nodes for providing femtocells or picocells (e.g., cells having smaller coverage areas, smaller user capacity, or higher bandwidth compared to macrocells), e.g., low power (LP) RAN node 3220.

In at least one embodiment, any of RAN nodes 3218 and 3220 can terminate an air interface protocol and can be a first point of contact for UEs 3202 and 3204. In at least one embodiment, any of RAN nodes 3218 and 3220 can fulfill various logical functions for RAN 3216 including, but not limited to, radio network controller (RNC) functions such as radio bearer management, uplink and downlink dynamic radio resource management and data packet scheduling, and mobility management.

In at least one embodiment, UEs 3202 and 3204 can be configured to communicate using Orthogonal Frequency-Division Multiplexing (OFDM) communication signals with each other or with any of RAN nodes 3218 and 3220 over a multi-carrier communication channel in accordance various communication techniques, such as, but not limited to, an Orthogonal Frequency Division Multiple Access (OFDMA) communication technique (e.g., for downlink communications) or a Single Carrier Frequency Division Multiple Access (SC-FDMA) communication technique (e.g., for uplink and ProSe or sidelink communications), and/or variations thereof. In at least one embodiment, OFDM signals can comprise a plurality of orthogonal sub-carriers.

In at least one embodiment, a downlink resource grid can be used for downlink transmissions from any of RAN nodes 3218 and 3220 to UEs 3202 and 3204, while uplink transmissions can utilize similar techniques. In at least one embodiment, a grid can be a time frequency grid, called a resource grid or time-frequency resource grid, which is a physical resource in a downlink in each slot. In at least one embodiment, such a time frequency plane representation is a common practice for OFDM systems, which makes it intuitive for radio resource allocation. In at least one embodiment, each column and each row of a resource grid corresponds to one OFDM symbol and one OFDM subcarrier, respectively. In at least one embodiment, a duration of a resource grid in a time domain corresponds to one slot in a radio frame. In at least one embodiment, a smallest time-frequency unit in a resource grid is denoted as a resource element. In at least one embodiment, each resource grid comprises a number of resource blocks, which describe a mapping of certain physical channels to resource elements. In at least one embodiment, each resource block comprises a collection of resource elements. In at least one embodiment, in a frequency domain, this may represent a smallest quantity of resources that currently can be allocated. In at least one embodiment, there are several different physical downlink channels that are conveyed using such resource blocks.

In at least one embodiment, a physical downlink shared channel (PDSCH) may carry user data and higher-layer signaling to UEs 3202 and 3204. In at least one embodiment, a physical downlink control channel (PDCCH) may carry information about a transport format and resource allocations related to PDSCH channel, among other things. In at least one embodiment, it may also inform UEs 3202 and 3204 about a transport format, resource allocation, and HARQ (Hybrid Automatic Repeat Request) information related to an uplink shared channel. In at least one embodiment, typically, downlink scheduling (assigning control and shared channel resource blocks to UE 3202 within a cell) may be performed at any of RAN nodes 3218 and 3220 based on channel quality information fed back from any of UEs 3202 and 3204. In at least one embodiment, downlink resource assignment information may be sent on a PDCCH used for (e.g., assigned to) each of UEs 3202 and 3204.

In at least one embodiment, a PDCCH may use control channel elements (CCEs) to convey control information. In at least one embodiment, before being mapped to resource elements, PDCCH complex valued symbols may first be organized into quadruplets, which may then be permuted using a sub-block interleaver for rate matching. In at least one embodiment, each PDCCH may be transmitted using one or more of these CCEs, where each CCE may correspond to nine sets of four physical resource elements known as resource element groups (REGs). In at least one embodiment, four Quadrature Phase Shift Keying (QPSK) symbols may be mapped to each REG. In at least one embodiment, PDCCH can be transmitted using one or more CCEs, depending on a size of a downlink control information (DCI) and a channel condition. In at least one embodiment, there can be four or more different PDCCH formats defined in LTE with different numbers of CCEs (e.g., aggregation level, L=1, 2, 4, or 8).

In at least one embodiment, an enhanced physical downlink control channel (EPDCCH) that uses PDSCH resources may be utilized for control information transmission. In at least one embodiment, EPDCCH may be transmitted using one or more enhanced control channel elements (ECCEs). In at least one embodiment, each ECCE may correspond to nine sets of four physical resource elements known as an enhanced resource element group (EREG). In at least one embodiment, an ECCE may have other numbers of EREGs in some situations.

In at least one embodiment, RAN 3216 is shown to be communicatively coupled to a core network (CN) 3238 via an S1 interface 3222. In at least one embodiment, CN 3238 may be an evolved packet core (EPC) network, a NextGen Packet Core (NPC) network, or some other type of CN. In at least one embodiment, S1 interface 3222 is split into two parts: S1-U interface 3226, which carries traffic data between RAN nodes 3218 and 3220 and serving gateway (S-GW) 3230, and a S1-mobility management entity (MME) interface 3224, which is a signaling interface between RAN nodes 3218 and 3220 and MMEs 3228.

In at least one embodiment, CN 3238 comprises MMEs 3228, S-GW 3230, Packet Data Network (PDN) Gateway (P-GW) 3234, and a home subscriber server (HSS) 3232. In at least one embodiment, MMEs 3228 may be similar in function to a control plane of legacy Serving General Packet Radio Service (GPRS) Support Nodes (SGSN). In at least one embodiment, MMEs 3228 may manage mobility aspects in access such as gateway selection and tracking area list management. In at least one embodiment, HSS 3232 may comprise a database for network users, including subscription related information to support a network entities' handling of communication sessions. In at least one embodiment, CN 3238 may comprise one or several HSSs 3232, depending on a number of mobile subscribers, on a capacity of an equipment, on an organization of a network, etc. In at least one embodiment, HSS 3232 can provide support for routing/roaming, authentication, authorization, naming/addressing resolution, location dependencies, etc.

In at least one embodiment, S-GW 3230 may terminate a S1 interface 3222 towards RAN 3216, and routes data packets between RAN 3216 and CN 3238. In at least one embodiment, S-GW 3230 may be a local mobility anchor point for inter-RAN node handovers and also may provide an anchor for inter-3GPP mobility. In at least one embodiment, other responsibilities may include lawful intercept, charging, and some policy enforcement.

In at least one embodiment, P-GW 3234 may terminate an SGi interface toward a PDN. In at least one embodiment, P-GW 3234 may route data packets between an EPC network 3238 and external networks such as a network including application server 3240 (alternatively referred to as application function (AF)) via an Internet Protocol (IP) interface 3242. In at least one embodiment, application server 3240 may be an element offering applications that use IP bearer resources with a core network (e.g., UMTS Packet Services (PS) domain, LTE PS data services, etc.). In at least one embodiment, P-GW 3234 is shown to be communicatively coupled to an application server 3240 via an IP communications interface 3242. In at least one embodiment, application server 3240 can also be configured to support one or more communication services (e.g., Voice-over-Internet Protocol (VoIP) sessions, PTT sessions, group communication sessions, social networking services, etc.) for UEs 3202 and 3204 via CN 3238.

In at least one embodiment, P-GW 3234 may further be a node for policy enforcement and charging data collection. In at least one embodiment, policy and Charging Enforcement Function (PCRF) 3236 is a policy and charging control element of CN 3238. In at least one embodiment, in a non-roaming scenario, there may be a single PCRF in a Home Public Land Mobile Network (HPLMN) associated with a UE's Internet Protocol Connectivity Access Network (IP-CAN) session. In at least one embodiment, in a roaming scenario with local breakout of traffic, there may be two PCRFs associated with a UE's IP-CAN session: a Home PCRF (H-PCRF) within a HPLMN and a Visited PCRF (V-PCRF) within a Visited Public Land Mobile Network (VPLMN). In at least one embodiment, PCRF 3236 may be communicatively coupled to application server 3240 via P-GW 3234. In at least one embodiment, application server 3240 may signal PCRF 3236 to indicate a new service flow and select an appropriate Quality of Service (QoS) and charging parameters. In at least one embodiment, PCRF 3236 may provision this rule into a Policy and Charging Enforcement Function (PCEF) (not shown) with an appropriate traffic flow template (TFT) and QoS class of identifier (QCI), which commences a QoS and charging as specified by application server 3240.

In at least one embodiment, system 3200 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

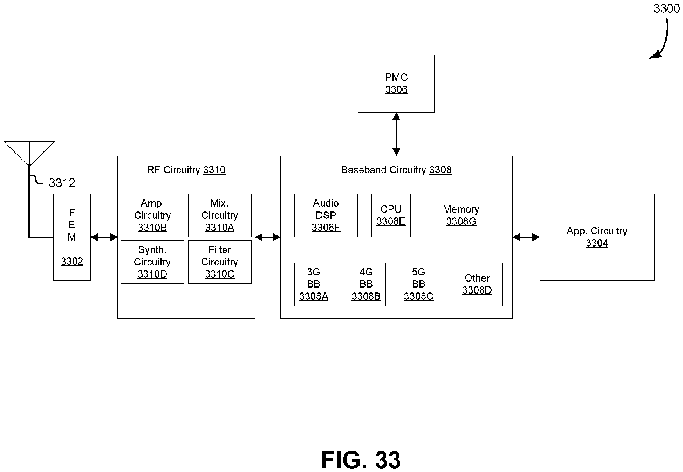

FIG. 33 illustrates example components of a device 3300 in accordance with at least one embodiment. In at least one embodiment, device 3300 may include application circuitry 3304, baseband circuitry 3308, Radio Frequency (RF) circuitry 3310, front-end module (FEM) circuitry 3302, one or more antennas 3312, and power management circuitry (PMC) 3306 coupled together at least as shown. In at least one embodiment, components of illustrated device 3300 may be included in a UE or a RAN node. In at least one embodiment, device 3300 may include less elements (e.g., a RAN node may not utilize application circuitry 3304, and instead include a processor/controller to process IP data received from an EPC). In at least one embodiment, device 3300 may include additional elements such as, for example, memory/storage, display, camera, sensor, or input/output (I/O) interface. In at least one embodiment, components described below may be included in more than one device (e.g., said circuitries may be separately included in more than one device for Cloud-RAN (C-RAN) implementations).

In at least one embodiment, application circuitry 3304 may include one or more application processors. In at least one embodiment, application circuitry 3304 may include circuitry such as, but not limited to, one or more single-core or multi-core processors. In at least one embodiment, processor(s) may include any combination of general purpose processors and dedicated processors (e.g., graphics processors, application processors, etc.). In at least one embodiment, processors may be coupled with or may include memory/storage and may be configured to execute instructions stored in memory/storage to enable various applications or operating systems to run on device 3300. In at least one embodiment, processors of application circuitry 3304 may process IP data packets received from an EPC.

In at least one embodiment, baseband circuitry 3308 may include circuitry such as, but not limited to, one or more single-core or multi-core processors. In at least one embodiment, baseband circuitry 3308 may include one or more baseband processors or control logic to process baseband signals received from a receive signal path of RF circuitry 3310 and to generate baseband signals for a transmit signal path of RF circuitry 3310. In at least one embodiment, baseband processing circuity 3308 may interface with application circuitry 3304 for generation and processing of baseband signals and for controlling operations of RF circuitry 3310. In at least one embodiment, baseband circuitry 3308 may include a third generation (3G) baseband processor 3308A, a fourth generation (4G) baseband processor 3308B, a fifth generation (5G) baseband processor 3308C, or other baseband processor(s) 3308D for other existing generations, generations in development or to be developed (e.g., second generation (2G), sixth generation (6G), etc.). In at least one embodiment, baseband circuitry 3308 (e.g., one or more of base-band processors 3308A-D) may handle various radio control functions that enable communication with one or more radio networks via RF circuitry 3310. In at least one embodiment, some, or all of a functionality of baseband processors 3308A-D may be included in modules stored in memory 3308G and executed via a Central Processing Unit (CPU) 3308E. In at least one embodiment, radio control functions may include, but are not limited to, signal modulation/demodulation, encoding/decoding, radio frequency shifting, etc. In at least one embodiment, modulation/demodulation circuitry of baseband circuitry 3308 may include Fast-Fourier Transform (FFT), precoding, or constellation mapping/demapping functionality. In at least one embodiment, encoding/decoding circuitry of baseband circuitry 3308 may include convolution, tail biting convolution, turbo, Viterbi, or Low Density Parity Check (LDPC) encoder/decoder functionality.

In at least one embodiment, baseband circuitry 3308 may include one or more audio digital signal processor(s) (DSP) 3308F. In at least one embodiment, audio DSP(s) 3308F may be include elements for compression/decompression and echo cancellation and may include other suitable processing elements in other embodiments. In at least one embodiment, components of baseband circuitry may be suitably combined in a single chip, a single chipset, or disposed on a same circuit board in some embodiments. In at least one embodiment, some, or all of constituent components of baseband circuitry 3308 and application circuitry 3304 may be implemented together such as, for example, on a system on a chip (SOC).

In at least one embodiment, baseband circuitry 3308 may provide for communication compatible with one or more radio technologies. In at least one embodiment, baseband circuitry 3308 may support communication with an evolved universal terrestrial radio access network (EUTRAN) or other wireless metropolitan area networks (WMAN), a wireless local area network (WLAN), a wireless personal area network (WPAN). In at least one embodiment, baseband circuitry 3308 is configured to support radio communications of more than one wireless protocol and may be referred to as multimode baseband circuitry.

In at least one embodiment, RF circuitry 3310 may enable communication with wireless networks using modulated electromagnetic radiation through a non-solid medium. In at least one embodiment, RF circuitry 3310 may include switches, filters, amplifiers, etc. to facilitate communication with a wireless network. In at least one embodiment, RF circuitry 3310 may include a receive signal path which may include circuitry to down-convert RF signals received from FEM circuitry 3302 and provide baseband signals to baseband circuitry 3308. In at least one embodiment, RF circuitry 3310 may also include a transmit signal path which may include circuitry to up-convert baseband signals provided by baseband circuitry 3308 and provide RF output signals to FEM circuitry 3302 for transmission.

In at least one embodiment, receive signal path of RF circuitry 3310 may include mixer circuitry 3310a, amplifier circuitry 3310b and filter circuitry 3310c. In at least one embodiment, a transmit signal path of RF circuitry 3310 may include filter circuitry 3310c and mixer circuitry 3310a. In at least one embodiment, RF circuitry 3310 may also include synthesizer circuitry 3310d for synthesizing a frequency for use by mixer circuitry 33 10a of a receive signal path and a transmit signal path. In at least one embodiment, mixer circuitry 3310a of a receive signal path may be configured to down-convert RF signals received from FEM circuitry 3302 based on a synthesized frequency provided by synthesizer circuitry 3310d. In at least one embodiment, amplifier circuitry 3310b may be configured to amplify down-converted signals and filter circuitry 3310c may be a low-pass filter (LPF) or band-pass filter (BPF) configured to remove unwanted signals from down-converted signals to generate output baseband signals. In at least one embodiment, output baseband signals may be provided to baseband circuitry 3308 for further processing. In at least one embodiment, output baseband signals may be zero-frequency baseband signals, although this is not a requirement. In at least one embodiment, mixer circuitry 3310a of a receive signal path may comprise passive mixers.

In at least one embodiment, mixer circuitry 3310a of a transmit signal path may be configured to up-convert input baseband signals based on a synthesized frequency provided by synthesizer circuitry 3310d to generate RF output signals for FEM circuitry 3302. In at least one embodiment, baseband signals may be provided by baseband circuitry 3308 and may be filtered by filter circuitry 3310c.

In at least one embodiment, mixer circuitry 3310a of a receive signal path and mixer circuitry 3310a of a transmit signal path may include two or more mixers and may be arranged for quadrature down conversion and up conversion, respectively. In at least one embodiment, mixer circuitry 3310a of a receive signal path and mixer circuitry 3310a of a transmit signal path may include two or more mixers and may be arranged for image rejection (e.g., Hartley image rejection). In at least one embodiment, mixer circuitry 33 10a of a receive signal path and mixer circuitry 3310a may be arranged for direct down conversion and direct up conversion, respectively. In at least one embodiment, mixer circuitry 3310a of a receive signal path and mixer circuitry 3310a of a transmit signal path may be configured for super-heterodyne operation.

In at least one embodiment, output baseband signals and input baseband signals may be analog baseband signals. In at least one embodiment, output baseband signals and input baseband signals may be digital baseband signals. In at least one embodiment, RF circuitry 3310 may include analog-to-digital converter (ADC) and digital-to-analog converter (DAC) circuitry and baseband circuitry 3308 may include a digital baseband interface to communicate with RF circuitry 3310.

In at least one embodiment, a separate radio IC circuitry may be provided for processing signals for each spectrum In at least one embodiment, synthesizer circuitry 33 lOd may be a fractional-N synthesizer or a fractional N/N+1 synthesizer. In at least one embodiment, synthesizer circuitry 3310d may be a delta-sigma synthesizer, a frequency multiplier, or a synthesizer comprising a phase-locked loop with a frequency divider.

In at least one embodiment, synthesizer circuitry 3310d may be configured to synthesize an output frequency for use by mixer circuitry 3310a of RF circuitry 3310 based on a frequency input and a divider control input. In at least one embodiment, synthesizer circuitry 3310d may be a fractional N/N+1 synthesizer.

In at least one embodiment, frequency input may be provided by a voltage-controlled oscillator (VCO). In at least one embodiment, divider control input may be provided by either baseband circuitry 3308 or applications processor 3304 depending on a desired output frequency. In at least one embodiment, a divider control input (e.g., N) may be determined from a look-up table based on a channel indicated by applications processor 3304.

In at least one embodiment, synthesizer circuitry 3310d of RF circuitry 3310 may include a divider, a delay-locked loop (DLL), a multiplexer and a phase accumulator. In at least one embodiment, divider may be a dual modulus divider (DMD) and phase accumulator may be a digital phase accumulator (DPA). In at least one embodiment, DMD may be configured to divide an input signal by either N or N+1 (e.g., based on a carry out) to provide a fractional division ratio. In at least one embodiment, DLL may include a set of cascaded, tunable, delay elements, a phase detector, a charge pump, and a D-type flip-flop. In at least one embodiment, delay elements may be configured to break a VCO period up into Nd equal packets of phase, where Nd is a number of delay elements in a delay line. In at least one embodiment, in this way, DLL provides negative feedback to help ensure that total delay through a delay line is one VCO cycle.

In at least one embodiment, synthesizer circuitry 3310d may be configured to generate a carrier frequency as an output frequency, while in other embodiments, output frequency may be a multiple of a carrier frequency (e.g., twice a carrier frequency, four times a carrier frequency) and used in conjunction with quadrature generator and divider circuitry to generate multiple signals at a carrier frequency with multiple different phases with respect to each other. In at least one embodiment, output frequency may be a LO frequency (fLO). In at least one embodiment, RF circuitry 3310 may include an IQ/polar converter.

In at least one embodiment, FEM circuitry 3302 may include a receive signal path which may include circuitry configured to operate on RF signals received from one or more antennas 3312, amplify received signals and provide amplified versions of received signals to RF circuitry 3310 for further processing. In at least one embodiment, FEM circuitry 3302 may also include a transmit signal path which may include circuitry configured to amplify signals for transmission provided by RF circuitry 3310 for transmission by one or more of one or more antennas 3312. In at least one embodiment, amplification through a transmit or receive signal paths may be done solely in RF circuitry 3310, solely in FEM 3302, or in both RF circuitry 3310 and FEM 3302.

In at least one embodiment, FEM circuitry 3302 may include a TX/RX switch to switch between transmit mode and receive mode operation. In at least one embodiment, FEM circuitry may include a receive signal path and a transmit signal path. In at least one embodiment, a receive signal path of FEM circuitry may include an LNA to amplify received RF signals and provide amplified received RF signals as an output (e.g., to RF circuitry 3310). In at least one embodiment, a transmit signal path of FEM circuitry 3302 may include a power amplifier (PA) to amplify input RF signals (e.g., provided by RF circuitry 3310), and one or more filters to generate RF signals for subsequent transmission (e.g., by one or more of one or more antennas 3312).

In at least one embodiment, PMC 3306 may manage power provided to baseband circuitry 3308. In at least one embodiment, PMC 3306 may control power-source selection, voltage scaling, battery charging, or DC-to-DC conversion. In at least one embodiment, PMC 3306 may often be included when device 3300 is capable of being powered by a battery, for example, when device is included in a UE. In at least one embodiment, PMC 3306 may increase power conversion efficiency while providing desirable implementation size and heat dissipation characteristics.

In at least one embodiment, PMC 3306 may be additionally or alternatively coupled with, and perform similar power management operations for, other components such as, but not limited to, application circuitry 3304, RF circuitry 3310, or FEM 3302.

In at least one embodiment, PMC 3306 may control, or otherwise be part of, various power saving mechanisms of device 3300. In at least one embodiment, if device 3300 is in an RRC Connected state, where it is still connected to a RAN node as it expects to receive traffic shortly, then it may enter a state known as Discontinuous Reception Mode (DRX) after a period of inactivity. In at least one embodiment, during this state, device 3300 may power down for brief intervals of time and thus save power.

In at least one embodiment, if there is no data traffic activity for an extended period of time, then device 3300 may transition off to an RRC Idle state, where it disconnects from a network and does not perform operations such as channel quality feedback, handover, etc. In at least one embodiment, device 3300 goes into a very low power state and it performs paging where again it periodically wakes up to listen to a network and then powers down again. In at least one embodiment, device 3300 may not receive data in this state, in order to receive data, it must transition back to RRC Connected state.

In at least one embodiment, an additional power saving mode may allow a device to be unavailable to a network for periods longer than a paging interval (ranging from seconds to a few hours). In at least one embodiment, during this time, a device is totally unreachable to a network and may power down completely. In at least one embodiment, any data sent during this time incurs a large delay and it is assumed delay is acceptable.

In at least one embodiment, processors of application circuitry 3304 and processors of baseband circuitry 3308 may be used to execute elements of one or more instances of a protocol stack. In at least one embodiment, processors of baseband circuitry 3308, alone or in combination, may be used execute Layer 3, Layer 2, or Layer 1 functionality, while processors of application circuitry 3308 may utilize data (e.g., packet data) received from these layers and further execute Layer 4 functionality (e.g., transmission communication protocol (TCP) and user datagram protocol (UDP) layers). In at least one embodiment, layer 3 may comprise a radio resource control (RRC) layer. In at least one embodiment, Layer 2 may comprise a medium access control (MAC) layer, a radio link control (RLC) layer, and a packet data convergence protocol (PDCP) layer. In at least one embodiment, Layer 1 may comprise a physical (PHY) layer of a UE/RAN node.

In at least one embodiment, device 3300 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

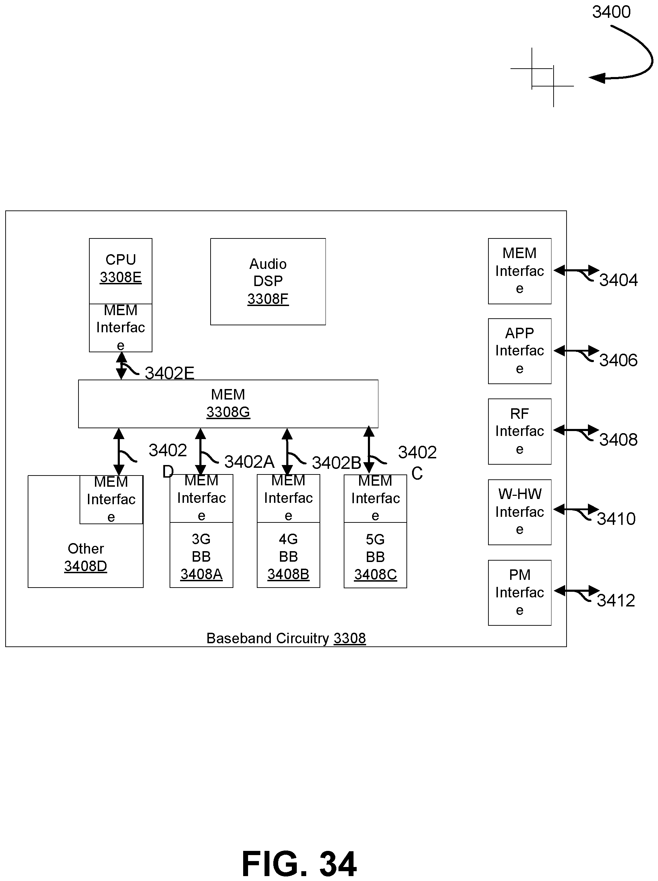

FIG. 34 illustrates example interfaces of baseband circuitry, in accordance with at least one embodiment. In at least one embodiment, as discussed above, baseband circuitry 3308 of FIG. 33 may comprise processors 3308A-3308E and a memory 3308G utilized by said processors. In at least one embodiment, each of processors 3308A-3308E may include a memory interface, 3402A-3402E, respectively, to send/receive data to/from memory 3308G.

In at least one embodiment, baseband circuitry 3308 may further include one or more interfaces to communicatively couple to other circuitries/devices, such as a memory interface 3404 (e.g., an interface to send/receive data to/from memory external to baseband circuitry 3308), an application circuitry interface 3406 (e.g., an interface to send/receive data to/from application circuitry 3304 of FIG. 33), an RF circuitry interface 3408 (e.g., an interface to send/receive data to/from RF circuitry 3310 of FIG. 33), a wireless hardware connectivity interface 3410 (e.g., an interface to send/receive data to/from Near Field Communication (NFC) components, Bluetooth^{®} components (e.g., Bluetooth^{®} Low Energy), Wi-Fi^{®} components, and other communication components), and a power management interface 3412 (e.g., an interface to send/receive power or control signals to/from PMC 3306.

In at least one embodiment, baseband circuitry 3308 and/or interfaces thereof can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

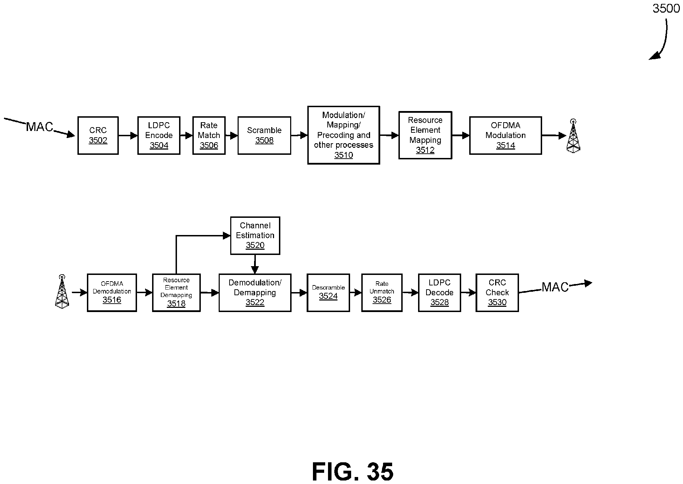

FIG. 35 illustrates an example of an uplink channel, in accordance with at least one embodiment. In at least one embodiment, FIG. 35 illustrates transmitting and receiving data within a physical uplink shared channel (PUSCH) in 5GNR, which may be part of a physical layer of a mobile device network.

In at least one embodiment, Physical Uplink Shared Channel (PUSCH) in 5G NR is designated to carry multiplexed control information and user application data. In at least one embodiment, 5G NR provides much more flexibility and reliability comparing to its predecessor, which in some examples may be referred to as 4GLTE, including more elastic pilot arrangements and support for both cyclic prefix (CP)-OFDM and Discrete Fourier Transform spread (DFT-s)-OFDM waveforms. In at least one embodiment, standard introduced filtered OFDM (f-OFDM) technique is utilized to add additional filtering to reduce Out-of-Band emission and improve performance at higher modulation orders. In at least one embodiment, modifications in Forward Error Correction (FEC) were imposed to replace Turbo Codes used in 4G LTE by Quasi-Cyclic Low Density Parity Check (QC-LDPC) codes, which were proven to achieve better transmission rates and provide opportunities for more efficient hardware implementations.

In at least one embodiment, transmission of 5G NR downlink and uplink data is organized into frames of 10 ms duration, each divided into 10 subframes of 1 ms each. In at least one embodiment, subframes are composed of a variable number of slots, depending on a selected subcarrier spacing which is parameterized in 5G NR. In at least one embodiment, a slot is built from 14 OFDMA symbols, each prepended with a cyclic prefix. In at least one embodiment, a subcarrier that is located within a passband and is designated for transmission is called a Resource Element (RE). In at least one embodiment, a group of 12 neighboring RE in a same symbol form a Physical Resource Block (PRB).

In at least one embodiment, 5G NR standard defined two types of reference signals associated with transmission within a PUSCH channel. In at least one embodiment, Demodulation Reference Signal (DMRS) is a user specific reference signal with high frequency density. In at least one embodiment, DMRS is transmitted within dedicated orthogonal frequency-division multiple access (OFDMA) symbols only and designated for frequency-selective channel estimation. In at least one embodiment, a number of DMRS symbols within a slot may vary between 1 and 4 depending on configuration, where a denser DMRS symbol spacing in time is designated for fast time-varying channels to obtain more accurate estimates within a coherence time of a channel. In at least one embodiment, in a frequency domain, DMRS PRB are mapped within a whole transmission allocation. In at least one embodiment, spacing between a DMRS resource element (RE) assigned for a same Antenna Port (AP) may be chosen between 2 and 3. In at least one embodiment, in a case of 2-2 multiple-input, multiple-output (MIMO), a standard allows for orthogonal assignment of RE between AP. In at least one embodiment, a receiver may perform partial single input, multiple output (SIMO) channel estimation based on a DMRS RE prior to MIMO equalization, neglecting spatial correlation.

In at least one embodiment, a second type of reference signal is a Phase Tracking Reference Signal (PTRS). In at least one embodiment, PTRS subcarriers are arranged in a comb structure having high density in a time domain. In at least one embodiment, it is used mainly in mmWave frequency bands to track and correct phase noise, which is a considerable source of performance losses. In at least one embodiment, usage of PTRS is optional, as it may lower a total spectral efficiency of a transmission when effects of phase noise are negligible.

In at least one embodiment, for transmission of data, a transport block may be generated from a MAC layer and given to a physical layer. In at least one embodiment, a transport block may be data that is intended to be transmitted. In at least one embodiment, a transmission in a physical layer starts with grouped resource data, which may be referred to as transport blocks. In at least one embodiment, a transport block is received by a cyclic redundancy check (CRC) 3502. In at least one embodiment, a cyclic redundancy check is appended to each transport block for error detection. In at least one embodiment, a cyclic redundancy check is used for error detection in transport blocks. In at least one embodiment, an entire transport block is used to calculate CRC parity bits and these parity bits are then attached to an end of a transport block. In at least one embodiment, minimum and maximum code block sizes are specified so blocks sizes are compatible with further processes. In at least one embodiment, an input block is segmented when an input block is greater than a maximum code block size.

In at least one embodiment, a transport block is received and encoded by a low-density parity-check (LDPC) encode 3504. In at least one embodiment, NR employs low-density parity-check (LDPC) codes for a data channel and polar codes for a control channel. In at least one embodiment, LDPC codes are defined by their parity-check matrices, with each column representing a coded bit, and each row representing a parity-check equation. In at least one embodiment, LDPC codes are decoded by exchanging messages between variables and parity checks in an iterative manner. In at least one embodiment, LDPC codes proposed for NR use a quasi-cyclic structure, where a parity-check matrix is defined by a smaller base matrix. In at least one embodiment, each entry of the base matrix represents either a ZxZ zero matrix or a shifted ZxZ identity matrix

In at least one embodiment, an encoded transport block is received by rate match 3506. In at least one embodiment, an encoded block is used to create an output bit stream with a desired code rate. In at least one embodiment, rate match 3506 is utilized to create an output bit stream to be transmitted with a desired code rate. In at least one embodiment, bits are selected and pruned from a buffer to create an output bit stream with a desired code rate. In at least one embodiment, a Hybrid Automatic Repeat Request (HARQ) error correction scheme is incorporated.

In at least one embodiment, output bits are scrambled, which may aid in privacy, in scramble 3508. In at least one embodiment, codewords are bit-wise multiplied with an orthogonal sequence and a UE-specific scrambling sequence. In at least one embodiment, output of scramble 3508 may be input into modulation/mapping/precoding and other processes 3510. In at least one embodiment, various modulation, mapping, and precoding processes are performed.

In at least one embodiment, bits output from scramble 3508 are modulated with a modulation scheme, resulting in blocks of modulation symbols. In at least one embodiment, scrambled codewords undergo modulation using one of modulation schemes QPSK, 16 QAM, 64 QAM, resulting in a block of modulation symbols. In at least one embodiment, a channel interleaver process may be utilized that implements a first time mapping of modulation symbols onto a transmit waveform while ensuring that HARQ information is present on both slots. In at least one embodiment, modulation symbols are mapped to various layers based on transmit antennas. In at least one embodiment, symbols may be precoded, in which they are divided into sets, and an Inverse Fast Fourier Transform may be performed. In at least one embodiment, transport data and control multiplexing may be performed such that HARQ acknowledge (ACK) information is present in both slots and is mapped to resources around demodulation reference signals. In at least one embodiment, various precoding processes are performed.

In at least one embodiment, symbols are mapped to allocated physical resource elements in resource element mapping 3512. In at least one embodiment, allocation sizes may be limited to values whose prime factors are 2, 3 and 5. In at least one embodiment, symbols are mapped in increasing order beginning with subcarriers. In at least one embodiment, subcarrier mapped modulation symbols data are orthogonal frequency-division multiple access (OFDMA) modulated through IFFT operation in OFDMA modulation 3514. In at least one embodiment, time domain representations of each symbol are concatenated and filtered using transmit FIR filter to attenuate unwanted Out of Band emission to adjacent frequency bands caused by phase discontinuities and utilization of different numerologies. In at least one embodiment, an output of OFDMA modulation 3514 may be transmitted to be received and processed by another system.

In at least one embodiment, a transmission may be received by OFDMA demodulation 3516. In at least one embodiment, a transmission may originate from user mobile devices over a cellular network, although other contexts may be present. In at least one embodiment, a transmission may be demodulated through IFFT processing. In at least one embodiment, once OFDMA demodulation through IFFT processing has been accomplished, an estimation and correction of residual Sample Time Offset (STO) and Carrier Frequency Offset (CFO) may be performed. In at least one embodiment, both CFO and STO corrections have to be performed in frequency domain, because a received signal can be a superposition of transmissions coming from multiple UEs multiplexed in frequency, each suffering from a specific residual synchronization error. In at least one embodiment, residual CFO is estimated as a phase rotation between pilot subcarriers belonging to different OFDM symbols and corrected by a circular convolution operation in frequency domain.

In at least one embodiment, output of OFDMA demodulation 3516 may be received by resource element demapping 3518. In at least one embodiment, resource element demapping 3518 may determine symbols and demap symbols from allocated physical resource elements. In at least one embodiment, a channel estimation and equalization is performed in channel estimation 3520 in order to compensate for effects of multipath propagation. In at least one embodiment, channel estimation 3520 may be utilized to minimize effects of noise originating from various transmission layers and antennae. In at least one embodiment, channel estimation 3520 may generate equalized symbols from an output of resource element demapping 3518. In at least one embodiment, demodulation/demapping 3522 may receive equalized symbols from channel estimation 3520. In at least one embodiment, equalized symbols are demapped and permuted through a layer demapping operation. In at least one embodiment, a Maximum A Posteriori Probability (MAP) demodulation approach may be utilized to produce values representing beliefs regarding a received bit being 0 or 1, expressed in a form of Log-Likelihood Ratio (LLR).

In at least one embodiment, soft-demodulated bits are processed using various operations, including descrambling, deinterleaving and rate unmatching with LLR soft-combining using a circular buffer prior to LDPC decoding. In at least one embodiment, descramble 3524 may involve processes that reverse one or more processes of scramble 3508. In at least one embodiment, rate unmatch 3526 may involve processes that reverse one or more processes of rate match 3506. In at least one embodiment, descramble 3524 may receive output from demodulation/demapping 3522, and descramble received bits. In at least one embodiment, rate unmatch 3526 may receive descrambled bits, and utilize LLR soft-combining utilizing a circular buffer prior to LDPC decode 3528.

In at least one embodiment, decoding of LDPC codes in practical applications is done based on iterative belief propagation algorithms. In at least one embodiment, an LDPC code can be represented in a form of a bipartite graph with parity check matrix H of size M x N being a biadjacency matrix defining connections between graph nodes. In at least one embodiment, M rows of matrix H corresponds to parity check nodes, whereas N columns corresponds to variable nodes, i.e., received codeword bits. In at least one embodiment, a principle of belief propagation algorithms is based on iterative message exchange, in which A Posteriori probabilities between a variable and check nodes are updated, until a valid codeword is obtained. In at least one embodiment, LDPC decode 3528 may output a transport block comprising data.

In at least one embodiment, CRC check 3530 may determine errors and perform one or more actions based on parity bits attached to a received transport block. In at least one embodiment, CRC check 3530 may analyze and process parity bits attached to a received transport block, or otherwise any information associated with a CRC. In at least one embodiment, CRC check 3530 may transmit a processed transport block to a MAC layer for further processing.

It should be noted that, in various embodiments, transmitting and receiving data, which may be a transport block or other variation thereof, may include various processes not depicted in FIG. 35. In at least one embodiment, processes depicted in FIG. 35 are not intended to be exhaustive and further processes such as additional modulation, mapping, multiplexing, precoding, constellation mapping/demapping, MIMO detection, detection, decoding and variations thereof may be utilized in transmitting and receiving data as part of a network.

In at least one embodiment, said uplink channel can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

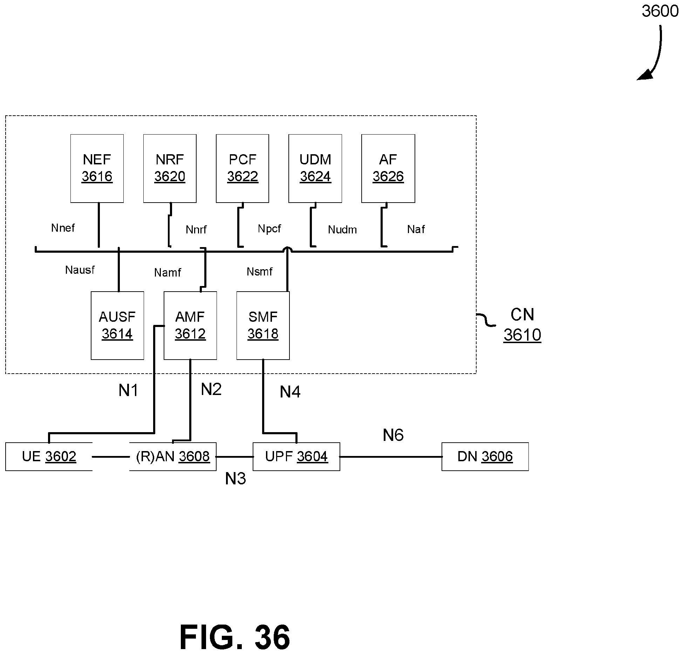

FIG. 36 illustrates an architecture of a system 3600 of a network in accordance with some embodiments. In at least one embodiment, system 3600 is shown to include a UE 3602, a 5G access node or RAN node (shown as (R)AN node 3608), a User Plane Function (shown as UPF 3604), a Data Network (DN 3606), which may be, for example, operator services, Internet access or 3rd party services, and a 5G Core Network (5GC) (shown as CN 3610).

In at least one embodiment, CN 3610 includes an Authentication Server Function (AUSF 3614); a Core Access and Mobility Management Function (AMF 3612); a Session Management Function (SMF 3618); a Network Exposure Function (NEF 3616); a Policy Control Function (PCF 3622); a Network Function (NF) Repository Function (NRF 3620); a Unified Data Management (UDM 3624); and an Application Function (AF 3626). In at least one embodiment, CN 3610 may also include other elements that are not shown, such as a Structured Data Storage network function (SDSF), an Unstructured Data Storage network function (UDSF), and variations thereof.

In at least one embodiment, UPF 3604 may act as an anchor point for intra-RAT and inter-RAT mobility, an external PDU session point of interconnect to DN 3606, and a branching point to support multi-homed PDU session. In at least one embodiment, UPF 3604 may also perform packet routing and forwarding, packet inspection, enforce user plane part of policy rules, lawfully intercept packets (UP collection); traffic usage reporting, perform QoS handling for user plane (e.g. packet filtering, gating, UL/DL rate enforcement), perform Uplink Traffic verification (e.g., SDF to QoS flow mapping), transport level packet marking in uplink and downlink, and downlink packet buffering and downlink data notification triggering. In at least one embodiment, UPF 3604 may include an uplink classifier to support routing traffic flows to a data network. In at least one embodiment, DN 3606 may represent various network operator services, Internet access, or third party services.

In at least one embodiment, AUSF 3614 may store data for authentication of UE 3602 and handle authentication related functionality. In at least one embodiment, AUSF 3614 may facilitate a common authentication framework for various access types.

In at least one embodiment, AMF 3612 may be responsible for registration management (e.g., for registering UE 3602, etc.), connection management, reachability management, mobility management, and lawful interception of AMF-related events, and access authentication and authorization. In at least one embodiment, AMF 3612 may provide transport for SM messages for SMF 3618, and act as a transparent proxy for routing SM messages. In at least one embodiment, AMF 3612 may also provide transport for short message service (SMS) messages between UE 3602 and an SMS function (SMSF) (not shown by FIG. 36). In at least one embodiment, AMF 3612 may act as Security Anchor Function (SEA), which may include interaction with AUSF 3614 and UE 3602 and receipt of an intermediate key that was established as a result of UE 3602 authentication process. In at least one embodiment, where USIM based authentication is used, AMF 3612 may retrieve security material from AUSF 3614. In at least one embodiment, AMF 3612 may also include a Security Context Management (SCM) function, which receives a key from SEA that it uses to derive access-network specific keys. In at least one embodiment, furthermore, AMF 3612 may be a termination point of RAN CP interface (N2 reference point), a termination point of NAS (NI) signaling, and perform NAS ciphering and integrity protection.

In at least one embodiment, AMF 3612 may also support NAS signaling with a UE 3602 over an N3 interworking-function (IWF) interface. In at least one embodiment, N3IWF may be used to provide access to untrusted entities. In at least one embodiment, N3IWF may be a termination point for N2 and N3 interfaces for control plane and user plane, respectively, and as such, may handle N2 signaling from SMF and AMF for PDU sessions and QoS, encapsulate/de-encapsulate packets for IPSec and N3 tunneling, mark N3 user-plane packets in uplink, and enforce QoS corresponding to N3 packet marking taking into account QoS requirements associated to such marking received over N2. In at least one embodiment, N3IWF may also relay uplink and downlink control-plane NAS (NI) signaling between UE 3602 and AMF 3612, and relay uplink and downlink user-plane packets between UE 3602 and UPF 3604. In at least one embodiment, N3IWF also provides mechanisms for IPsec tunnel establishment with UE 3602.

In at least one embodiment, SMF 3618 may be responsible for session management (e.g., session establishment, modify and release, including tunnel maintain between UPF and AN node); UE IP address allocation & management (including optional Authorization); Selection and control of UP function; Configures traffic steering at UPF to route traffic to proper destination; termination of interfaces towards Policy control functions; control part of policy enforcement and QoS; lawful intercept (for SM events and interface to LI System); termination of SM parts of NAS messages; downlink Data Notification; initiator of AN specific SM information, sent via AMF over N2 to AN; determine SSC mode of a session. In at least one embodiment, SMF 3618 may include following roaming functionality: handle local enforcement to apply QoS SLAB (VPLMN); charging data collection and charging interface (VPLMN); lawful intercept (in VPLMN for SM events and interface to LI System); support for interaction with external DN for transport of signaling for PDU session authorization/ authentication by external DN.

In at least one embodiment, NEF 3616 may provide means for securely exposing services and capabilities provided by 3GPP network functions for third party, internal exposure/re-exposure, Application Functions (e.g., AF 3626), edge computing or fog computing systems, etc. In at least one embodiment, NEF 3616 may authenticate, authorize, and/or throttle AFs. In at least one embodiment, NEF 3616 may also translate information exchanged with AF 3626 and information exchanged with internal network functions. In at least one embodiment, NEF 3616 may translate between an AF-Service-Identifier and an internal 5GC information. In at least one embodiment, NEF 3616 may also receive information from other network functions (NFs) based on exposed capabilities of other network functions. In at least one embodiment, this information may be stored at NEF 3616 as structured data, or at a data storage NF using a standardized interface. In at least one embodiment, stored information can then be re-exposed by NEF 3616 to other NFs and AFs, and/or used for other purposes such as analytics.

In at least one embodiment, NRF 3620 may support service discovery functions, receive NF Discovery Requests from NF instances, and provide information of discovered NF instances to NF instances. In at least one embodiment, NRF 3620 also maintains information of available NF instances and their supported services.

In at least one embodiment, PCF 3622 may provide policy rules to control plane function(s) to enforce them, and may also support unified policy framework to govern network behavior. In at least one embodiment, PCF 3622 may also implement a front end (FE) to access subscription information relevant for policy decisions in a UDR of UDM 3624.

In at least one embodiment, UDM 3624 may handle subscription-related information to support a network entities' handling of communication sessions, and may store subscription data of UE 3602. In at least one embodiment, UDM 3624 may include two parts, an application FE and a User Data Repository (UDR). In at least one embodiment, UDM may include a UDM FE, which is in charge of processing of credentials, location management, subscription management and so on. In at least one embodiment, several different front ends may serve a same user in different transactions. In at least one embodiment, UDM-FE accesses subscription information stored in an UDR and performs authentication credential processing; user identification handling; access authorization; registration/mobility management; and subscription management. In at least one embodiment, UDR may interact with PCF 3622. In at least one embodiment, UDM 3624 may also support SMS management, wherein an SMS-FE implements a similar application logic as discussed previously.

In at least one embodiment, AF 3626 may provide application influence on traffic routing, access to a Network Capability Exposure (NCE), and interact with a policy framework for policy control. In at least one embodiment, NCE may be a mechanism that allows a 5GC and AF 3626 to provide information to each other via NEF 3616, which may be used for edge computing implementations. In at least one embodiment, network operator and third party services may be hosted close to UE 3602 access point of attachment to achieve an efficient service delivery through a reduced end-to-end latency and load on a transport network. In at least one embodiment, for edge computing implementations, 5GC may select a UPF 3604 close to UE 3602 and execute traffic steering from UPF 3604 to DN 3606 via N6 interface. In at least one embodiment, this may be based on UE subscription data, UE location, and information provided by AF 3626. In at least one embodiment, AF 3626 may influence UPF (re)selection and traffic routing. In at least one embodiment, based on operator deployment, when AF 3626 is considered to be a trusted entity, a network operator may permit AF 3626 to interact directly with relevant NFs.

In at least one embodiment, CN 3610 may include an SMSF, which may be responsible for SMS subscription checking and verification, and relaying SM messages to/from UE 3602 to/from other entities, such as an SMS-GMSC/IWMSC/SMS-router. In at least one embodiment, SMS may also interact with AMF 3612 and UDM 3624 for notification procedure that UE 3602 is available for SMS transfer (e.g., set a UE not reachable flag, and notifying UDM 3624 when UE 3602 is available for SMS).

In at least one embodiment, system 3600 may include following service-based interfaces: Namf: Service-based interface exhibited by AMF; Nsmf: Service-based interface exhibited by SMF; Nnef: Service-based interface exhibited by NEF; Npcf: Service-based interface exhibited by PCF; Nudm: Service-based interface exhibited by UDM; Naf: Service-based interface exhibited by AF; Nnrf: Service-based interface exhibited by NRF; and Nausf: Service-based interface exhibited by AUSF.

In at least one embodiment, system 3600 may include following reference points: N1: Reference point between UE and AMF; N2: Reference point between (R)AN and AMF; N3: Reference point between (R)AN and UPF; N4: Reference point between SMF and UPF; and N6: Reference point between UPF and a Data Network. In at least one embodiment, there may be many more reference points and/or service-based interfaces between a NF services in NFs, however, these interfaces and reference points have been omitted for clarity. In at least one embodiment, an NS reference point may be between a PCF and AF; an N7 reference point may be between PCF and SMF; an N11 reference point between AMF and SMF; etc. In at least one embodiment, CN 3610 may include an Nx interface, which is an inter-CN interface between NIW and AMF 3612 in order to enable interworking between CN 3610 and CN 7236.

In at least one embodiment, system 3600 may include multiple RAN nodes (such as (R)AN node 3608) wherein an Xn interface is defined between two or more (R)AN node 3608 (e.g., gNBs) that connecting to 5GC 410, between a (R)AN node 3608 (e.g., gNB) connecting to CN 3610 and an eNB (e.g., a macro RAN node), and/or between two eNBs connecting to CN 3610.

In at least one embodiment, Xn interface may include an Xn user plane (Xn-U) interface and an Xn control plane (Xn-C) interface. In at least one embodiment, Xn-U may provide non-guar-anteed delivery of user plane PDUs and support/provide data forwarding and flow control functionality. In at least one embodiment, Xn-C may provide management and error handling functionality, functionality to manage a Xn-C interface; mobility support for UE 3602 in a connected mode (e.g., CM-CONNECTED) including functionality to manage UE mobility for connected mode between one or more (R)AN node 3608. In at least one embodiment, mobility support may include context transfer from an old (source) serving (R)AN node 3608 to new (target) serving (R)AN node 3608; and control of user plane tunnels between old (source) serving (R)AN node 3608 to new (target) serving (R)AN node 3608.

In at least one embodiment, a protocol stack of a Xn-U may include a transport network layer built on Internet Protocol (IP) transport layer, and a GTP-U layer on top of a UDP and/or IP layer(s) to carry user plane PDUs. In at least one embodiment, Xn-C protocol stack may include an application layer signaling protocol (referred to as Xn Application Protocol (Xn-AP)) and a transport network layer that is built on an SCTP layer. In at least one embodiment, SCTP layer may be on top of an IP layer. In at least one embodiment, SCTP layer provides a guaranteed delivery of application layer messages. In at least one embodiment, in a transport IP layer point-to-point transmission is used to deliver signaling PDUs. In at least one embodiment, Xn-U protocol stack and/or a Xn-C protocol stack may be same or similar to a user plane and/or control plane protocol stack(s) shown and described herein.

In at least one embodiment, system 3600 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

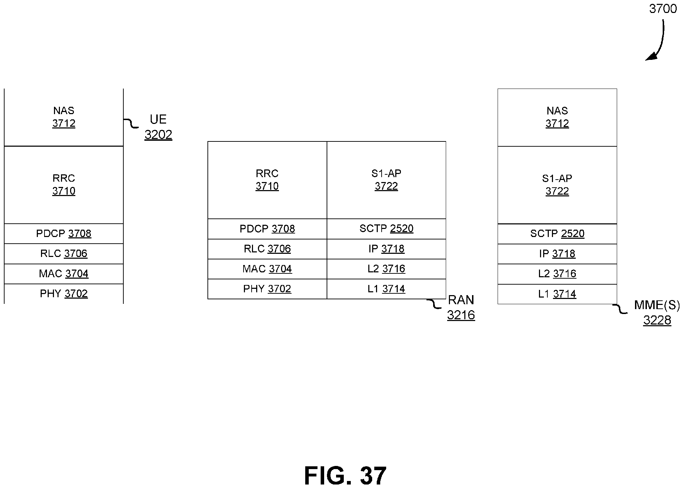

FIG. 37 is an illustration of a control plane protocol stack in accordance with some embodiments. In at least one embodiment, a control plane 3700 is shown as a communications protocol stack between UE 3202 (or alternatively, UE 3204), RAN 3216, and MME(s) 3228.

In at least one embodiment, PHY layer 3702 may transmit or receive information used by MAC layer 3704 over one or more air interfaces. In at least one embodiment, PHY layer 3702 may further perform link adaptation or adaptive modulation and coding (AMC), power control, cell search (e.g., for initial synchronization and handover purposes), and other measurements used by higher layers, such as an RRC layer 3710. In at least one embodiment, PHY layer 3702 may still further perform error detection on transport channels, forward error correction (FEC) coding/de-coding of transport channels, modulation/demodulation of physical channels, interleaving, rate matching, mapping onto physical channels, and Multiple Input Multiple Output (MIMO) antenna processing.

In at least one embodiment, MAC layer 3704 may perform mapping between logical channels and transport channels, multiplexing of MAC service data units (SDUs) from one or more logical channels onto transport blocks (TB) to be delivered to PHY via transport channels, demultiplexing MAC SDUs to one or more logical channels from transport blocks (TB) delivered from PHY via transport channels, multiplexing MAC SDUs onto TBs, scheduling information reporting, error correction through hybrid automatic repeat request (HARD), and logical channel prioritization.

In at least one embodiment, RLC layer 3706 may operate in a plurality of modes of operation, including: Transparent Mode (TM), Unacknowledged Mode (UM), and Acknowledged Mode (AM). In at least one embodiment, RLC layer 3706 may execute transfer of upper layer protocol data units (PDUs), error correction through automatic repeat request (ARQ) for AM data transfers, and concatenation, segmentation and reassembly of RLC SDUs for UM and AM data transfers. In at least one embodiment, RLC layer 3706 may also execute re-segmentation of RLC data PDUs for AM data transfers, reorder RLC data PDUs for UM and AM data transfers, detect duplicate data for UM and AM data transfers, discard RLC SDUs for UM and AM data transfers, detect protocol errors for AM data transfers, and perform RLC re-establishment.

In at least one embodiment, PDCP layer 3708 may execute header compression and decompression of IP data, maintain PDCP Sequence Numbers (SNs), perform in-sequence delivery of upper layer PDUs at re-establishment of lower layers, eliminate duplicates of lower layer SDUs at re-establishment of lower layers for radio bearers mapped on RLC AM, cipher and decipher control plane data, perform integrity protection and integrity verification of control plane data, control timer-based discard of data, and perform security operations (e.g., ciphering, deciphering, integrity protection, integrity verification, etc.).

In at least one embodiment, main services and functions of a RRC layer 3710 may include broadcast of system information (e.g., included in Master Information Blocks (MIBs) or System Information Blocks (SIBs) related to a non-access stratum (NAS)), broadcast of system information related to an access stratum (AS), paging, establishment, maintenance and release of an RRC connection between an UE and E-UTRAN (e.g., RRC connection paging, RRC connection establishment, RRC connection modification, and RRC connection release), establishment, configuration, maintenance and release of point-to-point radio bearers, security functions including key management, inter radio access technology (RAT) mobility, and measurement configuration for UE measurement reporting. In at least one embodiment, said MIBs and SIBs may comprise one or more information elements (IEs), which may each comprise individual data fields or data structures.

In at least one embodiment, UE 3202 and RAN 3216 may utilize a Uu interface (e.g., an LTE-Uu interface) to exchange control plane data via a protocol stack comprising PHY layer 3702, MAC layer 3704, RLC layer 3706, PDCP layer 3708, and RRC layer 3710.

In at least one embodiment, non-access stratum (NAS) protocols (NAS protocols 3712) form a highest stratum of a control plane between UE 3202 and MME(s) 3228. In at least one embodiment, NAS protocols 3712 support mobility of UE 3202 and session management procedures to establish and maintain IP connectivity between UE 3202 and P-GW 3234.

In at least one embodiment, Si Application Protocol (S1-AP) layer (Si-AP layer 3722) may support functions of a Si interface and comprise Elementary Procedures (EPs). In at least one embodiment, an EP is a unit of interaction between RAN 3216 and CN 3228. In at least one embodiment, S1 -AP layer services may comprise two groups: UE-associated services and non UE-associated services. In at least one embodiment, these services perform functions including, but not limited to: E-UTRAN Radio Access Bearer (E-RAB) management, UE capability indication, mobility, NAS signaling transport, RAN Information Management (RIM), and configuration transfer.

In at least one embodiment, Stream Control Transmission Protocol (SCTP) layer (alternatively referred to as a stream control transmission protocol/internet protocol (SCTP/IP) layer) (SCTP layer 3720) may ensure reliable delivery of signaling messages between RAN 3216 and MME(s) 3228 based, in part, on an IP protocol, supported by an IP layer 3718. In at least one embodiment, L2 layer 3716 and an L1 layer 3714 may refer to communication links (e.g., wired or wireless) used by a RAN node and MME to exchange information.

In at least one embodiment, RAN 3216 and MME(s) 3228 may utilize an S1 -MME interface to exchange control plane data via a protocol stack comprising a L1 layer 3714, L2 layer 3716, IP layer 3718, SCTP layer 3720, and Si -AP layer 3722.

In at least one embodiment, control plane 3700 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

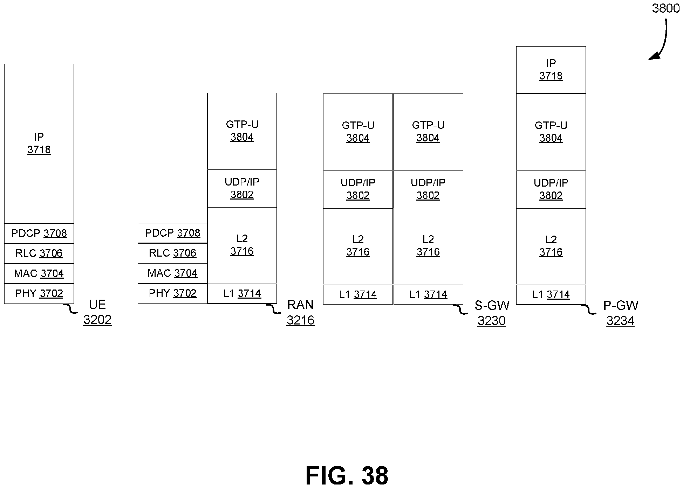

FIG. 38 is an illustration of a user plane protocol stack in accordance with at least one embodiment. In at least one embodiment, a user plane 3800 is shown as a communications protocol stack between a UE 3202, RAN 3216, S-GW 3230, and P-GW 3234. In at least one embodiment, user plane 3800 may utilize a same protocol layers as control plane 3700. In at least one embodiment, for example, UE 3202 and RAN 3216 may utilize a Uu interface (e.g., an LTE-Uu interface) to exchange user plane data via a protocol stack comprising PHY layer 3702, MAC layer 3704, RLC layer 3706, PDCP layer 3708.

In at least one embodiment, General Packet Radio Service (GPRS) Tunneling Protocol for a user plane (GTP-U) layer (GTP-U layer 3804) may be used for carrying user data within a GPRS core network and between a radio access network and a core network. In at least one embodiment, user data transported can be packets in any of IPv4, IPv6, or PPP formats, for example. In at least one embodiment, UDP and IP security (UDP/IP) layer (UDP/IP layer 3802) may provide checksums for data integrity, port numbers for addressing different functions at a source and destination, and encryption and authentication on selected data flows. In at least one embodiment, RAN 3216 and S-GW 3230 may utilize an S1 -U interface to exchange user plane data via a protocol stack comprising L1 layer 3714, L2 layer 3716, UDP/IP layer 3802, and GTP-U layer 3804. In at least one embodiment, S-GW 3230 and P-GW 3234 may utilize an S5/S8a interface to exchange user plane data via a protocol stack comprising L1 layer 3714, L2 layer 3716, UDP/IP layer 3802, and GTP-U layer 3804. In at least one embodiment, as discussed above with respect to FIG. 37, NAS protocols support a mobility of UE 3202 and session management procedures to establish and maintain IP connectivity between UE 3202 and P-GW 3234.

In at least one embodiment, user plane 3800 can include or otherwise implement one or more circuits to causing communication of a plurality of wireless devices with one or more base stations to be simulated based, at least in part, on grouping the plurality of wireless devices according to one or more shared communication frequency bands and/or otherwise perform any of the operations described above or elsewhere herein. One or more circuits can be configured by software to causing communication of a plurality of wireless devices with one or more base stations to be simulated based, at least in part, on grouping the plurality of wireless devices according to one or more shared communication frequency bands and/or otherwise perform any of the operations described above or elsewhere herein.

Operations of processes, systems, and processors described herein can be implemented for 5G and subsequent or modified versions of 5G. In at least one embodiment, processors, systems, and other computing units perform operations including providing wireless service for any 3rd Generation partnership Project (3GPP) wireless communication standard, including Sixth Generation (6G) and further generations from 3GPP or other standard setting organizations (e.g., European Telecommunications Standards Institute (ETSI) and Institute of Electrical and Electronics Engineers (IEEE)).

At least one embodiment of the disclosure can be described in view of the following clauses:
1. A processor comprising, one or more circuits to cause communication of a plurality of wireless devices with one or more base stations to be simulated based, at least in part, on grouping the plurality of wireless devices according to one or more shared communication frequency bands.
2. The processor of clause 1, wherein the grouping the plurality of wireless devices is based, at least in part on, the plurality of wireless devices using one or more wireless signals at different times, using one or more different frequencies, or including spatially different antennas.
3. The processor of clauses 1 or 2, wherein the one or more circuits are to group the plurality of wireless devices into orthogonal user equipment (UE) parameters and non-orthogonal UE parameters based, at least in part, on time, frequency, and port domain allocations.
4. The processor of any one of clauses 1-3, wherein one or more orthogonal UE parameters are processed using a single graphics processing unit (GPU) kernel to generate simulation outputs of each UE.
5. The processor of any one of clauses 1-4, wherein the one or more shared communication bands include one or more channels to be simulated in parallel by one or more processors.
6. The processor of any one of clauses 1-5, wherein the simulation of communication includes generating a data structure containing grouped UE parameters, the data structure comprising orthogonal UE parameters and non-orthogonal UE parameters.
7. The processor of any one of clauses 1-6, wherein the communication of a plurality of wireless devices to be simulated includes a channel generation component that simulates channel conditions of each UE based, at least in part, on one or more allocated frequency bands.
8. A system comprising, one or more processors to cause communication of a plurality of wireless devices with one or more base stations to be simulated based, at least in part, on grouping the plurality of wireless devices according to one or more shared communication frequency bands.
9. The system of clause 8, wherein the one or more processors are to cause one or more channels of the one or more base stations to be simulated in parallel based, at least in part, on assigning each portion of the one or more channels a unique identifier.
10. The system of clauses 8 or 9, wherein the one or more processors are to cause one or more channels of the one or more base stations to be simulated in parallel using a single kernel based, at least in part, on assigning each portion of the one or more channels a unique identifier.
11. The system of any one of clauses 8-10, wherein one or more orthogonal UE parameters are processed using a single graphics processing unit (GPU) kernel to generate simulation outputs of each UE.
12. The system of any one of clauses 8-11, wherein the one or more shared communication bands include one or more channels to be simulated in parallel by one or more processors.
13. The system of any one of clauses 8-12, wherein the simulation of communication includes generating a data structure containing grouped UE parameters, the data structure comprising orthogonal UE parameters and non-orthogonal UE parameters.
14. The system of any one of clauses 8-13, wherein the communication of a plurality of wireless devices to be simulated includes a channel generation component that simulates channel conditions of each UE based, at least in part, on one or more allocated frequency bands.
15. A method comprising: causing communication of a plurality of wireless devices with one or more base stations to be simulated based, at least in part, on grouping the plurality of wireless devices according to one or more shared communication frequency bands.
16. The method of clause 15, wherein the grouping the plurality of wireless devices is based, at least in part on, the plurality of wireless devices using one or more wireless signals at different times, using one or more different frequencies, or including spatially different antennas.
17. The method of clauses 15 or 16, further comprising grouping the plurality of wireless devices into orthogonal user equipment (UE) parameters and non-orthogonal UE parameters based, at least in part, on time, frequency, and port domain allocations.
18. The method of any one of clauses 15-17, wherein one or more orthogonal UE parameters are processed using a single graphics processing unit (GPU) kernel to generate simulation outputs of each UE.
19. The method of any one of clauses 15-18, wherein the one or more shared communication bands include one or more channels to be simulated in parallel by one or more processors.
20. The method of any one of clauses 15-19, wherein the simulation of communication includes generating a data structure containing grouped UE parameters, the data structure comprising orthogonal UE parameters and non-orthogonal UE parameters.

As will be apparent to one of ordinary skill in the art, other variations are within spirit of present disclosure. Thus, while disclosed techniques are susceptible to various modifications and alternative constructions, certain illustrated embodiments thereof are shown in drawings and have been described above in detail. It should be understood, however, that there is no intention to limit disclosure to specific form or forms disclosed, but on contrary, intention is to cover all modifications, alternative constructions, and equivalents falling within spirit and scope of disclosure, as defined in appended claims.

Use of terms "a" and "an" and "the" and similar referents in context of describing disclosed embodiments (especially in context of following claims) are to be construed to cover both singular and plural, unless otherwise indicated herein or clearly contradicted by context, and not as a definition of a term. Terms "comprising," "having," "including," and "containing" are to be construed as openended terms (meaning "including, but not limited to,") unless otherwise noted. Use of "may" and/or "can" is intended to indicate by way of example without limiting any particular embodiment or component or other function described above, below, or elsewhere herein. "Connected," when unmodified and referring to physical connections, is to be construed as partly or wholly contained within, attached to, or joined together, even if there is something intervening. Recitation of ranges of values herein are merely intended to serve as a shorthand method of referring individually to each separate value falling within range, unless otherwise indicated herein and each separate value is incorporated into specification as if it were individually recited herein. Use of term "set" (e.g., "a set of items") or "subset" unless otherwise noted or contradicted by context, is to be construed as a nonempty collection comprising one or more members. Further, unless otherwise noted or contradicted by context, term "subset" of a corresponding set does not necessarily denote a proper subset of corresponding set, but subset and corresponding set may be equal.

Conjunctive language, such as, but not limited to, phrases of form "at least one of A, B, and C," or "at least one of A, B and C," unless specifically stated otherwise or otherwise clearly contradicted by context, is otherwise understood with context as used in general to present that an item, term, etc., may be either A or B or C, or any nonempty subset of set of A and B and C. For instance, in illustrative example of a set having three members, conjunctive phrases "at least one of A, B, and C" and "at least one of A, B and C" refer to any of following sets: {A}, {B}, {C}, {A, B}, {A, C}, {B, C}, {A, B, C}. Thus, such conjunctive language is not generally intended to imply that certain embodiments require at least one of A, at least one ofB and at least one of C each to be present. In addition, unless otherwise noted or contradicted by context, term "plurality" indicates a state of being plural (e.g., "a plurality of items" indicates multiple items). Number of items in a plurality can be at least two, but can be more when so indicated either explicitly or by context. Further, unless stated otherwise or otherwise clear from context, phrase "based on" means "based at least in part on" and not "based solely on."

Operations of processes described herein can be performed in any suitable order unless otherwise indicated herein or otherwise clearly contradicted by context. A process such as, but not limited to, those processes described herein (or variations and/or combinations thereof) can be performed under control of one or more computer systems configured with executable instructions and is implemented as code (e.g., executable instructions, one or more computer programs or one or more applications) executing collectively on one or more processors, by hardware or combinations thereof. Code can be stored on a computer-readable storage medium, for example, in form of a computer program comprising a plurality of instructions executable by one or more processors. A computer-readable storage medium can be a non-transitory computer-readable storage medium that excludes transitory signals (e.g., a propagating transient electric or electromagnetic transmission) but includes non-transitory data storage circuitry (e.g., buffers, cache, and queues) within transceivers of transitory signals. Code (e.g., executable code or source code) can be stored on a set of one or more non-transitory computer-readable storage media having stored thereon executable instructions (or other memory to store executable instructions) that, when executed (i.e., as a result of being executed) by one or more processors of a computer system, cause computer system to perform operations described herein. A set of non-transitory computer-readable storage media can include multiple non-transitory computer-readable storage media and one or more of individual non-transitory storage media of multiple non-transitory computer-readable storage media lack all of code while multiple non-transitory computer-readable storage media collectively store all of code. Executable instructions can be executed such that different instructions are executed by different processors - for example, a non-transitory computer-readable storage medium store instructions and a main central processing unit ("CPU") executes some of instructions while a graphics processing unit ("GPU") executes other instructions. Different components of a computer system can have separate processors and different processors execute different subsets of instructions.

An arithmetic logic unit can include a set of combinational logic circuitry that takes one or more inputs to produce a result. An arithmetic logic unit can be used by a processor to implement mathematical operation such as, but not limited to, addition, subtraction, or multiplication. An arithmetic logic unit is used to implement logical operations such as, but not limited to, logical AND/OR or XOR. An arithmetic logic unit can be stateless, and made from physical switching components such as, but not limited to, semiconductor transistors arranged to form logical gates. An arithmetic logic unit may operate internally as a stateful logic circuit with an associated clock. An arithmetic logic unit may be constructed as an asynchronous logic circuit with an internal state not maintained in an associated register set. An arithmetic logic unit can be used by a processor to combine operands stored in one or more registers of the processor and produce an output that can be stored by the processor in another register or a memory location.

As a result of processing an instruction retrieved by the processor, the processor may present one or more inputs or operands to an arithmetic logic unit, causing the arithmetic logic unit to produce a result based at least in part on an instruction code provided to inputs of the arithmetic logic unit. The instruction codes provided by the processor to the ALU may be based at least in part on the instruction executed by the processor. Combinational logic in the ALU may process the inputs and produces an output which is placed on a bus within the processor. A processor can select a destination register, memory location, output device, or output storage location on the output bus so that clocking the processor causes the results produced by the ALU to be sent to the desired location.

In the scope of this application, the term arithmetic logic unit, or ALU, is used to refer to any computational logic circuit that processes operands to produce a result. For example, in the present document, the term ALU can refer to a floating point unit, a DSP, a tensor core, a shader core, a coprocessor, or a CPU.

One or more components of systems and/or processors disclosed above can communicate with one or more CPUs, ASICs, GPUs, FPGAs, or other hardware, circuitry, or integrated circuit components that include, e.g., an upscaler or upsampler to upscale an image, an image blender or image blender component to blend, mix, or add images together, a sampler to sample an image (e.g., as part of a DSP), a neural network circuit that is configured to perform an upscaler to upscale an image (e.g., from a low resolution image to a high resolution image), or other hardware to modify or generate an image, frame, or video to adjust its resolution, size, or pixels; one or more components of systems and/or processors disclosed above can use components described in this disclosure to perform methods, operations, or instructions that generate or modify an image.

Computer systems can be configured to implement one or more services that singly or collectively perform operations of processes described herein and such computer systems are configured with applicable hardware and/or software that enable performance of operations. Further, a computer system that implements at least one embodiment of present disclosure is a single device and, in another embodiment, is a distributed computer system comprising multiple devices that operate differently such that distributed computer system performs operations described herein and such that a single device does not perform all operations.

Use of any and all examples, or example language (e.g., "such as, but not limited to,") provided herein, is intended merely to better illuminate embodiments of disclosure and does not pose a limitation on scope of disclosure unless otherwise claimed. No language in specification should be construed as indicating any non-claimed element as essential to practice of disclosure.

All references, including publications, patent applications, and patents, cited herein are hereby incorporated by reference to same extent as if each reference were individually and specifically indicated to be incorporated by reference and were set forth in its entirety herein.

In description and claims, terms "coupled" and "connected," along with their derivatives, may be used. It should be understood that these terms may be not intended as synonyms for each other. Rather, in particular examples, "connected" or "coupled" may be used to indicate that two or more elements are in direct or indirect physical or electrical contact with each other. "Coupled" may also mean that two or more elements are not in direct contact with each other, but yet still co-operate or interact with each other.

Unless specifically stated otherwise, it may be appreciated that throughout specification terms such as, but not limited to, "processing," "computing," "calculating," "determining," or like, refer to action and/or processes of a computer or computing system, or similar electronic computing device, that manipulate and/or transform data represented as physical, such as, but not limited to, electronic, quantities within computing system's registers and/or memories into other data similarly represented as physical quantities within computing system's memories, registers or other such information storage, transmission or display devices.

In a similar manner, term "processor" may refer to any device or portion of a device that processes electronic data from registers and/or memory and transform that electronic data into other electronic data that may be stored in registers and/or memory. As non-limiting examples, "processor" may be a CPU or a GPU. A "computing platform" may comprise one or more processors. As used herein, "software" processes may include, for example, software and/or hardware entities that perform work over time, such as, but not limited to, tasks, threads, and intelligent agents. Also, each process may refer to multiple processes, for carrying out instructions in sequence or in parallel, continuously or intermittently. Terms "system" and "method" are used herein interchangeably insofar as system may embody one or more methods and methods may be considered a system.

References may be made to obtaining, acquiring, receiving, or inputting analog or digital data into a subsystem, computer system, or computer-implemented machine. Processes of obtaining, acquiring, receiving, or inputting analog and digital data can be accomplished in a variety of ways such as, but not limited to, by receiving data as a parameter of a function call or a call to an application programming interface. Processes of obtaining, acquiring, receiving, or inputting analog or digital data can be accomplished by transferring data via a serial or parallel interface. Processes of obtaining, acquiring, receiving, or inputting analog or digital data can be accomplished by transferring data via a computer network from providing entity to acquiring entity. References may also be made to providing, outputting, transmitting, sending, or presenting analog or digital data. In various examples, processes of providing, outputting, transmitting, sending, or presenting analog or digital data can be accomplished by transferring data as an input or output parameter of a function call, a parameter of an application programming interface or interprocess communication mechanism.

Although descriptions herein set forth example implementations of described techniques, other architectures may be used to implement described functionality, and are intended to be within scope of this disclosure. Furthermore, although specific distributions of responsibilities may be defined above for purposes of description, various functions and responsibilities might be distributed and divided in different ways, depending on circumstances.

Furthermore, although subject matter has been described in language specific to structural features and/or methodological acts, it is to be understood that subject matter claimed in appended claims is not necessarily limited to specific features or acts described. Rather, specific features and acts are disclosed as example forms of implementing the claims.

## Claims

1. A processor comprising: one or more circuits to cause communication of a plurality of wireless devices with one or more base stations to be simulated based, at least in part, on grouping the plurality of wireless devices according to one or more shared communication frequency bands.

2. The processor of claim 1, wherein the grouping the plurality of wireless devices is based, at least in part on, the plurality of wireless devices using one or more wireless signals at different times, using one or more different frequencies, or including spatially different antennas.

3. The processor of claim 1, wherein the one or more circuits are to group the plurality of wireless devices into orthogonal user equipment (UE) parameters and non-orthogonal UE parameters based, at least in part, on time, frequency, and port domain allocations.

4. The processor of claim 1, wherein one or more orthogonal UE parameters are processed using a single graphics processing unit (GPU) kernel to generate simulation outputs of each UE.

5. The processor of claim 1, wherein the one or more shared communication bands include one or more channels to be simulated in parallel by one or more processors.

6. The processor of claim 1, wherein the simulation of communication includes generating a data structure containing grouped UE parameters, the data structure comprising orthogonal UE parameters and non-orthogonal UE parameters.

7. The processor of claim 1, wherein the communication of a plurality of wireless devices to be simulated includes a channel generation component that simulates channel conditions of each UE based, at least in part, on one or more allocated frequency bands.

8. A system comprising: one or more processors to cause communication of a plurality of wireless devices with one or more base stations to be simulated based, at least in part, on grouping the plurality of wireless devices according to one or more shared communication frequency bands.

9. The system of claim 8, wherein the one or more processors are to cause one or more channels of the one or more base stations to be simulated in parallel based, at least in part, on assigning each portion of the one or more channels a unique identifier.

10. The system of claim 8, wherein the one or more processors are to cause one or more channels of the one or more base stations to be simulated in parallel using a single kernel based, at least in part, on assigning each portion of the one or more channels a unique identifier.

11. The system of claim 8, wherein one or more orthogonal UE parameters are processed using a single graphics processing unit (GPU) kernel to generate simulation outputs of each UE.

12. The system of claim 8, wherein the one or more shared communication bands include one or more channels to be simulated in parallel by one or more processors.

13. The system of claim 8, wherein the simulation of communication includes generating a data structure containing grouped UE parameters, the data structure comprising orthogonal UE parameters and non-orthogonal UE parameters.

14. The system of claim 8, wherein the communication of a plurality of wireless devices to be simulated includes a channel generation component that simulates channel conditions of each UE based, at least in part, on one or more allocated frequency bands.

15. A method comprising: causing communication of a plurality of wireless devices with one or more base stations to be simulated based, at least in part, on grouping the plurality of wireless devices according to one or more shared communication frequency bands.

16. The method of claim 15, wherein the grouping the plurality of wireless devices is based, at least in part on, the plurality of wireless devices using one or more wireless signals at different times, using one or more different frequencies, or including spatially different antennas.

17. The method of claim 15, further comprising grouping the plurality of wireless devices into orthogonal user equipment (UE) parameters and non-orthogonal UE parameters based, at least in part, on time, frequency, and port domain allocations.

18. The method of claim 15, wherein one or more orthogonal UE parameters are processed using a single graphics processing unit (GPU) kernel to generate simulation outputs of each UE.

19. The method of claim 15, wherein the one or more shared communication bands include one or more channels to be simulated in parallel by one or more processors.

20. The method of claim 15, wherein the simulation of communication includes generating a data structure containing grouped UE parameters, the data structure comprising orthogonal UE parameters and non-orthogonal UE parameters.
